(19) Europäisches Patentamt
European Patent Office
Office européen des brevets

(11) EP 2 483 356 B1

# (12) EUROPEAN PATENT SPECIFICATION

(45) Date of publication and mention of the grant of the patent:
**25.05.2016 Bulletin 2016/21**

(21) Application number: **10820740.8**

(22) Date of filing: **28.09.2010**

(51) Int Cl.:
***C09B 69/10*** *(2006.01)* ***C08F 2/50*** *(2006.01)*
***C08F 20/02*** *(2006.01)* ***C08F 20/34*** *(2006.01)*
***C08F 20/38*** *(2006.01)* ***C08F 20/56*** *(2006.01)*
***C08F 20/60*** *(2006.01)* ***C08F 220/36*** *(2006.01)*
***C08F 220/60*** *(2006.01)* ***C09B 23/00*** *(2006.01)*
***C09B 57/10*** *(2006.01)* ***G02B 5/20*** *(2006.01)*
***G02B 5/22*** *(2006.01)* ***G02F 1/1335*** *(2006.01)*
***G03F 7/004*** *(2006.01)* ***G03F 7/032*** *(2006.01)*
***G03F 7/033*** *(2006.01)* ***G03F 7/038*** *(2006.01)*
***G03F 7/40*** *(2006.01)* ***H01L 27/14*** *(2006.01)*

(86) International application number:
**PCT/JP2010/067321**

(87) International publication number:
**WO 2011/040628 (07.04.2011 Gazette 2011/14)**

## (54) COLORANT MULTIMER, COLORED CURABLE COMPOSITION, COLOR FILTER AND METHOD FOR PRODUCING THE SAME, AND SOLID-STATE IMAGE SENSOR, IMAGE DISPLAY DEVICE, LIQUID CRYSTAL DISPLAY DEVICE AND ORGANIC EL DISPLAY WITH THE COLOR FILTER

FARBSTOFF-MULTIMER, GEFÄRBTE HÄRTBARE ZUSAMMENSETZUNG, FARBFILTER UND HERSTELLUNGSVERFAHREN DAFÜR SOWIE FESTKÖRPERBILDAUFNAHMESENSOR, BILDANZEIGEVORRICHTUNG, FLÜSSIGKRISTALLANZEIGEVORRICHTUNG UND ORGANISCHE EL-ANZEIGE MIT DEM FARBFILTER

MULTIMÈRE COLORANT, COMPOSITION DURCISSABLE COLORÉE, FILTRE COLORÉ ET PROCÉDÉ DE FABRICATION DE CEUX-CI, ET DÉTECTEUR D’IMAGES À L’ÉTAT SOLIDE, DISPOSITIF D’AFFICHAGE D’IMAGES, DISPOSITIF D’AFFICHAGE À CRISTAUX LIQUIDES ET DISPOSITIF D’AFFICHAGE ÉLECTROLUMINESCENT ORGANIQUE AVEC LE FILTRE COLORÉ

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority:
**29.09.2009 JP 2009224960**
**30.09.2009 JP 2009228867**
**23.10.2009 JP 2009244465**
**26.11.2009 JP 2009269088**
**31.03.2010 JP 2010084604**
**30.07.2010 JP 2010172789**
**15.09.2010 JP 2010207215**
**21.09.2010 JP 2010210889**

(43) Date of publication of application:
**08.08.2012 Bulletin 2012/32**

(73) Proprietor: **FUJIFILM Corporation**
**Tokyo 106-8620 (JP)**

(72) Inventors:
- **ITO, Junichi**
**Haibara-gun**
**Shizuoka 421-0396 (JP)**
- **YOSHIKAWA, Masaru**
**Haibara-gun**
**Shizuoka 421-0396 (JP)**
- **MIZUKAWA, Yuki**
**Haibara-gun**
**Shizuoka 421-0396 (JP)**
- **USHIJIMA, Kenta**
**Haibara-gun**
**Shizuoka 421-0396 (JP)**
- **KANNA, Shinichi**
**Haibara-gun**
**Shizuoka 421-0396 (JP)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- **INABE, Haruki**
  **Haibara-gun**
  **Shizuoka 421-0396 (JP)**
- **FUJIE, Yoshihiko**
  **Haibara-gun**
  **Shizuoka 421-0396 (JP)**
- **GOTO, Akiyoshi**
  **Haibara-gun**
  **Shizuoka 421-0396 (JP)**
- **KANEKO, Yushi**
  **Haibara-gun**
  **Shizuoka 421-0396 (JP)**
- **IDEI, Hiroaki**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**



(56) References cited:
**EP-A2- 2 006 310**
**JP-A- 2000 302 810**
**JP-A- 2002 134 274**
**JP-A- 2002 134 274**
**JP-A- 2003 026 950**
**JP-A- 2005 284 011**
**JP-A- 2010 037 545**
**US-A1- 2007 112 134**
**US-A1- 2007 117 031**

## Description

### Technical Field

The present invention relates to a colorant multimer, a colored curable composition, a color filter and a method for producing the same, and a solid-state image sensor, an image display device, a liquid crystal display device and an organic el display with the color filter.

### Background Art

In recent years, with the advancement of personal computers and wide-screen liquid crystal televisions, the demand for liquid crystal displays (LCDs), in particular for liquid crystal color displays has tended to increase. Further, due to the demand for much higher image quality, the popularization of organic EL displays has been eagerly awaited.

Meanwhile, the demand for solid-state image sensors such as CCD image sensors has been significantly growing in accordance with the popularization of digital cameras, camera-equipped mobile phones and the like. Color filters have been used as a key device of such displays or optical devices, and the demand for cost reduction of color filters has been increasing in conjunction with the demand for higher image quality.

A color filter used for an mage display device or a solid-state image sensor generally has a color pattern of three primary colors, red (R), green (G), and blue (B), and serves to color the transmitting light or separate it into the three primary colors.

Coloring agents used in the color filter are commonly required to have the following characteristics. That is, they are required to have preferable light absorption characteristics in view of color reproducibility, to exhibit no occurrence of optical disturbance such as light scattering responsible for lowering of contrast in liquid crystal displays or non-uniformity of an optical density responsible for color unevenness or rough feeling in solid-state image sensors, to have favorable resistance for the environmental conditions under which they are used, such as, for example, heat resistance, light fastness and resistance to moist heat, and to provide a large molar absorption coefficient and the possibility of thickness reduction.

Examples of the methods of manufacturing the color filter used for liquid crystal displays, solid-state image sensors, or the like include a pigment dispersing method. Specific examples of the pigment dispersing method include a method of manufacturing a color filter by the use of a photolithographic method using a colored radiation-sensitive composition, in which a pigment is dispersed in various photosensitive compositions. More specifically, a radiation-sensitive composition is coated on a substrate using a spin coater, a roll coater or the like, and is dried, thereby forming a coated film. The coated film is exposed in a pattern-wise manner and developed, thereby obtaining colored pixels. The operation is repeated in desired numbers of color hues, thereby manufacturing a color filter.

The above method has been widely used as a method of manufacturing a color filter for color displays or the like, because, in the method, the color filter, which is formed using a pigment, is stable against heat or light, and patterning is performed by a photolithographic method, so that positioning accuracy can sufficiently be secured.

Liquid crystal displays have been widely used as television screens, computer screens or other display devices, since liquid crystal displays are compact and achieve power-saving as display devices and have equivalent or better function compared with conventional display devices

In recent years, the development of liquid crystal displays has expanded from application for computer screens or monitors, which have relatively small surface areas, to application for TV screens, which have large surface areas and require high image quality.

In the application for TV screens, higher image quality compared with conventional monitors, that is, improved contrast and color purity, has been demanded. In order to improve the contrast, photosensitive resin compositions for forming color filters are required to contain colorants (organic pigments or the like) having a smaller particle size. Furthermore, in order to improve color purity, it is important to increase the content of the colorants (organic pigments or the like) with respect to the solid content of the photosensitive resin compositions. However, conventional pigment dispersing methods are not sufficient for these requirements.

Furthermore, in recent years, higher definition in color filters for solid-state image sensors such as a CCD or the like has been demanded. Accordingly, micronization of pigments has been desired in order to suppress the color unevenness caused by coarse particles of pigments. Further, in a liquid crystal display, an organic EL display and the like, a color filter manufactured by the photolithographic method using a pigment dispersing method has the advantages that light fastness and heat resistance are excellent, but has the problems that a decrease in contrast or an increase in haze resulting from light scattering due to coarse particles of pigment arise. Therefore, in a color filter for a liquid crystal display, an organic EL display or the like, micronization of pigment particles has been desired.

However, since fine particles of a pigment are apt to aggregate, it is necessary to impart dispersibility to pigment. With an increase in definition, the size of a pattern tends to be micronized, but it is thought that it will be difficult to further

micronize the pattern size, and to further enhance the resolution, by using the widely used pigment dispersing methods. One of the reasons for this is that, in a minute pattern, color unevenness is caused by coarse particles formed by aggregation of pigment particles. Accordingly, in recent years, a situation has been reached where the pigment dispersing methods, which have been widely used, are not necessarily suitable for use in, for example, solid-state image sensors requiring a minute pattern.

Under such circumstances, a technique using a dye in place of a pigment has been suggested (for example, see Japanese Patent Application Laid-Open (JP-A) No.6-75375). When a dye is used in place of the pigment, color filters for solid-state image sensors are expected to achieve high resolution by solving the problems of color unevenness and rough feeling, whereas liquid crystal displays or organic EL displays are expected to achieve improvements in optical properties such as contrast or haze. In addition, the inkjet method using a dye generally has high jetting stability and is expected to achieve easy recovery of an ink jetting state by wiping or purging even when there is nozzle clogging associated with an increased ink viscosity or the like.

However, a dye-containing colored curable composition has other problems as follows.

(1) Dyes in a molecular dispersed state are generally poor in light fastness and heat resistance as compared to pigments forming molecular aggregates. In particular, there is a problem in that optical properties are changed due to a high-temperature process when forming a film of indium tin oxide (ITO) widely used as an electrode for liquid crystal displays or the like.

(2) Dyes in a molecular dispersed state are generally poor in solvent resistance as compared to pigments forming molecular aggregates.

(3) Dyes tend to inhibit a radical polymerization reaction, so there is difficulty in designing of a colored curable composition, for a system where radical polymerization is used as a curing means.

(4) Conventional dyes exhibit low solubility in an alkaline aqueous solution or organic solvent (hereinbelow, also referred to simply as "solvent"), and thus, it is difficult to obtain a colored curable composition with a desired spectrum.

(5) Dyes often exhibit interaction with other components in the colored curable composition, so it is difficult to control the solubility (developability) of the exposed parts and the non-exposed parts.

(6) When a molar absorption coefficient (ε) of the dye is low, a large amount of the dye needs to be added. Therefore, the amount of other components such as a polymerizable compound (monomer), a binder or photopolymerization initiator in the colored curable composition has to be relatively decreased, thereby reducing the curability, post-curing heat resistance, and developability of the composition.

Among these problems related to dyes, dipyrromethene metal complexes have been studied as dyes that solve the problems in item (1) above related to light fastness and heat resistance of dyes, and in item (6) above related to the molar absorption coefficient (ε) of dyes (for example, see U.S. Patent Publication No. 2008/0076044).

In a polymerizable composition that polymerizes with visible light, dipyrromethene metal complexes are used as a functional compound in addition to a sensitizer for a radical polymerization initiator (for example, see Japanese Patent Nos. 3279035, and 3324279, and JP-ANos. 11-352685, 11-352686, 2000-19729, 2000-19738, and 2002-236360). It is reported that the dipyrromethene metal complexes have excellent light fastness and heat resistance, a high molar absorption coefficient (ε), and preferable light absorption characteristics in view of color reproducibility (for example, see U.S. Patent Application Publication No. 2008/0076044).

Because of these problems, it has been difficult hitherto to form a color pattern for high-definition color filters, which is composed of a fine thin film and has excellent resistance, using a dye. In addition, with regard to color filters for solid-state image sensors, a colored layer is required to be formed of a thin film having a thickness of 1 μm or less. Therefore, in order to achieve desired absorption, a large amount of the colorant needs to be added to the curable composition, consequently resulting in the aforementioned problems.

Further, with regard to a colored curable composition containing a dye, it has been pointed out that, when a heating treatment is applied after the formation of a film, color transfer readily occurs between adjacent differently color patterns or between stacked and overlapped layers. In addition to color transfer, pattern peeling readily takes place in a low-exposure dose region due to the decreased sensitivity, and a desired shape or color density cannot be obtained due to thermal sagging, elution upon development, or the like which is caused by the decrease in the relative amount of photosensitive components contributing to photolithographic properties.

As approaches to solve these problems, there have been conventionally proposed a variety of methods involving selecting the kind of initiators, increasing an addition amount of initiators, or the like (for example, see JP-A No. 2005-316012). Further, there has been disclosed a method of producing a color filter wherein a color pattern is formed, and then polymerization is carried out in an elevated exposure temperature state by irradiating light to the color pattern while heating a substrate, thus increasing a polymerization rate of the system (for example, see Japanese Patent No. 3309514). In addition, there has been disclosed a method of producing a color filter wherein light irradiation is carried out between a development treatment and a heating treatment, thereby preventing shape deformation of the color filter

(for example, see JP-A No. 2006-258916).

Furthermore, the conventional dyes are problematic in that the dyes exhibit low developability in an alkaline solution, and thus a colored curable composition including such a dye exhibits low solubility (developability) in the non-exposed parts, which impairs pattern formation. As approaches to solve this problem, a method of polymerizing dyes by copolymerizing a monomer having a colorant group and a monomer having an alkali-soluble group in order to impart developability to a dye has been disclosed (for example, see JP-ANos. 2007-139906 and 2007-138051, and Japanese Patent No 3736221).

Summary of Invention

The colored curable composition containing a dipyrromethene metal complex as a dye is required to have more excellent light fastness and heat resistance.

Further, as recited in the problem of item (2) above, it has been necessary to increase solvent resistance when a dye is used as a coloring component. Solvent resistance is a property whereby a colorant in a cured portion is held in a film without eluting in a solvent. When an RGB color filter is manufactured by a photolithographic method, in order to form each color pattern sequentially, a color pattern is covered with a resist liquid whose color hue is different from that of the color pattern. At this time, since the elution of the colorant component in a cured portion into a resist liquid for subsequent color causes the problem of color mixing, extremely high solvent resistance in the cured portion is required in the manufacturing process for a color filter. In this regard, dyes in a molecular dispersed state are inferior to pigments that form aggregates with strong intermolecular force in terms of the solvent resistance.

Further, in the manufacture of a color filter, since in some cases, after coating, exposure and development processes, a color pattern is subjected to a heat treatment in order to increase the curability in a cured portion, the fixability of the dye in the cured portion is also important. Since the dyes in a molecular dispersed state can move with relatively low thermal energy as compared to pigments that form molecular aggregates, color transfer of the dye readily occurs between adjacent differently colored patterns. Accordingly, the fixability of dyes in the cured portion has been a significant issue.

A first aspect of the present invention was made in view of the above circumstances, and is to achieve the following objects.

That is, a first object of the first aspect of the invention is to provide a colorant multimer that can form a cured film having excellent color purity, light fastness, heat resistance and solvent resistance, less color transfer, and favorable pattern formability.

A second object of the first aspect of the invention is to provide a colored curable composition that can form a cured film having excellent color purity, light fastness, heat resistance and solvent resistance, less color transfer, and favorable pattern formability.

A third object of the first aspect of the invention is to provide a color filter provided with a color pattern having excellent color purity, heat resistance and light fastness even in a thin film, and a method of manufacturing the color filter.

As the results of the intensive studies by the inventors, it has been found that dipyrromethene metal complex compounds having a specific structure have favorable hue and high absorption coefficient, and excellent solvent solubility and resistances such as heat resistance or light fastness. By introducing the dipyrromethene metal complex structure into a colorant multimer, specifically, by forming a colorant multimer as a polymerization component formed by introducing a polymerizable group into the dipyrromethene metal complex structure, a cured film that has high solvent resistance and can reduce color transfer can be obtained. Furthermore, as necessary, by introducing an alkali-soluble group into the colorant multimer, a cured film having excellent pattern formability (with less dependency on the concentration of alkaline developer) can be obtained. The first aspect of the invention was attained based on such findings.

The first aspect of the invention is as follows:

<1> A colorant multimer including, as a partial structure of a colorant moiety, a dipyrromethene metal complex compound or tautomer thereof obtained from:

(i) a dipyrromethene compound represented by the following Formula (M); and
(ii) a metal or a metal compound:

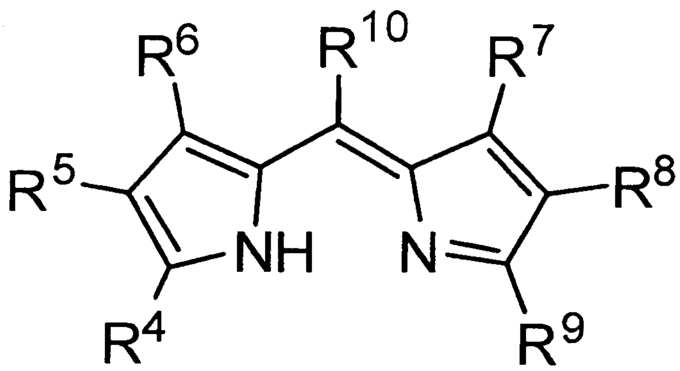

Formula (M)

wherein in Formula (M), $R^4$, $R^5$, $R^6$, $R^7$, $R^8$, $R^9$, and $R^{10}$ each independently represent a hydrogen atom or a monovalent substituent,

wherein the colorant multimer comprises at least one of constituent units represented by the following Formula (A), (B) or (C), or the colorant multimer is a colorant multimer represented by Formula (D):

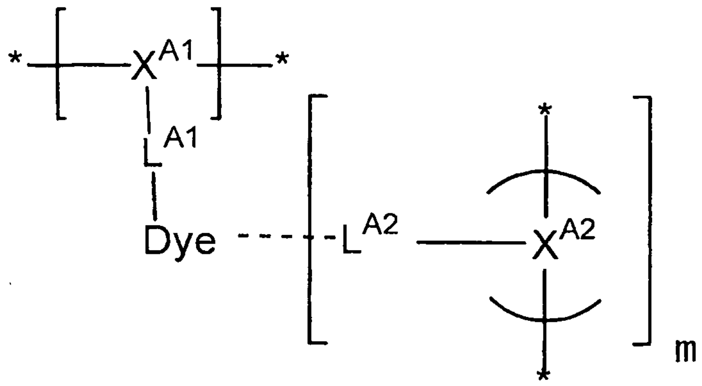

Formula (A)

wherein in Formula (A), $X^{A1}$ represents a linking group formed by polymerization; $L^{A1}$ represents a single bond or a divalent linking group; "Dye" represents a colorant residue formed by removing any one to (*m*+1) hydrogen atoms from the dipyrromethene metal complex compound or tautomer thereof obtained from (i) the dipyrromethene compound represented by Formula (M) and (ii) a metal or a metal compound; $X^{A2}$ represents a linking group formed by polymerization; $L^{A2}$ represents a single bond or a divalent linking group; m represents an integer of from 0 to 3; and "Dye" and $L^{A2}$ may be linked to each other by a covalent bond, an ionic bond or a coordinate bond:

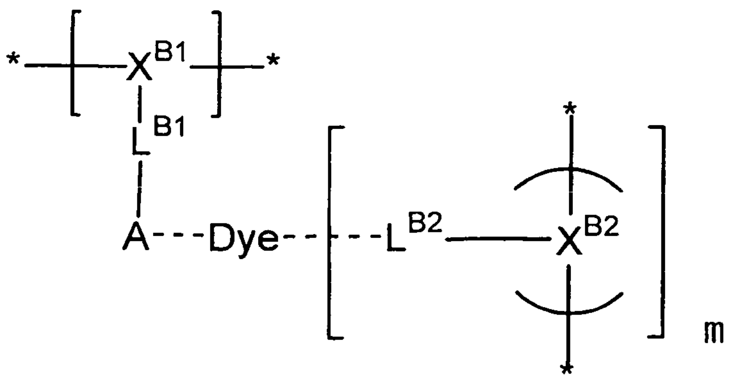

Formula (B)

wherein in Formula (B), $X^{B1}$ represents a linking group formed by polymerization; $L^{B1}$ represents a single bond or a divalent linking group; A represents a group that can be bonded to "Dye" via an ionic bond or a coordinate bond; "Dye" represents a colorant residue having a group that can be bonded to A, via an ionic bond or a coordinate bond, on a substituent in the dipyrromethene metal complex compound or tautomer thereof obtained from (i) the dipyrromethene compound represented by Formula (M) and (ii) a metal or a metal compound; $X^{B2}$ represents a linking group formed by polymerization; $L^{B2}$ represents a single bond or a divalent linking group; m represents an integer

of from 0 to 3; and "Dye" and $L^{B2}$ may be linked to each other by a covalent bond, an ionic bond or a coordinate bond:

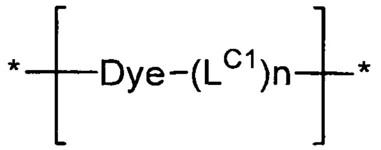

Formula (C)

wherein in Formula (C), $L^{C1}$ represents a single bond or a divalent linking group; "Dye" represents a colorant residue formed by removing any two of hydrogen atoms from the dipyrromethene metal complex compound or tautomer thereof obtained from (i) the dipyrromethene compound represented by Formula (M) and (ii) a metal or a metal compound; and n represents an integer of from 1 to 4.

<2> The colorant multimer according to <1>, wherein the dipyrromethene metal complex compound or tautomer thereof is represented by the following Formula (5) or (6):

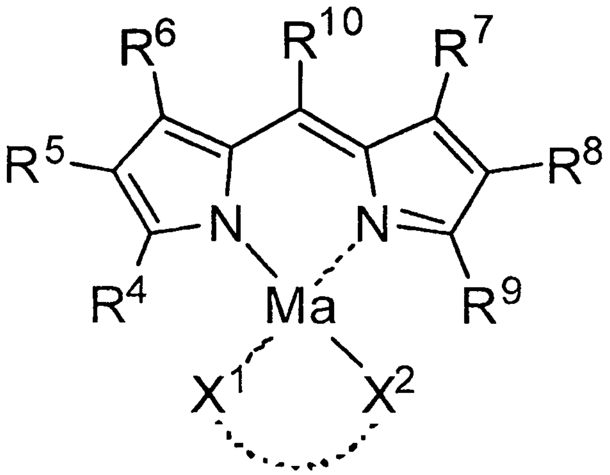

Formula (5)

wherein in Formula (5), $R^4$ to $R^9$ each independently represent a hydrogen atom or a substituent; $R^{10}$ represents a hydrogen atom, a halogen atom, an alkyl group, an aryl group or a heterocyclic group; Ma represents a metal atom or a metal compound; $X^1$ represents a group that can be bonded to Ma; $X^2$ represents a group that neutralizes the charge of Ma; and $X^1$ and $X^2$ may be linked to each other to form a 5-, 6-, or 7-membered ring together with Ma:

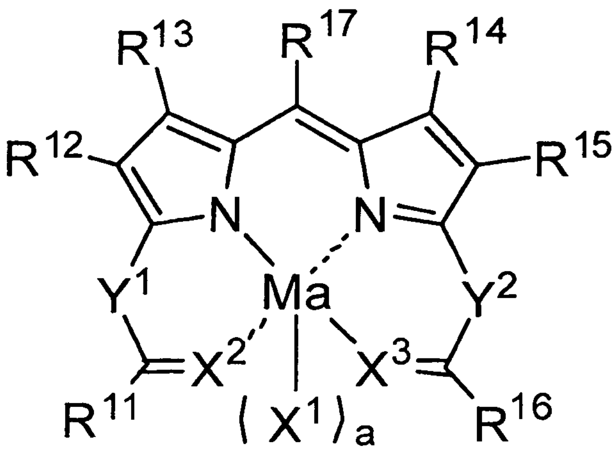

Formula (6)

wherein in Formula (6), $R^{11}$ and $R^{16}$ each independently represent an alkyl group, an alkenyl group, an aryl group, a heterocyclic group, an alkoxy group, an aryloxy group, an alkylamino group, an arylamino group, or a heterocyclic amino group; $R^{12}$ to $R^{15}$ each independently represent a hydrogen atom or a substituent; $R^{17}$ represents a hydrogen atom, a halogen atom, an alkyl group, an aryl group, or a heterocyclic group; Ma represents a metal atom or a metal compound; $X^2$ and $X^3$ each independently represent NR' (wherein R' represents a hydrogen atom, an alkyl group,

an alkenyl group, an aryl group, a heterocyclic group, an acyl group, an alkylsulfonyl group or an arylsulfonyl group), a nitrogen atom, an oxygen atom, or a sulfur atom; $Y^1$ and $Y^2$ each independently represent NR" (wherein R" represents a hydrogen atom, an alkyl group, an alkenyl group, an aryl group, a heterocyclic group, an acyl group, an alkylsulfonyl group, or an arylsulfonyl group), a nitrogen atom or a carbon atom; $R^{11}$ and $Y^1$ may be linked to each other to form a 5-, 6-, or 7-membered ring; $R^{16}$ and $Y^2$ may be linked to each other to form a 5-, 6-, or 7-membered ring; $X^1$ represents a group that can be bonded to Ma; and *a* represents 0, 1, or 2.

<3> The colorant multimer according to <1> or <2>, wherein the dipyrromethene metal complex compound or tautomer thereof is represented by the formula (6) as defined in <2> above.

<4> The colorant multimer according to <3>, wherein the constituent unit represented by Formula (A) is derived from a colorant monomer represented by the following Formula (1):

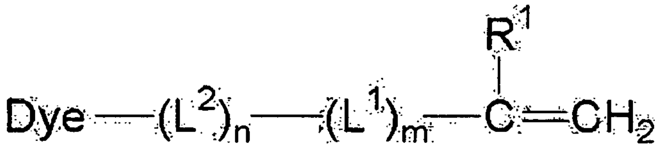

Formula (1)

wherein in Formula (1), $R^1$ represents a hydrogen atom, a halogen atom, an alkyl group or an aryl group; $L^1$ represents $-N(R^2)C(=O)-$, $-OC(=O)-$, $-C(=O)N(R^2)-$,$-C(=O)O-$, a group represented by the following Formula (2), a group represented by the following Formula (3), or a group represented by the following Formula (4); $L^2$ represents a divalent linking group; *m* and *n* each independently represent 0 or 1; "Dye" represents a colorant residue formed by removing any one hydrogen atom from the dipyrromethene metal complex compound or tautomer thereof obtained from (i) the dipyrromethene compound represented by Formula (M) and (ii) a metal or a metal compound; and $R^2$ represents a hydrogen atom, an alkyl group, an aryl group or a heterocyclic group:

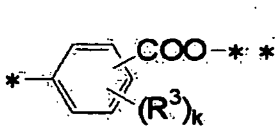

Formula (2)

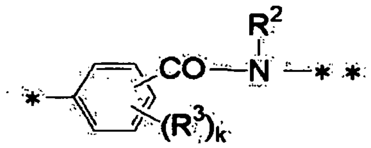

Formula (3)

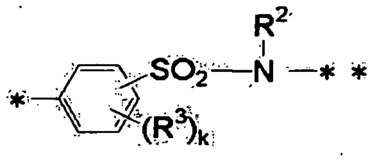

Formula (4)

wherein, $R^2$ in Formulae (3) and (4) independently represents a hydrogen atom, an alkyl group, an aryl group or a heterocyclic group; $R^3$ in Formulae (2) to (4) independently represents a hydrogen atom or a substituent; *k* in Formulae (2) to (4) independently represents an integer of from 0 to 4; * in Formulae (2) to (4) independently represents a position to which the $-C(R^1)=CH_2$ group in Formula (1) is linked; and ** in Formulae (2) to (4) independently represents a position to which $L^2$ or "Dye" (when *n* represents 0) in Formula (1) is linked.

<5> The colorant multimer according to <4>, further comprising, as a copolymerization component, a monomer having a terminal ethylenically unsaturated bond and having a structure different from that of the colorant monomer represented by Formula (1).

<6> The colorant multimer according to any one of <2> to <5>, wherein Ma in Formula (5) or Formula (6) is at lest one of Zn, Co, V=O or Cu.

<7> The colorant multimer according to any one of <2> to <5>, wherein Ma in Formula (5) or Formula (6) is Zn.

<8> The colorant multimer according to any one of <1> to <7>, wherein the colorant multimer has an alkali-soluble group.

<9> The colorant multimer according to <8>, wherein at least one selected from the group consisting of the colorant multimer comprising at least one of the constituent units represented by Formula (A), (B) or (C), the colorant multimer represented by Formula (D), the colorant monomer represented by Formula (1), and the monomer having a terminal ethylenically unsaturated bond and having a structure different from that of the colorant monomer represented by Formula (1), has the alkali-soluble group.

<10> The colorant multimer according to <8> or <9>, wherein the colorant multimer comprising at least one of the constituent units represented by Formula (A), (B) or (C), the colorant multimer represented by Formula (D), or "Dye" in Formula (1), has the alkali-soluble group.

<11> A colored curable composition comprising the colorant multimer according to any one of <1> to <10>.

<12> A color filter formed by using the colored curable composition according to <11>.

<13> A method of manufacturing a color filter, comprising coating the colored curable composition according to <11> on a substrate, exposing the coated film through a mask, and developing the exposed film to form a pattern

image.

Since the color filter according to the first aspect of the invention is formed using a colorant multimer that can form a cured film having excellent color purity, light fastness heat resistance, solvent resistance and pattern formability, in which color transfer is suppressed, the invention of the first aspect of the invention is particularly useful for forming a color filter for a solid-state image sensor in which a pixel pattern is formed in a thin film (for example, at a thickness of 1 μm or less), and high definition with a minute size of 2 μm or less (for example, a side length of the pixel pattern viewed from the substrate normal direction is from 0.5 to 2.0 μm is required, and a favorable rectangular cross-sectional profile is required, or a color filter for a liquid crystal display device, in which sufficient color purity and weather fastness are required in a pixel pattern formed in a thin film.

According to the first aspect of the invention, there is provided a colorant multimer that has excellent color purity, light fastness, heat resistance and solvent resistance, has less color transfer, and can form a cured film having favorable pattern formability.

According to the first aspect of the invention, there is also provided a colored curable composition that has excellent color purity, light fastness, heat resistance and solvent resistance, has less color transfer, and can form a cured film having favorable pattern formability.

Furthermore, according to the first aspect of the invention, there is provided a color filter provided with a color pattern having excellent color purity, heat resistance and light fastness even in a thin film, and a method of manufacturing the color filter.

The color filter and the method of manufacturing the color filter can be provided using the colored curable composition containing the colorant multimer of the first aspect of the present invention.

Modes for Carrying out the Invention

Hereinbelow, a colorant multimer, a colored curable composition, a color filter, and a method of manufacturing the color filter according to the first aspect of the invention are described in detail. Although the explanation of the constituent features described hereinbelow are made based on representative embodiments of the present invention, the present invention is not limited thereto. Further, the numeral range expressed by using "-" in the present specification represents a range including the numerical values described in front of and behind "-", as the minimum value and the maximum value.

*Colorant multimer*

The colorant multimer of the first aspect of the invention is a colorant multimer that includes, as a partial structure, a colorant skeleton derived from a dipyrromethene metal complex compound described below. The method of introducing the colorant skeleton derived from a dipyrromethene metal complex compound into the colorant multimer of the first aspect of the invention can be arbitrary selected. Examples of the method include a method in which a multimer is obtained by polymerizing or copolymerizing a polymerizable monomer into which the colorant skeleton has been introduced, and a method in which, after a multimer is formed, the colorant skeleton is introduced into the multimer by a polymerization reaction or the like.

Preferable examples of the colorant multimer include a colorant multimer including at least one of the constituent units represented by Formula (A), (B) or (C); and a colorant multimer containing the colorant monomer represented by Formula (1) as a polymerizable component.

*Preferable properties of colorant multimer of the invention*

Since he colorant multimer of the invention can form a cured film having excellent color purity, light fastness, heat resistance and solvent resistance, less color transfer, and favorable pattern formability, the colorant multimer can be suitably used for colored curable composition for forming the color pattern of a color filter. Therefore, when the colorant multimer of the invention is used for a colored curable composition, the colorant multimer of the invention preferably has an alkali-soluble group in order to improve formability of the color pattern.

The method of introducing an alkali-soluble group into the colorant multimer of the invention is not particularly limited, and examples thereof include a method in which an alkali-soluble group is introduced by synthesizing a colorant multimer using a monomer having an alkali-soluble group, and a method in which an alkali-soluble group is introduced after synthesizing a colorant multimer.

When a colorant multimer is synthesized using the monomer having an alkali-soluble group, at least one of the multimer containing at least one of the constituent units represented by Formula (A), (B) or (C), the colorant monomer represented by Formula (1), or the monomer having a terminal ethylenically unsaturated bond and having a structure

different from that of the colorant monomer represented by Formula (1), has an alkali-soluble group. When the constituent unit represented by Formula (A), Formula (B), or Formula (C), or the colorant monomer represented by Formula (1) is a monomer having an alkali-soluble group, the "Dye" moiety (colorant residue) may have the alkali-soluble group. From the viewpoint of synthesis suitability, it is preferable that at least one of monomers having ethylenically unsaturated bond contained as a copolymerization component has an alkali-soluble group, rather than the monomer that forms the constituent unit having the "Dye" moiety (colorant residue).

When the colorant multimer of the invention is used for a colored curable composition, from the viewpoint of formability of the color pattern, the colorant multimer preferably contains the alkali-soluble group such that the colorant multimer has an acid value of from 10 to 400 mgKOH/g, more preferably an acid value of from 30 to 300 mgKOH/g and still more preferably an acid value of from 50 to 200 mgKOH/g.

In the present invention, the acid value is determined by the method according to JIS Standard (JIS K 0070: 1992).

The solubility of the colorant multimer of the invention in an alkaline solution (pH of from 9 to 15) is preferably from 0.1% by mass to 80% by mass, more preferably from 0.5% by mass to 50% by mass, and still more preferably from 1% by mass to 30% by mass. When the solubility of the colorant multimer of the invention in an alkaline solution is within the above range, a suitable shape can be obtained and residues on a substrate can be reduced when the multimer of the invention is used for a color resist or the like, which requires alkali development.

It is preferable that the colorant multimer of the invention is soluble in an organic solvent. Examples of the organic solvent include esters (such as methyl 3-ethoxypropionate, ethyl 3-ethoxypropionate, ethyl lactate, butyl acetate or methyl 3-methoxypropionate); ethers (such as methyl cellosolve acetate, ethyl cellosolve acetate, propyleneglycol monomethyl ether or propyleneglycol monomethyl ether acetate); ketones (such as methyl ethyl ketone, cyclohexanone, 2-heptanone or 3-heptanone); and aromatic hydrocarbons (such as toluene or xylene). The colorant multimer is preferably soluble in the organic solvent at 1% by mass to 50% by mass, more preferably at 5% by mass to 40% by mass, and still more preferably at 10% by mass to 30% by mass. Within the above range, when the multimer of the invention is used for a color resist or the like, favorable coated surface can be obtained and reduction in concentration due to elution after coating a coating liquid for the other color can be suppressed.

The Tg (glass transition temperature) of the colorant multimer of the invention is preferably 50°C or more, and more preferably 100°C or more. A temperature determined by thermogravimetric analysis (TGA measurement) at which 5% of weight of the colorant multimer is lost is preferably 120°C or more, more preferably 150°C or more, and still more preferably 200°C or more. When the temperature is within the above range, the change in the concentration due to heating when the multimer of the invention is used for a color resist or the like can be reduced.

The maximal absorption wavelength ($\lambda$max) of the colorant multimer of the inventions is preferably from 510 nm to 590 nm, more preferably from 530 nm to 570 nm, and still more preferably from 540 nm to 555 nm. When the $\lambda$max is within the above range, a color filter with favorable color reproducibility can be obtained when the multimer of the invention is used for a color resist or the like. The absorbance of the colorant multimer of the invention at the maximal absorption wavelength ($\lambda$max) is preferably 1,000 times or more the absorbance at 450 nm, more preferably 10,000 or more times the absorbance at 450 nm, and still more preferably 100,000 or more times the absorbance at 450 nm. When the absorbance is within the above range, a color filter with higher transmittance can be obtained when the multimer of the invention is used for a color resist or the like, particularly in a blue color filter.

The absorption coefficient per unit weight of the colorant multimer of the invention (hereinbelow, denoted as $\varepsilon'$. $\varepsilon' = \varepsilon$/average molecular weight; unit: L/g·cm) is preferably 30 or more, more preferably 60 or more, and still more preferably 100 or more. When the absorption coefficient per unit weight is within the above range, a color filter with favorable color reproducibility can be obtained when the multimer of the invention is used for a color resist or the like.

It is more preferable that the colorant multimer of the invention satisfies both the preferable range of the maximum absorption wavelength ($\lambda$max) and the preferable range of the absorption coefficient per unit weight.

*Structure of the colorant multimer of the invention*

Hereinbelow, the structure of the colorant multimer of the invention is described in detail.

The colorant multimer of the invention includes a colorant skeleton derived from a dipyrromethene metal complex compound or tautomer thereof obtained from (i) the dipyrromethene compound represented by the following Formula (M) and (ii) a metal or a metal compound. Specifically, the colorant multimer of the invention preferably includes a colorant skeleton derived from the dipyrromethene metal complex compound represented by the following Formula (5) or the dipyrromethene metal complex compound represented by the following Formula (6).

*Dipyrromethene metal complex compound and tautomer thereof obtained from (i) the dipyrromethene compound represented by Formula (M) and (ii) a metal or a metal compound*

An aspect of the colorant multimer of the invention is a colorant multimer that includes, as a colorant moiety, a complex (hereinbelow, sometime referred to as a specific complex of the present invention), in which a compound

(dipyrromethene compound) represented by Formula (M) or tautomer thereof is coordinated to a metal or a metal compound. Here, the dipyrromethene metal complex compound according to the present invention includes tautomers thereof unless otherwise specified.

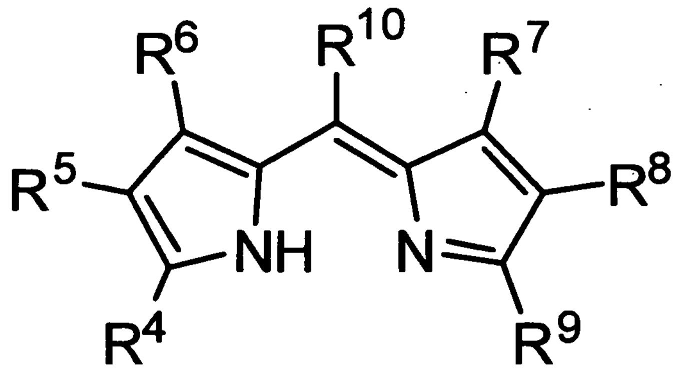

Formula (M)

In Formula (M), $R^4$, $R^5$, $R^6$, $R^7$, $R^8$, $R^9$ and $R^{10}$ each independently represent a hydrogen atom or a monovalent substituent.

It is preferable that, in Formula (M), $R^4$ to $R^9$ each independently represent a hydrogen atom or a monovalent substituent, and $R^{10}$ represents a hydrogen atom, a halogen atom, an alkyl group, an aryl group or a heterocyclic group.

Examples of the monovalent substituent represented by $R^4$ to $R^9$ in Formula (M) include a halogen atom (such as a fluorine atom, a chlorine atom or a bromine atom), an alkyl group (a straight-chain, branched-chain or cyclic alkyl group having preferably 1 to 48, more preferably 1 to 24 carbon atoms, such as a methyl group, an ethyl group, a propyl group, an isopropyl group, a butyl group, a t-butyl group, a pentyl group, a hexyl group, a heptyl group, an octyl group, a 2-ethylhexyl group, a dodecyl group, a hexadecyl group, a cyclopropyl group, a cyclopentyl group, a cyclohexyl group, a 1-norbornyl group or a 1-adamantyl group), an alkenyl group (an alkenyl group having preferably 2 to 48, more preferably 2 to 18 carbon atoms, such as a vinyl group, an allyl group or a 3-buten-1-yl group), an aryl group (an aryl group having preferably 6 to 48, more preferably 6 to 24 carbon atoms, such as a phenyl group or a naphthyl group), a heterocyclic group (a heterocyclic group having preferably 1 to 32, more preferably 1 to 18 carbon atoms, such as a 2-thienyl group, a 4-pyridyl group, a 2-furyl group, a 2-pyrimidinyl group, a 1-pyridyl group, a 2-benzothiazolyl group, a 1-imidazolyl group, a 1-pyrazolyl group or a benzotriazol-1-yl group), a silyl group (a silyl group having preferably 3 to 38, more preferably 3 to 18 carbon atoms, such as a trimethylsilyl group, a triethylsilyl group, a tributylsilyl group, a t-butyldimethylsilyl group or a t-hexyldimethylsilyl group), a hydroxy group, a cyano group, a nitro group, an alkoxy group (an alkoxy group having preferably 1 to 48, more preferably 1 to 24 carbon atoms, such as a methoxy group, an ethoxy group, a 1-butoxy group, a 2-butoxy group, an isopropoxy group, a t-butoxy group, a dodecyloxy group, or a cycloalkyloxy group such as a cyclopentyloxy group or a cyclohexyloxy group), an aryloxy group (an aryloxy group having preferably 6 to 48, more preferably 6 to 24 carbon atoms, such as a phenoxy group or a 1-naphthoxy group), a heterocyclic oxy group (a heterocyclic oxy group having preferably 1 to 32, more preferably 1 to 18 carbon atoms, such as a 1-phenyltetrazole-5-oxy group or a 2-tetrahydropyranyloxy group),

a silyloxy group (a silyloxy group having preferably 1 to 32, more preferably 1 to 18 carbon atoms, such as a trimethylsilyloxy group, a t-butyldimethylsilyloxy group or a diphenylmethylsilyloxy group), an acyloxy group (an acyloxy group having preferably 2 to 48, more preferably 2 to 24 carbon atoms, such as an acetoxy group, a pivaloyloxy group, a benzoyloxy group or a dodecanoyloxy group), an alkoxycarbonyloxy group (an alkoxycarbonyloxy group having preferably 2 to 48, more preferably 2 to 24 carbon atoms, such as an ethoxycarbonyloxy group, a t-butoxycarbonyloxy group, or a cycloalkyloxycarbonyloxy group such as a cyclohexyloxycarbonyloxy group), an aryloxycarbonyloxy group (an aryloxycarbonyloxy group having preferably 7 to 32, more preferably 7 to 24 carbon atoms, such as a phenoxycarbonyloxy group), a carbamoyloxy group (a carbamoyloxy group having preferably 1 to 48, more preferably 1 to 24 carbon atoms, such as an N,N-dimethylcarbamoyloxy group, an N-butylcarbamoyloxy group, an N-phenylcarbamoyloxy group or an N-ethyl-N-phenylcarbamoyloxy group), a sulfamoyloxy group (a sulfamoyloxy group having preferably 1 to 32, more preferably 1 to 24 carbon atoms, such as an N,N-diethylsulfamoyloxy group or an N-propylsulfamoyloxy group), an alkylsulfonyloxy group (an alkylsulfonyloxy group having preferably 1 to 38, more preferably 1 to 24 carbon atoms, such as a methylsulfonyloxy group, a hexadecylsulfonyloxy group or a cyclohexylsulfonyloxy group),

an arylsulfonyloxy group (an arylsulfonyloxy group having preferably 6 to 32, more preferably 6 to 24 carbon atoms, such as a phenylsulfonyloxy group), an acyl group (an acyl group having preferably 1 to 48, more preferably 1 to 24 carbon atoms, such as a formyl group, an acetyl group, a pivaloyl group, a benzoyl group, a tetradecanoyl group or a cyclohexanoyl group), an alkoxycarbonyl group (an alkoxycarbonyl group having preferably 2 to 48, more preferably 2 to 24 carbon atoms, such as a methoxycarbonyl group, an ethoxycarbonyl group, an octadecyloxycarbonyl group, a

cyclohexyloxycarbonyl group or a 2,6-di-tert-butyl-4-methylcyclohexyloxycarbonyl group), an aryloxycarbonyl group (an aryloxycarbonyl group having preferably 7 to 32, more preferably 7 to 24 carbon atoms, such as a phenoxycarbonyl group), a carbamoyl group (a carbamoyl group having preferably 1 to 48, more preferably 1 to 24 carbon atoms, such as a carbamoyl group, an N,N-diethylcarbamoyl group, an N-ethyl-N-octylcarbamoyl group, an N,N-dibutylcarbamoyl group, an N-propylcarbamoyl group, an N-phenylcarbamoyl group, a N-methyl-N-phenylcarbamoyl group or an N,N-dicyclohexylcarbamoyl group), an amino group (an amino group having preferably 32 or less, more preferably 24 or less carbon atoms, such as an amino group, a methylamino group, an N,N-dibutylamino group, a tetradecylamino group, a 2-ethylhexylamino group or a cyclohexylamino group),

an anilino group (an anilino group having preferably 6 to 32, more preferably 6 to 24 carbon atoms, such as an anilino group or an N-methylanilino group), a heterocyclic amino group (a heterocyclic amino group having preferably 1 to 32, more preferably 1 to 18 carbon atoms, such as a 4-pyridylamino group), a carbonamido group (a carbonamido group having preferably 2 to 48, more preferably 2 to 24 carbon atoms, such as an acetamido group, a benzamido group, a tetradecanamido group, a pivaloylamido group or a cyclohexaneamido group), an ureido group (an ureido group having preferably 1 to 32, more preferably 1 to 24 carbon atoms, such as an ureido group, an N,N-dimethylureido group or an N-phenylureido group), an imido group (an imido group having preferably 36 or less, more preferably 24 or less carbon atoms, such as an N-succinimido group or an N-phthalimido group), an alkoxycarbonylamino group (an alkoxycarbonylamino group having preferably 2 to 48, more preferably 2 to 24 carbon atoms, such as a methoxycarbonylamino group, an ethoxycarbonylamino group, a t-butoxycarbonylamino group, an octadecyloxycarbonylamino group or a cyclohexyloxycarbonylamino group), an aryloxycarbonylamino group (an aryloxycarbonylamino group having preferably 7 to 32, more preferably 7 to 24 carbon atoms, such as an phenoxycarbonylamino group), a sulfonamido group (a sulfonamido group having preferably 1 to 48, more preferably 1 to 24 carbon atoms, such as a methanesulfonamido group, a butanesulfonamido group, a benzenesulfonamido group, a hexadecanesulfonamido group or a cyclohexanesulfonamido group), a sulfamoylamino group (a sulfamoylamino group having preferably 1 to 48, more preferably 1 to 24 carbon atoms, such as an N,N-dipropylsulfamoylamino group or an N-ethyl-N-dodecylsulfamoylamino group), an azo group (an azo group having preferably 1 to 32, more preferably 1 to 24 carbon atoms, such as a phenylazo group or a 3-pyrazolylazo group),

an alkylthio group (an alkylthio group having preferably 1 to 48, more preferably 1 to 24 carbon atoms, such as a methylthio group, an ethylthio group, an octylthio group or a cyclohexylthio group), an arylthio group (an arylthio group having preferably 6 to 48, more preferably 6 to 24 carbon atoms, such as a phenylthio group), a heterocyclic thio group (a heterocyclic thio group having preferably 1 to 32, more preferably 1 to 18 carbon atoms, such as a 2-benzothiazolylthio group, a 2-pyridylthio group or a 1-phenyltetrazolylthio group), an alkylsulfinyl group (an alkylsulfinyl group having preferably 1 to 32, more preferably 1 to 24 carbon atoms, such as a dodecanesulfinyl group), an arylsulfinyl group (an arylsulfinyl group having preferably 6 to 32, more preferably 6 to 24 carbon atoms, such as a phenylsulfinyl group), an alkylsulfonyl group (an alkylsulfonyl group having preferably 1 to 48, more preferably 1 to 24 carbon atoms, such as a methylsulfonyl group, an ethylsulfonyl group, a propylsulfonyl group, a butylsulfonyl group, an isopropylsulfonyl group, a 2-ethylhexylsulfonyl group, a hexadecylsulfonyl group, an octylsulfonyl group or a cyclohexylsulfonyl group), an arylsulfonyl group (an arylsulfonyl group having preferably 6 to 48, more preferably 6 to 24 carbon atoms, such as a phenylsulfonyl group or a 1 -naphthylsulfonyl group), a sulfamoyl group (a sulfamoyl group having preferably 32 or less, more preferably 24 or less carbon atoms, such as a sulfamoyl group, an N,N-dipropylsulfamoyl group, an N-ethyl-N-dodecylsulfamoyl group, an N-ethyl-N-phenylsulfamoyl group or an N-cyclohexylsulfamoyl group), a sulfo group, a phosphonyl group (a phosphonyl group having preferably 1 to 32, more preferably 1 to 24 carbon atoms, such as a phenoxyphosphonyl group, an octyloxyphosphonyl group or a phenylphosphonyl group) and a phosphinoylamino group (a phosphinoylamino group having preferably 1 to 32, more preferably 1 to 24 carbon atoms, such as a diethoxyphosphinoylamino group or an dioctyloxyphosphinoylamino group).

When the monovalent group represented by $R^4$ to $R^9$ is a group that may further be substituted, the monovalent group may further be substituted by any of the monovalent substituent groups in $R^4$ to $R^9$ above. When the monovalent group has two or more substituents, these substituents may be the same as or different from one another.

In Formula (M), $R^4$ and $R^5$ may be linked to each other to form a 5-membered to 7-membered saturated ring or a 5-membered to 7-membered unsaturated ring; $R^5$ and $R^6$ may be linked to each other to form a 5-membered to 7-membered saturated ring or a 5-membered to 7-membered unsaturated ring; $R^7$ and $R^8$ may be linked to each other to form a 5-membered to 7-membered saturated ring or a 5-membered to 7-membered unsaturated ring; and $R^8$ and $R^9$ may be linked to each other to form a 5-, 6- or 7-membered saturated ring or a 5-, 6- or 7-membered unsaturated ring. When the 5-, 6-or 7-membered saturated or unsaturated ring has a substituent, the substituent may be any of the monovalent substituent groups in $R^4$ to $R^9$ above. When the 5-, 6- or 7-membered saturated or unsaturated ring has two or more substituents, these substituents may be the same as or different from one another.

Examples of the 5-, 6- or 7-membered saturated or unsaturated ring include unsubstituted 5-, 6- or 7-membered saturated or unsaturated rings include a pyrrole ring, a furan ring, a thiophene ring, a pyrazole ring, an imidazole ring, a triazole ring, an oxazole ring, a thiazole ring, a pyrrolidine ring, a piperidine ring, a cyclopentene ring, a cyclohexene

ring, a benzene ring, a pyridine ring, a pyrazine ring or a pyridazine ring. Among these, a benzene ring and a pyridine ring are preferable.

In Formula (M), $R^{10}$ preferably represents a hydrogen atom, a halogen atom, an alkyl group, an aryl group or a heterocyclic group. Each of the hydrogen atom, the halogen atom, the alkyl group, the aryl group and the heterocyclic group has the same definition as the hydrogen atom, the halogen atom, the alkyl group, the aryl group and the heterocyclic group in $R^4$ to $R^9$ above, and has the same preferable definitions as the hydrogen atom, the halogen atom, the alkyl group, the aryl group and the heterocyclic group in $R^4$ to $R^9$ above.

When an alkyl group, an aryl group or a heterocyclic group represented by $R^{10}$ is a group that may further be substituted, the group may further be substituted by any of the monovalent substituent groups in $R^4$ to $R^9$ above. When the group has two or more substituents, these substituents may be the same as or different from one another.

*Metal atom or metal compound*

The specific complex of the present invention is a complex in which the compound represented by Formula (M) or a tautomer thereof is coordinated to a metal atom or metal compound.

Here, the metal atom or metal compound may be any metal atom or metal compound as long as it may form a complex, and examples include bivalent metal atoms, bivalent metal oxides, bivalent metal hydroxides and bivalent metal chlorides. Specific examples thereof include Zn, Mg, Si, Sn, Rh, Pt, Pd, Mo, Mn, Pb, Cu, Ni, Co and Fe; metal chlorides such as $AlCl_3$, $InCl_3$, $FeCl_2$, $TiCl_2$, $SnCl_2$, $SiCl_2$ or $GeCl_2$; metal oxides such as TiO or VO; and metal hydroxides such as $Si(OH)_2$.

Among these, Fe, Zn, Mg, Si, Pt, Pd, Mo, Mn, Cu, Ni, Co, TiO and VO are preferable, Zn, Mg, Si, Pt, Pd, Cu, Ni, Co and VO are more preferable, and Zn is still more preferable in view of stability, spectral property, heat resistance, light fastness, and production suitability and the like of the complex.

A preferable embodiment of the specific complex including the compound represented by Formula (M) and the metal atom or the metal compound is described below.

Namely, it is preferable that, in Formula (M), $R^4$ and $R^9$ each independently represent a hydrogen atom, an alkyl group, an alkenyl group, an aryl group, a heterocyclic group, a silyl group, a hydroxy group, a cyano group, an alkoxy group, an aryloxy group, a heterocyclic oxy group, an acyl group, an alkoxycarbonyl group, a carbamoyl group, an amino group, an anilino group, a heterocyclic amino group, a carbonamido group, an ureido group, an imido group, an alkoxycarbonylamino group, an aryloxycarbonylamino group, a sulfonamido group, an azo group, an alkylthio group, an arylthio group, a heterocyclic thio group, an alkylsulfonyl group, an arylsulfonyl group or a phosphinoylamino group, $R^5$ and $R^8$ each independently represent a hydrogen atom, a halogen atom, an alkyl group, an alkenyl group, an aryl group, a heterocyclic group, a hydroxy group, a cyano group, a nitro group, an alkoxy group, an aryloxy group, a heterocyclic oxy group, an acyl group, an alkoxycarbonyl group, an aryloxycarbonyl group, a carbamoyl group, an imido group, an alkoxycarbonylamino group, a sulfonamido group, an azo group, an alkylthio group, an arylthio group, a heterocyclic thio group, an alkylsulfonyl group, an arylsulfonyl group or a sulfamoyl group, $R^6$ and $R^7$ each independently represent a hydrogen atom, a halogen atom, an alkyl group, an alkenyl group, an aryl group, a heterocyclic group, a silyl group, a hydroxy group, a cyano group, an alkoxy group, an aryloxy group, a heterocyclic oxy group, an acyl group, an alkoxycarbonyl group, a carbamoyl group, an anilino group, a carbonamido group, an ureido group, an imido group, an alkoxycarbonylamino group, a sulfonamido group, an azo group, an alkylthio group, an arylthio group, a heterocyclic thio group, an alkylsulfonyl group, an arylsulfonyl group, a sulfamoyl group or a phosphinoylamino group, and $R^{10}$ represents a hydrogen atom, a halogen atom, an alkyl group, an aryl group or a heterocyclic group; and the metal atom or the metal compound is Zn, Mg, Si, Pt, Pd, Mo, Mn, Cu, Ni, Co, TiO or VO.

It is more preferable that, in Formula (M), $R^4$ and $R^9$ each independently represent a hydrogen atom, an alkyl group, an alkenyl group, an aryl group, a heterocyclic group, a cyano group, an acyl group, an alkoxycarbonyl group, a carbamoyl group, an amino group, a heterocyclic amino group, a carbonamido group, an ureido group, an imido group, an alkoxycarbonylamino group, an aryloxycarbonylamino group, a sulfonamido group, an azo group, an alkylsulfonyl group, an arylsulfonyl group or a phosphinoylamino group, $R^5$ and $R^8$ each independently represent an alkyl group, an alkenyl group, an aryl group, a heterocyclic group, a cyano group, a nitro group, an acyl group, an alkoxycarbonyl group, an aryloxycarbonyl group, a carbamoyl group, an imido group, an alkylsulfonyl group, an arylsulfonyl group or a sulfamoyl group, $R^6$ and $R^7$ each independently represent a hydrogen atom, an alkyl group, an alkenyl group, an aryl group, a heterocyclic group, a cyano group, an acyl group, an alkoxycarbonyl group, a carbamoyl group, a carbonamido group, an ureido group, an imido group, an alkoxycarbonylamino group, a sulfonamido group, an alkylthio group, an arylthio group, a heterocyclic thio group, an alkylsulfonyl group, an arylsulfonyl group or a sulfamoyl group, and $R^{10}$ represents a hydrogen atom, a halogen atom, an alkyl group, an aryl group or a heterocyclic group; and the metal atom or the metal compound is Zn, Mg, Si, Pt, Pd, Cu, Ni, Co or VO.

It is still more preferable that, in Formula (M), $R^4$ and $R^9$ each independently represent a hydrogen atom, an alkyl group, an aryl group, a heterocyclic group, an amino group, a heterocyclic amino group, a carbonamido group, an

ureido group, an imido group, an alkoxycarbonylamino group, a sulfonamido group, an azo group, an alkylsulfonyl group, an arylsulfonyl group or a phosphinoylamino group, $R^5$ and $R^8$ each independently represent an alkyl group, an aryl group, a heterocyclic group, a cyano group, an acyl group, an alkoxycarbonyl group, a carbamoyl group, an alkylsulfonyl group or an arylsulfonyl group, $R^6$ and $R^7$ each independently represent a hydrogen atom, an alkyl group, an aryl group or a heterocyclic group, and $R^{10}$ represents a hydrogen atom, an alkyl group, an aryl group or a heterocyclic group; and the metal atom or the metal compound is Zn, Cu, Co or VO.

In addition, a preferable embodiment of the specific complex includes a compound represented by Formula (5) or Formula (6) described in detail below.

*Dipyrromethene metal complex compound represented by Formula (5)*

One aspect of the colorant multimer of the invention includes a colorant multimer having a dye residue, in which any one hydrogen atom is removed from the dipyrromethene metal complex compound represented by the following Formula (5):

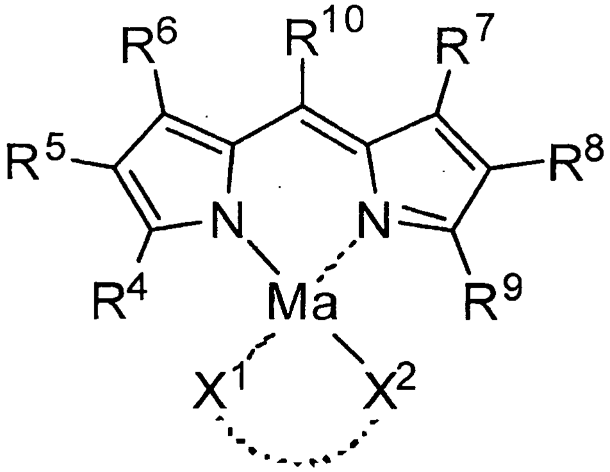

Formula (5)

In Formula (5), $R^4$ to $R^9$ each independently represent a hydrogen atom or a substituent; $R^{10}$ represents a hydrogen atom, a halogen atom, an alkyl group, an aryl group or a heterocycle group; Ma represents a metal atom or a metal compound; $X^1$ represents a group that can be bonded to Ma; $X^2$ represents a group that neutralizes the charge of Ma; and $X^1$ and $X^2$ may be linked to each other to form a 5-, 6- or 7-membered ring together with Ma. Examples of the dipyrromethene metal complex represented by Formula (5) include tautomers thereof.

When the dipyrromethene metal complex compound represented by Formula (5) is introduced into the constituent unit represented by Formula (A), (B) or (C), or the monomer represented by Formula (1), the position to be introduced is preferably, but not limited to, any one of $R^4$ to $R^9$, more preferably any one of $R^4$, $R^6$, $R^7$ and $R^9$, and still more preferably $R^4$ or $R^9$, in view of the synthetic suitability.

Examples of the method of introducing an alkali-soluble group into the colorant multimer of the invention include a method in which the alkali-soluble group is introduced into one, or two or more substituents of $R^4$ to $R^{10}$, and $X^1$, and $X^2$ of the dipyrromethene metal complex compound represented by Formula (5). The alkali-soluble group is preferably introduced into any one of $R^4$ to $R^9$ and $X^1$, more preferably any one of $R^4$, $R^6$, $R^7$ and $R^9$, and till more preferably one of $R^4$ or $R^9$.

The dipyrromethene metal complex compound represented by Formula (5) may have a functional group in addition to the alkali-soluble group, unless the effect of the invention is impaired.

$R^4$ to $R^9$ in Formula (5) have the same definitions as $R^4$ to $R^9$ in Formula (M), and have the same preferable definitions as Formula (M).

In Formula (5), Ma represents a metal atom or a metal compound. The metal atom or the metal compound may be any metal atom or metal compound, as long as the metal atom or metal compound can form a complex, and examples thereof include a divalent metal atom, a divalent metal oxide, a divalent metal hydroxide, and a divalent metal chloride.

Examples thereof include Zn, Mg, Si, Sn, Rh, Pt, Pd, Mo, Mn, Pb, Cu, Ni, Co, Fe, metal chlorides such as $AlCl_3$, $InCl_3$, $FeCl_2$, $TiCl_2$, $SnCl_2$, $SiCl_2$ or $GeCl_2$, metal oxides such as TiO or VO, and metal hydroxide such as $Si(OH)_2$.

Among these, from the viewpoint of the stability of the complex, spectrum characteristics, heat resistance, light fastness, manufacture suitability, and the like, Fe, Zn, Mg, Si, Pt, Pd, Mo, Mn, Cu, Ni, Co, TiO and VO are preferable,

Zn, Mg, Si, Pt, Pd, Cu, Ni, Co and VO are more preferable, and Zn, Cu, Co and VO are still more preferable, and Zn is most preferable.

In Formula (5), $R^{10}$ represents a hydrogen atom, a halogen atom, an alkyl group, an aryl group or a heterocyclic group, and preferable represents a hydrogen atom.

$X^1$ in Formula (5) may be any group as long as it can be bonded to Ma, and specific examples thereof include water, alcohols (e.g., methanol, ethanol, propanol) and the like, and groups derived from the compounds described in "Metal Chelates" [1] Takeichi Sakaguchi and Kyohei Ueno (1995 Nankodo), "Metal Chelates" [2] (1996), "Metal Chelates" [3] (1997) and the like. Among these, in view of manufacturability, water, a carboxylic acid compound and alcohols are preferable, and water and a carboxylic acid compound are more preferable.

$X^2$ in Formula (5) is a group that neutralizes the charge of Ma, and examples thereof include a halogen atom, a hydroxy group, a carboxy group, a phosphoric acid group, and a sulfonic acid group. Among these, in view of manufacturability, a halogen atom, a hydroxy group, a carboxy group and a sulfonic acid group are preferable, and a hydroxy group and a carboxy group are more preferable.

$X^1$ and $X^2$ in Formula (5) may be linked to each other to form a 5-, 6- or 7-membered ring together with Ma. The 5-, 6- or 7-membered ring to be formed may be a saturated or unsaturated ring. The 5-, 6- or 7-membered ring may be formed from only carbon atoms and hydrogen atoms, or may be a heterocycle having at least one atom selected from a nitrogen atom, an oxygen atom and a sulfur atom.

In the preferable embodiment of the compound represented by Formula (5), $R^4$ to $R^9$ each independently has the same preferable definition as $R^4$ to $R^9$ in Formula (M); $R^{10}$ has the same preferable definition as $R^{10}$ in Formula (M); Ma is Zn, Cu, Co or VO; $X^1$ represents water or a carboxylic acid compound; $X^2$ represents a hydroxy group or a carboxy group; and $X^1$ and $X^2$ is linked to each other to form a 5- or 6-membered ring.

*Dipyrromethene metal complex compound represented by Formula (6)*

An aspect of the colorant multimer of the invention includes a colorant multimer having a dye residue, in which any one hydrogen atom from any one of the substituents of $R^{11}$ to $R^{17}$, $X^1$ and $Y^1$ to $Y^2$ of the dipyrromethene metal complex compound represented by the following Formula (6) is removed:

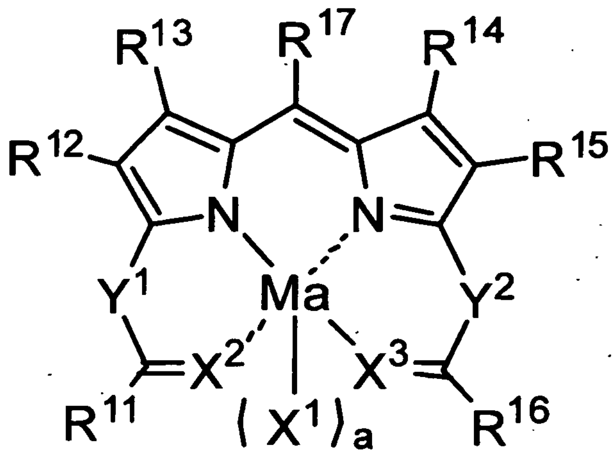

Formula (6)

In Formula (6), $R^{11}$ and $R^{16}$ each independently represent an alkyl group, an alkenyl group, an aryl group, a heterocyclic group, an alkoxy group, an aryloxy group, an alkylamino group, an arylamino group or a heterocyclic amino group; $R^{12}$ to $R^{15}$ each independently represent a hydrogen atom or a substituent; $R^{17}$ represents a hydrogen atom, a halogen atom, an alkyl group, an aryl group or a heterocyclic group; Ma represents a metal atom or a metal compound; $X^2$ and $X^3$ each independently represent NR' (wherein R' represents a hydrogen atom, an alkyl group, an alkenyl group, an aryl group, a heterocyclic group, an acyl group, an alkylsulfonyl group or an arylsulfonyl group), a nitrogen atom, an oxygen atom or a sulfur atom; $Y^1$ and $Y^2$ each independently represent NR" (wherein R" represents a hydrogen atom, an alkyl group, an alkenyl group, an aryl group, a heterocyclic group, an acyl group, an alkylsulfonyl group or an arylsulfonyl group), a nitrogen atom or a carbon atom; $R^{11}$ and $Y^1$ may be linked to each other to form a 5-, 6- or 7-membered ring; $R^{16}$ and $Y^2$ may be linked to each other to form a 5-, 6- or 7-membered ring; $X^1$ represents a group capable of combining with Ma; and *a* represents 0, 1 or 2. Here, when *a* represents 2, each $X^1$ may be the same as or different from each other. Examples of the dipyrromethene metal complex compounds represented by Formula (6) include tautomers thereof.

The position of the colorant multimer of the invention, into which the dipyrromethene metal complex compound represented by Formula (6) is introduced, is not particularly limited as long as the effect of the invention is not impaired,

but is preferably any one of $R^{11}$ to $R^{17}$, $X^1$, $Y^1$ and $Y^2$. In view of the synthetic suitability, the dipyrromethene metal complex compound is preferably introduced into any one of $R^{11}$ to $R^{16}$ and $X^1$, more preferably any one of $R^{11}$, $R^{13}$, $R^{14}$ and $R^{16}$, and still more preferably $R^{11}$ or $R^{16}$.

When the colorant monomer or constituent unit having an alkali-soluble group is used, examples of the method of introducing an alkali-soluble group into the colorant multimer of the invention includes a method in which the alkali-soluble group can be introduced into one, or two more of the substituents of $R^{11}$ to $R^{17}$, $X^1$, $Y^1$ and $Y^2$ of the dipyrromethene metal complex compound represented by Formula (6). The alkali-soluble group is preferably introduced into any one of $R^{11}$ to $R^{16}$ and $X^1$, more preferably any one of $R^{11}$, $R^{13}$, $R^{14}$ and $R^{16}$, and still more preferably one of $R^{11}$or $R^{16}$.

The dipyrromethene metal complex compound represented by Formula (6) may have a functional group in addition to the alkali-soluble group, unless the effect of the invention is impaired.

$R^{12}$ to $R^{15}$ have the same definitions as $R^5$ to $R^8$ in Formula (M), respectively, and have the same preferable definitions as Formula (M) respectively. $R^{17}$ has the same definition as $R^{10}$ of in Formula (M), and has the same preferable definition as Formula (M). Ma has the same definition as t Ma in Formula (M), and has the same preferable definition as Ma in Formula (M).

More specifically, in $R^{12}$ to $R^{15}$ in Formula (6), it is preferable that $R^{12}$ and $R^{15}$ each independently represent an alkoxycarbonyl group, an aryloxycarbonyl group, a carbamoyl group, an alkylsulfonyl group, an arylsulfonyl group, a nitrile group, an imido group or a carbamoyl sulfonyl group; it is more preferable that $R^{12}$ and $R^{15}$ each independently represent an alkoxycarbonyl group, an aryloxycarbonyl group, a carbamoyl group, an alkylsulfonyl group, a nitrile group, an imido group or a carbamoyl sulfonyl group; it is still more preferable that $R^{12}$ and $R^{15}$ each independently represent an alkoxycarbonyl group, an aryloxycarbonyl group, a carbamoyl group, a nitrile group, an imido group or a carbamoyl sulfonyl group; and it is even more preferable that $R^{12}$ and $R^{15}$ each independently represent an alkoxycarbonyl group, an aryloxycarbonyl group or a carbamoyl group.

It is preferable that $R^{13}$ and $R^{14}$ each independently represent a substituted or unsubstituted alkyl group, a substituted or unsubstituted aryl group or a substituted or unsubstituted heterocyclic group; and it is more preferable that $R^{13}$ and $R^{14}$ each independently represent a substituted or unsubstituted alkyl group or a substituted or unsubstituted aryl group. Here, specific examples of the preferable alkyl, aryl, and heterocyclic groups include the specific examples for $R^6$ and $R^7$ in Formula (M).

In Formula (6), $R^{11}$ and $R^{16}$ each independently represent an alkyl group (a straight-chain, branched-chain or cyclic alkyl group having preferably 1 to 36, more preferably 1 to 12 carbon atoms, such as a methyl group, an ethyl group, a propyl group, an isopropyl group, a butyl group, an isobutyl group, a t-butyl group, a hexyl group, a 2-ethylhexyl group, a dodecyl group, a cyclopropyl group, a cyclopentyl group, a cyclohexyl group or a 1-adamantyl group), an alkenyl group (an alkenyl group having preferably 2 to 24, more preferably 2 to 12 carbon atoms, such as a vinyl group, an allyl group or a 3-buten-1-yl group), an aryl group (an aryl group having preferably 6 to 36, more preferably 6 to 18 carbon atoms, such as a phenyl group or a naphthyl group), a heterocyclic group (a heterocyclic group having preferably 1 to 24, more preferably 1 to 12 carbon atoms, such as a 2-thienyl group, a 4-pyridyl group, a 2-furyl group, a 2-pyrimidinyl group, a 2-pyridyl group, a 2-benzothiazolyl group, a 1-imidazolyl group, a 1-pyrazolyl group or a benzotriazol-1-yl group), an alkoxy group (an alkoxy group having preferably 1 to 36, more preferably 1 to 18 carbon atoms, such as a methoxy group, an ethoxy group, a propyloxy group, a butoxy group, a hexyloxy group, a 2-ethylhexyloxy group, a dodecyloxy group or a cyclohexyloxy group), an aryloxy group (an aryloxy group having preferably 6 to 24, more preferably 1 to 18 carbon atoms, such as a phenoxy group or a naphthyloxy group), an alkylamino group (an alkylamino group having preferably 1 to 36, more preferably 1 to 18 carbon atoms, such as a methylamino group, an ethylamino group, a propylamino group, a butylamino group, a hexylainino group, a 2-ethylhexylamino group, an isopropylamino group, a t-butylamino group, a t-octylamino group, a cyclohexylamino group, an N,N-diethylamino group, an N,N-dipropylamino group, an N,N-dibutylamino group or an N-methyl-N-ethylamino group), an arylamino group (an aryl amino group having preferably 6 to 36, more preferably 6 to 18 carbon atoms, such as a phenylamino group, a naphthylamino group, an N,N-diphenylamino group or an N-ethyl-N-phenylamino group), or a heterocyclic amino group (a heterocyclic amino group having preferably 1 to 24, more preferably 1 to 12 carbon atoms, such as a 2-aminopyrrole group, a 3-aminopyrazole group, a 2-aminopyridine group or a 3-aminopyridine group).

Among these, it is preferable that $R^{11}$ and $R^{16}$ each independently represent an alkyl group, an alkenyl group, an aryl group, a heterocyclic group, an alkylamino group, an arylamino group or a heterocyclic amino group; it is more preferable that $R^{11}$ and $R^{16}$ each independently represent an alkyl group, an alkenyl group, an aryl group or a heterocyclic group; it is still more preferable that $R^{11}$ and $R^{16}$ each independently represent an alkyl group, an alkenyl group or an aryl group; and it is even more preferable that $R^{11}$ and $R^{16}$ each independently represent an alkyl group.

In Formula (6), when the alkyl group, alkenyl group, aryl group, heterocyclic group, alkoxy group, aryloxy group, alkylamino group, arylamino group or heterocyclic amino group represented by $R^8$ or $R^9$ is a group that may further be substituted, it may be substituted by any of the substituents in $R^1$ of Formula (1) described below, and when it is substituted by two or more substituents, the substituents may be the same as or different from one another.

In Formula (6), $X^2$ and $X^3$ each independently represent NR', a nitrogen atom, an oxygen atom or a sulfur atom,

wherein R' represents a hydrogen atom, an alkyl group (a straight-chain, branched-chain, or cyclic alkyl group having preferably 1 to 36, more preferably 1 to 12 carbon atoms, such as a methyl group, an ethyl group, a propyl group, an isopropyl group, a butyl group, an isobutyl group, a t-butyl group, a hexyl group, a 2-ethylhexyl group, a dodecyl group, a cyclopropyl group, a cyclopentyl group, a cyclohexyl group, a 1-adamantyl group), an alkenyl group (an alkenyl group having preferably 2 to 24, more preferably 2 to 12 carbon atoms, such as a vinyl group, an allyl group or a 3-buten-1-yl group), an aryl group (an aryl group having preferably 6 to 36, more preferably 6 to 18 carbon atoms, such as a phenyl group or a naphthyl group), a heterocyclic group (a heterocyclic group having preferably 1 to 24, more preferably 1 to 12 carbon atoms, such as a 2-thienyl group, a 4-pyridyl group, a 2-furyl group, a 2-pyrimidinyl group, a 1-pyridyl group, a 2-benzothiazolyl group, a 1-imidazolyl group, a 1-pyrazolyl group or a benzotriazol-1-yl group), an acyl group (an acyl group having preferably 1 to 24, more preferably 2 to 18 carbon atoms, such as an acetyl group, a pivaloyl group, a 2-ethylhexyl group, a benzoyl group or a cyclohexanoyl group), an alkylsulfonyl group (an alkylsulfonyl group having preferably 1 to 24, more preferably 1 to 18 carbon atoms, such as a methylsulfonyl group, a ethylsulfonyl group, a isopropylsulfonyl group or a cyclohexylsulfonyl group), or an arylsulfonyl group (an arylsulfonyl group having preferably 6 to 24, more preferably 6 to 18 carbon atoms, such as a phenylsulfonyl group or a naphthylsulfonyl group).

The alkyl group, alkenyl group, aryl group, heterocyclic group, acyl group, alkylsulfonyl group or arylsulfonyl group represented by R' may further be substituted by any of the substituents in $R^1$ of Formula (1) described below, and when it is substituted by two or more substituents, the substituents may be the same as or different from one another.

In Formula (6), $Y^2$ and $Y^3$ each independently represent NR", a nitrogen atom, a carbon atom; and R" has the same definition as R' in $X^2$ and $X^3$ above, and has the same preferable definition as R' in $X^2$ and $X^3$ above.

In Formula (6), $R^{11}$ and $Y^1$ may be linked to each other to form, with a carbon atom, a 5-membered ring (e.g., cyclopentane, pyrrolidine, tetrahydrofuran, dioxolane, tetrahydrothiophene, pyrrole, furan, thiophene, indole, benzofuran or benzothiophene), a 6-membered ring (e.g., cyclohexane, piperidine, piperazine, morpholine, tetrahydropyran, dioxane, pentamethylenesulfide, dithiane, benzene, piperidine, piperazine, pyridazine, quinoline or quinazoline) or a 7-membered ring (e.g., cycloheptane or hexamethyleneimine).

In Formula (6), $R^{161}$ and $Y^2$ may be linked to each other to form, with a carbon atom, a 5-membered ring (e.g., cyclopentane, pyrrolidine, tetrahydrofuran, dioxolane, tetrahydrothiophene, pyrrole, furan, thiophene, indole, benzofuran or benzothiophene), a 6-membered ring (e.g., cyclohexane, piperidine, piperazine, morpholine, tetrahydropyran, dioxane, pentamethylenesulfide, dithiane, benzene, piperidine, piperazine, pyridazine, quinoline or quinazoline) or a 7-membered ring (e.g., cycloheptane or hexamethyleneimine).

In Formula (6), when the 5-, 6- or 7-membered ring formed by the linking of $R^{11}$ and $Y^1$ or $R^{16}$ and $Y^2$ is a ring that may further be substituted, it may be substituted by any of the substituents in $R^1$ of Formula (1) described below, and when it is substituted by two or more substituents, the substituents may be the same as or different from one another.

In Formula (6), $X^1$ represents a group that can be bonded to Ma. Specific examples thereof include the same groups as defined for $X^1$ in Formula (5). $X^1$ in Formula (6) has the same preferable definitions as $X^1$ in Formula (5).

In Formula (6), *a* represents 0, 1 or 2. Here, when *a* represents 2, each $X^1$ may be the same as or different from each other.

A preferable embodiment of the compound represented by Formula (6) is as follows.

Namely, in a preferable embodiment, $R^{12}$ to $R^{15}$ each independently have the same preferable definitions as $R^5$ to $R^8$ in Formula (5), respectively; $R^{17}$ has the same preferable definition as $R^{10}$ in Formula (5); Ma represents Zn, Cu, Co or VO; $X^2$ represents NR' (wherein R' represents a hydrogen atom or an alkyl group), a nitrogen atom or an oxygen atom; $X^3$ represents NR' (wherein R' represents a hydrogen atom or an alkyl group) or an oxygen atom; $Y^1$ represents NR" (wherein R" represents a hydrogen atom or an alkyl group), a nitrogen atom or a carbon atom; $Y^2$ represents a nitrogen atom or a carbon atom; $R^{11}$ and $R^{16}$ each independently represent an alkyl group, an aryl group, a heterocyclic group, an alkoxy group or an alkylamino group; $X^1$ represents a group that binds via an oxygen atom; and *a* represents 0 or 1. $R^{11}$ and $Y^1$ may be linked to each other to form a 5- or 6-membered ring; and $R^{16}$ and $Y^2$ may be linked to each other to form a 5- or 6-membered ring.

In a more preferable embodiment, $R^{12}$ to $R^{15}$ each independently have the same preferable definitions as $R^5$ to $R^8$ in Formula (5), respectively; $R^{17}$ has the same preferable definition as $R^{10}$ in Formula (5); Ma represents Zn; $X^2$ and $X^3$ represents an oxygen atom; $Y^1$ represents NH; $Y^2$ represents a nitrogen atom; $R^{11}$ and $R^{16}$ each independently represent an alkyl group, an aryl group, a heterocyclic group, an alkoxy group or an alkylamino group; $X^1$ represents a group that binds via an oxygen atom; and *a* represents 0 or 1. $R^{11}$ and $Y^1$ may be linked to each other to form a 5- or 6-membered ring; and $R^{16}$ and $Y^2$ may be linked to each other to form a 5- or 6-membered ring.

It is preferable that the mol absorption coefficient of the dipyrromethene metal complex compounds represented by Formulae (5) and (6) is as high as possible in view of film thickness. The maximum absorption wavelength $\lambda$max is preferably from 520 nm to 580 nm, more preferably from 530 nm to 570 nm in view of color purity. The maximum absorption wavelength and mol absorption coefficient are measured by a spectrophotometer (trade name: UV-2400PC, manufactured by Shimadzu Corporation).

It is preferable that the melting point of the dipyrromethene metal complex compounds represented by Formulae

(5) and (6) is not too high in view of solubility.

The dipyrromethene metal complex compounds represented by Formulae (5) and (6) may be synthesized by the methods described in U. S. Patents Nos. 4,774,339 and 5,433,896, JP-A Nos. 2001-240761 and 2002-155052, Japanese Patent No. 3614586, Aust. J. Chem, 1965, 11, 1835-1845, J. H. Boger et al, Heteroatom Chemistry, Vol. 1, No. 5, 389 (1990), and the like.

Specifically, the method described in the paragraphs [0131] to [0157] of JP-A No. 2008-292970 may be applied.

The colorant multimer of the invention having a preferable colorant skeleton is explained. Examples of the colorant multimer having the colorant skeleton derived from the dipyrromethene metal complex compound include: the multimer including at least one of the constituent units represented by the following Formula (A), (B) or (C); and the colorant multimer including the colorant monomer represented by the following Formula (1) as a polymerization component. Hereinbelow, these colorant multimer are explained.

*Constituent unit represented by Formula (A)*

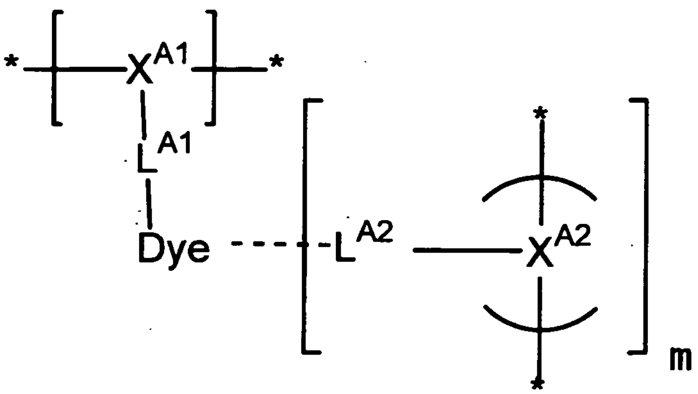

Formula (A)

In Formula (A), $X^{A1}$ represents a linking group formed by polymerization; $L^{A1}$ represents a single bond or a divalent linking group; "Dye" represents a colorant residue formed by removing any one to (m+1) hydrogen atoms from the dipyrromethene metal complex compound obtained from (i) the dipyrromethene compound represented by Formula (M) and (ii) a metal or a metal compound; $X^{A2}$ represents a linking group formed by polymerization; $L^{A2}$ represents a single bond or a divalent linking group; and "Dye" and $L^{A2}$ may be linked to each other by a covalent bond, an ionic bond or a coordinate bond.

In Formula (A), m represents an integer of from 0 to 3. When m represents 2 or 3, each $X^{A2}$ may be the same as or different from one another. When m represents 2 or 3, each $L^{A2}$ may be the same as or different from one another.

In Formula (A), $X^{A1}$ and $X^{A2}$ each independently represent a linking group formed by polymerization. That is, $X^{A1}$ and $X^{A2}$ each represent a moiety that forms a repeating unit corresponding to the main chain formed by the polymerization reaction. The moieties between two * positions correspond to a repeating unit. Examples of $X^{A1}$ and $X^{A2}$ include a linking group formed by the polymerization of substituted or unsubstituted ethylenically unsaturated groups, and a linking group formed by the ring-opening polymerization of cyclic ether. Preferable examples of $X^{A1}$ and $X^{A2}$ include a linking group formed by the polymerization of ethylenically unsaturated groups. Specific examples thereof include the following linking groups, but the invention is not particularly limited to these examples.

In the following (X-1) to (X-15), $L^{A1}$ or $L^{A2}$ is connected at the position represented by *.

(X-1)

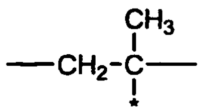

(X-2)

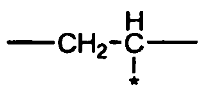

(X-3)

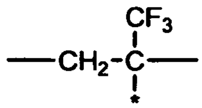

(X-4)

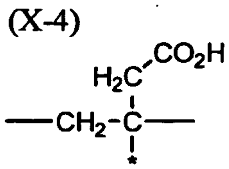

(X-5)

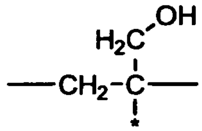

(X-6)

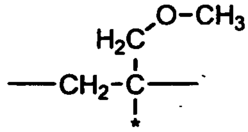

(X-7)

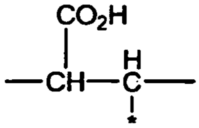

(X-8)

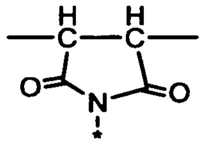

(X-9)

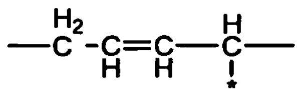

(X-10)

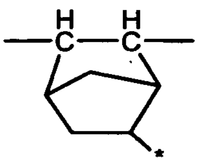

(X-11)

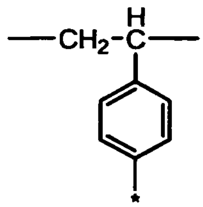

(X-12)

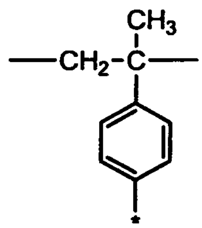

(X-13)

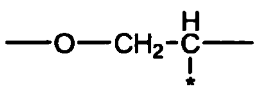

(X-14)

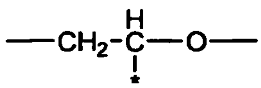

(X-15)

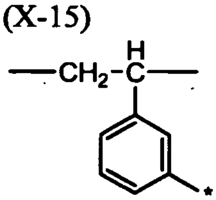

In Formula (A), $L^{A1}$ and each independently represent a single bond or a divalent linking group. When $L^{A1}$ or $L^{A2}$ represents a divalent linking group, examples of the divalent linking group include a substituted or unsubstituted straight-chained, branched or cyclic alkylene group having 1 to 30 carbon atoms (such as a methylene group, an ethylene group, a trimethylene group, a propylene group or a butylene group); a substituted or unsubstituted arylene group having 6 to 30 carbon atoms (such as a phenylene group or a naphthalene group); a substituted or unsubstituted heterocyclic linking group; - $CH_2$=$CH_2$-, -O-, -S-, -NR-, -C (=O)-, SO-, -$SO_2$- a linking group represented by the following Formula (2); a linking group represented by the following Formula (3); a linking group represented by the following Formula (4); and a linking group formed by connecting two or more of these groups such as -N(R)C(=O)-,-OC(=O)-, -C(=O)N(R)-, -C(=O)O- (here, each R independently represents a hydrogen atom, an alkyl group, an aryl group or a heterocyclic group). However, the divalent linking group in Formula (A) is not limited to these groups, as long as the divalent linking group exerts the effect of the invention.

In Formula (A), "Dye" represents a dipyrromethene metal complex compound obtained from (i) the dipyrromethene compound represented by Formula (M) and (ii) a metal or a metal compound, preferably represents a colorant residue obtained by removing any one to (*m*+1) hydrogen atoms hydrogen atoms from the dipyrromethene metal complex compound represented by Formula (5) or Formula (6).

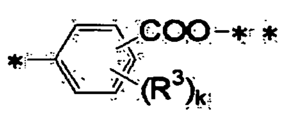

Formula (2)

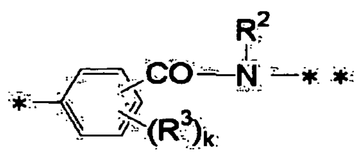

Formula (3)

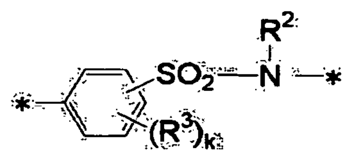

Formula (4)

Here, $R^2$ in Formulae (3) and (4) independently represents a hydrogen atom, an alkyl group, an aryl group, or a heterocyclic group; $R^3$ in Formulae (2) to (4) independently represents a hydrogen atom or a substituent; k in Formulae (2) to (4) independently represents an integer of from 0 to 4; * in Formulae (2) to (4) independently represents a position to which $-C(R^1)=CH_2-$ group in Formula (1) is linked; and ** in Formulae (2) to (4) independently represents a position to which $L^2$ or "Dye" (in the case of n = 0) in Formula (1) is linked.

Examples of the constituent units represented by Formula (A) include the following, but the invention is not particularly limited to these examples.

(A-1)

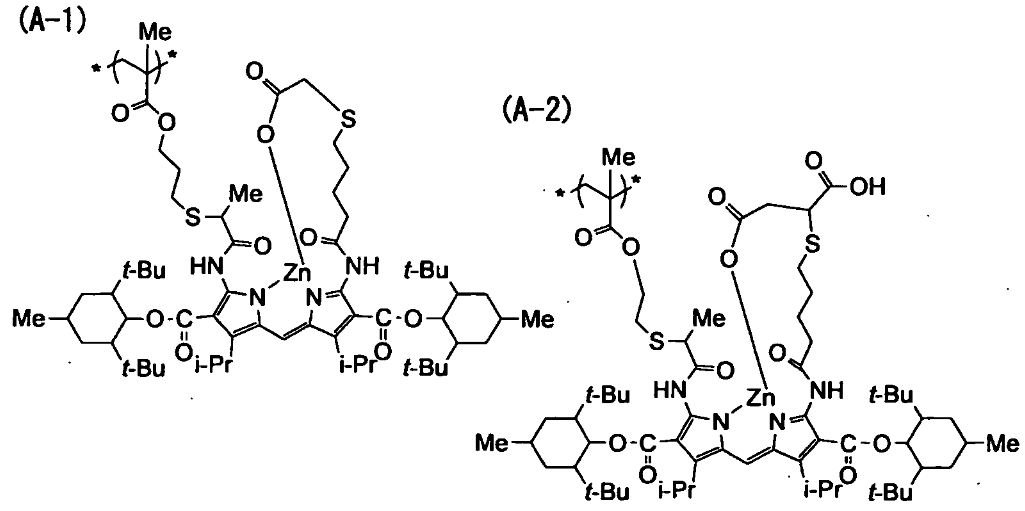

(A-2)

(A-3)

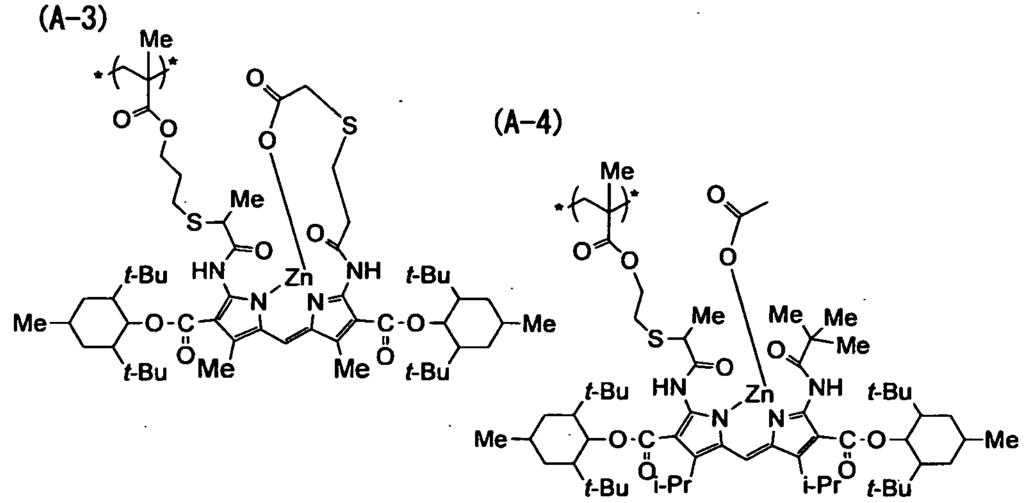

(A-4)

(A-5)

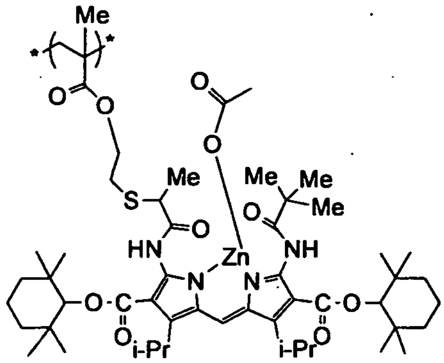

(A-6)

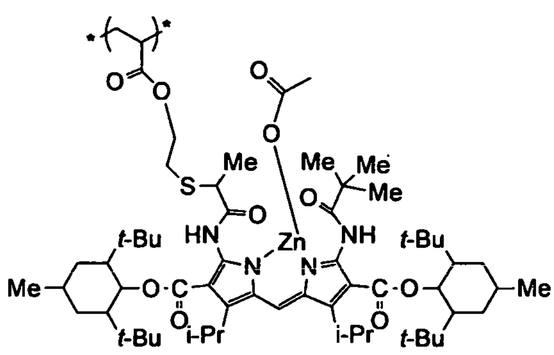

(A-7)

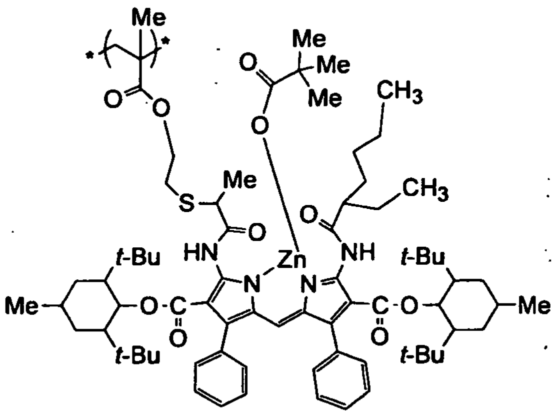

(A-8)

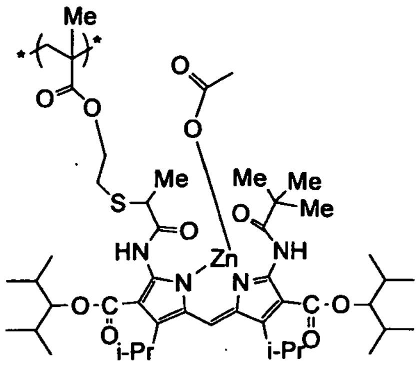

(A-9)

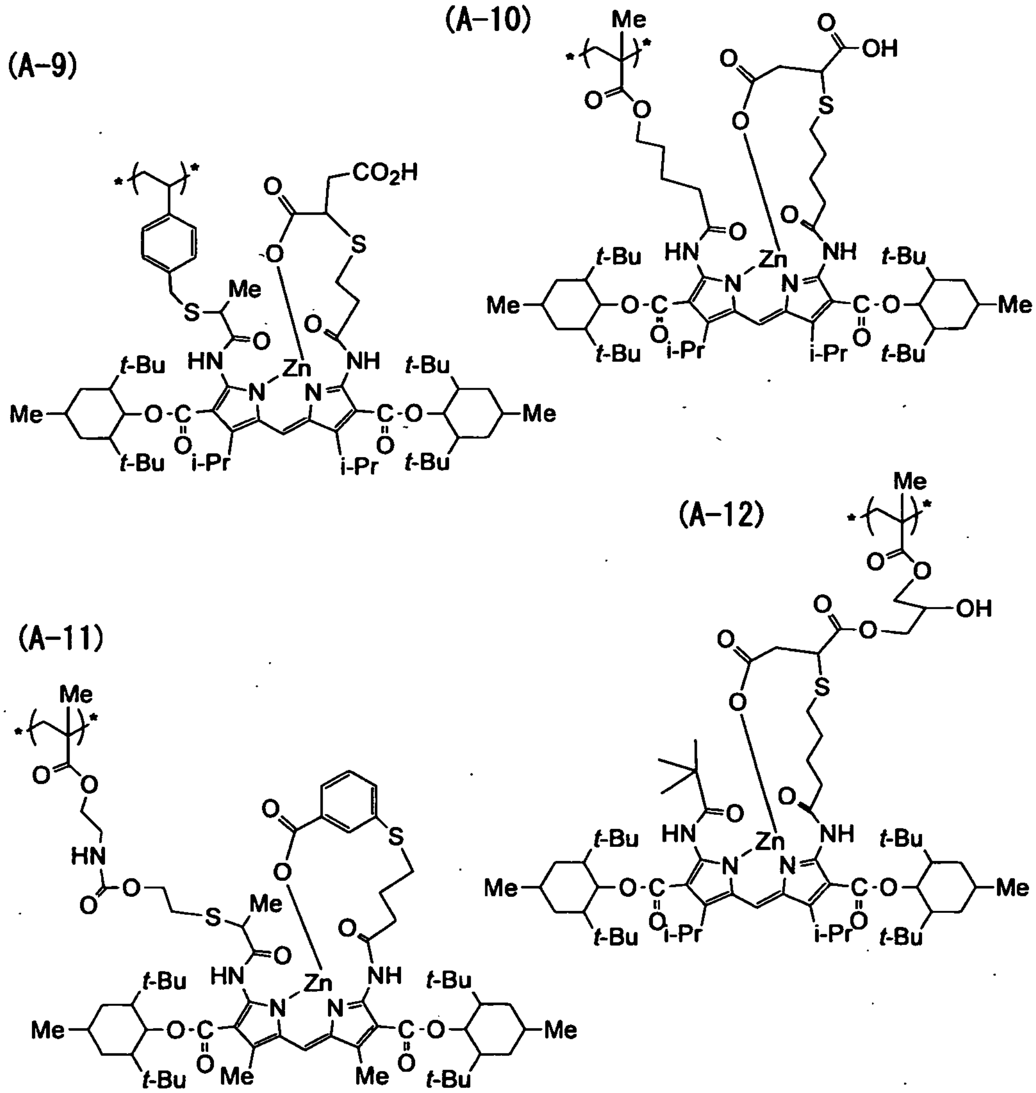

(A-10)

(A-11)

(A-12)

(A-13)

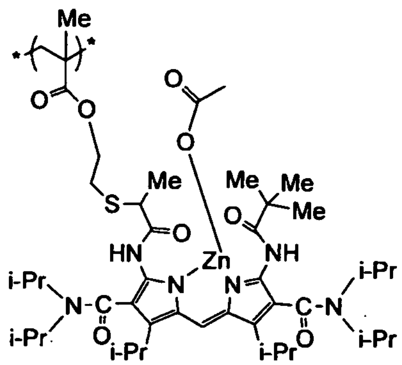

(A-14)

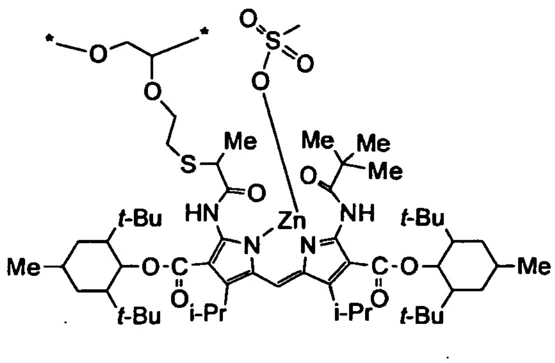

(A-15)

(A-16)

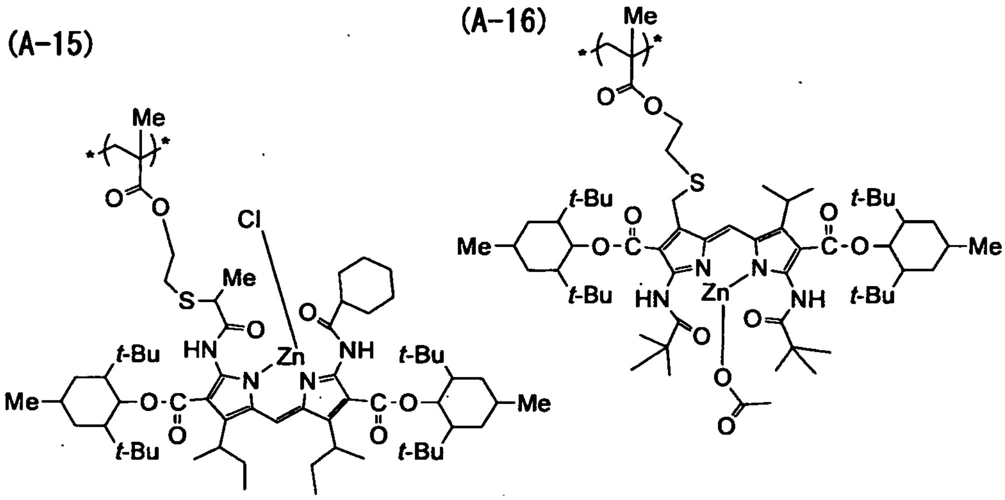

(A-17)

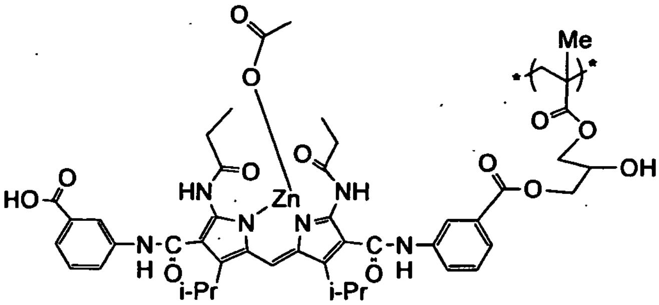

(A-18) (A-19)

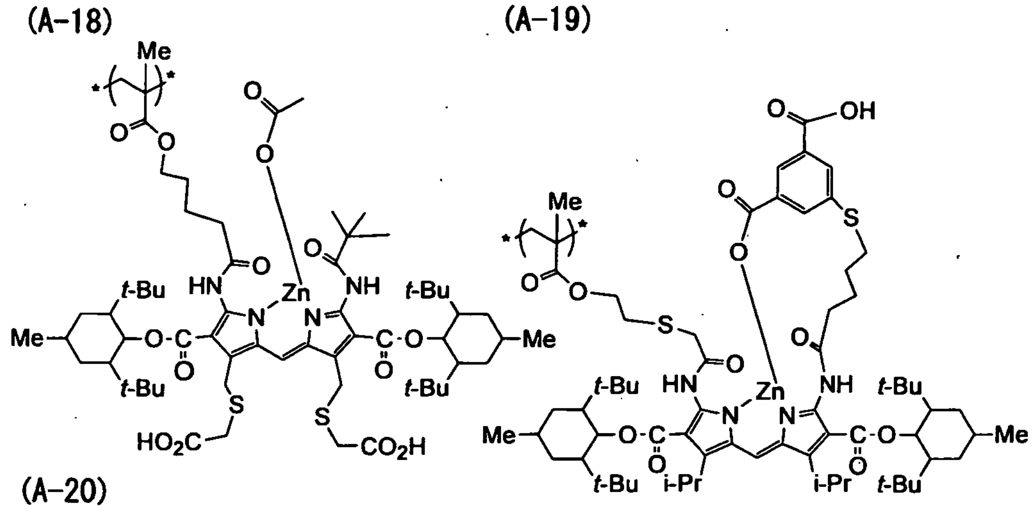

(A-20)

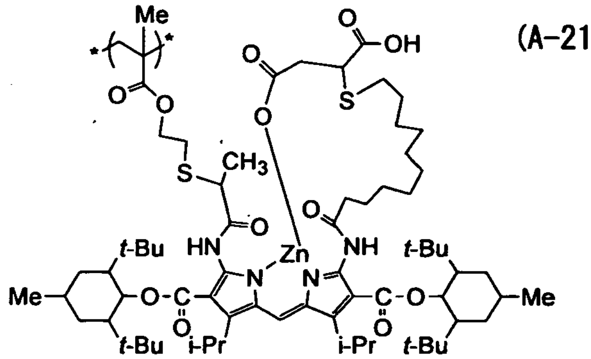

(A-21)

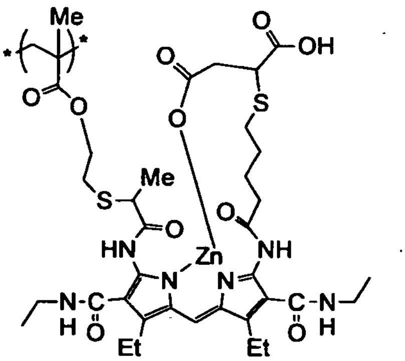

(A-21)

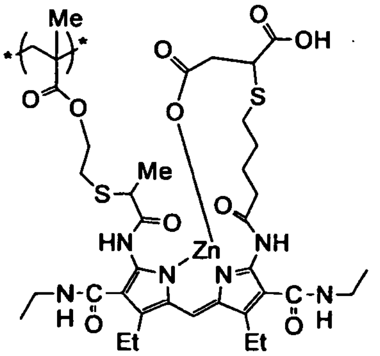

(A-22)

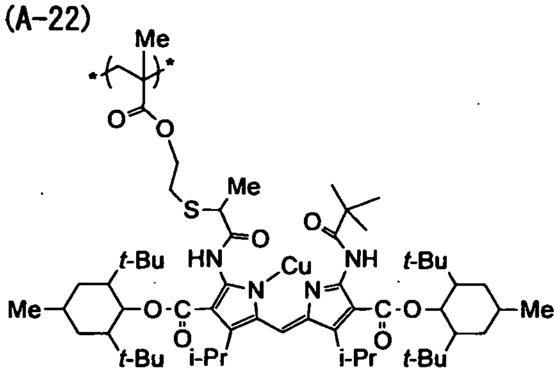

(A-23)

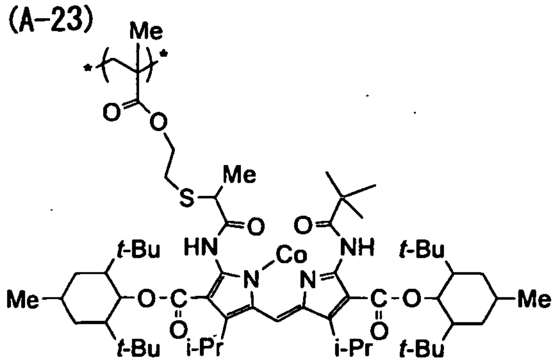

(A-24)

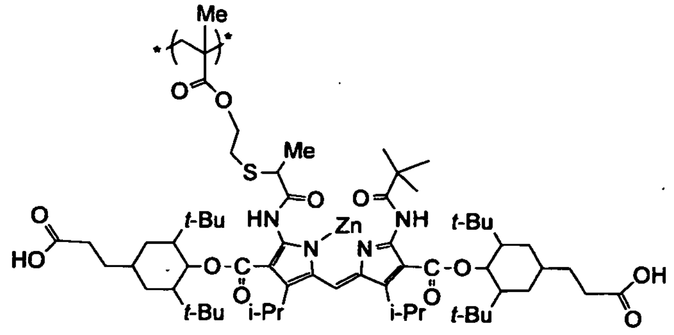

(A-25)

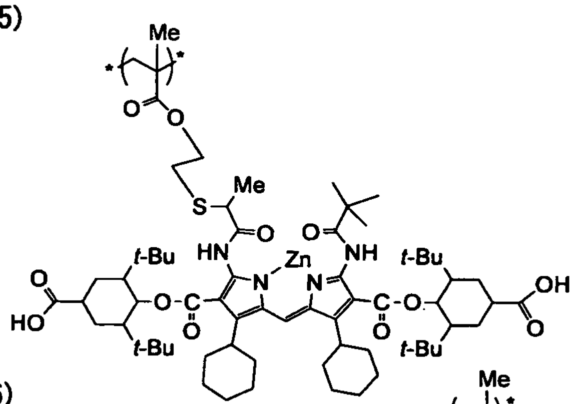

(A-26)

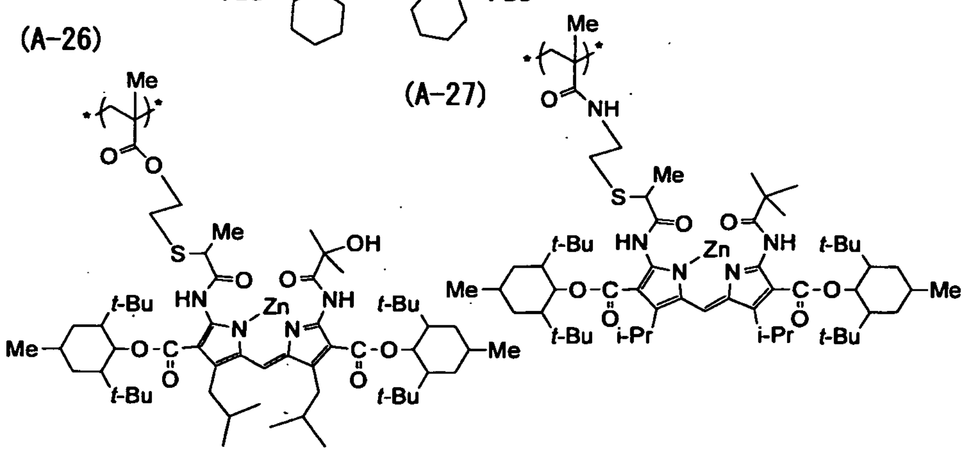

(A-27)

(A-28)

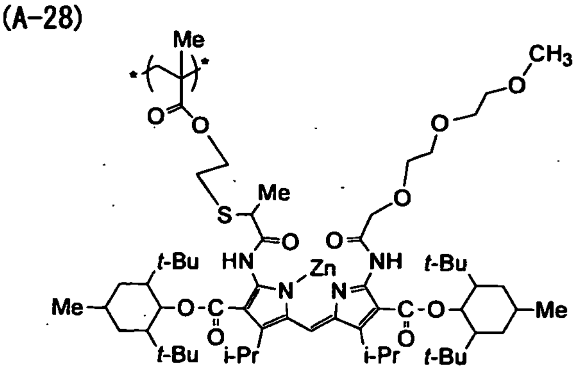

(A-29)

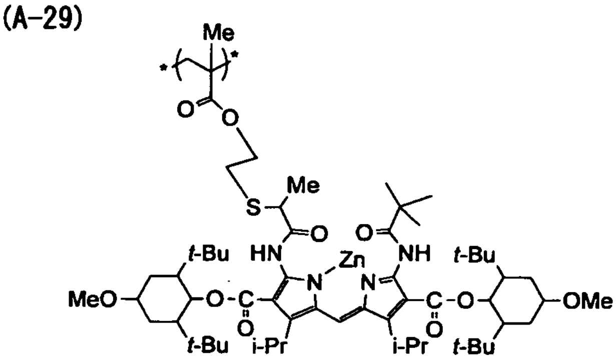

(A-30)

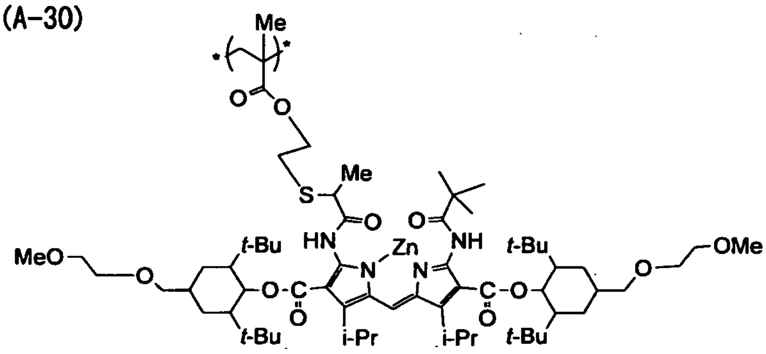

(A-31)

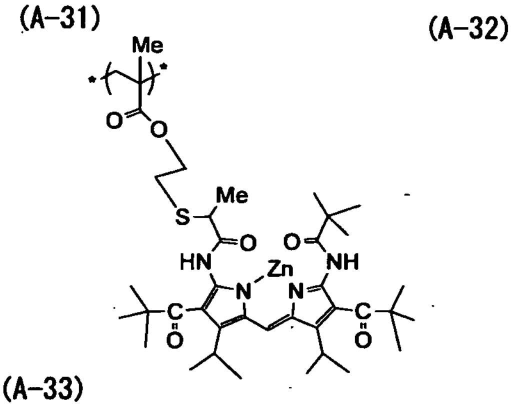

(A-32)

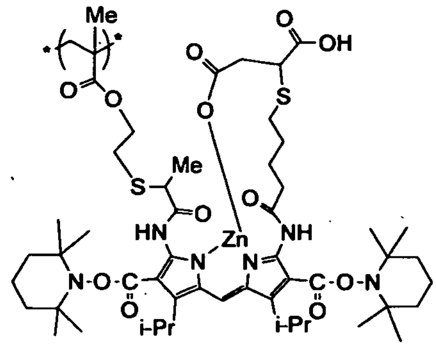

(A-33)

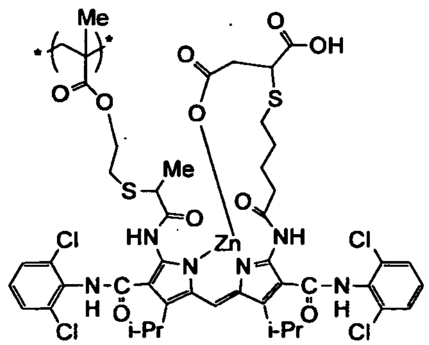

(A-34)

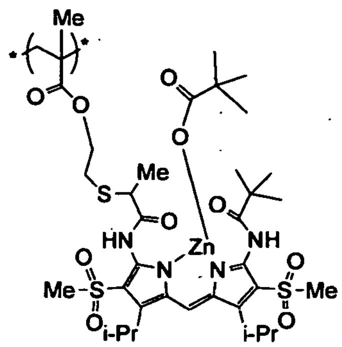

(A-35)

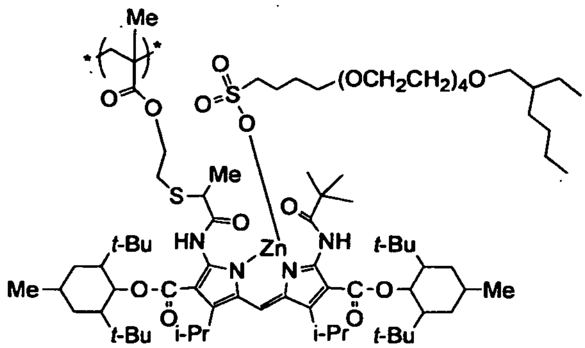

(A-36)

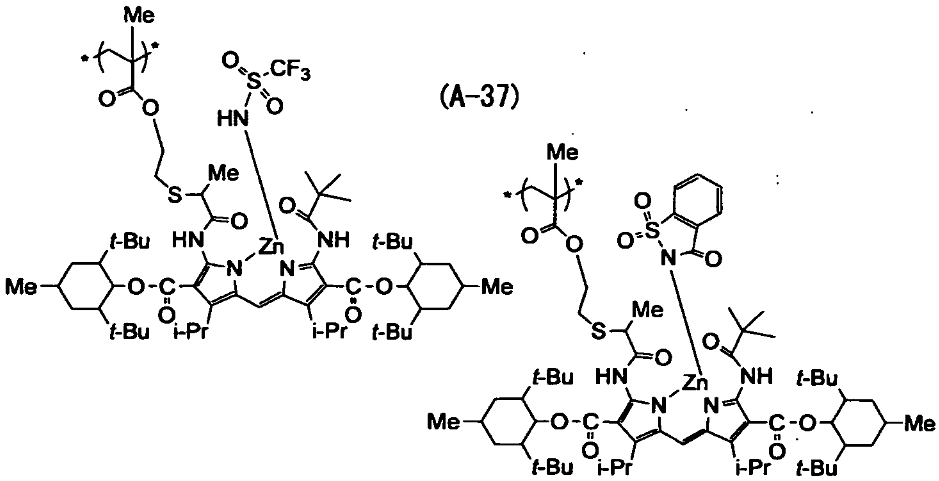

(A-37)

(A-38)

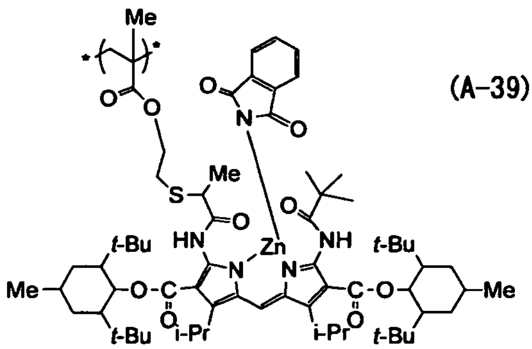

(A-39)

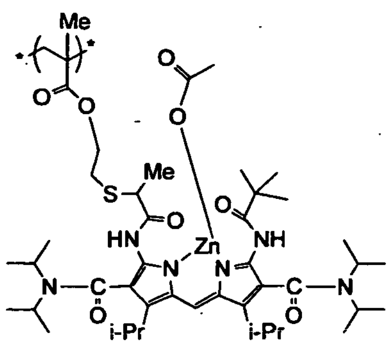

*Constituent unit represented by Formula (B)*

Hereinbelow, the details of the constituent units represented by Formula (B) are explained.

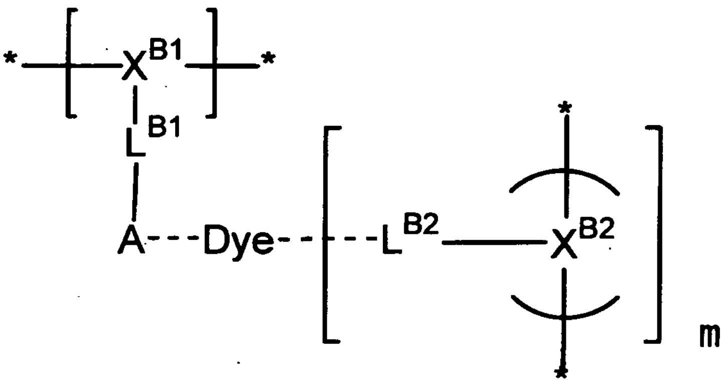

Formula (B)

In Formula (B), $X^{B1}$ represents a linking group formed by polymerization; $L^{B1}$ represents a single bond or a divalent linking group; A represents a group that can be bonded to "Dye" via an ionic bond or a coordinate bond; "Dye" represents a colorant residue having a group that can be bonded to A, via an ionic bond or a coordinate bond, on a substituent in the dipyrromethene metal complex compound obtained from (i) the dipyrromethene compound represented by Formula (M) and a metal or (ii) a metal compound; $X^{B2}$ represents a linking group formed by polymerization; $L^{B2}$ represents a single bond or a divalent linking group; m represents an integer of from 0 to 3; and "Dye" and $L^{B2}$ may be linked to each other by a covalent bond, an ionic bond or a coordinate bond.

In Formula (B), *m* represents an integer of from 0 to 3. When *m* represents 2 or 3, each $X^{B2}$ may be the same as or different from one another. When *m* represents 2 or 3, each $L^{B2}$ may be the same as or different from one another.

In Formula (B), the group represented by $X^{B1}$ and $X^{B2}$, and the group represented by $L^{B1}$ and $L^{B2}$ have the same definition as $X^{A1}$ and $X^{A2}$, and $L^{A1}$ and $L^{A2}$ in Formula (A), respectively, and have the same preferable definition as $X^{A1}$ and $X^{A2}$, and $L^{A1}$ and $L^{A2}$ in Formula (A), respectively.

The group represented by A in Formula (B) is any group as long as the group can be bonded to the "Dye" group via an ionic bond or a coordinate bond. Examples of the group that can be bonded to the "Dye" group via an ionic bond may be an anionic group or a cationic group. Examples of the anionic group include an anionic group having a pKa of 12 or less, preferably a pKa of 7 or less, more preferably a pKa of 5 or less, such as a carboxy group, a phosphonic acid group, a sulfonic acid group, an acyl sulfonamido group or a sulfonimido group. The anionic group may be linked with Ma or a heterocyclic group in the "Dye" via an ionic bond or a coordinate bond, and is preferably linked with Ma via an ionic bond. Preferable examples of the anionic groups include the following, but the invention is not particularly limited to these examples. In the anionic groups shown below, each R independently represents a hydrogen atom, an alkyl group, an aryl group or a heterocyclic group.

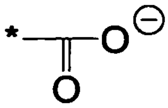
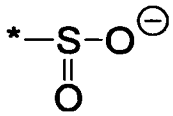
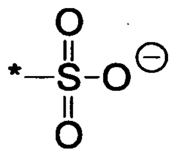
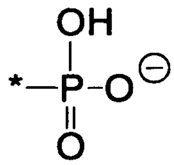

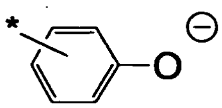
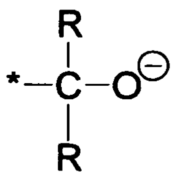

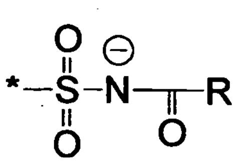
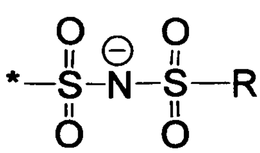
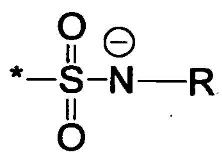

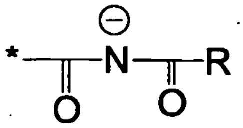

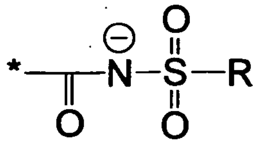

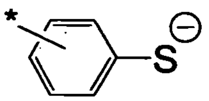

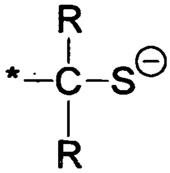

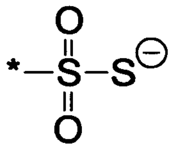

The cationic group represented by A in Formula (B) is preferably a substituted or unsubstituted onium cation (such as a substituted or unsubstituted ammonium group, a substituted or unsubstituted pyridinium group, a substituted or unsubstituted imidazolium group, a substituted or unsubstituted sulfonium group, or a substituted or unsubstituted phosphonium group), and more preferably a substituted ammonium group.

Specific examples of the constituent unit represented by Formula (B) include the following, but the invention is not particularly limited to these examples.

(B-1)

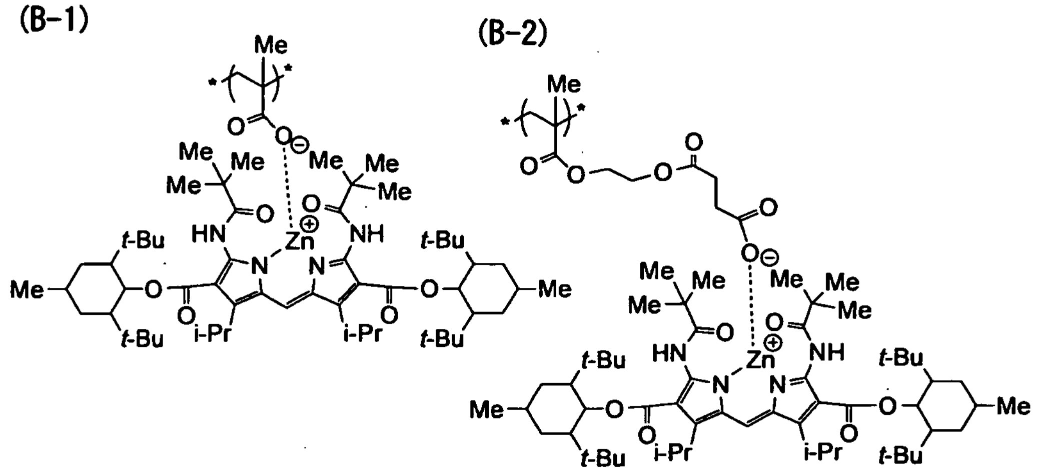

(B-2)

(B-3) (B-4)

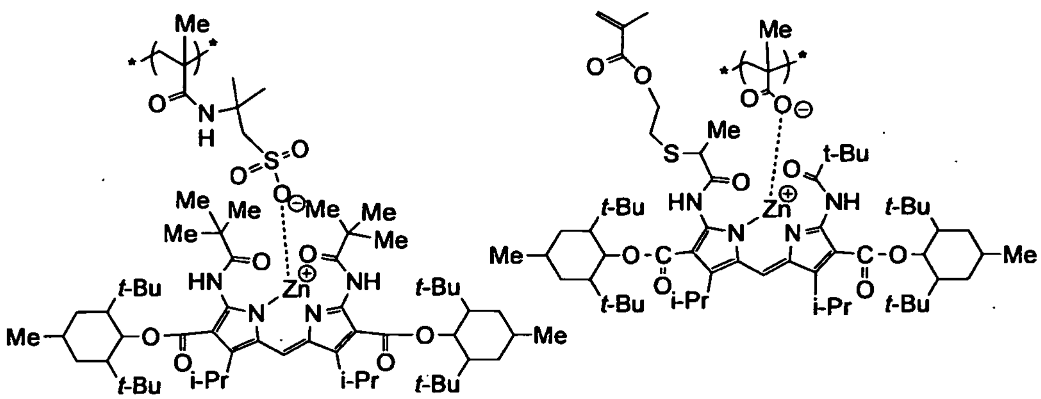

(B-6)

(B-5)

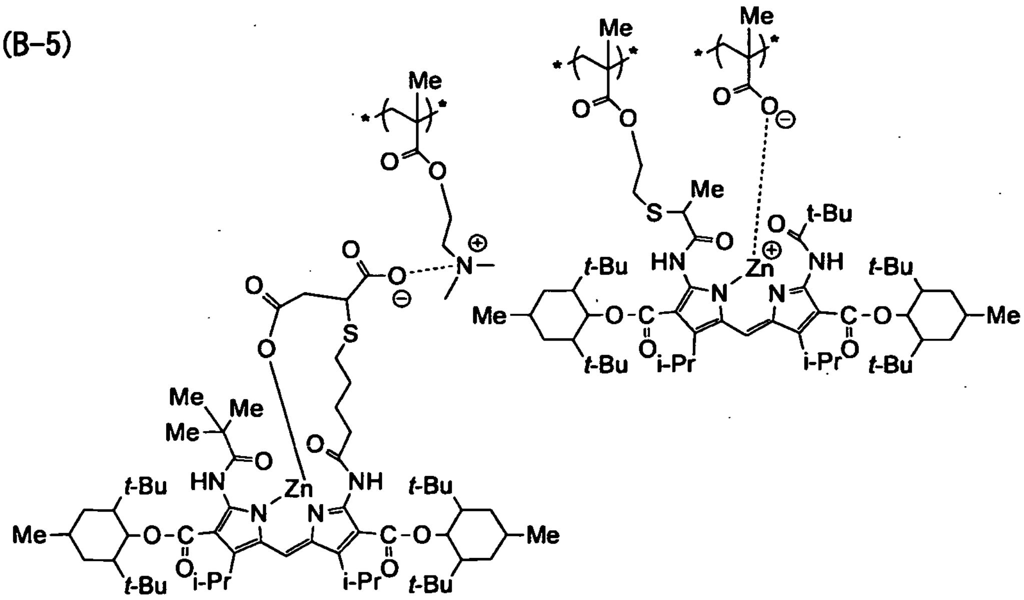

(B-7)

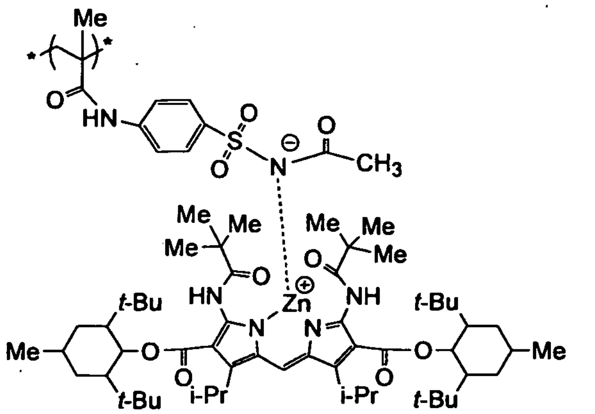

(B-8)

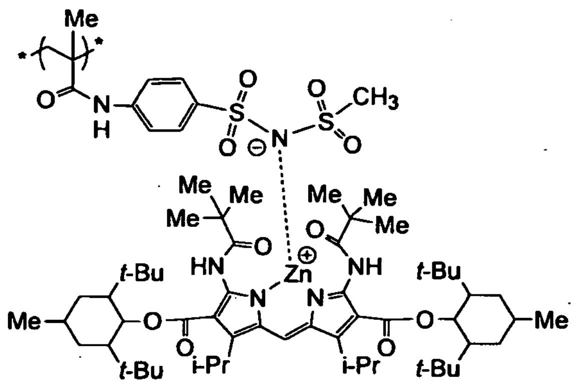

*Constituent unit represented by Formula (C)*

Hereinbelow, the details of the constituent unit represented by Formula (C) are described.

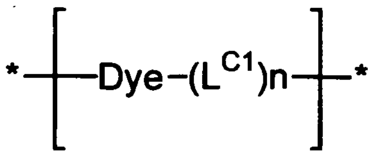

Formula (C)

In Formula (C), $L^{C1}$ represents a single bond or a divalent linking group; and "Dye" represents a colorant residue formed by removing any two of hydrogen atoms from the dipyrromethene metal complex compound obtained from (i) the dipyrromethene compound represented by Formula (M) and (ii) a metal or a metal compound. "Dye" preferably represents a colorant residue formed by removing any two hydrogen atoms from the dipyrromethene metal complex compound represented by Formula (5) or Formula (6). *n* represents an integer of from 1 to 4. When *n* represents an integer of 2 or more, each $L^{C1}$ may be the same as or different from one another.

In Formula (C), examples of the divalent linking group represented by $L^{C1}$ include a substituted or unsubstituted straight-chain, branched-chain or cyclic alkylene group having 1 to 30 carbon atoms (such as a methylene group, an ethylene group, a trimethylene group, a propylene group or a butylene group); a substituted or unsubstituted arylene group having 6 to 30 carbon atoms (such as a phenylene group or a naphthalene group); a substituted or unsubstituted heterocyclic linking group;$-CH_2=CH_2-$, -O-, -S-, -NR-, -C(=O)-, -SO-, $-SO_2-$ and a linking group formed by linking two or more of these groups such as -N(R)C(=O)-, -OC(=O)-, -C(=O)N(R)-, -C(=O)O-, or -N(R)C(=O)N(R)- (here, each R independently represents a hydrogen atom, an alkyl group, an aryl group or a heterocyclic group).

Preferable examples of the divalent linking group represented by $L^{C1}$ in Formula (C) includes the followings, but $L^{C1}$ is not limited to these examples.

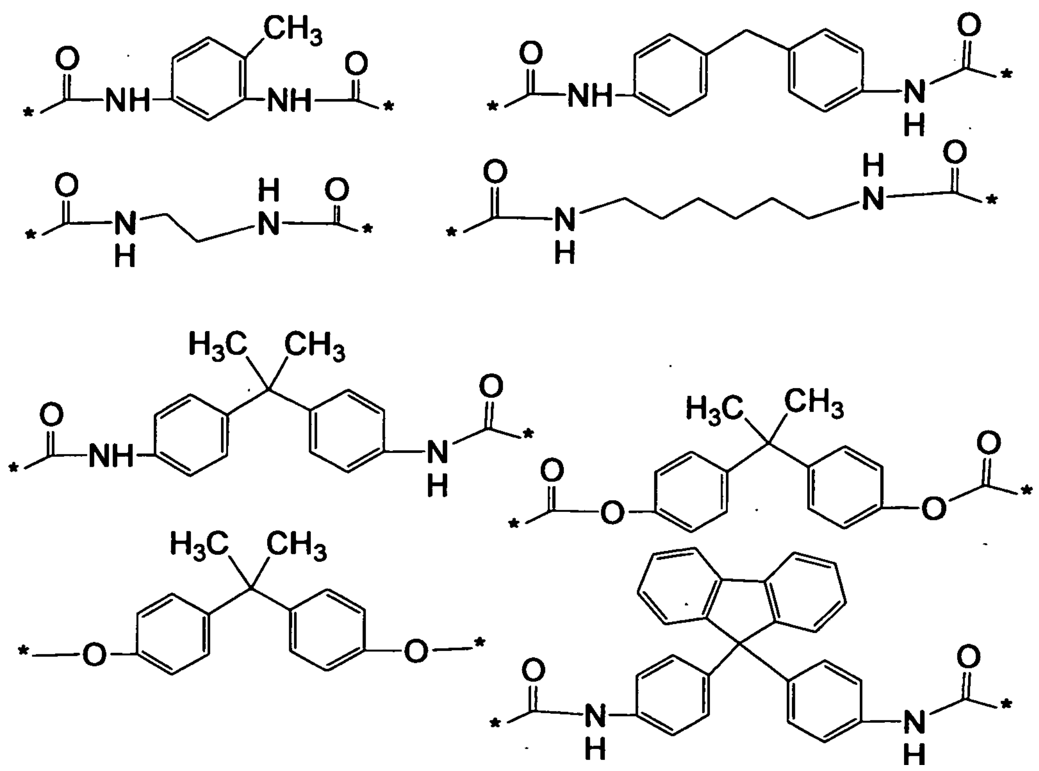

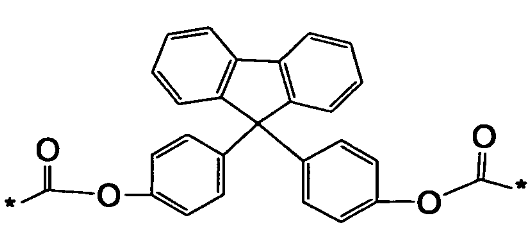
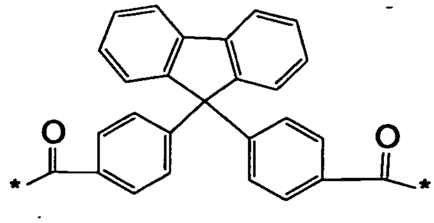

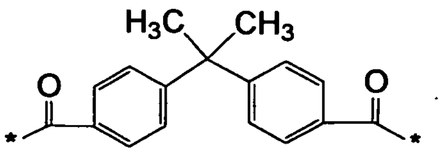
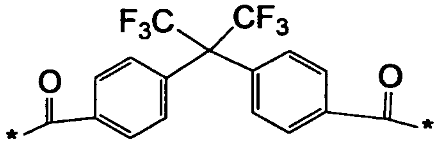

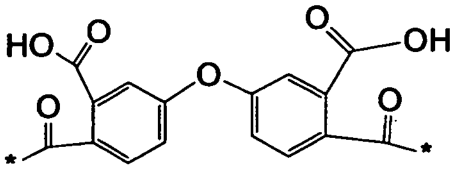
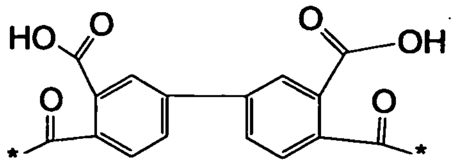

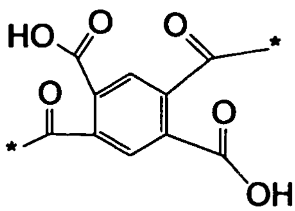
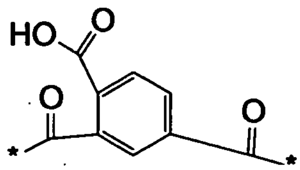

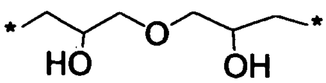
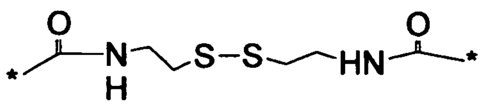

Specific examples of the constituent units represented by Formula (C) include the following, but the invention is not particularly limited to these examples.

(C-1)

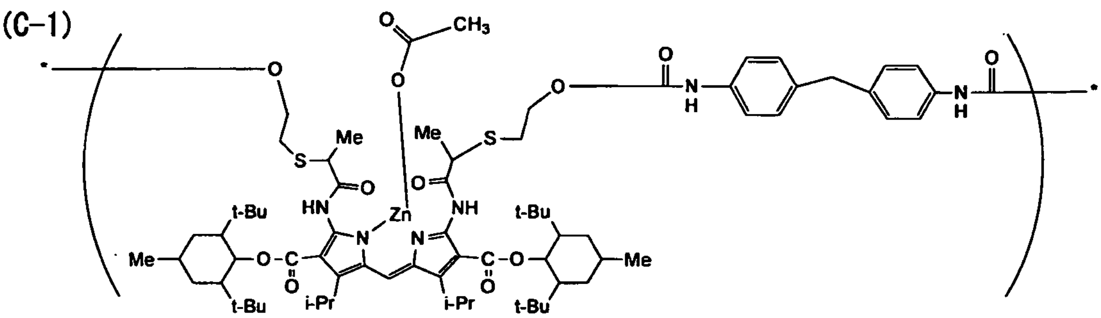

(C-2)

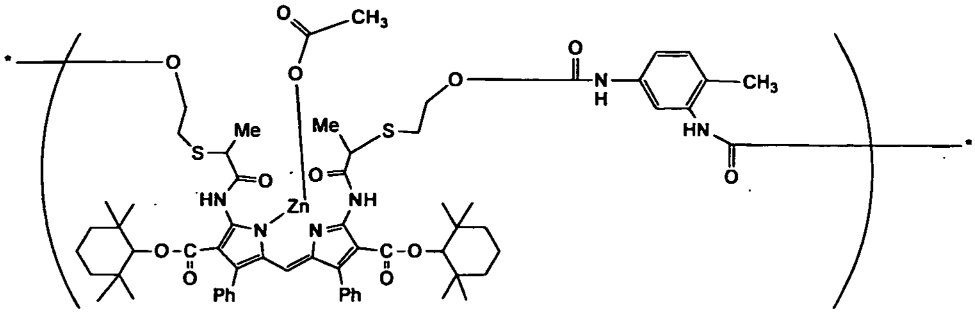

(C-3)

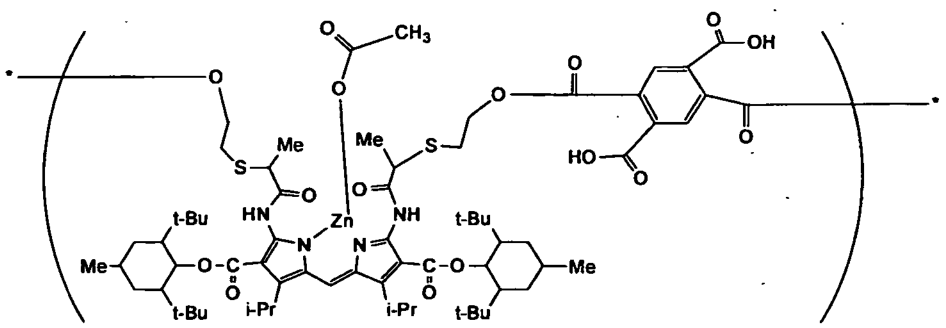

(C-4)

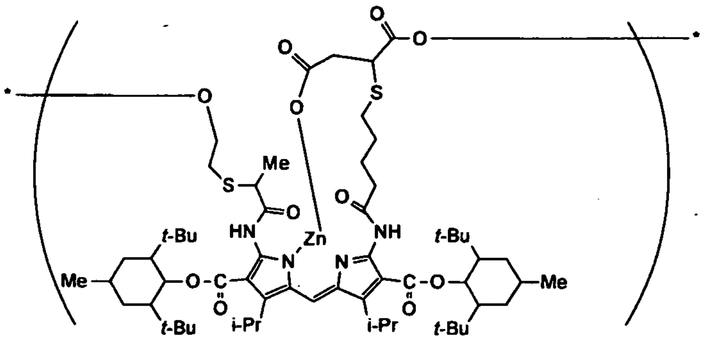

(C-5)

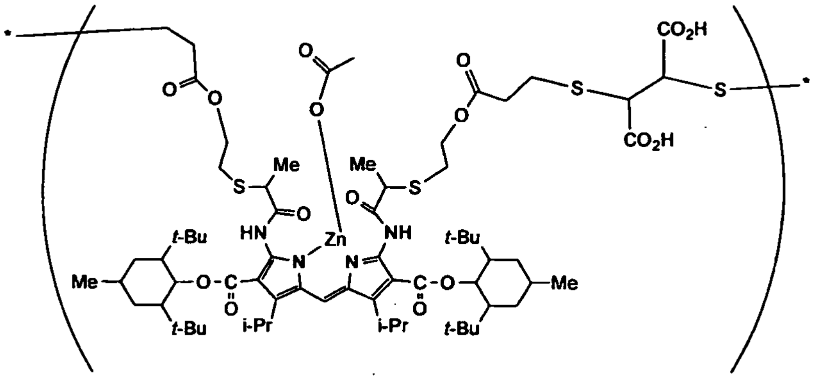

*Copolymerization component*

The colorant multimer of the invention may be formed only by the constituent units represented by Formula (A), Formula (B) and/or Formula (C), but may be multimerized with other constituent units. Preferable examples of the other units include the following constituent units. Specific examples thereof are shown below, but the invention is not particularly limited to these examples.

(H-1)

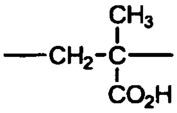

(H-2)

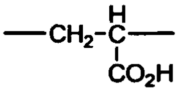

(H-3)

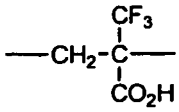

(H-4)

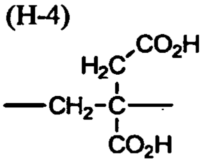

(H-5)

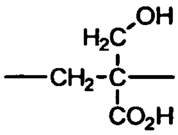

(H-6)

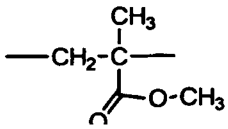

(H-7)

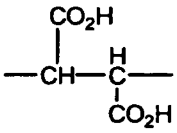

(H-8)

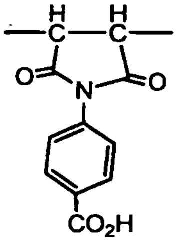

(H-9)

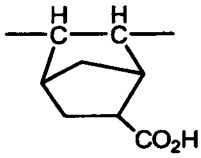

(H-10)

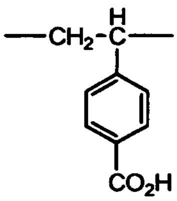

(H-11)

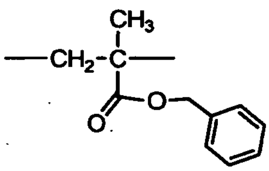

(H-12)

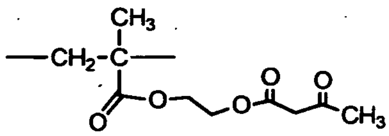

(H-13)

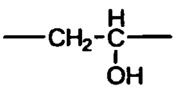

(H-14)

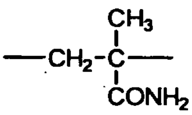

(H-15)

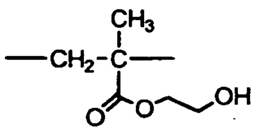

(H-16)

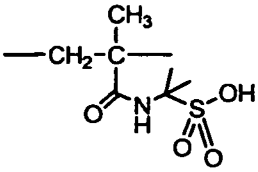

(H-17)

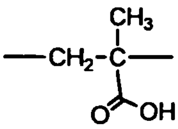

(H-18)

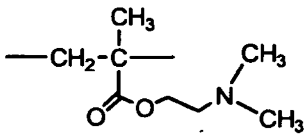

(H-19)

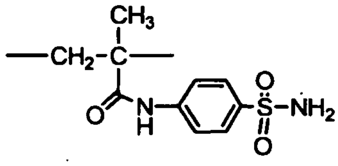

(H-20)

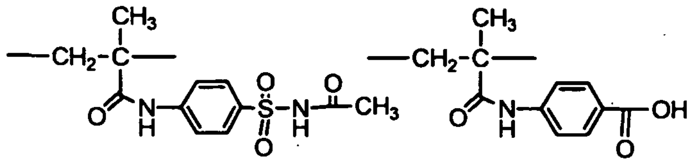

(H-21)

(H-22)

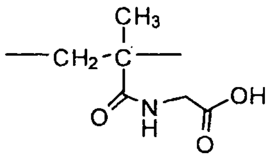

(H-23)

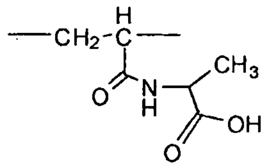

(H-24)

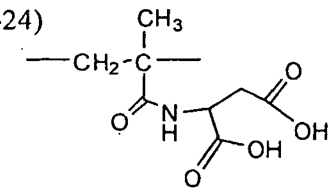

(H-24)

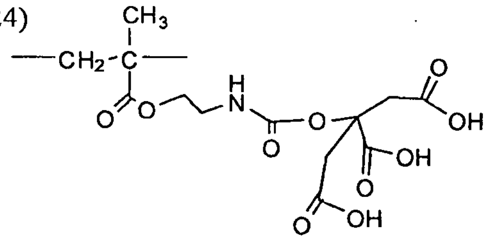

(H-25)

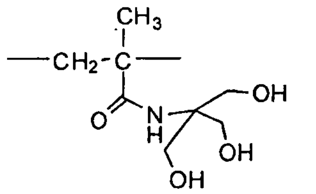

Hereinbelow, preferable examples of the colorant multimer of the invention are shown in the following Table 1 with a constituent unit (the constituent unit described above), a copolymerization molar ratio, a weight average molecular weight, and a degree of dispersion thereof.

Table 1

| | Constituent unit 1 | | Constituent unit 2 | | Constituent unit 3 | | Weight average molecular weight | Degree of dispersion |
|---|---|---|---|---|---|---|---|---|
| | Type | wt% | Type | wt% | Type | wt% | Mw | Mw/Mn |
| S-1 | A-1 | 88 | H-1 | 12 | - | - | 7700 | 1.8 |
| S-2 | A-2 | 100 | - | - | - | - | 7800 | 2.1 |
| S-3 | A-2 | 88 | H-1 | 12 | - | - | 4500 | 1.9 |
| S-4 | A-2 | 88 | H-1 | 12 | - | - | 8100 | 1.8 |
| S-5 | A-2 | 88 | H-1 | 12 | - | - | 12000 | 1.9 |
| S-6 | A-2 | 88 | H-1 | 12 | - | - | 18000 | 1.9 |
| S-7 | A-2 | 82 | H-1 | 12 | H-3 | 6 | 8000 | 2.1 |
| S-8 | A-2 | 82 | H-1 | 12 | H-12 | 6 | 9000 | 2.5 |
| S-9 | A-2 | 82 | H-1 | 12 | H-20 | 6 | 7500 | 1.8 |
| S-10 | A-3 | 88 | H-1 | 12 | - | - | 8000 | 1.7 |
| S-11 | A-4 | 88 | H-1 | 12 | - | - | 7800 | 2.1 |
| S-12 | A-7 | 88 | H-1 | 12 | - | - | 6900 | 2.0 |
| S-13 | A-15 | 88 | H-1 | 12 | - | - | 7200 | 1.9 |
| S-14 | B-1 | 88 | H-1 | 12 | - | - | 7800 | 2.5 |
| S-15 | B-1 | 82 | H-1 | 12 | H-6 | 6 | 8000 | 1.8 |

(continued)

| | Constituent unit 1 | | Constituent unit 2 | | Constituent unit 3 | | Weight average molecular weight | Degree of dispersion |
|---|---|---|---|---|---|---|---|---|
| | Type | wt% | Type | wt% | Type | wt% | Mw | Mw/Mn |
| S-16 | B-4 | 82 | H-1 | 12 | H-6 | 6 | 8200 | 1.8 |
| S-17 | B-5 | 82 | H-1 | 12 | H-18 | 6 | 7500 | 1.9 |
| S-18 | B-6 | 88 | H-1 | 12 | | | 8600 | 1.6 |
| S-19 | B-6 | 82 | A-6 | 6 | H-1 | 12 | 9000 | 1.8 |
| S-20 | C-1 | 100 | - | - | - | - | 5200 | 1.2 |
| S-21 | C-5 | 100 | - | - | - | - | 6000 | 1.3 |
| S-22 | D-1 | 100 | - | - | - | - | 4800 | 1.2 |
| S-23 | D-2 | 100 | - | - | - | - | 3900 | 1.4 |
| S-24 | D-4 | 100 | - | - | - | - | 4100 | 1.2 |
| S-25 | D-6 | 100 | - | - | - | - | 5900 | 1.2 |
| S-26 | D-7 | 100 | - | - | - | - | 6800 | 1.1 |

The colorant multimer of the invention preferably includes, as a partial structure, at least one of the constituent unit represented by Formula (A), (B) or (C). The colorant multimer of the invention more preferably includes the constituent unit represented by Formula (A).

Further, the constituent unit represented by Formula (A) is preferably formed with the colorant monomer represented by the following Formula (1) as a polymerization component.

Hereinbelow, the details of the colorant monomer represented by Formula (1) are described.

*Colorant monomer represented by Formula (1)*

The colorant monomer contained in the colorant multimer of the invention as a polymerization component, that is a compound represented by the following Formula (1), is explained in detail.

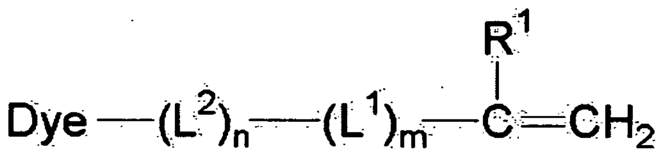

Formula (1)

In Formula (1), $R^1$ represents a hydrogen atom, a halogen atom, an alkyl group or an aryl group; $L^1$ represents $-N(R^2)C(=O)-$, $-OC(=O)-$, $-C(=O)N(R^2)-$, $-C(=O)O-$, a group represented by the following Formula (2), a group represented by the following Formula (3), or a group represented by the following Formula (4); $L^2$ represents a divalent linking group; *m* and *n* each independently represent 0 or 1; "Dye" represents a colorant residue formed by removing any one hydrogen atom from the dipyrromethene metal complex compound or tautomer thereof obtained from (i) the dipyrromethene compound represented by Formula (M) and (ii) a metal or a metal compound, preferably represents a colorant residue formed by removing any one hydrogen atom from the dipyrromethene metal complex compound represented by Formula (5) or a colorant residue formed by removing one hydrogen atom from any one of the substituents of $R^{11}$ to $R^{17}$, $X^1$, $Y^1$ and $Y^2$ in the dipyrromethene metal complex compound represented by Formula (6); and $R^2$ represents a hydrogen atom, an alkyl group, an aryl group or a heterocyclic group;

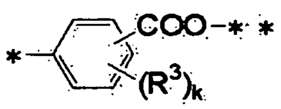
Formula (2)

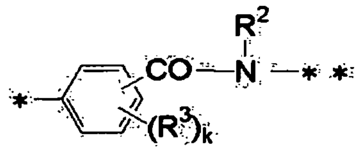
Formula (3)

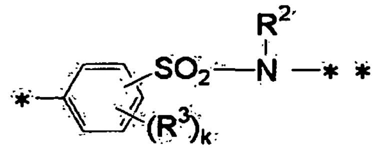
Formula (4)

wherein, $R^2$ in Formulae (3) and (4) independently represents a hydrogen atom, an alkyl group, an aryl group or a heterocyclic group; $R^3$ in Formulae (2) to (4) independently represents a hydrogen atom or a substituent; k in Formulae (2) to (4) independently represents an integer of from 0 to 4; * in Formulae (2) to (4) independently represents a position to which the -C($R^1$) =$CH_2$ group in Formula (1) is linked; and ** in Formulae (2) to (4) independently represents a position to which $L^2$ or "Dye" (when *n* represents 0) in Formula (1) is linked.

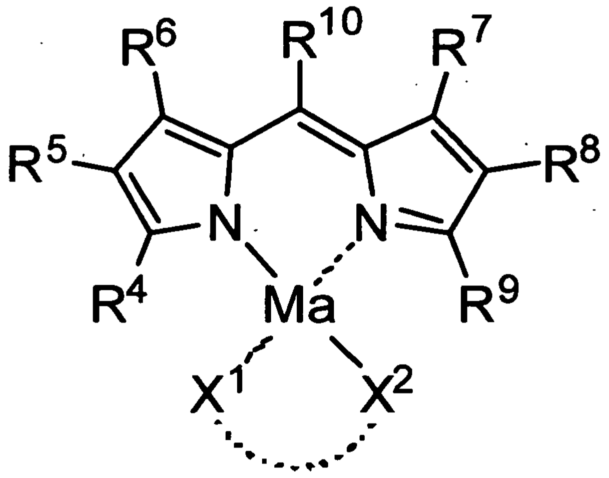
Formula (5)

In Formula (5), $R^4$ to $R^9$ each independently represent a hydrogen atom or a substituent; $R^{10}$ represents a hydrogen atom, a halogen atom, an alkyl group, an aryl group or a heterocyclic group; Ma represents a metal atom or a metal compound; $X^1$ represents a group that can be bonded to Ma; $X^2$ represents a group that neutralizes the charge of Ma; and $X^1$ and $X^2$ may be linked to each other to form a 5-, 6-, or 7-membered ring together with Ma. Examples of the dipyrromethene metal complex compound represented by Formula (5) also include tautomers thereof.

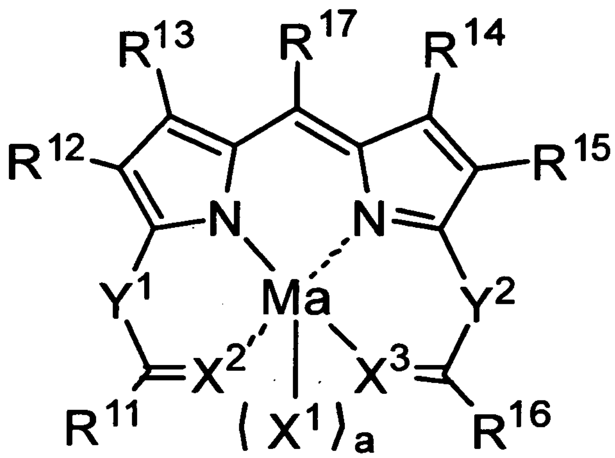
Formula (6)

In Formula (6), $R^{11}$ and $R^{16}$ each independently represent an alkyl group, an alkenyl group, an aryl group, a heterocyclic group, an alkoxy group, an aryloxy group, an alkylamino group, an arylamino group or a heterocyclic amino group; $R^{12}$ to $R^{15}$ each independently represent a hydrogen atom or a substituent; $R^{17}$ represents a hydrogen atom, a halogen atom, an alkyl group, an aryl group or a heterocyclic group; Ma represents a metal atom or a metal compound; $X^2$ and $X^3$ each independently represent NR' (wherein R' represents a hydrogen atom, an alkyl group, an alkenyl group,

an aryl group, a heterocyclic group, an acyl group, an alkylsulfonyl group or an arylsulfonyl group), a nitrogen atom, an oxygen atom or a sulfur atom; $Y^1$ and $Y^2$ each independently represent NR" (wherein R" represents a hydrogen atom, an alkyl group, an alkenyl group, an aryl group, a heterocyclic group, an acyl group, an alkylsulfonyl group or an arylsulfonyl group), a nitrogen atom or a carbon atom; $R^{11}$ and $Y^1$ may be linked to each other to form a 5-, 6-, or 7-membered ring; $R^{16}$ and $Y^2$ may be linked to each other to form a 5-, 6-, or 7-membered ring; $X^1$ represents a group that can be bonded to Ma; and *a* represents 0, 1, or 2. Here, when *a* represents 2, each $X^1$ may be the same as or different from each other. Examples of the dipyrromethene metal complex compound represented by Formula (6) also include tautomers thereof.

That is, the colorant monomer represented by Formula (1) is a compound in which the polymerizable group represented by $-(L^2)_n-(L^1)_m-C(R^1)=CH_2$ in Formula (1) is introduced into the dipyrromethene metal complex compound represented by Formula (5) or Formula (6).

When both *m* and *n* represent 0, the $-C(R^1)=CH_2$ group is directly introduced into the dipyrromethene metal complex compound. Here, $L^1$, $L^2$, and $R^1$ have the same definitions as $L^1$, $L^2$, and $R^1$ in Formula (1), respectively.

In the dipyrromethene metal complex compound represented by Formula (5), the position into which the polymerizable group is introduced is not particularly limited, but is preferably introduced into any one of $R^4$ to $R^9$, more preferably any one of $R^4$, $R^6$, $R^7$, and $R^9$, and still more preferably $R^4$ or $R^9$ in view of the synthetic suitability.

In the dipyrromethene metal complex compound represented by Formula (6), the position into which the polymerizable group is introduced is any one of $R^{11}$ to $R^{17}$, $X^1$, $Y^1$ and $Y^2$. In view of the synthetic suitability, the polymerizable group is preferably introduced into any one of $R^{11}$ to $R^{16}$ and $X^1$, more preferably any one of $R^{11}$, $R^{13}$, $R^{14}$ and $R^{16}$, and still more preferably $R^{11}$ or $R^{16}$.

In Formula (1), $R^1$ represents a hydrogen atom, a halogen atom, an alkyl group, or an aryl group. When $R^1$ represents an alkyl group or an aryl group, the alkyl group or the aryl group may be unsubstituted or substituted.

When $R^1$ is represents an alkyl group, the alkyl group is preferably a substituted or unsubstituted straight-chain, branched-chain or cyclic alkyl group having 1 to 36, more preferably 1 to 6 carbon atoms. Examples of the alkyl group include a methyl group, an ethyl group, a propyl group, a butyl group, an octyl group, an isopropyl group and a cyclohexyl group.

When $R^1$ represents an aryl group, the aryl group is preferably a substituted or unsubstituted aryl group having 6 to 18, more preferably 6 to 14, and still more preferably 6 to 12 carbon atoms. Examples of the aryl group include a phenyl group and a naphthyl group.

When $R^1$ represents a substituted alkyl group or a substituted aryl group, examples of the substituent include a halogen atom (such as a fluorine atom, a chlorine atom, a bromine atom or an iodine atom), an alkyl group (an alkyl group having preferably 1 to 24, more preferably 1 to 12 carbon atoms, such as a methyl group, an ethyl group, a propyl group, a butyl group, an isopropyl group, a t-butyl group, a 2-ethylhexyl group, a dodecyl group, a cyclopropyl group, a cyclopentyl group, a cyclohexyl group or an adamantly group), an aryl group (an aryl group having preferably 6 to 24, more preferably 6 to 12 carbon atoms, such as a phenyl group or a naphthyl group), a heterocyclic group (a heterocyclic group having preferably 1 to 24, more preferably 1 to 12 carbon atoms, such as a 2-thienyl group, a 4-pyridyl group, a 2-furyl group, a 2-pyrimidinyl group, a 1-pyridyl group, a 2-benzothiazolyl group, a 1-imidazolyl group, a 1-pyrazolyl group or a benzotriazol-1-yl group), a silyl group (a silyl group having preferably 3 to 24, more preferably 3 to 12 carbon atoms, such as a trimethylsilyl group, a triethylsilyl group, a tributylsilyl group, a t-butyldimethylsilyl group or a t-hexyldimethylsilyl group), a hydroxy group, a cyano group, a nitro group, a sulfonic acid group, a phosphonic acid group, a carboxy group, an alkoxy group (an alkoxy group having preferably 1 to 24, more preferably 1 to 12, still more preferably 1 to 6 carbon atoms, such as a methoxy group, an ethoxy group, a 1-butoxy group, a 2-butoxy group, isopropoxy group, a t-butoxy group, a dodecyloxy group, or a cycloalkyloxy group such as a cyclopentyloxy group or a cyclohexyloxy group), an aryloxy group (an aryloxy group having preferably 6 to 24, more preferably 6 to 12 carbon atoms, such as a phenoxy group or a 1-naphthoxy group), a heterocyclic oxy group (an alkoxy group having preferably 1 to 24, more preferably 1 to 12 carbon atoms, such as a1-phenyltetrazole-5-oxy group or a 2-tetrahydropyranyloxy group), a silyloxy group (a silyloxy group having preferably 1 to 24, more preferably 1 to 12 carbon atoms, such as a trimethylsilyloxy group, a t-butyldimethylsilyloxy group or a diphenylmethylsilyloxy group), an acyloxy group (an acetoxy group having preferably 2 to 24, more preferably 2 to 12 carbon atoms, such as an acetoxy group, a pivaloyloxy group, a benzoyloxy group or a dodecanoyloxy group), an alkoxycarbonyloxy group (an alkoxycarbonyloxy group having preferably 2 to 24, more preferably 2 to 12, sill more preferably 2 to 6 carbon atoms, such as an ethoxycarbonyloxy group, a t-butoxycarbonyloxy group, or a cycloalkyloxycarbonyloxy group such as a cyclohexyloxycarbonyloxy group), an aryloxycarbonyloxy group (an aryloxycarbonyl oxy group having preferably 7 to 24, more preferably 7 to 12 carbon atoms, such as a phenoxycarbonyloxy group), a carbamoyloxy group (a carbamoyloxy group having preferably 1 to 24, more preferably 1 to 12, still more preferably 1 to 6 carbon atoms, such as an N,N- dimethylcarbamoyloxy group, an N-butylcarbamoyloxy group, an N-phenylcarbamoyloxy group or an N-ethyl-N-phenylcarbamoyloxy group), a sulfamoyloxy group (sulfamoyloxy group having preferably 1 to 24, more preferably 1 to 12, still more preferably 1 to 6 carbon atoms, such as an N,N-diethylsulfamoyloxy group or an N-propylsulfamoyloxy group), an alkylsulfonyloxy group (an alkylsulfonyloxy group having preferably 1 to 24, more preferably 1 to 12, still more preferably 1 to 6 carbon atoms, such as a methylsulfonyloxy group, a

hexadecylsulfonyloxy group or a cyclohexylsulfonyloxy group), an arylsulfonyloxy group (an arylsulfonyloxy group having preferably 6 to 24, more preferably 6 to 12 carbon atoms, such as a phenylsulfonyloxy group), an acyl group (an acyl group having preferably 1 to 24, more preferably 1 to 12 carbon atoms, such as a formyl group, an acetyl group, a pivaloyl group, a benzoyl group, a tetradecanoyl group or a cyclohexanoyl group);
an alkoxycarbonyl group (an alkoxycarbonyl group having preferably 2 to 24, more preferably 2 to 12, still more preferably 2 to 6 carbon atoms, such as a methoxycarbonyl group, an ethoxycarbonyl group, an octadecyloxycarbonyl group or a cyclohexyloxycarbonyl group), an aryloxycarbonyl group (an aryloxycarbonyl group having preferably 7 to 24, more preferably 7 to 12 carbon atoms, such as a phenoxycarbonyl group), a carbamoyl group (a carbamoyl group having preferably 1 to 24, more preferably 1 to 12 carbon atoms, such as a carbamoyl group, an N,N-diethylcarbamoyl group, an N-ethyl-N-octylcarbamoyl group, an N,N-dibutylcarbamoyl group, an N-propylcarbamoyl group, an N-phenylcarbamoyl group, a N-methyl-N-phenylcarbamoyl group or an N,N-dicyclohexylcarbamoyl group), an amino group (an amino group having preferably 24 or less, more preferably 12 or less carbon atoms, such as an amino group, a methylamino group, an N,N-dibutylamino group, a tetradecylamino group, a 2-ethylhexylamino group or a cyclohexylamino group), an anilino group (an anilino group having preferably 6 to 24, more preferably 6 to 12 carbon atoms, such as an anilino group or an N-methylanilino group), a heterocyclic amino group (a heterocyclic amino group having preferably 1 to 24, more preferably 1 to 12 carbon atoms, such as a 4-pyridylamino group), a carbonamido group (a carbonamido group having preferably 2 to 24, more preferably 2 to 12carbon atoms, such as an acetamido group, a benzamido group, a tetradecanamido group, a pivaloylamido group or a cyclohexanamido group), an ureido group (an ureido group having preferably 1 to 24, more preferably 1 to 12 carbon atoms, such as an ureido group, an N,N-dimethylureido group or an N-phenylureido group), an imido group (an imido group having preferably 20 or less, more preferably 12 or less carbon atoms, such as an N-succinimido group or an N-phthalimido group), an alkoxycarbonylamino group (an alkoxycarbonylamino group having preferably 2 to 24, more preferably 2 to 12 carbon atoms, such as a methoxycarbonylamino group, an ethoxycarbonylamino group, a t-butoxycarbonylamino group, an octadecyloxycarbonylamino group or a cyclohexyloxycarbonylamino group), an aryloxycarbonylamino group (an aryloxycarbonylamino group having preferably 7 to 24, more preferably 7 to 12 carbon atoms, such as an phenoxycarbonylamino group), a sulfonamido group (a sulfonamido group having preferably 1 to 24, more preferably 1 to 12 carbon atoms, such as a methanesulfonamido group, a butanesulfonamido group, a benzenesulfonamido group, a hexadecanesulfonamido group or a cyclohexanesulfonamido group), a sulfamoylamino group (a sulfamoylamino group having preferably 1 to 24, more preferably 1 to 12 carbon atoms, such as an N,N-dipropylsulfamoylamino group or an N-ethyl-N-dodecylsulfamoylamino group), an azo group (an azo group having preferably 1 to 24, more preferably 1 to 12 carbon atoms, such as a phenylazo group or a 3-pyrazolylazo group), an alkylthio group (an alkylthio group having preferably 1 to 24, more preferably 1 to 12 carbon atoms, such as a methylthio group, an ethylthio group, an octylthio group or a cyclohexylthio group), an arylthio group (an arylthio group having preferably 6 to 24, more preferably 6 to 12 carbon atoms, such as a phenylthio group), a heterocyclic thio group (a heterocyclic thio group having preferably 1 to 24, more preferably 1 to 12 carbon atoms, such as a 2-benzothiazolylthio group, a 2-pyridylthio group or a 1-phenyltetrazolylthio group), an alkylsulfinyl group (an alkylsulfinyl group having preferably 1 to 24, more preferably 1 to 12 carbon atoms, such as a dodecanesulfinyl group);
an arylsulfinyl group (an arylsulfinyl group having preferably 6 to 24, more preferably 6 to 12 carbon atoms, such as a phenylsulfinyl group), an alkylsulfonyl group (an alkylsulfonyl group having preferably 1 to 24, more preferably 1 to 12 carbon atoms, such as a methylsulfonyl group, an ethylsulfonyl group, a propylsulfonyl group, a butylsulfonyl group, an isopropylsulfonyl group, a 2-ethylhexylsulfonyl group, a hexadecylsulfonyl group, an octylsulfonyl group or a cyclohexylsulfonyl group), an arylsulfonyl group (an arylsulfonyl group having preferably 6 to 24, more preferably 6 to 12 carbon atoms, such as a phenylsulfonyl group or a 1-naphthylsulfonyl group), a sulfamoyl group (a sulfamoyl group having preferably 24 or less, more preferably 16 or less carbon atoms, such as a sulfamoyl group, an N,N-dipropylsulfamoyl group, an N-ethyl-N-dodecylsulfamoyl group, an N-ethyl-N-phenylsulfamoyl group or an N-cyclohexylsulfamoyl group), a sulfo group, a phosphonyl group (a phosphonyl group having preferably 1 to 24, more preferably 1 to 12 carbon atoms, such as a phenoxyphosphonyl group, an octyloxyphosphonyl group or a phenylphosphonyl group) and a phosphinoylamino group (a phosphinoylamino group having preferably 1 to 24, more preferably 1 to 12 carbon atoms, such as a diethoxyphosphinoylamino group or an dioctyloxyphosphinoylamino group).

Among these substituents, a halogen atom, an alkyl group, an aryl group, a hydroxy group, a sulfonic acid group, a phosphonic acid group, a carboxy group, an alkoxy group, an aryloxy group, an alkoxycarbonyloxy group, a cycloalkyl carbonyloxy group, an aryloxycarbonyloxy group, a carbamoyloxy group, a sulfamoyloxy group, an alkylsulfonyloxy group, an arylsulfonyloxy group, an acyl group, an alkoxycarbonyl group, an aryloxycarbonyl group, a carbamoyl group, a carbonamido group, an imido group, a sulfonamido group, a sulfamoylamino group, and a sulfamoyl group are preferable;
an alkyl group, an aryl group, a hydroxy group, a sulfonic acid group, a phosphonic acid group, a carboxy group, an alkoxy group, an aryloxy group, an alkoxycarbonyloxy group, an aryloxycarbonyloxy group, a carbamoyloxy group, a sulfamoyloxy group, an alkylsulfonyloxy group, an arylsulfonyloxy group, an acyl group, and an alkoxycarbonyl group, an aryloxycarbonyl group, a carbamoyl group, a carbonamido group, a sulfonamido group, a sulfamoylamino group,

and a sulfamoyl group are more preferable;

a hydroxy group, a sulfonic acid group, a phosphonic acid group, a carboxy group, an alkoxy group, an aryloxy group, an alkoxycarbonyloxy group, an aryloxycarbonyloxy group, a carbamoyloxy group, a sulfamoyloxy group, an alkylsulfonyloxy group, an arylsulfonyloxy group, an acyl group, an alkoxycarbonyl group, and an aryloxycarbonyl group are still more preferable; and

a hydroxy group, a sulfonic acid group, a carboxy group, an alkoxy group, an alkoxycarbonyloxy group, a carbamoyloxy group, a sulfamoyloxy group, an alkylsulfonyloxy group, an acyl group, and an alkoxycarbonyl group are even more preferable.

Among these preferable substituents, a sulfonic acid group, a carboxy group, an alkoxy group, an alkoxycarbonyloxy group, an alkylsulfonyloxy group, and an alkoxycarbonyl group is more preferable; a sulfonic acid group, a carboxy group, an alkoxy group, and an alkoxycarbonyl group are still more preferable; and a sulfonic acid group, a carboxy group, and an alkoxy group are even more preferable.

$R^1$ represents preferably a hydrogen atom, an alkyl group or an aryl group, and more preferably a hydrogen atom or an alkyl group.

When the substituted alkyl group or the substituted aryl group represented by $R^1$ is a group that may further be substituted, the substituted alkyl or aryl group may further be substituted by any of the substituents described above. When the substituted alkyl or aryl group has two or more substituents, these substituents may be the same as or different from one another.

In Formula (1), $L^1$ represents $-N(R^2)C(=O)-$, $-OC(=O)-$, $-C(=O)N(R^2)-$, - $C(=O)O-$, the group represented by the following Formula (2), the group represented by the following Formula (3), or the group represented by the following Formula (4). Here, $R^2$ represents a hydrogen atom, an alkyl group, an aryl group, or a heterocyclic group.

$R^2$ represents an alkyl group, an aryl group or a heterocyclic group. Examples of the alkyl, aryl and heterocyclic group represented by $R^2$ include the alkyl, aryl and heterocyclic groups of the substituents in the substituted alkyl or aryl group represented by $R^1$ above, respectively. The alkyl group, the aryl group and the heterocyclic group represented by $R^2$ have the same preferable definition as the alkyl, aryl and heterocyclic groups of the substituents in the substituted alkyl or aryl group represented by $R^1$, respectively.

The alkyl group, the aryl group or the heterocyclic group represented by $R^2$ may be substituted by any of the substituents for $R^1$. When the aryl group or the heterocyclic group represented by $R^2$ has two or more substituents, these substituents may be the same as or different from one another.

Hereinbelow, the group represented by Formula (2), the group represented by Formula (3), and the group represented by Formula (4), which are represented by $L^1$ in Formula (1), are explained.

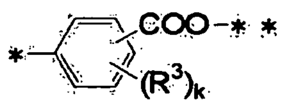

Formula (2)

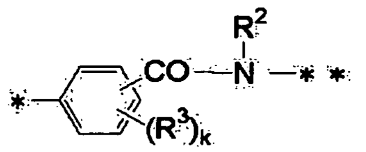

Formula (3)

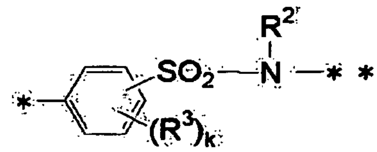

Formula (4)

Here, $R^2$ in Formulae (3) and (4) independently represents a hydrogen atom, an alkyl group, an aryl group or a heterocyclic group; $R^3$ in Formulae (2) to (4) independently represents a hydrogen atom or a substituent; k in Formulae (2) to (4) independently represents an integer of from 0 to 4; * in Formulae (2) to (4) independently represents a position to which the $-C(R^1)=CH_2$ group in Formula (1) is linked; and ** in Formulae (2) to (4) independently represents a position to which $L^2$ or "Dye" (when *n* represents 0) in Formula (1) is linked.

$R^2$ in Formulae (3) and (4) has the same definition as $R^2$ in Formula (1), and has the same preferable definition as $R^2$ in Formula (1).

$R^3$ in Formulae (2) to (4) represents a hydrogen atom or a substituent, and examples of the substituent represented by $R^3$ include the substituents for the substituted alkyl or aryl group represented by $R^1$. The substituent represented has the same preferable definition as the substituents for the substituted alkyl or aryl group represented by $R^1$. *k* in Formulae (2) to (4) represents 0, 1, 2, 3 or 4. When k represents 2, 3, or 4, each $R^3$ may be the same as or different from one another.

When the substituent represented by $R^3$ in Formulae (2) to (4) is a group that may further be substituted, the substituents represented by $R^3$ may be substituted by any of the substituents for the substituted alkyl or aryl group represented by $R^1$. When the substituent represented by $R^3$ has two or more substituents, these substituents may be the same as or different from one another.

In view of synthetic suitability, $L^1$ preferably represents $-N(R^2)C(=O)-$. - $OC(=O)-$, $-C(=O)N(R^2)-$ or $-C(=O)O-$, more preferably $-OC(=O)-$, $-C(=O)N(R^2)-$ or - $C(=O)O-$, and still more preferably $-C(=O)N(R^2)-$ or $-C(=O)O-$.

Hereinbelow, $L^2$ in Formula (1) is explained.

$L^2$ represents a divalent linking group that links $L^1$ or $-C(R^1)=CH_2$ (when *m* represents 0), with "Dye".

Preferable examples of $L^2$ include an alkylene group, an aralkylene group, an arylene group, - O-, -C(=O)-, -OC(=O)-, -OC(=O)O-, $-OSO_2-$, $-OC(=O)N(R^{50})-$, - $N(R^{50})-$, $-N(R^{50})C(=O)-$, $-N(R^{50})C(=O)O-$, $-N(R^{50})C(=O)N(R^{51})-$, $-N(R^{50})SO_2-$, - $N(R^{50})SO_2N(R^{51})-$, -S-, -S-S-, -SO-, $-SO_2-$, $-SO_2N(R^{50})-$, and $-SO_2O-$. Two or more of these divalent linking groups may be linked to one another to form a divalent linking group.

$R^{50}$ and $R^{51}$ each independently represent a hydrogen atom, an alkyl group, an aryl group or a heterocyclic group. Examples of the alkyl, aryl and heterocyclic groups represented by $R^{50}$ or $R^{51}$ include the alkyl, aryl and heterocyclic groups of the substituents for $R^1$, respectively. The alkyl, aryl and heterocyclic groups represented by $R^{50}$ or $R^{51}$ have the same preferable definitions as the alkyl, aryl and heterocyclic groups of the substituents for $R^1$, respectively. The alkyl, aryl, or heterocyclic group represented by $R^{50}$ or $R^{51}$ may be substituted with any of the substituents for $R^1$, respectively. When the alkyl, aryl or heterocyclic group represented by $R^{50}$ and $R^{51}$ has two or more substituents, these substituents may be the same as or different from one another.

When $L^2$ represents an alkylene group, an aralkylene group or an arylene group, these groups may be unsubstituted or substituted. When these groups are substituted, these groups may be substituted by any of the substituent for $R^1$. When an alkylene group, an aralkylene group or an arylene group represented by $L^2$ has two or more substituents, these substituents may be the same as or different from one another.

When $L^2$ represents an alkylene group, an aralkylene group or an arylene group, it is preferable that $L^2$ represents an alkylene group having 1 to 12 carbon atoms, an aralkylene group having 6 to 18 carbon atoms, or an arylene group having 6 to 18 carbon atoms, it is more preferable that $L^2$ represents an alkylene group having 1 to 8 carbon atoms, an aralkylene group having 6 to 16 carbon atoms, or an arylene group having 6 to 12 carbon atoms, and it is still more preferable that $L^2$ represents an alkylene group having 1 to 6 carbon atoms or an aralkylene group having 6 to 12 carbon atoms.

As the combination of $L^1$ and $L^2$, it is preferable that $L^1$ represents $-N(R^2)C(=O)-$, -OC(=O)-, $-C(=O)N(R^2)-$, or -C(=O)O-, and $L^2$ represents an alkylene group having 1 to 12 carbon atoms, an aralkylene group having 6 to 18 carbon atoms, an arylene group having 6 to 18 carbon atoms, an alkyl thioether group having 2 to 18 carbon atoms, an alkyl carbonamido group having 2 to 18 carbon atoms, or an alkyl aminocarbonyl group having 2 to 18 carbon atoms. It is more preferable that $L^1$ represents -OC(=O)-, $-C(=O)N(R^2)-$, or -C(=O)O-, and $L^2$ represents an alkylene group having 1 to 8 carbon atoms, an aralkylene group having 6 to 16 carbon atoms, an arylene group having 6 to 12 carbon atoms, an alkyl thioether group having 2 to 12 carbon atoms, an alkyl carbonamido group having 2 to 12 carbon atoms, or an alkyl aminocarbonyl group having 2 to 12 carbon atoms. It is still more preferable that $L^1$ represents $-C(=O)N(R^2)-$ or -C(=O)O-, and $L^2$ represents an alkylene group having 1 to 6 carbon atoms, an aralkylene group having 6 to 12 carbon atoms, an alkyl thioether group having 2 to 6 carbon atoms, an alkyl carbonamido group having 2 to 6 carbon atoms, or an alkyl aminocarbonyl group having 2 to 6 carbon atoms.

Examples of the polymerizable group represented by $-(L^2)_n-(L^1)_m-C(R^1)=CH_2$ in Formula (1) include the following. However, the invention is not particularly limited to these examples.

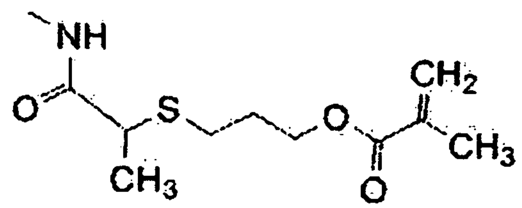
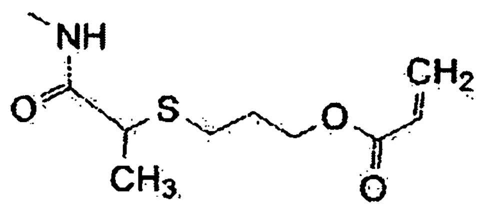

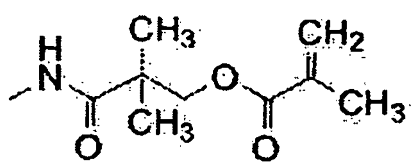
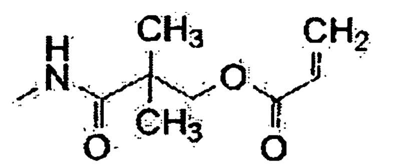

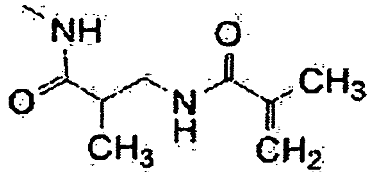
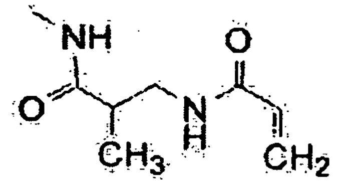

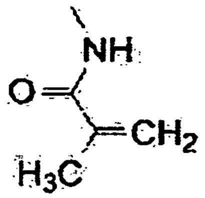

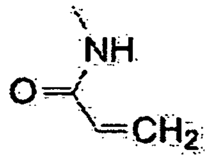

*Dipyrromethene metal complex compound*

The colorant monomer represented by Formula (1) has a colorant residue formed by removing any one hydrogen atom from the dipyrromethene metal complex compound represented by Formula (5), or a colorant residue formed by removing one hydrogen atom from any one of the substituents represented by $R^{11}$ to $R^{17}$, $X^1$, $Y^1$ and $Y^2$ in the dipyrromethene metal complex compound represented by Formula (6). That is, the colorant monomer represented by Formula (1) is a compound in which the polymerizable group represented by $-(L^2)_n-(L^1)_m-C(R^1)=CH_2$ is introduced into the dipyrromethene metal complex compound represented by Formula (5) or Formula (6). When both *m* and *n* represents 0, the $-C(R^1)=CH_2$ group is directly introduced into the dipyrromethene metal complex compound.

The dipyrromethene metal complex compound introduced into Formula (1) is the above described dipyrromethene metal complex compound represented by Formula (5) or Formula (6).

*Examples of colorant monomer*

Examples of colorant monomer represented by Formula (1) and the example of the synthetic method of the colorant monomer are shown below, but the invention is not particularly limited to these examples.

Exemplary compound a-9 was synthesized according to the following synthetic scheme.

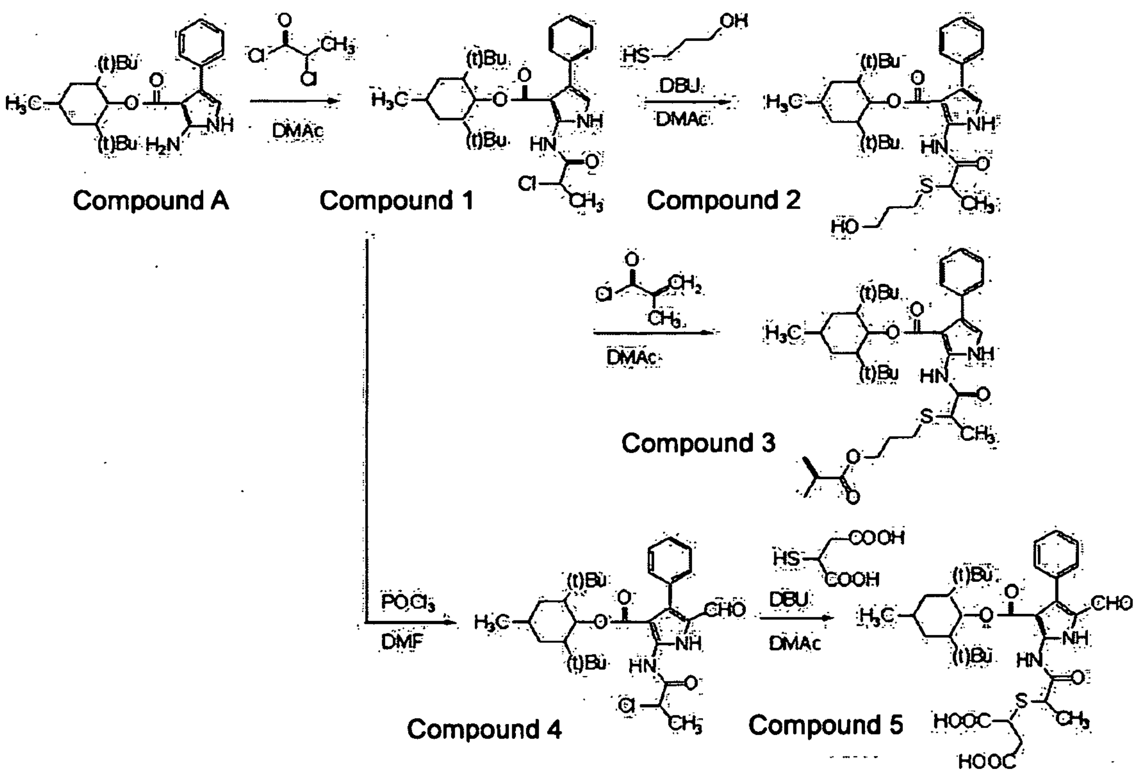


Compound A

Compound 1

Compound 2

Compound 3

Compound 4

Compound 5

Compound 3 + Compound 5

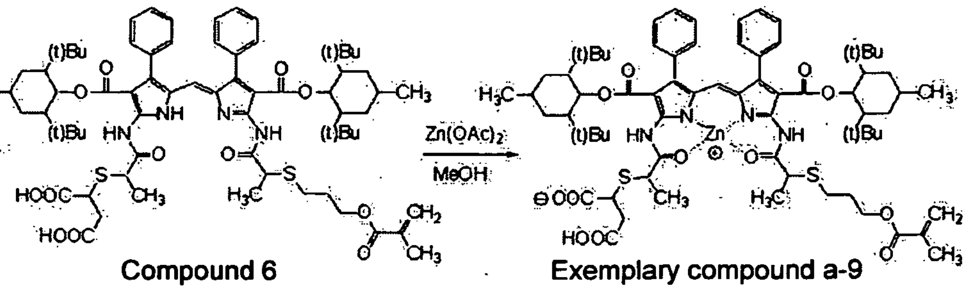


Compound 6 Exemplary compound a-9

*Synthetic method of compound 1*

4.11 g of 2-aminopyrrole compound (compound A) was stirred in acetonitrile at room temperature, and 1.33 g of 2-chloropropionyl chloride was dropped therein and the mixture was stirred for 30 minutes. The precipitated crystal was filtered and separated, and washed with 5 mL of acetonitrile, thereby obtaining 2.22 g of Compound 1.
Compound 1: $^1$H-NMR, 400 MHz, $\delta$($CDCl_3$) ppm: 0.45 - 1.58 (28H, m), 1.83 - 1.85 (3H, d), 4.57 - 4.6 (1H, q), 5.89 (1H, s), 6.35 (1H, s), 7.28 - 7.38 (5H, m), 10.78 - 10.82 (1H,br), 11.47- 11.51 (1H, br).

*Synthetic method of compound 2*

5 g of Compound 1 and 1.2 g of 3-mercapto-1-propanol were dissolved in 15 mL of dimethyl acetamide, and then the solution was stirred at room temperature. 1.82 g of 1,8-diazabicyclo[5, 4, 0]-7-undecene (DBU) was dropped into the mixture, and the resultant mixture was stirred at the room temperature for 1 hour. Thereafter, the reaction liquid was poured into 200 mL of aqueous hydrochloric acid solution, and the mixture was extracted with 50 mL of ethyl acetate. The organic phase was then dehydrated with 5 g of magnesium sulfate, and was filtered. The filtrate was concentrated to dryness. The residue was dispersed and washed with acetonitrile, and a solid was filtered and separated. The solid was washed with 5 mL of acetonitrile, thereby obtaining 3.51 g of Compound 2.
Compound 2: $^1$H-NMR, 400 MHz, $\delta$($CDCl_3$) ppm: 0.45 - 1.29 (28H, m), 1.55 - 1.61 (3H, d), 1.84 - 1.92 (2H, m), 2.76 - 2.82 (2H, t), 3.56 - 3.71 (1H, q), 3.73 - 3.8 (2H, q), 5.89 (1H, s), 6.33 (1H, s), 7.27 - 7.38 (5H, m), 10.78 - 10.82 (1H, br), 11.36 - 11.42 (1H, br).

*Synthesis of compound 3*

30 g of Compound 2 and 0.1 g of nitrobenzene were dissolved in 30 mL of dimethyl acetamide, and 14.1 g of methacrylic acid chloride was dropped therein and the mixture was stirred at room temperature for 4 hours. The reaction liquid was added to 1.2 L of water, and was neutralized with 30 g of sodium hydrogencarbonate. The resultant liquid was extracted with 500 mL of ethyl acetate. The organic phase was then dehydrated with 30 g of magnesium sulfate, and was filtered. The filtrate was concentrated to dryness. The residue was dispersed and washed with 100 mL of acetonitrile, and a solid was filtered and separated. The solid was washed with 30 mL of acetonitrile, thereby obtaining 24.6 g of Compound 3.
Compound 3: $^1$H-NMR, 400 MHz, $\delta$($CDCl_3$) ppm: 0.47 - 1.27 (28H, m), 1.57 - 1.59 (3H, d), 1.9 - 1.93 (3H, s), 1.93 - 2.06 (2H, m), 2.66 - 2.76 (2H, m), 3.55 - 3.71 (1H, q), 4.2 - 4.25 (2H, t), 5.52 (1H, s), 5.89 (1H, s), 6.08 (1H, s), 6.33 (1H, s), 7.27 - 7.38 (5H, m), 10.78 - 10.82 (1H, br), 11.38 - 11.42 (1H, br).

*Synthesis of compound 4*

5.5 mL of phosphorous oxychloride was dropped into 50 mL of dimethyl formamide while stirring the dimethyl formamide at 0°C and the mixture was stirred for 10 minutes. 15 g of Compound 1 was added thereto and the mixture was stirred at room temperature for 2.5 hours. The reaction liquid was poured into 1.5 L of water, and then the resultant liquid was neutralized with 7.2 g of sodium hydroxide. 150 mL of methanol was then poured therein, and the mixture was stirred for 2 hours. The crystal was filtered once, and was dispersed and washed with 150 mL of methanol again, thereby obtaining 8 g of Compound 4.
Compound 4: $^1$H-NMR, 400 MHz, $\delta$($CDCl_3$) ppm: 0.45 - 1.57 (28H, m), 1.81 - 1.83 (3H, d), 4.44 - 4.5 (1H, q), 5.88 (1H, s), 7.28 - 7.37 (5H, m), 9.06 (1H, s), 10.78 - 10.82 (1H, br), 11.47 - 11.51 (1H, br).

*Synthesis of compound 5*

19.6 g of Compound 4 and 8.34 g of thiomalic acid were added to 150 mL of dimethyl acetamide, and the mixture was stirred at room temperature. 28 g of DBU was then dropped therein, and the mixture was stirred at room temperature for 2 hours. The reaction liquid was poured into 1.5 L of water, and the obtained crystal was filtered and separated, and was dried under deduced pressure, thereby obtaining 17.5 g of Compound 5.
Compound 5: $^1$H-NMR, 400 MHz, δ($CDCl_3$) ppm: 0.45 - 1.59 (28H, m), 1.81 - 1.83 (3H, d), 1.84 - 1.87 (2H, d), 2.93 - 2.97 (1H, t), 4.56 - 4.61 (1H, q), 5.91 (1H, s), 7.28 - 7.37 (5H, m), 9.06 (1H, s), 10.92 - 10.96 (1H, br), 11.12 - 11.19 (1H, br).

*Synthesis of compound 6*

12.9 g of Compound 5 and 50 mL of acetic anhydride were stirred at room temperature, and then 11.4 g of trifluoroacetic acid was dropped therein. Subsequently, 12.5 g of Compound 3 was added thereto, and the reaction solution was stirred at room temperature for 4 hours. 1 L of water, 60 g of sodium hydrogencarbonate and ethyl acetate were stirred at room temperature, and the reaction solution was slowly poured therein to neutralize the reaction liquid. The organic phase was made acidic with an aqueous hydrochloric acid, and washed with saturated sodium chloride solution. The organic phase was then dried with sodium sulfate, and concentrated under reduced pressure. The residue was purified with column chromatography, and concentrated under reduced pressure, thereby obtaining 8.7 g of Compound 6.
Compound 6: $^1$H-NMR, 400 MHz, δ (DMSO-$d_6$) ppm: 0.92 - 4.09 (76H, m), 5.24 - 5.28 (2H, br), 5.6 (1H, s), 5.98 (1H, s), 6.57 (1H, s), 7.28 - 7.45 (10H, m), 10.62 - 10.86 (2H, br), 12.02 - 12.15 (1H, m).

*Synthesis of exemplary compound a-9*

17.6 g of Compound 6 and 200 mL of methanol were stirred at room temperature, 3.25 g of zinc acetate dihydrate was added thereto, and then the mixture was stirred for 2.5 hours. Thereafter, 200 mL of water was added to the reaction liquid. The precipitated crystal was filtered and dried, thereby obtaining 16.3 g of Exemplary Compound a-9.
Exemplary Compound a-9: $^1$H-NMR, 400 MHz, δ (DMSO-$d_6$) ppm: 0.88 - 4.41 (76H, m), 5.72 - 5.8 (2H, br), 5.82 (1H, s), 6.04 (1H, s), 6.88 (1H, s), 7.28 - 7.58 (10H, m), 10.41 - 10.49 (2H, br).
Specific examples of the colorant monomers represented by Formula (1) include the following.

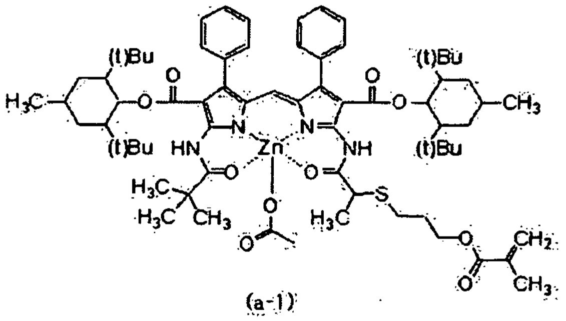
(a-1)

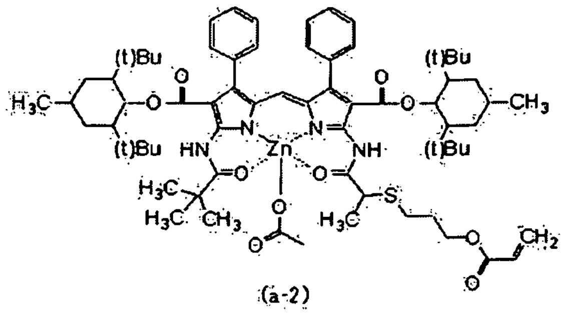
(a-2)

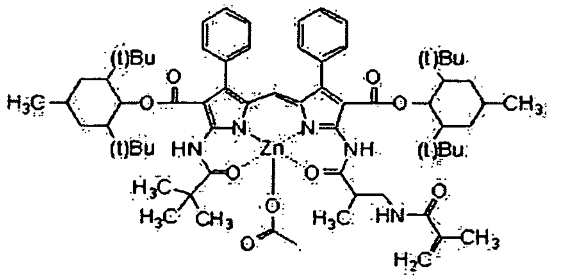
(a-3)

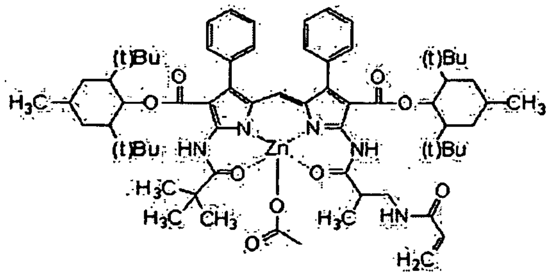
(a-4)

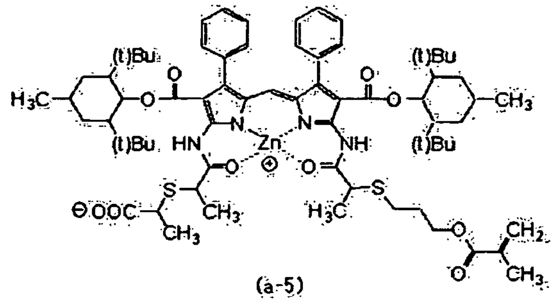

(a-5)

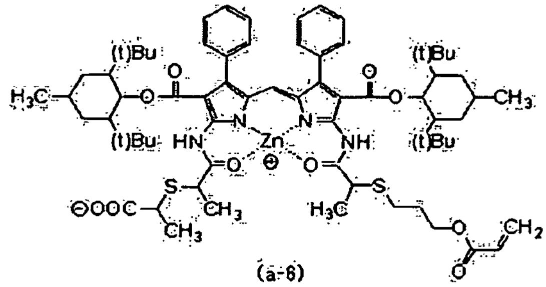

(a-6)

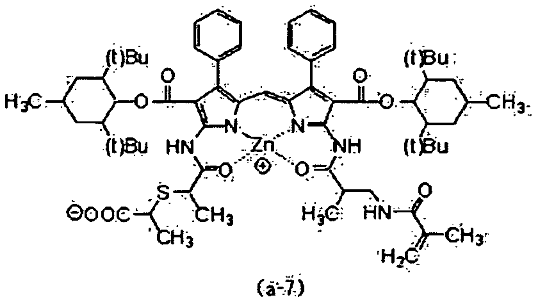

(a-7)

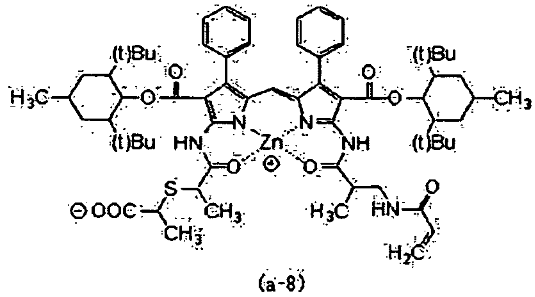

(a-8)

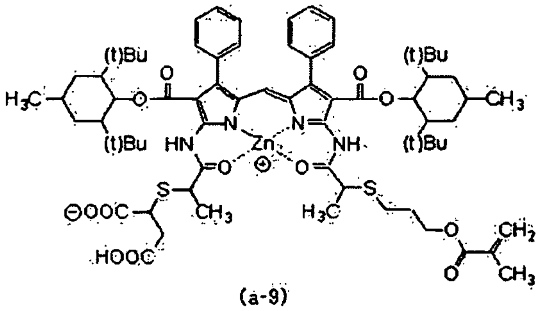

(a-9)

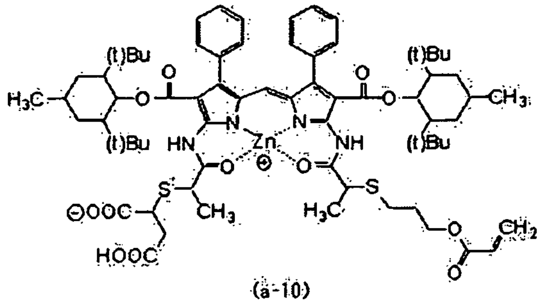

(a-10)

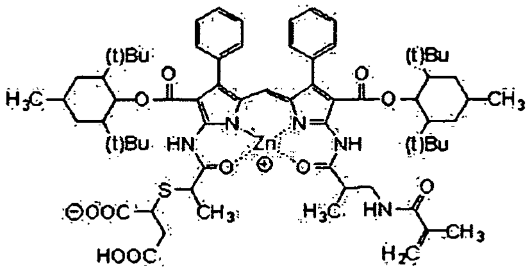

(a-11)

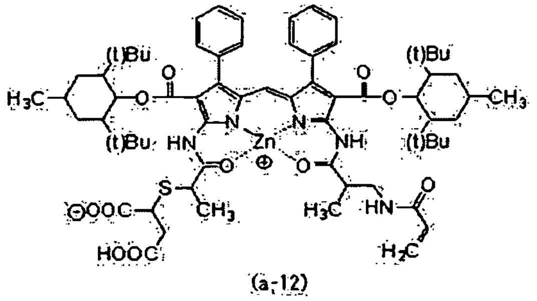

(a-12)

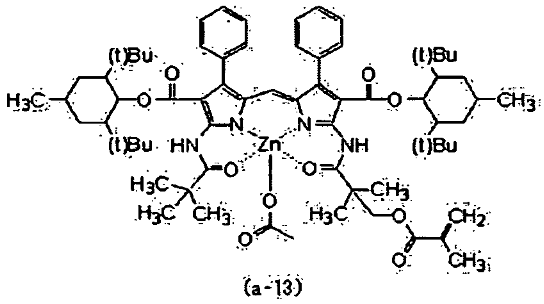

(a-13)

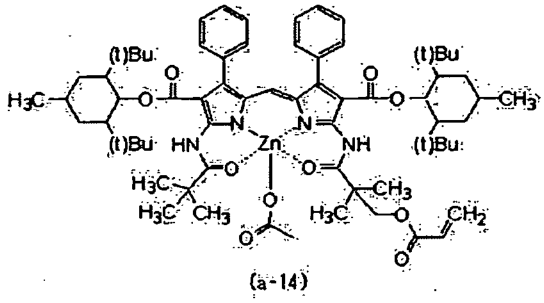

(a-14)

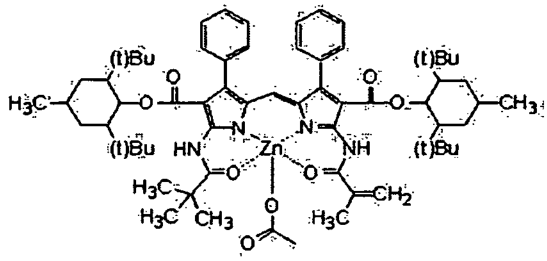

(a-15)

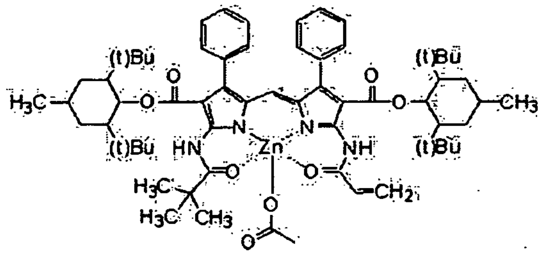

(a-16)

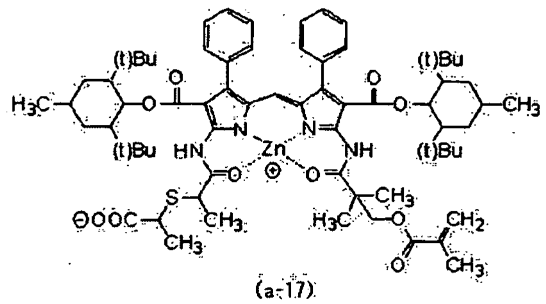

(a-17)

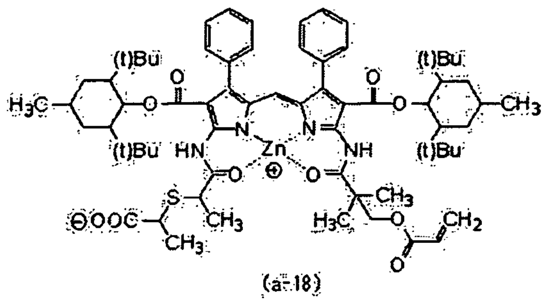

(a-18)

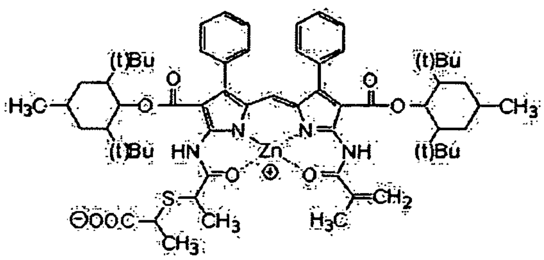

(a-19)

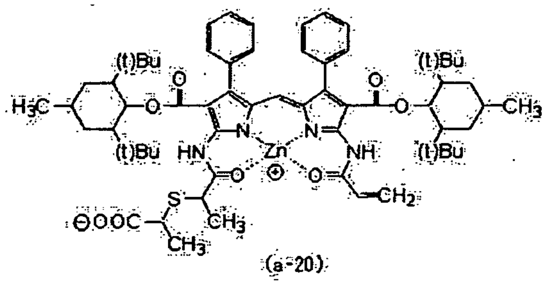

(a-20)

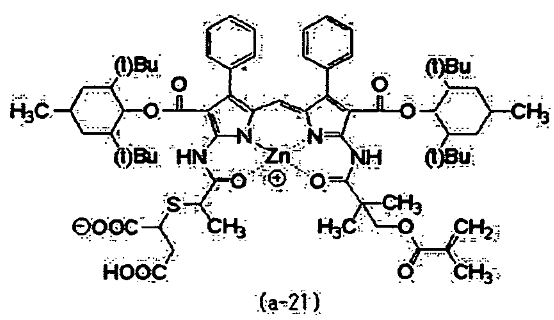

(a-21)

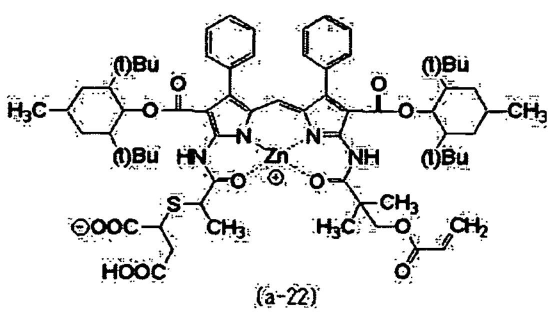

(a-22)

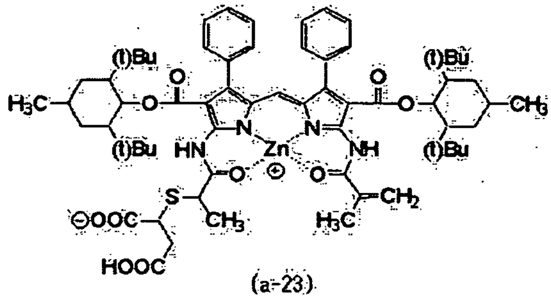

(a-23)

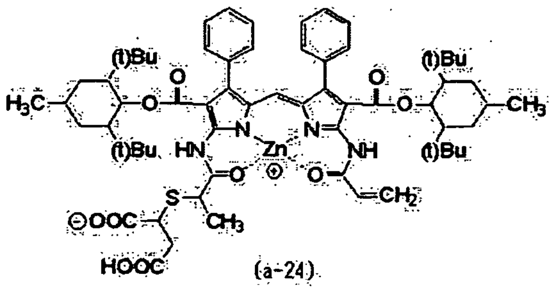

(a-24)

*Exemplary compound a-1*

$^1$H-NMR, 400 MHz, δ ($CDCl_3$) ppm: 0.2 - 2.1 (78H, m), 3.7 - 3.8 (1H, q), 4.15 - 4.28 (2H, t), 5.52 (1H, s), 5.85 (2H, br), 6.08 (1H, s), 6.25 (1H, s), 7 - 7.32 (10H, m), 11.49 (2H, s).

*Exemplary compound a-2*

$^1$H-NMR, 400 MHz, δ ($CDCl_3$) ppm: 0.2 - 2.4 (75H, m), 3.7 - 3.8 (1H, q), 3.87 - 3.91 (1H, m), 4.15 - 4.28 (2H, t), 5.52 (1H, d), 5.8 (2H, m), 6.03 (1H, d), 6.4 (1H, s), 7.02 - 7.42 (10H, m), 10.77 (2H, s).

*Exemplary compound a-3*

$^1$H-NMR, 400 MHz, δ ($CDCl_3$) ppm: 0.21 - 2.33 (74H, m), 3.2 - 3.4 (1H, q), 3.58 - 3.64 (2H, d), 5.81 (1H, s), 6.11 (2H, br), 6.2 (1H, s), 7.03 - 7.39 (10H, m), 10.66 (2H, br).

*Exemplary compound a-4*

$^1$H-NMR, 400 MHz, δ ($CDCl_3$) ppm: 0.19 - 2.29 (71H, m), 3.12 - 3.34 (1H, q), 3.62 - 3.64 (2H, d), 3.88 - 3.9 (1H, m), 5.66 - 5.69 (1H, d), 6.11 (2H, s), 6.35 - 6.38 (1H, d), 7.03 - 7.39 (10H, m), 10.01 (2H, br).

*Exemplary compound a-5*

$^1$H-NMR, 400 MHz, δ ($CDCl_3$) ppm: 0.2 - 4.7 (78H, m), 5.57 (1H, s), 5.85 (2H, br), 6.1 (1H, s), 6.25 (1H, s), 7 - 7.41 (10H, m), 11.32 (2H, s).

*Exemplary compound a-6*

$^1$H-NMR, 400 MHz, δ ($CDCl_3$) ppm: 0.2 - 4.7 (75H, m), 4.78 - 4.81 (1H, m), 5.21 (1H, m), 5.79 (1H, m), 5.8 (2H, br), 6.41 (1H, s), 7-7.39 (10H, m), 11.76 (2H, s).

*Exemplary compound a-7*

$^1$H-NMR, 400 MHz, δ ($CDCl_3$) ppm: 0.21 - 4.12 (73H, m), 5.73 (1H, s), 6.19 (2H, br), 6.33 (1H, s), 7.03 - 7.39 (10H, m), 10.51 - 10.55 (2H, br).

*Exemplary compound a-8*

$^1$H-NMR, 400 MHz, δ ($CDCl_3$) ppm: 0.21 - 4.59 (71H, m), 5.43 (1H, d), 6.19 (2H, br), 6.59 (1H, d), 7.03 - 7.35 (10H, m), 10.6 - 10.64 (2H, br).

*Exemplary compound a-10*

$^1$H-NMR, 400 MHz, δ ($CDCl_3$) ppm: 0.21 - 4.63 (74H, m), 5.67 - 5.71 (2H, br), 5.74 - 5.76 (1H, m), 6.11 (1H, s), 6.37 - 6.39 (1H, m), 7.27 - 7.53 (10H, m), 10.9 - 10.95 (2H, br).

*Exemplary compound a-11*

$^1$H-NMR, 400 MHz, δ ($CDCl_3$) ppm: 0.21 - 4.09 (70H, m), 5.81 (1H, s), 6.06 (2H, br), 6.25 (1H, s), 6.51 (1H, s), 7.23 - 7.42 (10H, m), 10.31 - 10.65 (2H, br).

*Exemplary compound a-12*

$^1$H-NMR, 400 MHz, δ ($CDCl_3$) ppm: 0.19 - 4.35 (68H, m), 4.92 - 4.94 (1H, m), 5.66 - 5.69 (1H, m), 6.02 - 6.04 (2H, br), 6.39 - 6.41 (1H, m), 7.28 - 7.37 (10H, m), 10.43 - 10.49 (2H, br).

*Exemplary compound a-13*

$^1$H-NMR, 400 MHz, δ ($CDCl_3$) ppm: 0.22 - 4.78 (76H, m), 5.84 (1H, s), 6.26 (2H, br), 6.27 (1H, s), 6.47 (1H, s), 7.24 - 7.44 (10H, m), 10.32 - 10.37 (2H, br).

*Exemplary compound a-14*

$^1$H-NMR, 400 MHz, δ ($CDCl_3$) ppm: 0.2 - 4.98 (74H, m), 5.02 - 5.05 (1H, m), 5.81 - 5.84 (1H, m), 6.02 - 6.04 (2H, br), 6.79 - 6.81 (1H, br), 7.28 - 7.45 (10H, m), 10.78 - 10.81 (2H, br).

*Exemplary compound a-15*

$^1$H-NMR, 400 MHz, δ ($CDCl_3$) ppm: 0.21 - 3.19 (68H, m), 5.81 (1H, s), 6.15 - 6.17 (2H, br), 6.24 (1H, s), 6.54 (1H, s), 7.03 - 7.39 (10H, m), 10.46 - 48 (2H, br).

*Exemplary compound a-16*

$^1$H-NMR, 400 MHz, δ ($CDCl_3$) ppm: 0.19 - 2.29 (56H, m), 3.88 - 3.9 (1H, m), 5.69 - 5.71 (1H, m), 6.24 (2H, br), 6.35 - 6.38 (1H, m), 6.69 (1H, s), 7.25 - 7.47 (10H, m), 10.82 - 7.85 (2H, br).

*Exemplary compound a-17*

$^1$H-NMR, 400 MHz, δ ($CDCl_3$) ppm: 0.2 - 4.7 (78H, m), 5.57 (1H, s), 5.85 (2H, br), 6.1 (1H, s), 6.25 (1H, s), 7 - 7.41 (10H, m), 11.32 (2H, s).

*Exemplary compound a-18*

$^1$H-NMR, 400 MHz, δ ($CDCl_3$) ppm: 0.21 - 4.45 (72H, m), 4.93 - 4.95 (1H, m), 5.21 - 5.22 (1H, m), 5.69 - 5.71 (1H, m), 5.83 - 5.85 (2H, br), 6.89 (1H, s), 7.24 - 7.41 (10H, m), 10.76 - 10.79 (2H, s).

*Exemplary compound a-19*

$^1$H-NMR, 400 MHz, δ ($CDCl_3$) ppm: 0.21 - 4.56 (67H, m), 5.98 (1H, s), 6.03 - 6.05 (2H, br), 6.34 (1H, s), 6.47 (1H, s), 7.03 - 7.39 (10H, m), 10.66 (2H, br).

*Exemplary compound a-20*

$^1$H-NMR, 400 MHz, δ ($CDCl_3$) ppm: 0.21 - 4.59 (65H, m), 5.71 - 5.73 (1H, m), 6.22 -6.24 (2H, br), 6.45 - 6.47 (1H, m), 6.67 (1H, s), 7.23 - 7.51 (10H, m), 10.73 - 10.76 (2H, br).

*Exemplary compound a-21*

$^1$H-NMR, 400 MHz, δ ($CDCl_3$) ppm: 0.2 - 4.73 (72H, m), 5.59 (1H, s), 5.75 - 5.77 (2H, br), 6.08 (1H, s), 6.22 (1H, s), 7.21 - 7.46 (10H, m), 11.32 - 11.36 (2H, br).

*Exemplary compound a-22*

$^1$H-NMR, 400 MHz, δ ($CDCl_3$) ppm: 0.21 - 4.45 (73H, m), 5.03 - 5.06 (1H, m), 5.55 - 5.57 (1H, m), 5.84-5.86

(2H, br), 5.96 - 5.99 (1H, m), 6.79 (1H, s), 7.24 - 7.49 (10H, m), 11.04 - 11.07 (2H, br).

*Exemplary compound a-23*

$^1$H-NMR, 400 MHz, δ ($CDCl_3$) ppm: 0.21 - 4.56 (66H, m), 6.21 (1H, s), 6.23 - 6.25 (2H, br), 6.69 (1H, s), 6.77 (1H, s), 7.02 - 7.46 (10H, m), 10.31 - 35 (2H, br).

*Exemplary compound a-24*

$^1$H-NMR, 400 MHz, δ ($CDCl_3$) ppm: 0.21 - 4.96 (64H, m), 5.75 - 5.77 (1H, m), 6.21 - 6.24 (2H, br), 6.45 - 6.47 (1H, m), 6.5 (1H, s), 7.23 - 7.5 (10H, m), 10.7 - 10.74 (2H, br).

*Synthesis example of colorant multimer: Synthesis of exemplary compound J-1*

Exemplary compound J-1 was synthesized according to the following synthetic scheme.

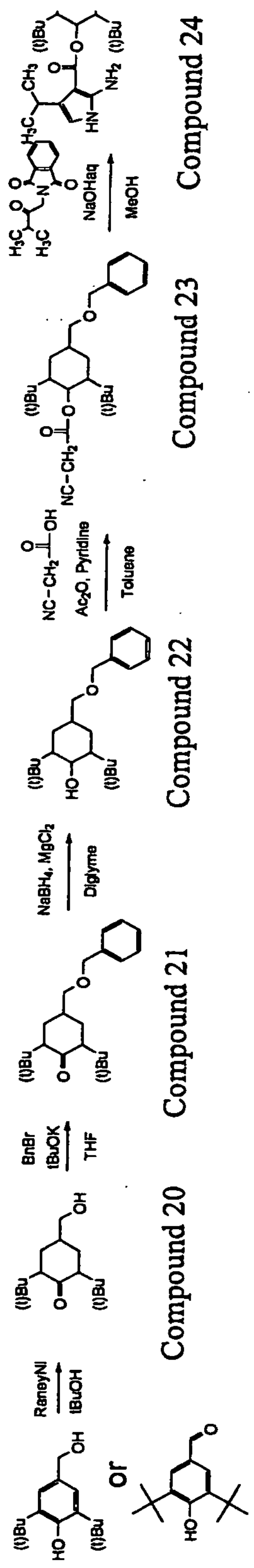


or

Compound 20

Compound 21

Compound 22

Compound 23

Compound 24

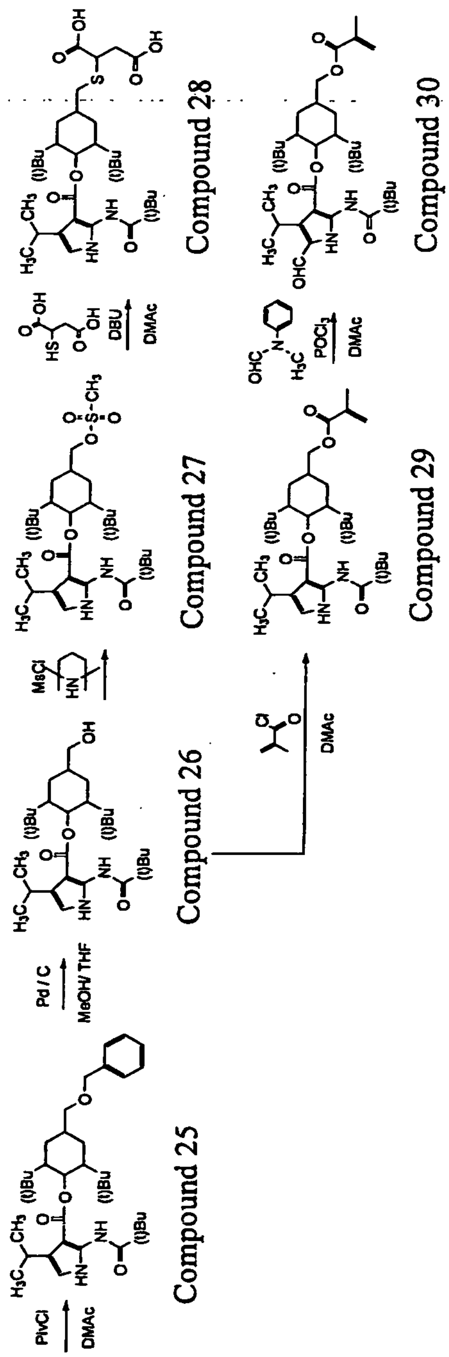


Compound 25

Compound 26

Compound 27

Compound 28

Compound 29

Compound 30

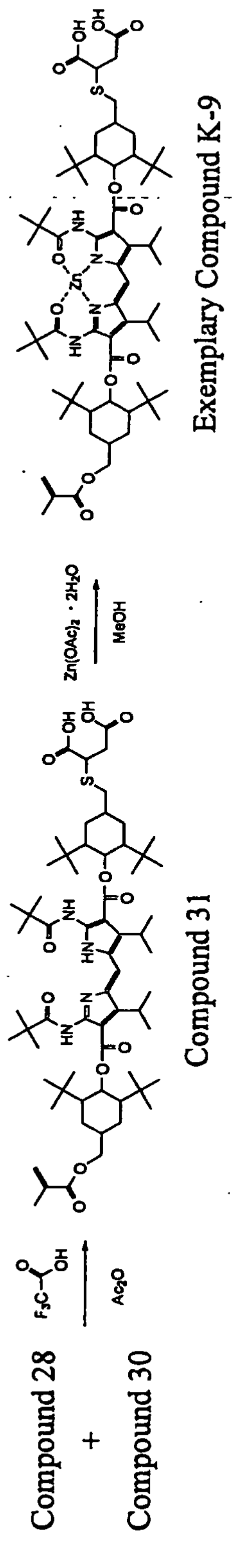


Compound 28 + Compound 30

Compound 31

Exemplary Compound K-9

*Synthesis of compound 7*

206.4 g of isopropyl methyl ketone was stirred in 1 L of methanol, and then 7 mL of hydrobromic acid (47% to 49% aqueous solution) was added thereto. Subsequently, bromine was dropped into the mixture at 30°C to 34°C over 3 hours. Thereafter, the reaction liquid was stirred at 30°C for 30 minutes. The reaction liquid was neutralized with an aqueous solution of 124 g of sodium hydrogencarbonate in 1.3 L of water. An aqueous solution of 400 g of sodium chloride in 1.3 L of water was then added to the mixture, thereby isolating a liquid reaction product by phase separation.

The isolated reaction product was dropped into a water-cooled solution, in which 222 g of potassium phthalimide was dissolved while stirring in 800 mL of dimethyl acetamide (DMAc), and the mixture was stirred for 4 hours at room

temperature. Thereafter, 720 mL of water was added to the resultant mixture with water-cooling and the precipitated crystal was filtered and separated. The obtained crystal was suspended in 1.5L of toluene, insoluble substances were filtered off, and the filtrate was concentrated, thereby obtaining 100 g of Compound 7.

Compound 7: $^1$H-NMR, 400 MHz, $\delta$ ($CDCl_3$) ppm: 1.21 - 1.23 (6H, d), 2.74 - 2.79 (1H, m), 4.56 (2H, s), 7.72 - 7.74 (2H, d), 7.85 - 7.87 (2H, d).

*Synthesis of compound 8*

Compound 8 was synthesized by the method described in Paragraph [0134] of JP-A No. 2008-292970.

*Synthesis of compound 9*

293 g of Compound 8 and 231 g of Compound 7 were stirred in 1.4 L of methanol under nitrogen gas atmosphere. Thereafter, a solution of 88 g of sodium hydroxide in 400 mL of water was dropped therein at room temperature. The reaction mixture was then refluxed for 8 hours, and cooled to room temperature. The precipitated crystal was filtered and separated, and washed with 100 mL of methanol, thereby obtaining 299 g of Compound 9.
Compound 9: $^1$H-NMR, 400 MHz, $\delta$ ($CDCl_3$) ppm: 0.88 - 0.95 (18H, s), 1.00 - 1.03 (3H, d), 1.17 - 1.19 (6H, d), 1.20 - 1.66 (7H, m), 3.38 - 3.43 (1H, m), 5.19 - 5.24 (2H, br), 5.95 (1H, br), 6.00 (1H, s), 7.39 - 7.45 (1H, br).

*Synthesis of compound 10*

80 g of Compound 9 was stirred in 250 mL of DMAc at room temperature, and then 29.2 g of 2-chloropropionyl chloride was dropped therein. The mixture was then stirred at room temperature for 3 hours. The reaction liquid was poured into a mixed liquid of 500 mL of ethyl acetate in 1 L of water, and washed with 500 mL of each of an aqueous saturated sodium bicarbonate solution, water, and saturated sodium chloride solution. The resultant was dried with magnesium sulfate, and concentrated under reduced pressure, thereby obtaining 89.4 g of Compound 10.
Compound 10: $^1$H-NMR, 400 MHz, $\delta$ ($CDCl_3$) ppm: 0.9 (18H, s), 0.96 - 1.01 (3H, d), 1.20 - 1.23 (2H, d), 1.26 - 1.38 (1H, q), 1.53 - 1.68 (6H, m), 1.8 - 1.82 (3H, d), 3.44 - 3.53 (1H, m) 4.5 - 4.57 (1H, q), 6.03 (1H, br), 6.27 (1H, s), 10.4 - 10.45 (1H, br), 11.31 - 11.42 (1H, br).

*Synthesis of compound 11*

372.3 g of Compound 10 and 79.8 g of 3-mercapto-1-propanol were dissolved in 1 L of N-methyl pyrrolidone (NMP), and the mixture was stirred at room temperature. 133.4 g of DBU was dropped into the mixture, and the resultant reaction liquid was stirred at room temperature for 2 hours. Thereafter, the reaction liquid was poured into a mixed liquid of 1.5 L of ethyl acetate and 1.5 L of water, and was washed with 1 L of each of a 1N hydrochloric acid, an aqueous saturated sodium bicarbonate solution, water, and saturated sodium chloride solution, and the organic phase was dehydrated with 50 g of magnesium sulfate. After filtration, the filtrate was evaporated to dryness. The residue was dispersed and washed, and the solid was filtered and separated. The resultant washed with 30 mL of acetonitrile, thereby obtaining 317 g of Compound 11.
Compound 11: $^1$H-NMR, 400 MHz, $\delta$ ($CDCl_3$) ppm: 0.9 (18H, s), 1.02 - 1.03 (3H, d), 1.21 - 1.22 (6H, d), 1.23 - 1.41 (5H, m), 1.56 - 1.57 (3H, d), 1.6 - 1.63 (2H, br), 1.79 - 1.89 (2H, m), 2.72 - 2.78 (2H, t), 3.43 - 3.47 (1H, m), 3.51 - 3.55 (1H, q), 3.78. - 3.73 (2H, q), 6.0 (1H, s), 6.23 (1H, s), 10.51 - 10.55 (1H, br), 11.21 - 11.29 (1H, br).

*Synthesis of compound 12*

30 g of Compound 11 and 0.1 mL of nitrobenzene were dissolved in 250 mL of dimethyl acetamide, and 14.1 g of methacrylic acid chloride was dropped therein. The mixture was then stirred at room temperature for 2 hours. The reaction liquid was then added to a solution of 1.5 L of ethyl acetate and 1.5 L of water, and was extracted in an organic phase. The organic phase was washed twice with 400 mL of each of a 1 N hydrochloric acid, an aqueous saturated sodium bicarbonate solution, a saturated sodium chloride solution, and water. The organic phase was dehydrated with 30 g of magnesium sulfate, and was filtrated. The filtrate was concentrated to dryness, thereby obtaining 27.9 g of Compound 12.
Compound 12: $^1$H-NMR, 400 MHz, $\delta$ ($CDCl_3$) ppm: 0.9 (18H, s), 1.02 - 1.03 (3H, d), 1.21 - 1.22 (6H, d), 1.23 - 1.41 (5H, m), 1.56 - 1.57 (3H, d), 1.6 - 1.63 (2H, br), 1.9 (3H, s) 1.93 - 2.02 (2H, m), 2.6 - 2.73 (2H, t), 3.42 - 3.5 (1H, m), 3.51 - 3.56 (1H, q), 4.06 - 4.12 (1H, q), 4.14 - 4.23 (2H, t), 5.5 (1H, s), 6.11 - 6.15 (2H, m), 6.23 (1H, s), 10.42 - 10.48 (1H, br), 11.28 - 11.32 (1H, br).

*Synthesis of compound 13*

263.6 g of Compound 9 was stirred in 800 mL of DMAc at room temperature, and then 108.5 g of 5-chlorovaleric acid chloride was dropped therein over 2 hours while cooling with ice. The reaction liquid was stirred at room temperature for 3 hours. The reaction liquid was poured into 18 L of water, and the precipitated crystal was filtered and separated. The obtained crystal was dispersed and washed with 1 L of acetonitrile, thereby obtaining 313 g of Compound 13.
Compound 13: $^1$H-NMR, 400 MHz, δ ($CDCl_3$) ppm: 0.9 (18H, s), 0.96 - 1.01 (3H, d), 1.20 - 1.75 (17H, m), 1.76 - 2.00 (2H, m), 2.41 - 2.53 (2H, m), 3.4 - 3.58 (1H, m), 3.54 - 3.60 (2H, m), 6.0 (1H, br), 6.22 (1H, s), 10.55 (2H, br).

*Synthesis of compound 14*

75 g of phosphorous oxychloride kept at 5°C or lower was dropped into a solution of 66.2 g of N-methylformanilide and 330 mL of acetonitrile while stirring at 0°C, and then the reaction liquid was stirred for one hour. Thereafter, 202 g of Compound 13 was added to the reaction liquid, stirred at a room temperature for 3 hours, and then stirred at 40°C for one hour. The reaction liquid was then poured into 2 L of water, and the precipitated crystal was filtered. The resultant was rinse-washed with 500 mL of water and 500 mL of methanol, thereby obtaining 181 g of Compound 14.
Compound 14: $^1$H-NMR, 400 MHz, δ ($CDCl_3$) ppm: 0.9 (18H, s), 0.96 - 1.21 (3H, d), 1.22 - 1.76 (17H, m), 1.78 - 2.22 (2H, m), 2.45 - 2.55 (2H, m), 3.4 - 3.58 (1H, m), 3.54 - 3.60 (2H, m), 6.3 (1H, br), 9.88 (1H, s), 11.09 (1H, br), 11.47 (1H, br).

*Synthesis of compound 15*

300 g of Compound 14 and 129 g of thiomalic acid were added to 3 L of dimethyl acetamide, and the mixture was stirred at room temperature. 434 g of DBU was then dropped into the mixture over 30 minutes with the temperature kept at 30°C or below. Thereafter, the reaction liquid was stirred at 60°C for 5 hours, and a solution of 103 g of sodium hydroxide in 600 mL of water was dropped into the reaction liquid over 10 minutes. The resultant mixture was cooled to room temperature, and the precipitated crystal was filtered. The resultant was rinse-washed with 1 L of ethyl acetate and then with 200 mL of methanol cooled to 5°C. The obtained crystal was dispersed in a solution of 1 L of ethyl acetate and 1 L of water, and then 220 mL of concentrated hydrochloric acid was added to the dispersion to dissolve the crystal in an organic phase. The organic phase was washed with 1 L of water twice, and 1 L of saturation sodium chloride solution once. The resultant was dried with 80 g of magnesium sulfate, and was filtered. The filtrate was concentrated under reduced pressure, thereby obtaining 255 g of Compound 15.
Compound 15: $^1$H-NMR, 400 MHz, δ ($CDCl_3$) ppm: 0.9 (18H, s), 0.96 - 1.21 (3H, d), 1.22 - 1.76 (17H, m), 1.78 - 2.22 (2H, m), 2.45 - 2.65 (4H, m), 3.35 - 3.61 (2H, m), 3.54 - 3.60 (2H, m), 6.3 (1H, br), 9.92 (1H, s), 11.11 (1H, br), 11.81 (1H, br).

*Synthesis of compound 16*

8.27 g of Compound 12, 8.92 g of Compound 13 and 45 mL of acetic anhydride were stirred at room temperature, and then 5.39 mL of trifluoroacetic acid was dropped therein while cooling with ice. The resultant mixture was stirred at room temperature for 3 hours. The reaction liquid was dropped into an aqueous solution, which is obtained by stirring 400 mL of water, 60 g of sodium hydrogencarbonate and three drops of pyridine at room temperature, to be neutralized, and the mixture was stirred at room temperature for 3 hours. The precipitated crystal was filtered and separated, and then rinse-washed with water. The resultant was dried with an air blower, thereby obtaining 16 g of Compound 16.
Compound 16: $^1$H-NMR, 400 MHz, δ ($CDCl_3$) ppm: 0.92 (36H, s), 0.96 - 2.0 (44H, m), 2.04 (3H, s), 2.62 - 2.83 (3H, m), 2.97 - 3.56 (7H, m), 4.14 - 4.27 (1H, m), 5.0 (1H, br), 6.05 (3H, br), 7.52 - 7.56 (1H, br), 10.25 - 10.89 (1H, br), 11.34 - 11.56 (1H, br).

*Synthesis of exemplary compound J-1*

12.6 g of Compound 16, 150 mL of methanol, and 75 mL of tetrahydrofuran were stirred at room temperature, and then 2.2 g of zinc acetate dihydrate was added thereto and stirred for 2 hours. Thereafter, 500 mL of water was added to the reaction liquid, and the precipitated crystal was filtered. The resultant was dried with air blow, thereby obtaining 13 g of Exemplary Compound J-1.
Exemplary Compound J-1: $^1$H-NMR, 400 MHz, δ (DMSO-$d_6$) ppm: 0.97 (36H, s), 0.99 - 2.05 (47H, m), 2.07 - 3.05 (8H, m), 4.04 - 4.4 (3H, m), 5.53 (1H, br), 6.05 - 6.12 (3H, br), 8.8 (1H, s), 10.97 - 11.18 (1H, br), 11.91 - 12.01 (1H, br).

*Synthesis example of colorant multimer: Synthesis of exemplary compound K-9*

Exemplary compound K-9 was synthesized according to the following synthetic scheme.

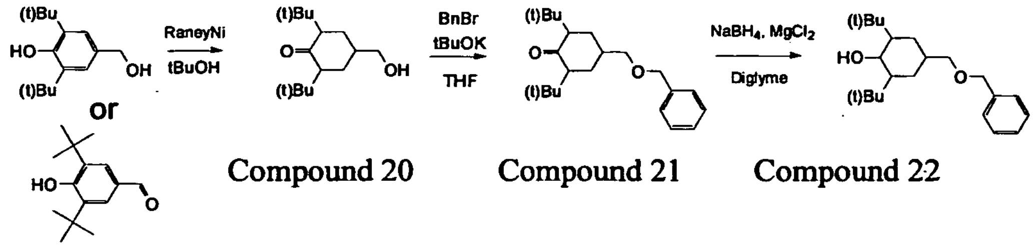


or

Compound 20 Compound 21 Compound 22

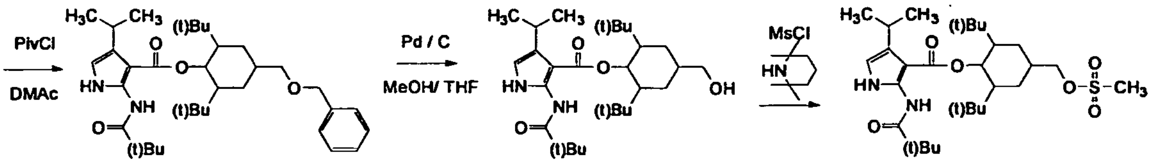


Compound 25 Compound 26 Compound 27

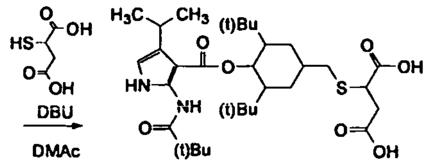


Compound 28

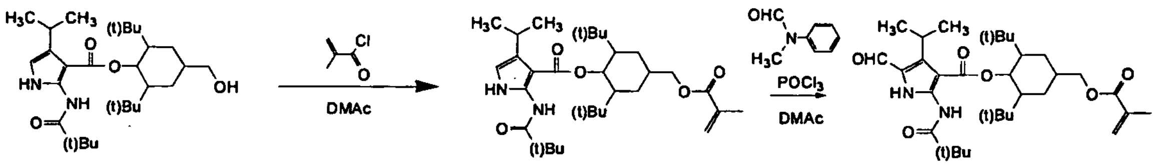


Compound 26 Compound 29 Compound 30

Compound 28
+
Compound 30

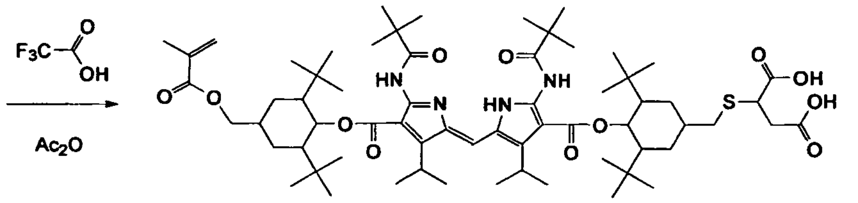


Compound 31

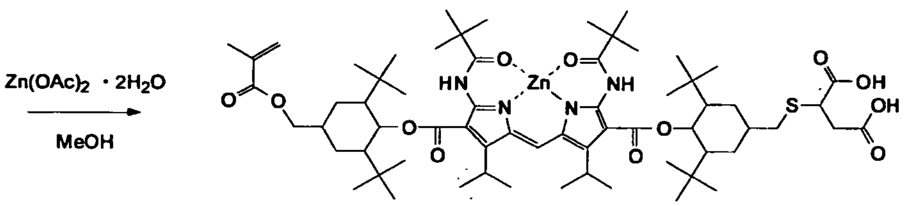


Exemplary compound K-9

Here, 2,6-di-tert-butyl-4-alkylcyclohexanols used for synthesizing the following Exemplary compounds K-1 to K-14 were obtained, for example, as described in Journal of American Chemistry, Vol.79, (1957), pp 5019-5023, in which 2,6-di-tert-butylcyclohexanone obtained by catalytic hydrogenation of 2,6-di-tert-butylphenol using a nickel catalyst is

further reduced with lithium aluminum hydride, thereby obtaining 2,6-di-tert-butylcyclohexanol; or as described in Japanese Patent No. 4065576, in which the reduction with sodium borohydride is conducted in the presence of diglyme as a reaction solvent and magnesium chloride or aluminum chloride:

*Synthesis of compound 20*

73.6 g of 2,6-di-tert-butyl-4-(hydroxymethyl) phenol, 12.5 g of Raney nickel and 340 mL of tert-butyl alcohol were placed in a 1 L stainless-steel autoclave. The autoclave was then sealed and the atmosphere in the autoclave was displaced with hydrogen gas such that an initial hydrogen pressure is 86.7 kg/cm$^2$ at 25°C. Subsequently, the mixture was stirred for 1 hour and 50 minutes at 125°C.
The autoclave was cooled to a room temperature, and then the reaction product was collected and filtered to remove the catalyst. The obtained reaction product was quantified with a gas chromatography, thereby obtaining 74.8 g of Compound 20 having a purity of 90%. The structure of the Compound 20 was confirmed by NMR.
Compound 20: $^1$H-NMR, 400 MHz, $\delta$ ($CDCl_3$) ppm: 0.981 (18H, s), 1.18 - 1.3 (2H, m), 1.96 - 2.09 (1H, m), 2.17 - 2.27 (4H, m), 3.52 - 3.58 (2H, t).
In a manner similarly to the above, the Compound 20 can be obtained using 3,5-di-tert-butyl-4-hydroxymethyl benzaldehyde as a starting material.

*Synthesis of compound 21*

74.8 g of the obtained Compound 20 was dissolved in 300 mL of tetrahydrofuran at 0°C or lower, and then38.4 g of tert-butoxypotassium was added thereto. Thereafter, 58.5 g of benzyl bromide was dropped into the mixture such that the temperature of the mixture is kept at 10°C or lower, and the resultant was stirred for 1 hour in an ice bath. The completion of the reaction was confirmed with a thin-layer chromatography. Subsequently, 1 L of water was poured into the reaction liquid, and extracted with ethyl acetate. The organic phase was then dried with magnesium sulfate, and the filtrate was concentrated under reduced pressure. The residue was purified with column chromatography, thereby obtaining 95 g (yield: 92.4%) of Compound 21.
Compound 21: $^1$H-NMR, 400 MHz, $\delta$ ($CDCl_3$) ppm: 0.97 (18H, s), 1.19 - 1.3 (2H, m), 2.08 - 2.28 (5H, m), 3.31 - 3.35 (2H, d), 4.52 (2H, s), 7.33 - 7.41 (5H, m).

*Synthesis of compound 22*

85 g (257mmol) of the obtained Compound 21 was dissolved in 250 mL of diglyme, and then 9.7 g (257 mmol) of sodium borohydride was added thereto. Thereafter, 12.1 g (127 mmol) of magnesium chloride was added to the mixture at 25°C, and then the mixture was stirred for 11 hours at 100°C. The completion of the reaction was confirmed with a thin-layer chromatography, and then the reaction liquid was cooled to a room temperature.
Subsequently, 20 mL of ethyl acetate and 20 mL of methanol were slowly added to the reaction liquid, and then a solution obtained by diluting 40 mL of concentrated hydrochloric acid with 500 mL of water, and 300 mL of ethyl acetate were added thereto. The mixture was stirred for 6 hours to extract. The organic phase was then dried with magnesium sulfate, and the filtrate was concentrated under reduced pressure. The residue was purified with column chromatography, thereby obtaining 83 g of Compound 22.
Compound 22: $^1$H-NMR, 400 MHz, $\delta$ ($CDCl_3$) ppm: 0.97 (18H, s), 1.02 - 1.18 (2H, m), 1.57 - 1.77 (5H, m), 3.35 - 3.39 (2H, d), 4.4 - 4.44 (1H, br), 4.53 - 4.57 (2H, s), 7.33 - 7.43 (5H, m).

*Synthesis of compound 26*

24 g (42.3 mmol) of Compound 25 was dissolved in 50 mL of methanol and 50 mL of tetrahydrofuran, and then 2.4 g of palladium-modified carbon (5%, wet type) manufactured by Wako Pure Chemical Industries, Ltd. was added thereto, displaced with hydrogen gas, and stirred for 2 hours at a room temperature. The completion of the reaction was confirmed with a thin-layer chromatography. The catalyst was filtered using celite, and the resultant was concentrated under reduced pressure, thereby obtaining 18.5 g (yield: 92%) of Compound 26.
Compound 26: $^1$H-NMR, 400 MHz, $\delta$ ($CDCl_3$) ppm: 0.912 - 1.01 (20H, m), 1.12 - 1.47 (16H, m), 1.47 - 1.92 (4H, m), 3.32 - 3.54 (1H, m), 3.56 - 3.72 (2H, d), 6.02 - 6.12 (1H, s), 6.18 - 6.27 (1H, s), 10.48 - 10.63 (1H, br), 10.82 - 10.97 (1H, br).
Compounds 23 to 25, Compounds 27 to 31, and Exemplary Compound K-9 in the above scheme can be synthesized by utilizing reactions similar to those shown in the above scheme, and cab be obtained similarly to the above by reference to the above scheme and the synthesis methods of Compounds 20-22 and 26. Here, in the synthesis of the Compound 20, tert-butyl alcohol is used as a solvent for reaction. This is intended to obtain the effect of suppressing the hydrogenolysis caused by benzyl alcohol as described in "Catalytic hydrogenation reaction, Application for organic

synthesis", Tokyo Kagaku Dojin, p255 (Bull. Chem. Soc. Jpn., 37, 887 (1964)). It is confirmed that the yield is improved and the reaction time is reduced when tert-butyl alcohol is used.

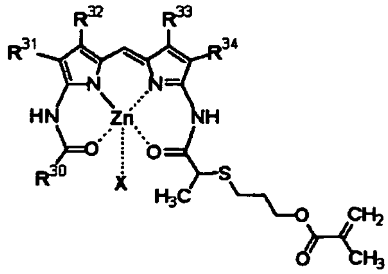

| Exemplary Compound | $R^{30}$ | $R^{31}$ | $R^{32}$ | $R^{33}$ | $R^{34}$ | X |
|---|---|---|---|---|---|---|
| A-1 | $-C_4H_9(t)$ | 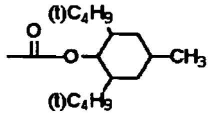 | 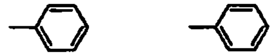 | | 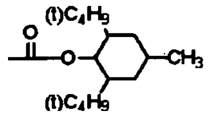 | 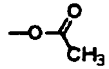 |
| A-2 | $-C_4H_9(t)$ | 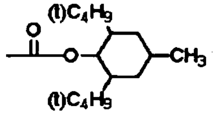 | 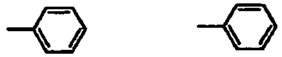 | | 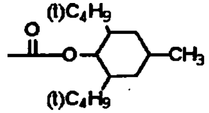 | -Cl |
| A-3 | $-C_4H_9(t)$ | 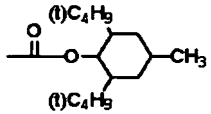 | 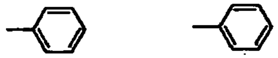 | | 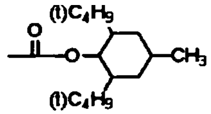 | 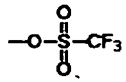 |
| A-4 | $-C_4H_9(t)$ | 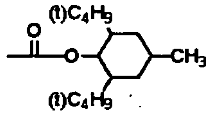 | 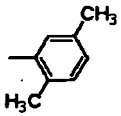 | 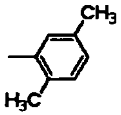 | 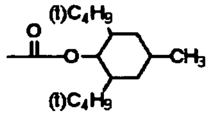 | 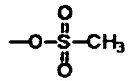 |
| A-5 | 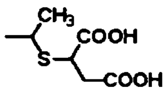 | 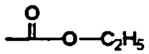 | 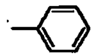 | 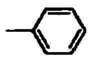 | 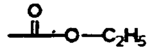 | -Cl |
| A-6 | 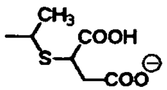 | 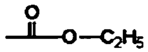 | 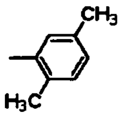 | 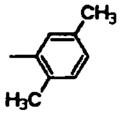 | 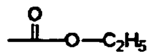 | |
| A-7 | 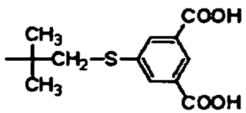 | 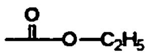 | 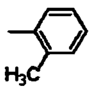 | 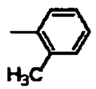 | 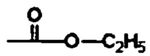 | 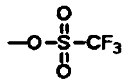 |
| A-8 | $-C_4H_9(t)$ | 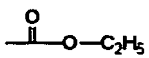 | 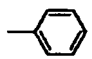 | 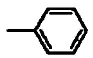 | 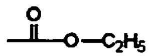 | -Cl |
| A-9 | $-C_4H_9(t)$ | 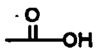 | 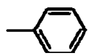 | 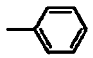 | 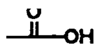 | -F |

(continued)

| Exemplary Compound | $R^{30}$ | $R^{31}$ | $R^{32}$ | $R^{33}$ | $R^{34}$ | X |
|---|---|---|---|---|---|---|
| A-10 | $-C_4H_9(t)$ | 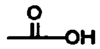 | 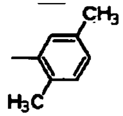 | 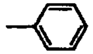 | 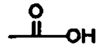 | -Br |
| A-11 | $-C_4H_9(t)$ | 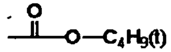 | 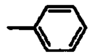 | 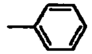 | 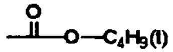 | 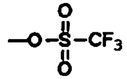 |
| A-12 | 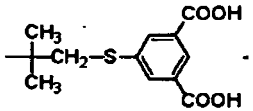 | 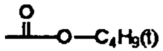 | 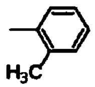 | 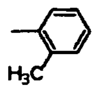 | 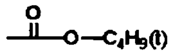 | -Cl |
| A-13 | 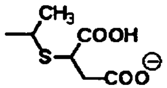 | 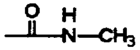 | 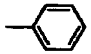 | 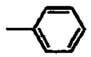 | 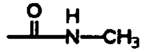 | |
| A-14 | 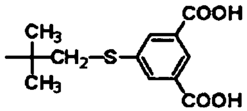 | 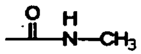 | 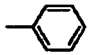 | 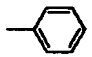 | 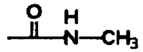 | 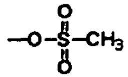 |
| A-15 | 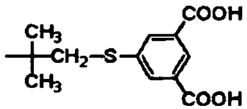 | 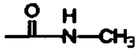 | 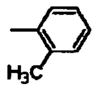 | 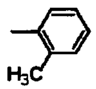 | 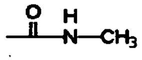 | 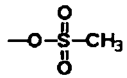 |
| A-16 | 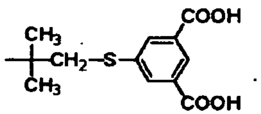 | 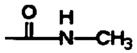 | 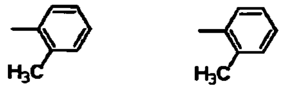 | | 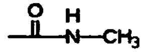 | 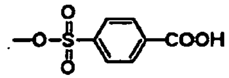 |
| A-17 | 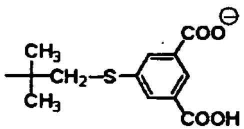 | 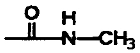 | 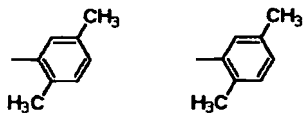 | | 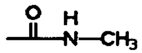 | |

(continued)

| Exemplary Compound | $R^{30}$ | $R^{31}$ | $R^{32}$ | $R^{33}$ | $R^{34}$ | X |
|---|---|---|---|---|---|---|
| A-18 | 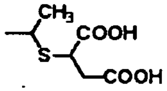 | 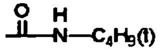 | 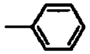 | 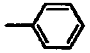 | 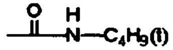 | -Cl |
| A-19 | $-C_4H_9(t)$ | 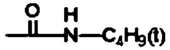 | 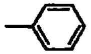 | 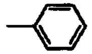 | 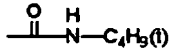 | -Cl |
| A-20 | $-C_4H_9(t)$ | 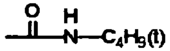 | 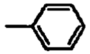 | 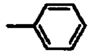 | 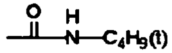 | 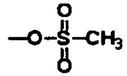 |

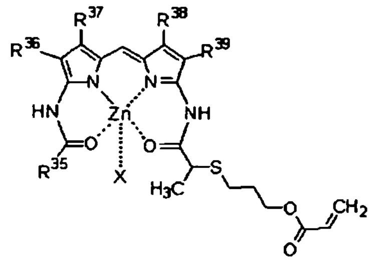

| Exemplary Compound | $R^{35}$ | $R^{36}$ | $R^{37}$ | $R^{38}$ | $R^{39}$ | X |
|---|---|---|---|---|---|---|
| B-1 | $-C_4H_9(t)$ | 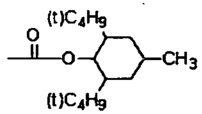 | 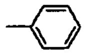 | 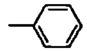 | 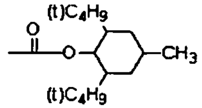 | 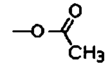 |
| B-2 | $-C_4H_9(t)$ | 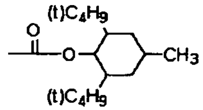 | 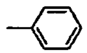 | 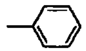 | 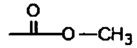 | -Cl |
| B-3 | $-C_4H_9(t)$ | 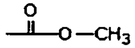 | 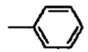 | 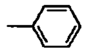 | 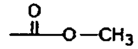 | 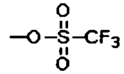 |
| B-4 | $-C_4H_9(t)$ | 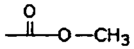 | 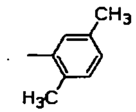 | 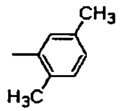 | 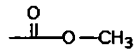 | 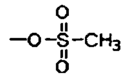 |
| B-5 | 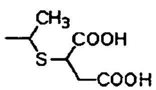 | 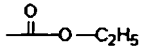 | 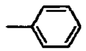 | 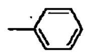 | 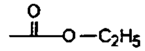 | -Cl |
| B-6 | 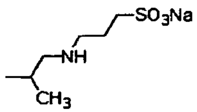 | 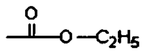 | 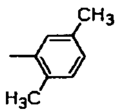 | 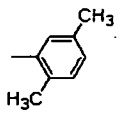 | 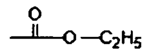 | 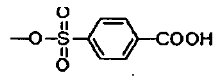 |
| B-7 | 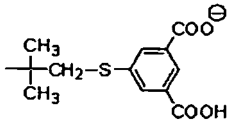 | 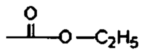 | 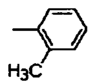 | 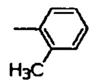 | 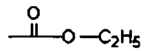 | |
| B-8 | $-C_4H_9(t)$ | 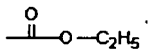 | 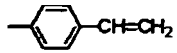 | 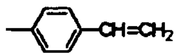 | 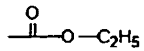 | -Cl |
| B-9 | $-C_4H_9(t)$ | 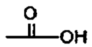 | | | | -F |
| B-10 | $-C_4H_9(t)$ | | | | | -Br |

(continued)

| Exemplary Compound | $R^{35}$ | $R^{35}$ | $R^{37}$ | $R^{38}$ | $R^{38}$ | X |
|---|---|---|---|---|---|---|
| B-11 | $-C_4H_9(t)$ | 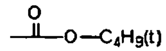 | 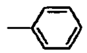 | 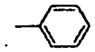 | 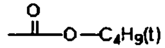 | 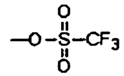 |
| B-12 | 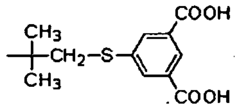 | 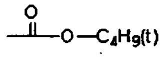 | 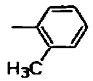 | 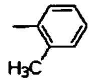 | 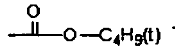 | 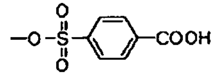 |
| B-13 | 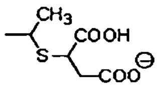 | 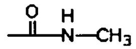 | 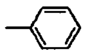 | 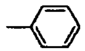 | 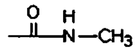 | |
| B-14 | $-C_4H_9(t)$ | 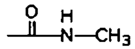 | 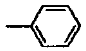 | 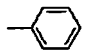 | 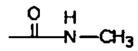 | 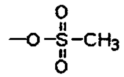 |
| B-15 | 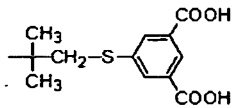 | 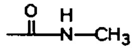 | 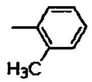 | 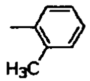 | 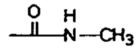 | 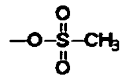 |
| B-16 | 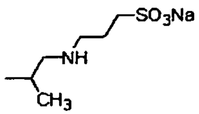 | 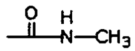 | 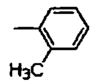 | 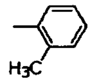 | 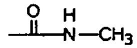 | -Cl |
| B-17 | 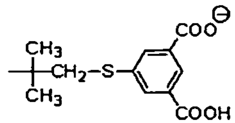 | 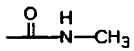 | 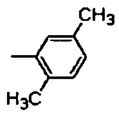 | 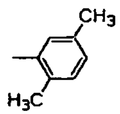 | 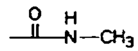 | |
| B-18 | 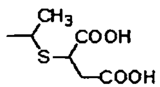 | 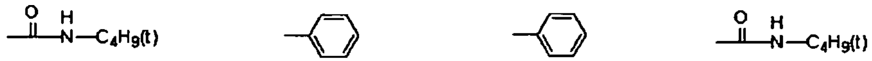 | | | | -Cl |
| B-19 | $-C_4H_9(t)$ | 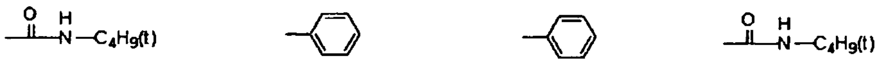 | | | | -Cl |

(continued)

| Exemplary Compound | $R^{35}$ | $R^{35}$ | $R^{37}$ | $R^{38}$ | $R^{38}$ | X |
|---|---|---|---|---|---|---|
| B-20 | $-C_4H_9(t)$ | 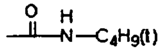 | 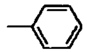 | 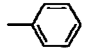 | 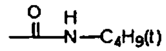 | 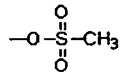 |

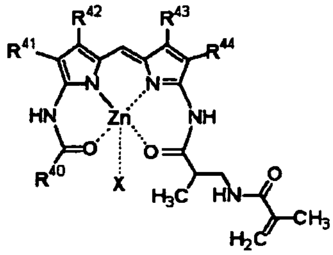

| Exemplary Compound | $R^{40}$ | $R^{41}$ | $R^{42}$ | $R^{43}$ | $R^{44}$ | X |
|---|---|---|---|---|---|---|
| C-1 | $-C_4H_9(t)$ | 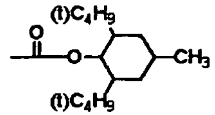 | 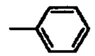 | 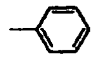 | 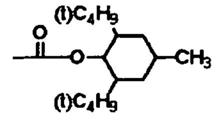 | 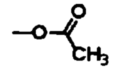 |
| C-2 | $-C_4H_9(t)$ | 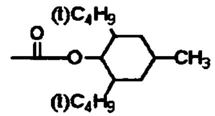 | 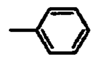 | 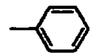 | 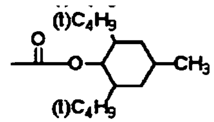 | -Cl |
| C-3 | $-C_4H_9(t)$ | 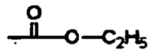 | 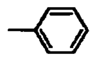 | 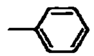 | 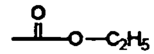 | 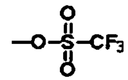 |
| C-4 | $-C_4H_9(t)$ | 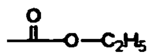 | 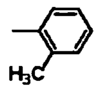 | 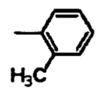 | 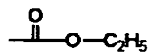 | -Cl |
| C-5 | 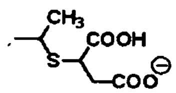 | 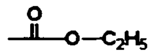 | 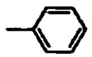 | 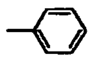 | 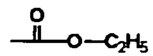 | |
| C-6 | 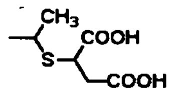 | 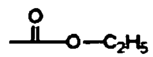 | 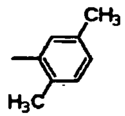 | 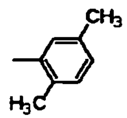 | 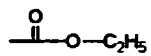 | -Cl |
| C-7 | 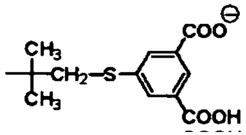 | 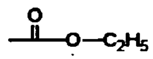 | 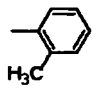 | 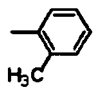 | 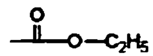 | |
| C-8 | 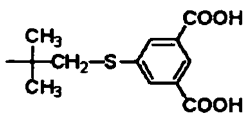 | 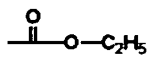 | 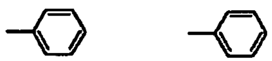 | | 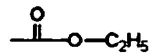 | -Cl |
| C-9 | $-C_4H_9(t)$ | 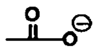 | 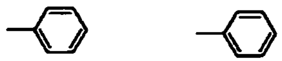 | | 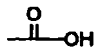 | |

(continued)

| Exemplary Compound | $R^{40}$ | $R^{41}$ | $R^{42}$ | $R^{43}$ | $R^{44}$ | X |
|---|---|---|---|---|---|---|
| C-10 | $-C_4H_9(t)$ | 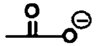 | 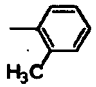 | 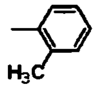 | 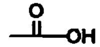 | |
| C-11 | $-C_4H_9(t)$ | 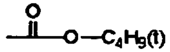 | 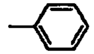 | 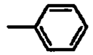 | 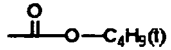 | -Cl |
| C-12 | 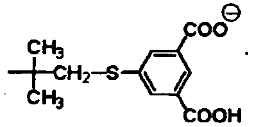 | 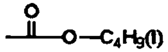 | 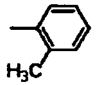 | 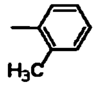 | 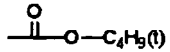 | |
| C-13 | 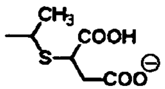 | 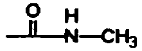 | 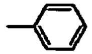 | 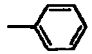 | 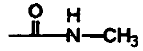 | |
| C-14 | 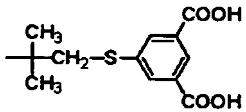 | 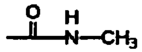 | 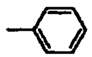 | 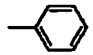 | 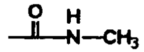 | -Cl |
| C-15 | 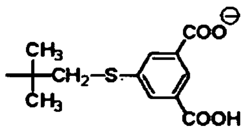 | 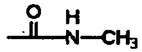 | 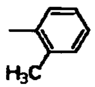 | 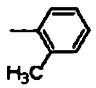 | 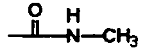 | |
| C-16 | 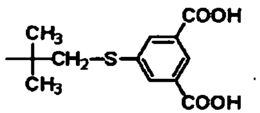 | 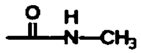 | 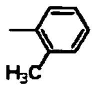 | 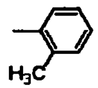 | | -Cl |
| C-17 | 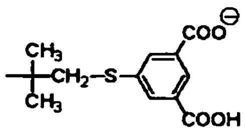 | 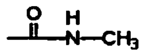 | 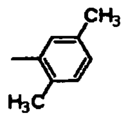 | 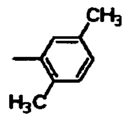 | | |
| C-18 | 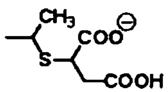 | 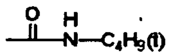 | 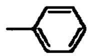 | 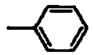 | | |

(continued)

| Exemplary Compound | $R^{40}$ | $R^{41}$ | $R^{42}$ | $R^{43}$ | $R^{44}$ | X |
|---|---|---|---|---|---|---|
| C-19 | $-C_4H_9(t)$ | 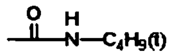 | 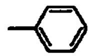 | 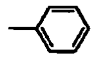 | 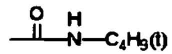 | -Cl |
| C-20 | $-C_4H_9(t)$ | 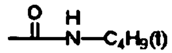 | 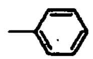 | 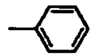 | 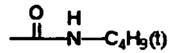 | 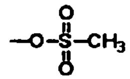 |

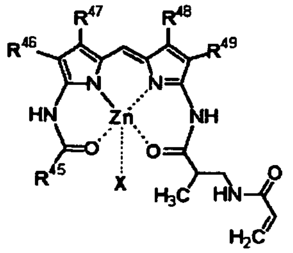

| Exemplary Compound | $R^{45}$ | $R^{46}$ | $R^{47}$ | $R^{48}$ | $R^{49}$ | X |
|---|---|---|---|---|---|---|
| D-1 | $-C_4H_9(t)$ | 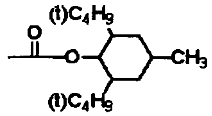 | 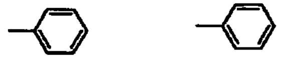 |  | 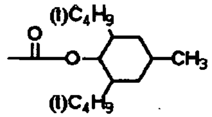 | 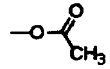 |
| D-2 | $-C_4H_9(t)$ | 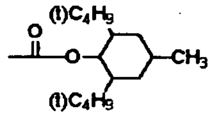 | 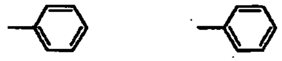 |  | 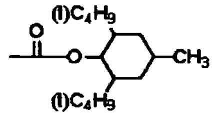 | -Cl |
| D-3 | 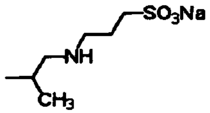 | 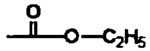 | 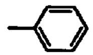 | 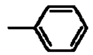 | 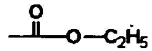 | 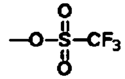 |
| D-4 | $-C_4H_9(t)$ | 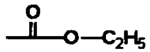 | 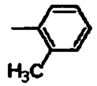 | 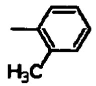 | 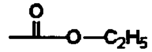 | -Cl - |
| D-5 | 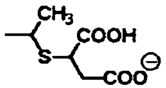 | 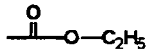 | 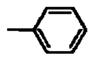 | 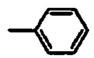 | 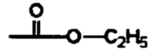 | |
| D-6 | 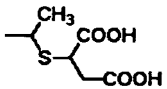 | 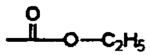 | 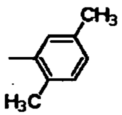 | 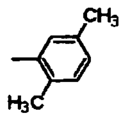 | 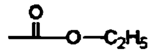 | -Cl |
| D-7 | 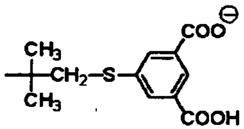 | 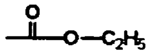 | 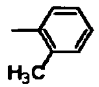 | 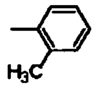 | 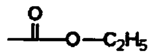 | |
| D-8 | 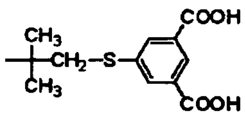 | 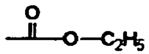 | 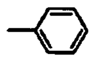 | 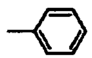 | 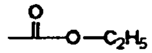 | -Cl |
| D-9 | $-C_4H_9(t)$ | 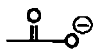 | 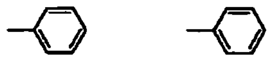 |  | 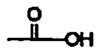 | |

(continued)

| Exemplary Compound | $R^{45}$ | $R^{46}$ | $R^{47}$ | $R^{48}$ | $R^{49}$ | X |
|---|---|---|---|---|---|---|
| D-10 | $-C_4H_9(t)$ | 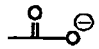 | 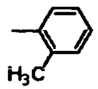 | 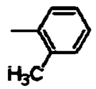 | 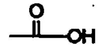 | |
| D-11 | $-C_4H_9(t)$ | 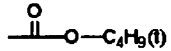 | 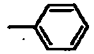 | 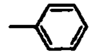 | 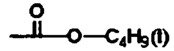 | -Cl |
| D-12 | 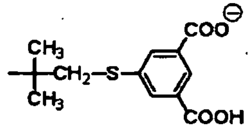 | 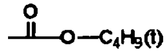 | 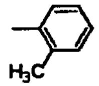 | 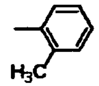 | 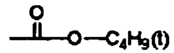 | |
| D-13 | 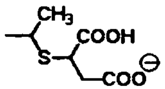 | 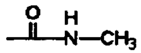 | 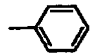 | 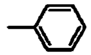 | 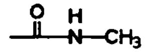 | |
| D-14 | 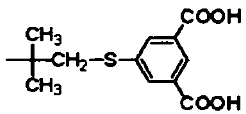 | 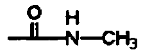 | 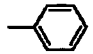 | 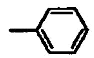 | 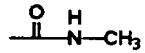 | -Cl |
| D-15 | 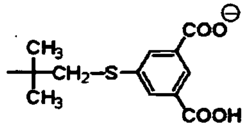 | 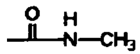 | 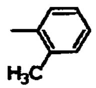 | 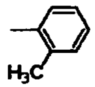 | 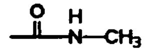 | |
| D-16 | 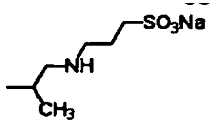 | 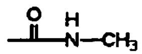 | 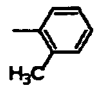 | 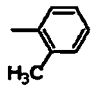 | 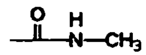 | -Cl |
| D-17 | 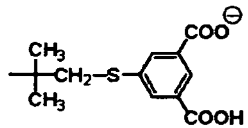 | 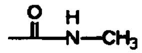 | 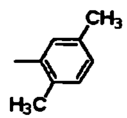 | 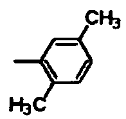 | 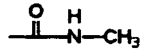 | |

(continued)

| Exemplary Compound | $R^{45}$ | $R^{46}$ | $R^{47}$ | $R^{48}$ | $R^{49}$ | X |
|---|---|---|---|---|---|---|
| D-18 | 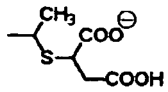 | 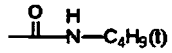 | 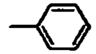 | 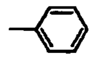 | 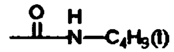 | |
| D-19 | $-C_4H_9(t)$ | 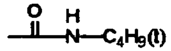 | 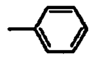 | 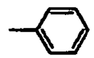 | 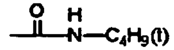 | -Cl |
| D-20 | $-C_4H_9(t)$ | 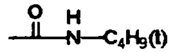 | 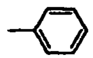 | 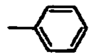 | 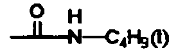 | 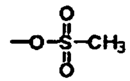 |

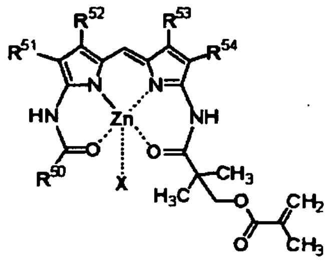

| Exemplary Compound | $R^{50}$ | $R^{51}$ | $R^{52}$ | $R^{53}$ | $R^{54}$ | X |
|---|---|---|---|---|---|---|
| E-1 | $-C_4H_9(t)$ | 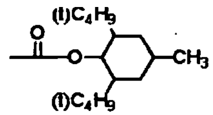 | 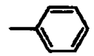 | 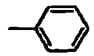 | 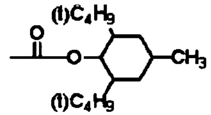 | 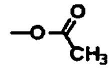 |
| E-2 | $-C_4H_9(t)$ | 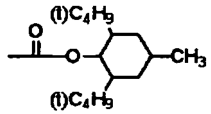 | 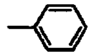 | 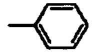 | 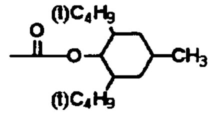 | -Cl |
| E-3 | $-C_4H_9(t)$ | 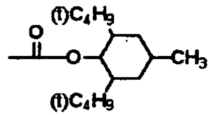 | 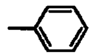 | 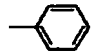 | 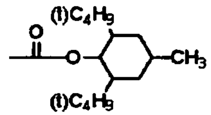 | 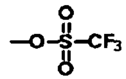 |
| E-4 | $-C_4H_9(t)$ | 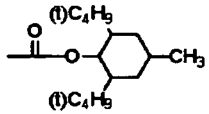 | 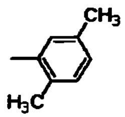 | 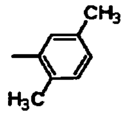 | 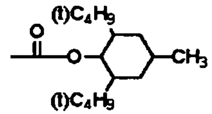 | 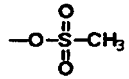 |
| E-5 | 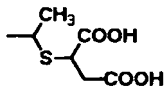 | 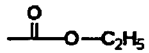 | 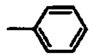 | 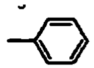 | 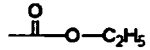 | -Cl |
| E-6 | 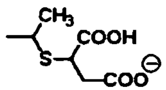 | 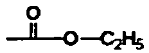 | 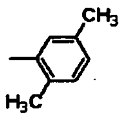 | 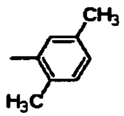 | 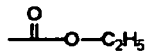 | |
| E-7 | 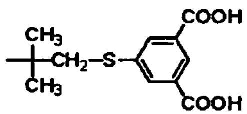 | 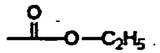 | 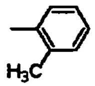 | 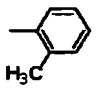 | 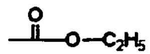 | 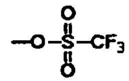 |
| E-8 | $-C_4H_9(t)$ | 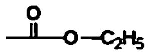 | 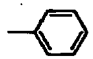 | 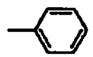 | 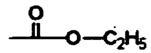 | -Cl |
| E-9 | $-C_4H_9(t)$ | 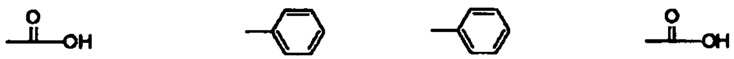 | | | | -F |

(continued)

| Exemplary Compound | $R^{50}$ | $R^{51}$ | $R^{52}$ | $R^{53}$ | $R^{54}$ | X |
|---|---|---|---|---|---|---|
| E-10 | $-C_4H_9(t)$ | 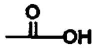 | 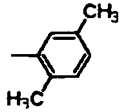 | 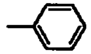 | 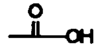 | -Br |
| E-11 | $-C_4H_9(t)$ | 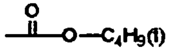 | 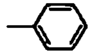 | 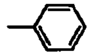 | 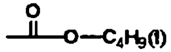 | 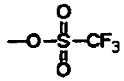 |
| E-12 | 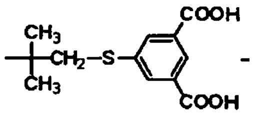 | 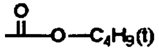 | 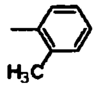 | 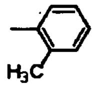 | 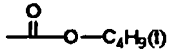 | -Cl |
| E-13 | 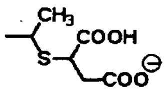 | 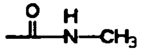 | 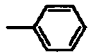 | 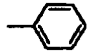 | 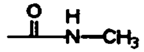 | |
| E-14 | 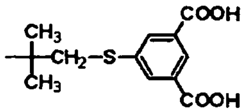 | 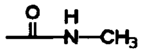 | 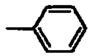 | 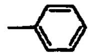 | 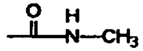 | 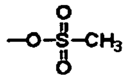 |
| E-15 | 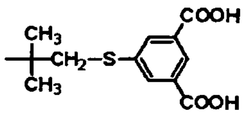 | 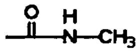 | 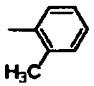 | 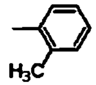 | 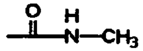 | 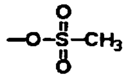 |
| E-16 | 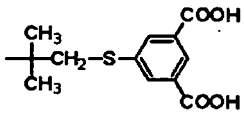 | 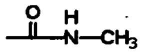 | 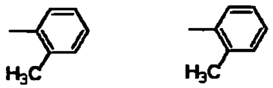 | | 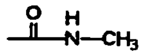 | 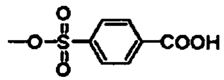 |
| E-17 | 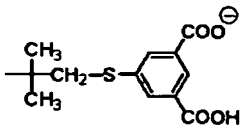 | 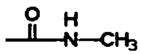 | 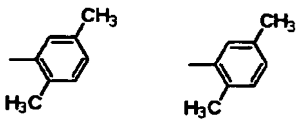 | | 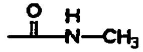 | |

(continued)

| Exemplary Compound | $R^{50}$ | $R^{51}$ | $R^{52}$ | $R^{53}$ | $R^{54}$ | X |
|---|---|---|---|---|---|---|
| E-18 | 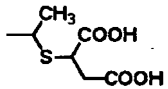 | 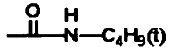 | 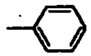 | 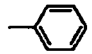 | 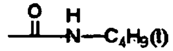 | -Cl |
| E-19 | $-C_4H_9(t)$ | 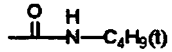 | 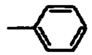 | 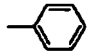 | 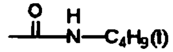 | -Cl |
| E-20 | $-C_4H_9(t)$ | 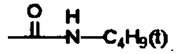 | 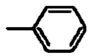 | 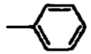 | 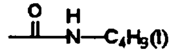 | 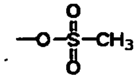 |

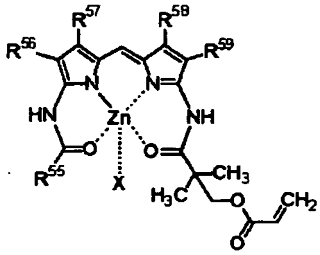

| Exemplary Compoound | $R^{56}$ | $R^{56}$ | $R^{57}$ | $R^{58}$ | $R^{59}$ | X |
|---|---|---|---|---|---|---|
| F-1 | $-C_4H_9(t)$ | 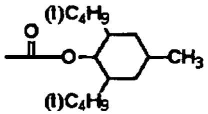 | 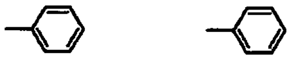 | | 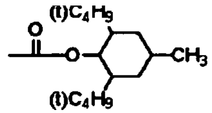 | 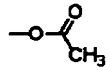 |
| F2 | $-C_4H_9(t)$ | 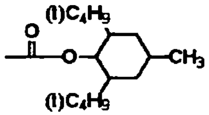 | 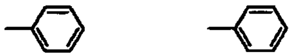 | | 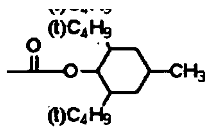 | -Cl |
| F-3 | 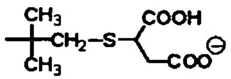 | 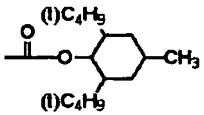 | 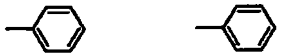 | | 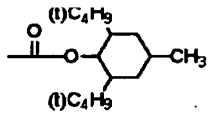 | |
| F-4 | $-C_4H_9(t)$ | 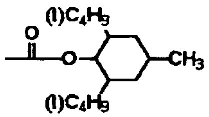 | 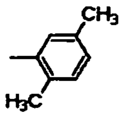 | 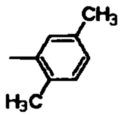 | 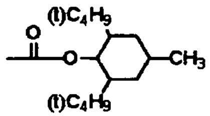 | 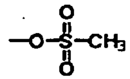 |
| F-5 | 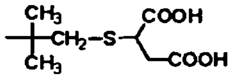 | 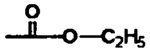 | 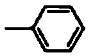 | 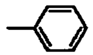 | 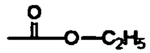 | -Cl |
| F-6 | 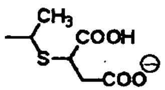 | 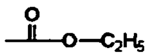 | 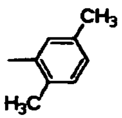 | 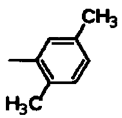 | 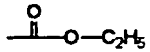 | |
| F-7 | 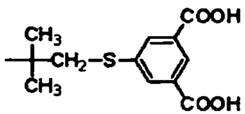 | 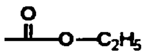 | 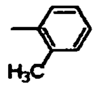 | 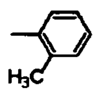 | 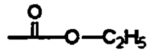 | 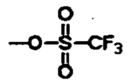 |
| F-8 | 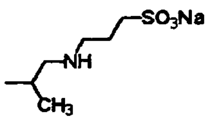 | 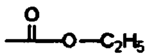 | 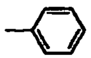 | 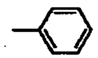 | 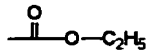 | -Cl |
| F-9 | $-C_4H_9(t)$ | 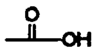 | 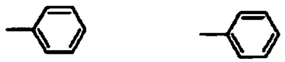 | | 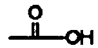 | -F |

(continued)

| Exemplary Compoound | $R^{56}$ | $R^{56}$ | $R^{57}$ | $R^{58}$ | $R^{59}$ | X |
|---|---|---|---|---|---|---|
| F-10 | $-C_4H_9(t)$ | 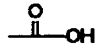 | 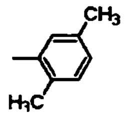 | 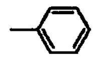 | 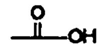 | -Br |
| F-11 | $-C_4H_9(t)$ | 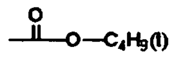 | 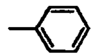 | 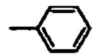 | 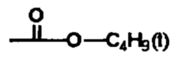 | 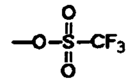 |
| F-12 | 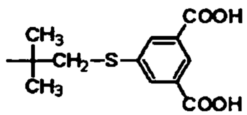 | 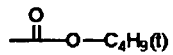 | 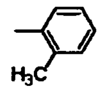 | 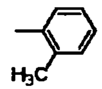 | 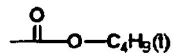 | -Cl |
| F-13 | 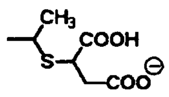 | 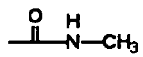 | 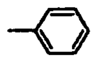 | 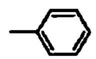 | 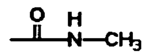 | |
| F-14 | 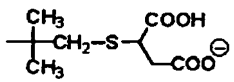 | 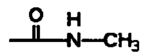 | 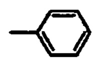 | 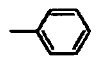 | 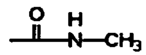 | |
| F-15 | 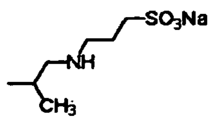 | 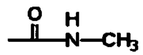 | 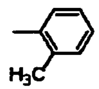 | 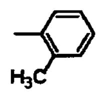 | 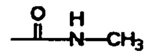 | 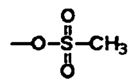 |
| F-16 | 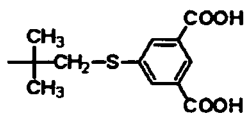 | 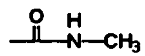 | 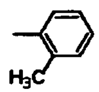 | 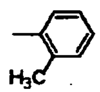 | 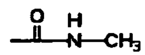 | 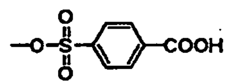 |

(continued)

| Exemplary Compoound | $R^{56}$ | $R^{56}$ | $R^{57}$ | $R^{58}$ | $R^{59}$ | X |
|---|---|---|---|---|---|---|
| F-17 | 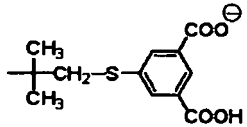 | 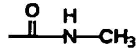 | 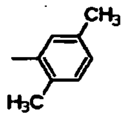 | 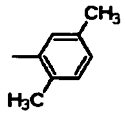 | 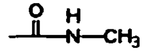 | |
| F-18 | 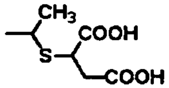 | 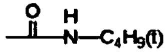 | 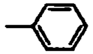 | 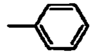 | 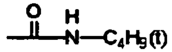 | -Cl |
| F-19 | $-C_4H_9(t)$ | 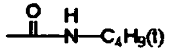 | 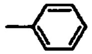 | 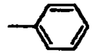 | 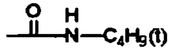 | -Cl |
| F-20 | 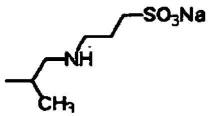 | 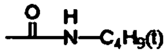 | 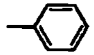 | 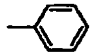 | 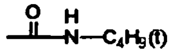 | 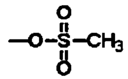 |

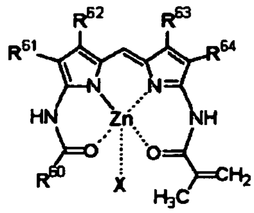

| Exemplary Compound | $R^{60}$ | $R^{61}$ | $R^{62}$ | $R^{63}$ | $R^{64}$ | X |
|---|---|---|---|---|---|---|
| G-1 | $-C_4H_9(t)$ | 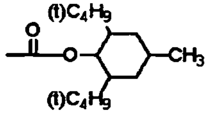 | 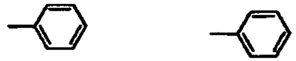 | | 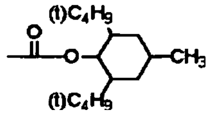 | 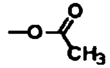 |
| G-2 | $-C_4H_9(t)$ | 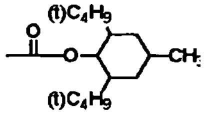 | 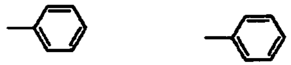 | | 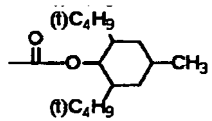 | -Cl |
| G3 | $-C_4H_9(t)$ | 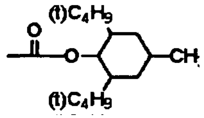 | 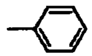 | 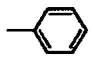 | 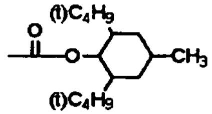 | 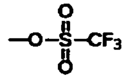 |
| G4 | $-C_4H_9(t)$ | 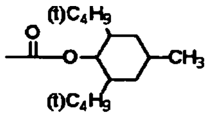 | 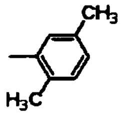 | 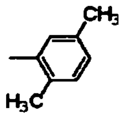 | 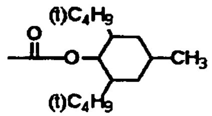 | 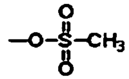 |
| G-5 | 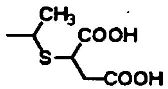 | 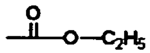 | 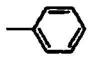 | 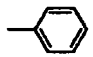 | 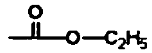 | -Cl |
| G-6 | 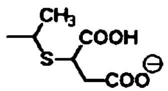 | 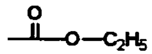 | 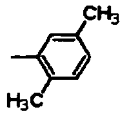 | 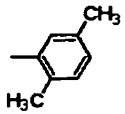 | 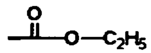 | |
| G7 | 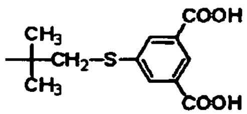 | 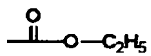 | 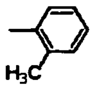 | 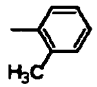 | 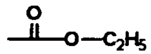 | 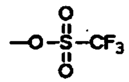 |
| G-8 | $-C_4H_9(t)$ | 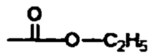 | 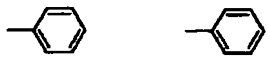 | | 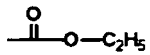 | -Cl |
| G-9 | $-C_4H_9(t)$ | 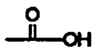 | 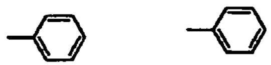 | | 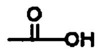 | -F |

(continued)

| Exemplary Compound | $R^{60}$ | $R^{61}$ | $R^{62}$ | $R^{63}$ | $R^{64}$ | X |
|---|---|---|---|---|---|---|
| G-10 | $-C_4H_9(t)$ | 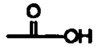 | 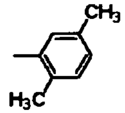 | 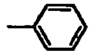 | 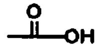 | -Br |
| G-11 | $-C_4H_9(t)$ | 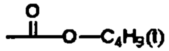 | 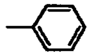 | 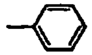 | 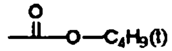 | 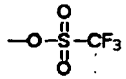 |
| G-12 | 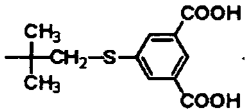 | 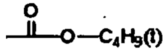 | 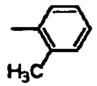 | 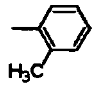 | 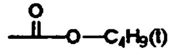 | -Cl |
| G-13 | 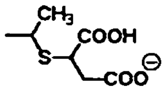 | 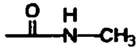 | 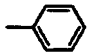 | 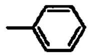 | 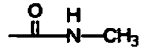 | |
| G-14 | 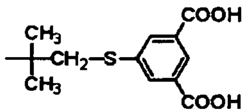 | 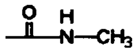 | 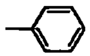 | 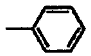 | 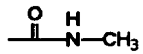 | 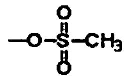 |
| G-15 | 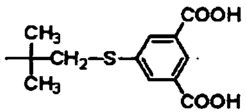 | 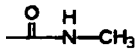 | 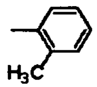 | 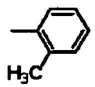 | 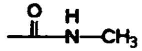 | 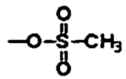 |
| G-16 | 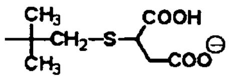 | 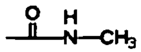 | 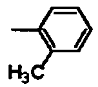 | 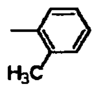 | 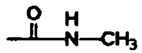 | |

(continued)

| Exemplary Compound | $R^{60}$ | $R^{61}$ | $R^{62}$ | $R^{63}$ | $R^{64}$ | X |
|---|---|---|---|---|---|---|
| G-17 | 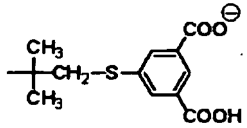 | 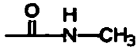 | 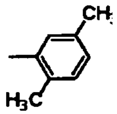 | 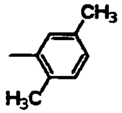 | 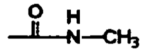 | |
| G-18 | 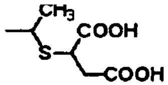 | 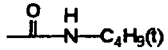 | 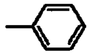 | 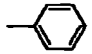 | 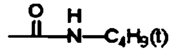 | -Cl |
| G-19 | 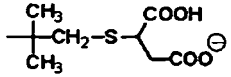 | 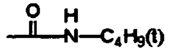 | 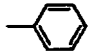 | 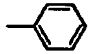 | 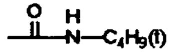 | |
| G-20 | 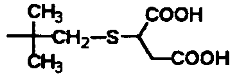 | 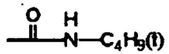 | 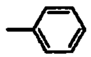 | 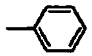 | 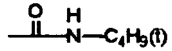 | 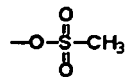 |

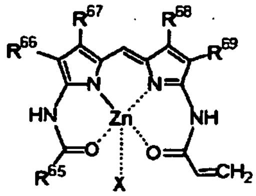

| Examplary Compound | $R^{65}$ | $R^{66}$ | $R^{67}$ | $R^{68}$ | $R^{69}$ | X |
|---|---|---|---|---|---|---|
| H-1 | $-C_4H_9(t)$ | 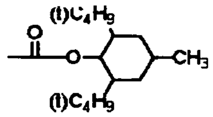 | 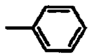 | 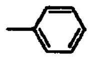 | 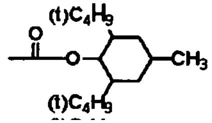 | 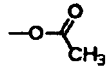 |
| H-2 | $-C_4H_9(t)$ | 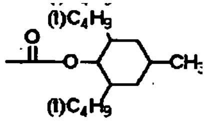 | 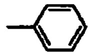 | 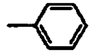 | 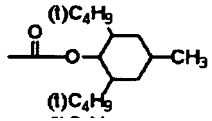 | -Cl |
| H-3 | $-C_4H_9(t)$ | 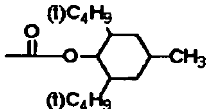 | 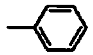 | 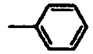 | 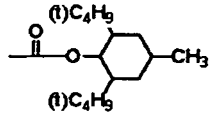 | 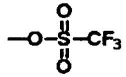 |
| H-4 | $-C_4H_9(t)$ | 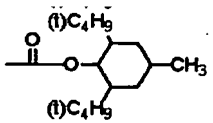 | 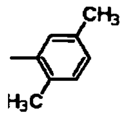 | 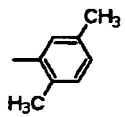 | 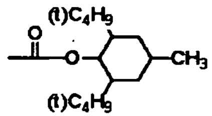 | 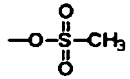 |
| H-5 | 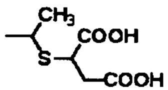 | 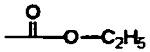 | 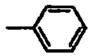 | 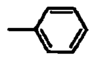 | 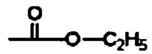 | -Cl |
| H-6 | 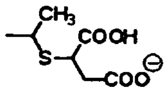 | 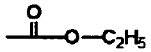 | 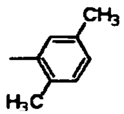 | 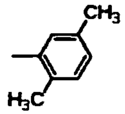 | 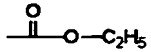 | |
| H-7 | 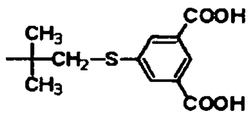 | 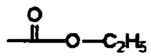 | 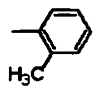 | 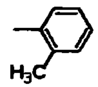 | 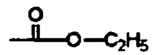 | 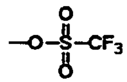 |
| H-8 | $-C_4H_9(t)$ | 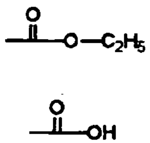 | 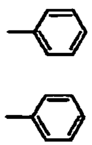 | 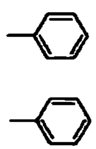 | 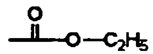 | -Cl |
| H-9 | $-C_4H_9(t)$ | | | | 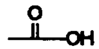 | -F |

(continued)

| Examplary Compound | $R^{65}$ | $R^{66}$ | $R^{67}$ | $R^{68}$ | $R^{69}$ | X |
|---|---|---|---|---|---|---|
| H-10 | $-C_4H_9(t)$ | 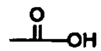 | 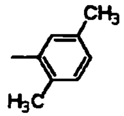 | 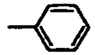 | 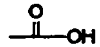 | -Br |
| H-11 | $-C_4H_9(t)$ | 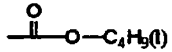 | 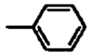 | 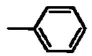 | 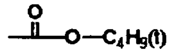 | 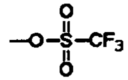 |
| H-12 | 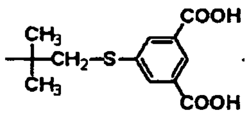 | 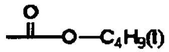 | 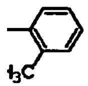 | 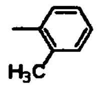 | 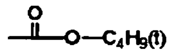 | -Cl |
| H-13 | 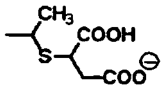 | 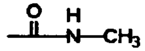 | 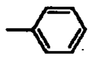 | 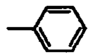 | 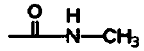 | |
| H-14 | 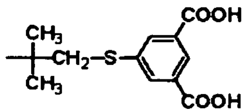 | 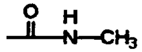 | 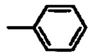 | 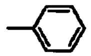 | 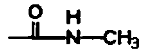 | 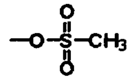 |
| H-15 | 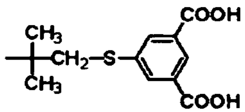 | 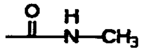 | 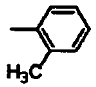 | 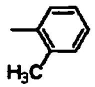 | 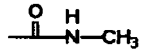 | 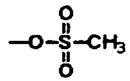 |
| H-16 | 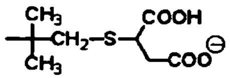 | 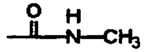 | 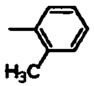 | 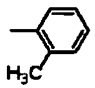 | 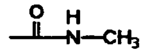 | |

(continued)

| Examplary Compound | $R^{65}$ | $R^{66}$ | $R^{67}$ | $R^{68}$ | $R^{69}$ | X |
|---|---|---|---|---|---|---|
| H-17 | 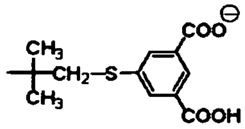 | 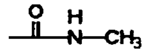 | 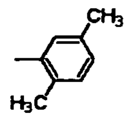 | 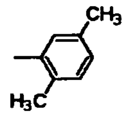 | 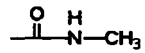 | |
| H-18 | 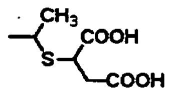 | 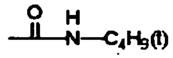 | 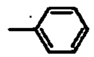 | 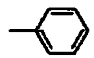 | 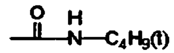 | -Cl |
| H-19 | 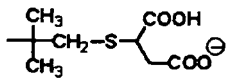 | 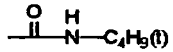 | 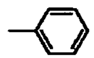 | 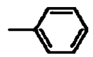 | 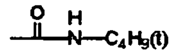 | |
| H-20 | 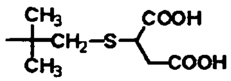 | 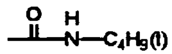 | 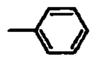 | 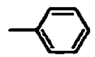 | 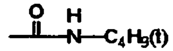 | 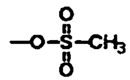 |

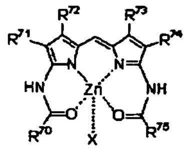

| Exemplary Compound | $R^{70}$ | $R^{71}$ | $R^{72}$ | $R^{73}$ | $R^{74}$ | $R^{75}$ | X |
|---|---|---|---|---|---|---|---|
| I-1 | $-C_4H_9(t)$ | 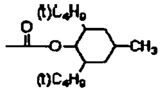 | 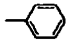 | 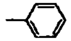 | 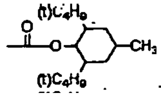 $-C_4H_9(t)$ | $-C_4H_9(t)$ | |
| I-2 | $-C_4H_9(t)$ | 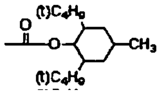 | 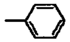 | 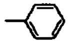 | 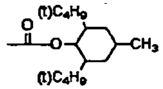 | $-C_4H_9(t)$ | 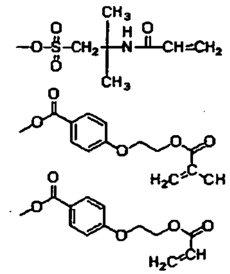 |
| I-3 | 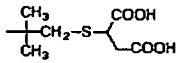 | 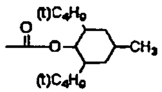 | 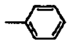 | 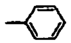 | 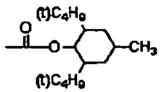 | $-C_4H_9(t)$ | |
| I-4 | $-C_4H_9(t)$ | 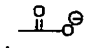 | 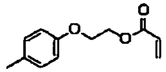 | 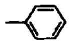 | 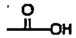 | $-C_4H_9(t)$ | |
| I-5 | 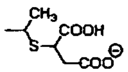 | 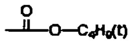 | 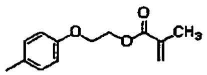 | 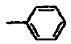 | 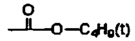 | $-C_4H_9(t)$ | |
| I-6 | 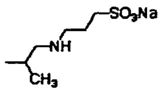 | 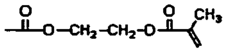 | 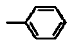 | 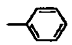 | 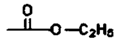 | 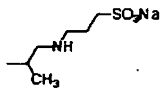 | -Cl |
| I-7 | 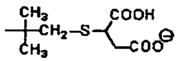 | 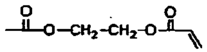 | 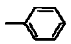 | 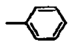 | 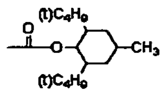 | $-C_4H_9(t)$ | |
| I-8 | 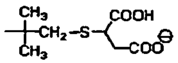 | 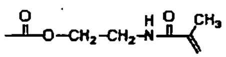 | 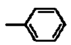 | 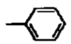 | 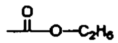 | $-C_4H_9(t)$ | |
| I-9 | 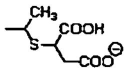 | | | | | $-C_4H_9(t)$ | |

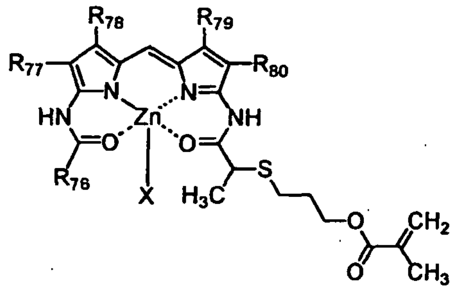

| Exemplary Compound | $R_{76}$ | $R_{77}$ | $R_{78}$ | $R_{79}$ | $R_{80}$ | X |
|---|---|---|---|---|---|---|
| J-1 | 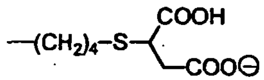 | 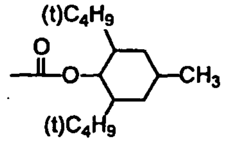 | 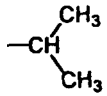 | 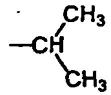 | 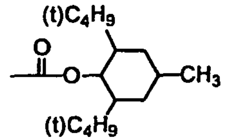 | |
| J-2 | 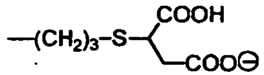 | 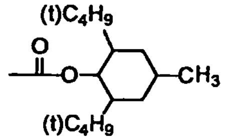 | 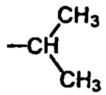 | 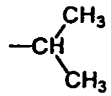 | 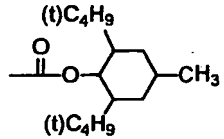 | |
| J-3 | 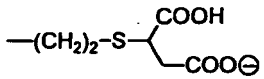 | 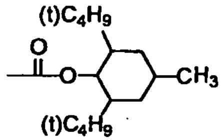 | 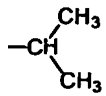 | 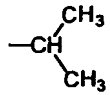 | 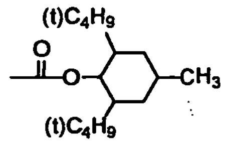 | |
| J-4 | 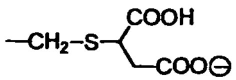 | 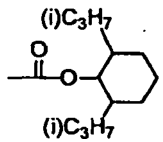 | 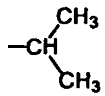 | 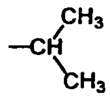 | 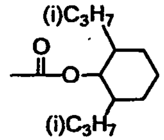 | |
| J-5 | 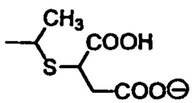 | 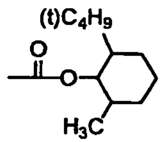 | 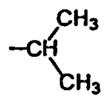 | 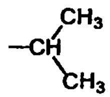 | 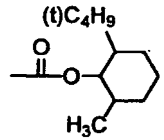 | |
| J-6 | 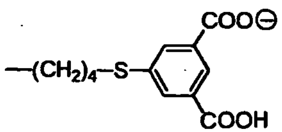 | 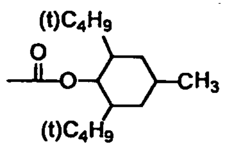 | 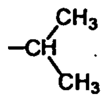 | 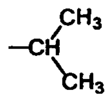 | 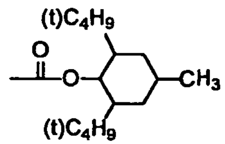 | |
| J-7 | 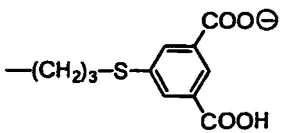 | 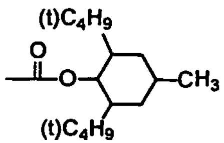 | 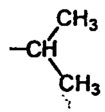 | 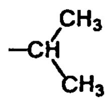 | 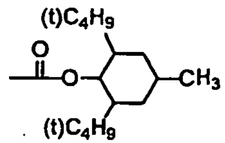 | |

(continued)

| Exemplary Compound | $R_{76}$ | $R_{77}$ | $R_{78}$ | $R_{79}$ | $R_{80}$ | X |
|---|---|---|---|---|---|---|
| J-8 | 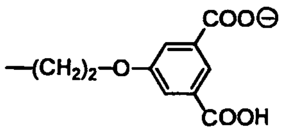 | 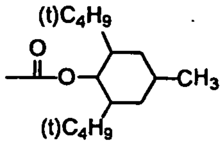 | 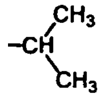 | 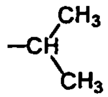 | 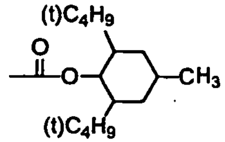 | |
| J-9 | 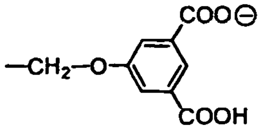 | 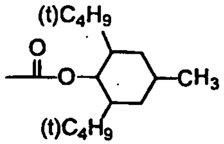 | 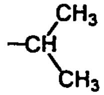 | 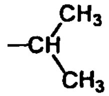 | 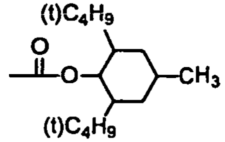 | |
| J-10 | 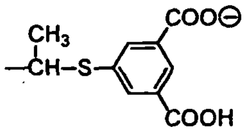 | 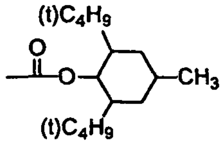 | 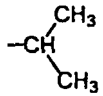 | 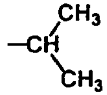 | 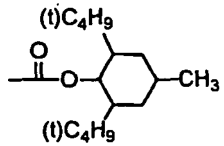 | |
| J-11 | 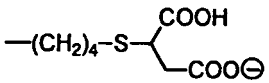 | 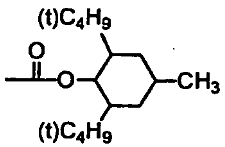 | $-CH_3$ | $-CH_3$ | 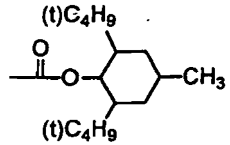 | |
| J-12 | 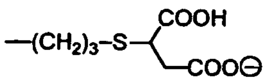 | 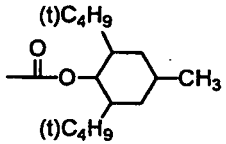 | $-CH_3$ | $-CH_3$ | 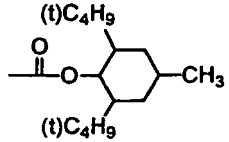 | |
| J-13 | 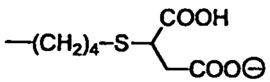 | 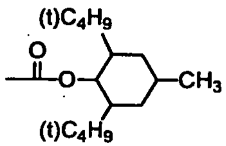 | $-CH_3$ | 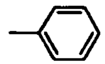 | 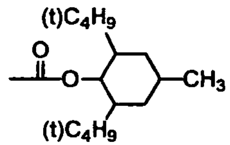 | |

(continued)

| Exemplary Compound | $R_{76}$ | $R_{77}$ | $R_{78}$ | $R_{79}$ | $R_{80}$ | X |
|---|---|---|---|---|---|---|
| J-14 | 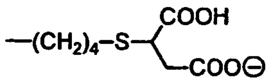 | 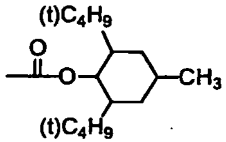 | 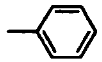 | $-CH_3$ | 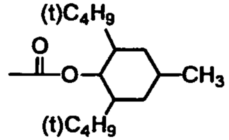 | |
| J-15 | 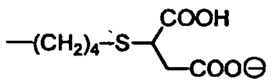 | 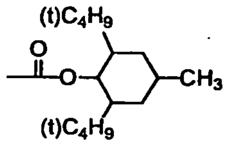 | 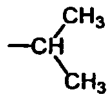 | 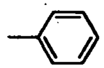 | 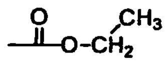 | |
| J-16 | 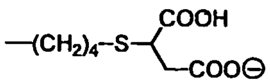 | 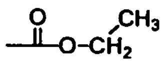 | 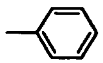 | 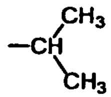 | 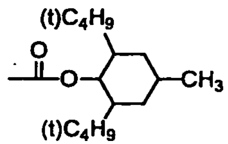 | |
| J-17 | 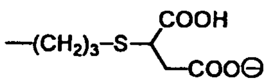 | 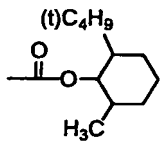 | 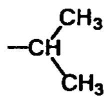 | 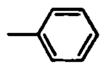 | 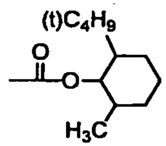 | |
| J-18 | 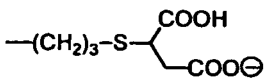 | 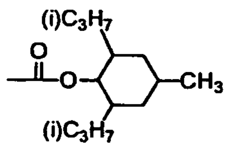 | 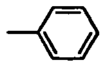 | 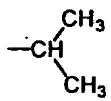 | 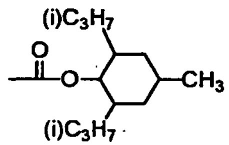 | |
| J-19 | 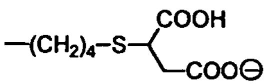 | 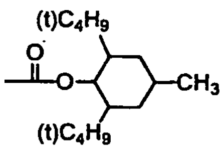 $-CH_2-CH_3$ | $-CH_2-CH_3$ | 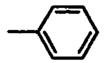 | 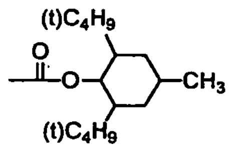 | |

(continued)

| Exemplary Compound | $R_{76}$ | $R_{77}$ | $R_{78}$ | $R_{79}$ | $R_{80}$ | X |
|---|---|---|---|---|---|---|
| J-20 | 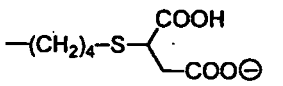 | 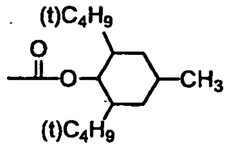 | 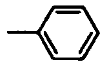 | $-CH_2-CH_3$ | 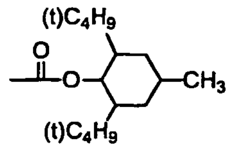 | |
| J-21 | 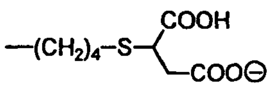 | 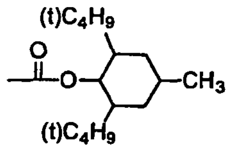 | 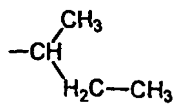 | 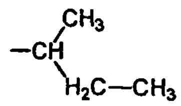 | 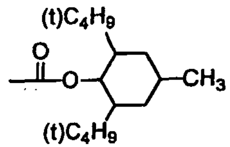 | |
| J-22 | 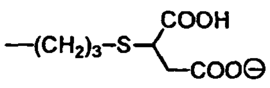 | 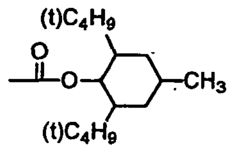 | 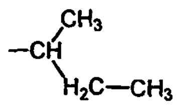 | 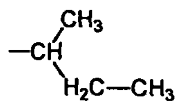 | 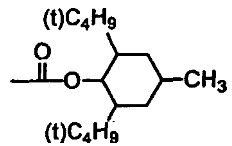 | |
| J-23 | 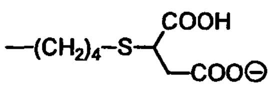 | 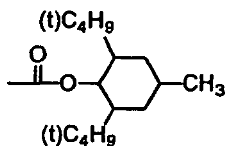 | 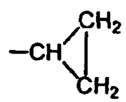 | 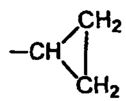 | 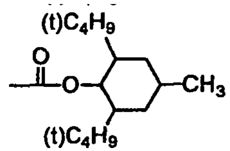 | |
| J-24 | 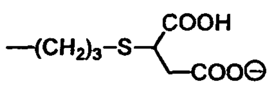 | 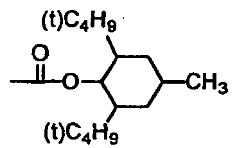 | 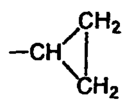 | 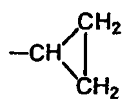 | 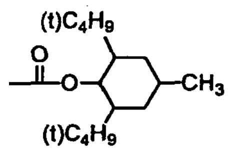 | |
| J-25 | 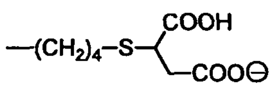 | 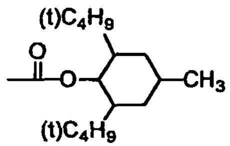 | $-CH_2-CH_3$ | $-CH_2-CH_3$ | 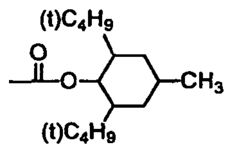 | |

(continued)

| Exemplary Compound | $R_{76}$ | $R_{77}$ | $R_{78}$ | $R_{79}$ | $R_{80}$ | X |
|---|---|---|---|---|---|---|
| J-26 | 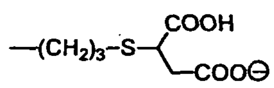 | 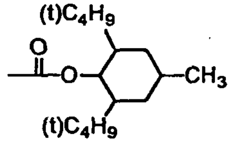 | $-CH_2-CH_3$ | $-CH_2-CH_3$ | 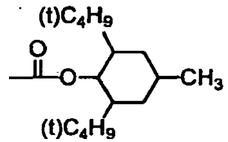 | |
| J-27 | 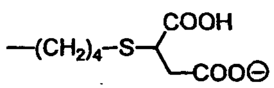 | 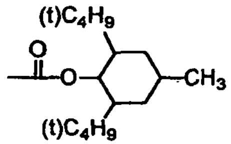 | $-(CH_2)_2-CH_3$ | $-(CH_2)_2-CH_3$ | 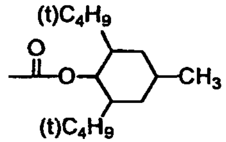 | $-(CH_2)_2-CH_3$ |
| J-28 | 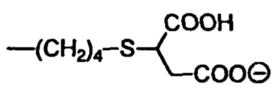 | 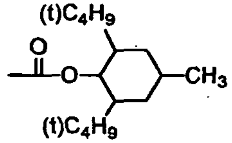 | 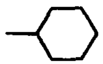 | 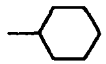 | 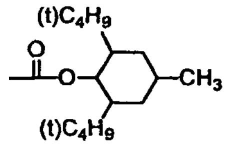 | |
| J-29 | 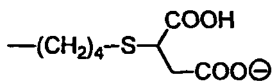 | 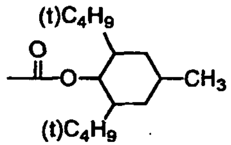 | 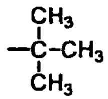 | 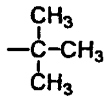 | 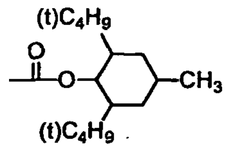 | |
| J-30 | 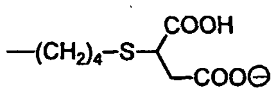 | 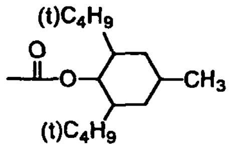 | 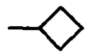 | 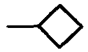 | 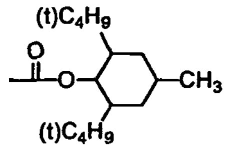 | |

(K-1)

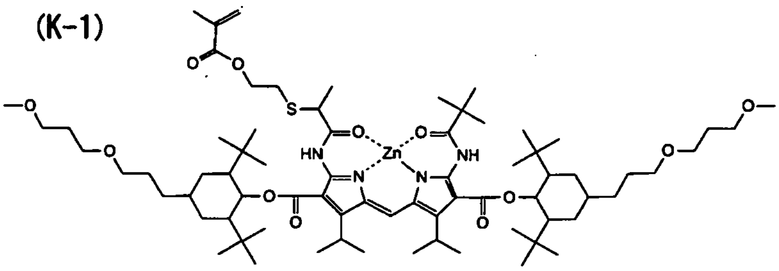

(K-2)

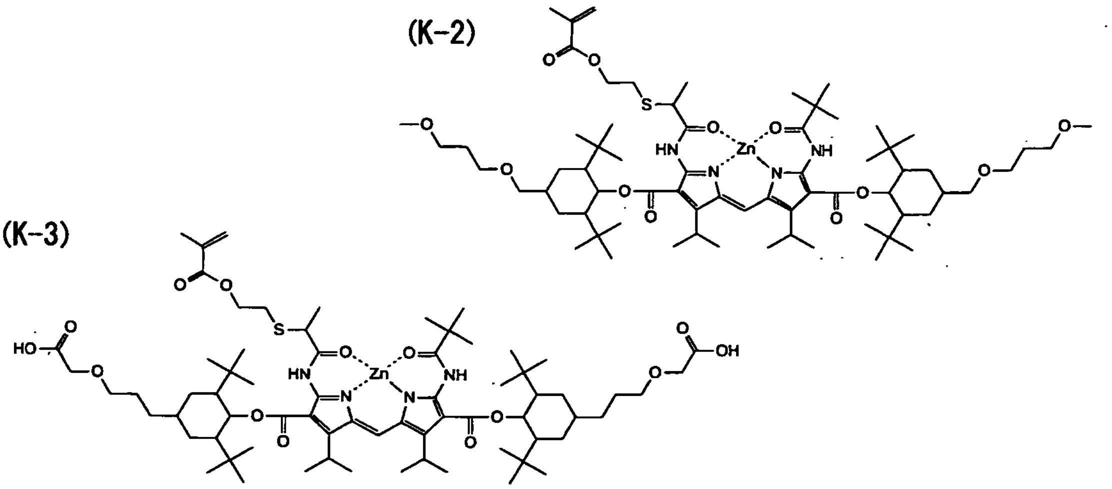

(K-3)

(K-4)

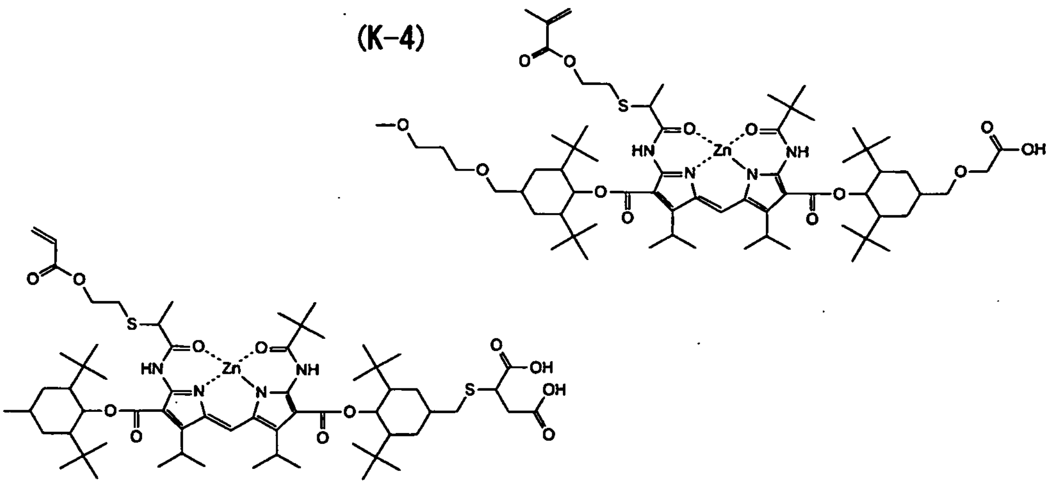

(K-5)

(K-6)

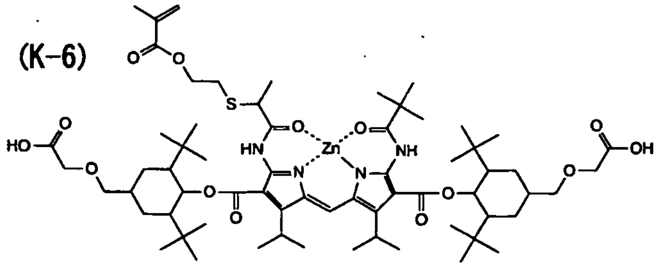

(K-7)

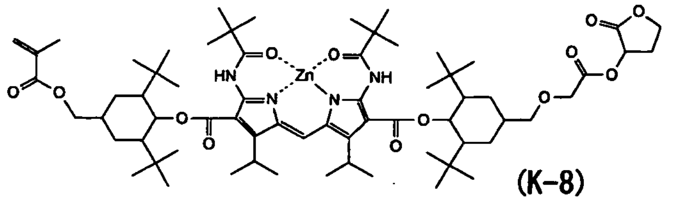

(K-8)

(K-9)

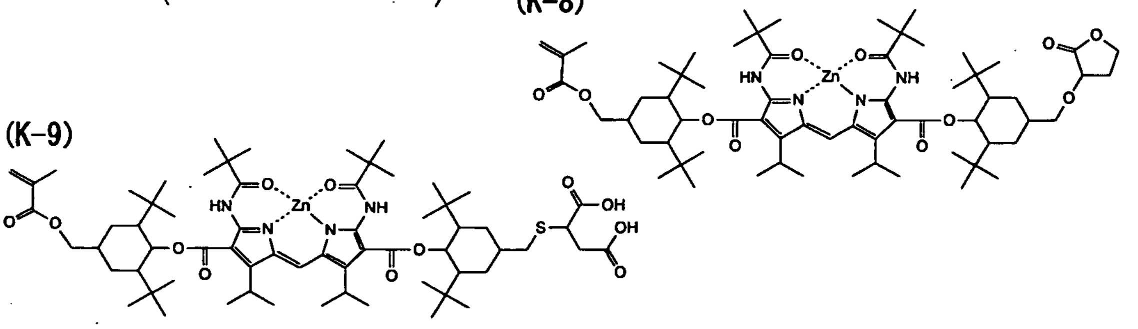

(K-10)

(K-11)

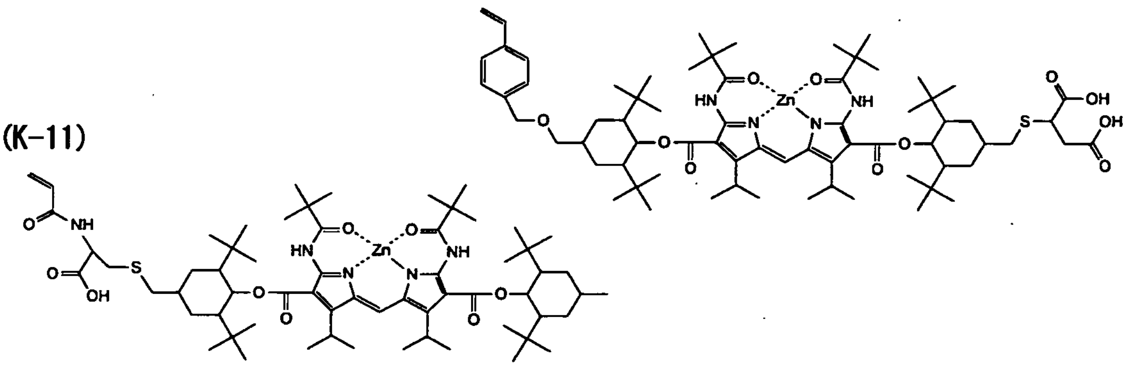

(K-12)

(K-13)

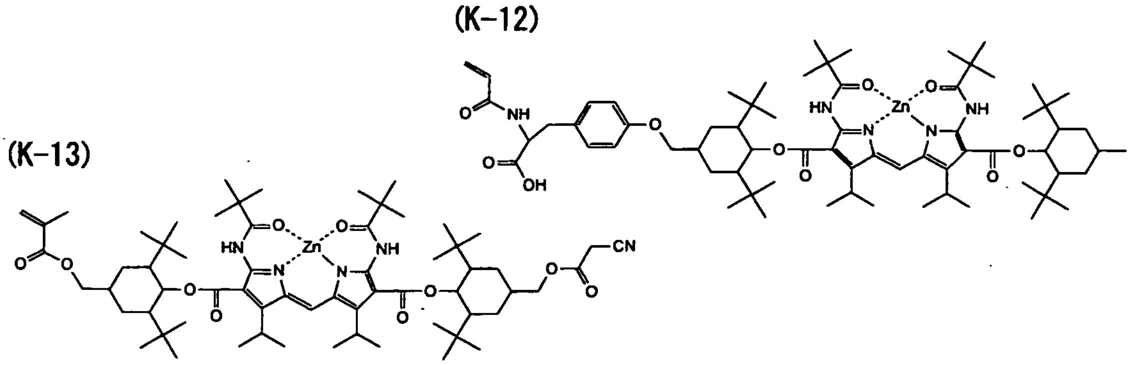

(K-14)

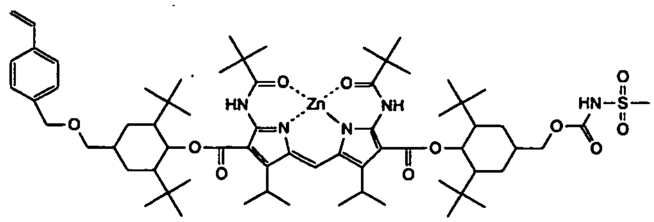

The colorant multimer of the invention may contain a single kind of the colorant monomer represented by

Formula (1) as a polymerization component, or may contain two or more kinds thereof.

When the colorant multimer of the invention contains an additional monomer having an ethylenically unsaturated bond described below as a copolymerization component, the colorant multimer may contain a single kind of the additional monomer having an ethylenically unsaturated bond, or may contain two or more kinds thereof. When the colorant multimer of the invention further contains another monomer as a copolymerization component as necessary, the colorant multimer may contain a single kind of the monomer, or may contain two or more kinds thereof.

The colorant multimer of the invention may contain the constituent unit represented by Formula (A), (B) and/or (C), and/or the colorant monomer represented by Formula (1), which is a preferable monomer that can form the constituent unit represented by Formula (A), at a mass ratio (% by mass) of 100% by mass. That is, the colorant multimer of the invention may be formed by polymerizing the constituent units represented by Formula (A), (B), and/or (C). In view of the film thickness, the total content of the constituent units represented by Formulae (A), (B) and (C) is preferably from 10% by mass to 100% by mass%, more preferably from 20% by mass to 100% by mass%, and still more preferably from 30% by mass to 100% by mass%, in terms of the mass ratio (by mass%).

*Monomer that has a terminal ethylenically unsaturated bond and has a structure different from that of the colorant monomer forming the constituent unit represented by Formula (A), (B) or (C)*

In addition to the at least one of the constituent unit represented by Formula (A), (B) or (C), and/ or the colorant monomer represented by Formula (1), which is the preferable example of the constituent unit, the colorant multimer of the invention may contain, as a polymerization component thereof, a monomer (hereinbelow, may be referred to as an "additional monomer having an ethylenically unsaturated bond") that has a terminal ethylenically unsaturated bond and has a structure different from that of the monomer which can form the constituent unit represented by Formula (A), (B) or (C). Furthermore, the colorant multimer of the invention may contain another monomer other than the above monomers as a copolymerization component.

That is, the colorant multimer of the invention may be a copolymer that contains at least one of the colorant monomer that can form the constituent unit represented by Formula (A), (B) or (C), or the colorant monomer represented by Formula (1), and the monomer having an ethylenically unsaturated bond that has a structure different from the structures of these colorant monomers. The copolymer may contain a single kind of the specific colorant monomer according to the invention, or may contain two or more kinds thereof. Further, the copolymer may contain a single kind of the monomer having an ethylenically unsaturated bond, or may contain two or more kinds thereof.

The additional monomer having an ethylenically unsaturated bond is not specifically limited, as long as the monomer has an ethylenically unsaturated bond at a terminal end thereof, and has a structure different from the structures of the colorant monomers that can form the constituent units represented by Formula (A), (B) or (C), or the structure of the colorant monomer represented by Formula (1).

When the colorant multimer of the invention is used for a colored curable composition, in order to improve the formability of the color pattern, the additional monomer having an ethylenically unsaturated bond is preferably a monomer having an alkali-soluble group in addition to the terminal ethylenically unsaturated bond.

Examples of the additional monomer having an alkali-soluble group together with an ethylenically unsaturated bond include: a vinyl monomer having a carboxy group, a vinyl monomer having a sulfonic acid group.

Examples of the vinyl monomer having a carboxy group include a (meth)acrylic acid, vinyl benzoic acid, maleic acid, monoalkyl maleate, fumaric acid, itaconic acid, crotonic acid, cinnamic acid, and an acrylic acid dimer. Examples further include, a vinyl monomer having a phosphoric acid group, an addition reaction products of a monomer having a hydroxy group such as 2-hydroxyethyl (meth)acrylate with a cyclic anhydride such as maleic anhydride, phthalic anhydride or cyclohexane dicarboxylic anhydride; and ω-carboxy-polycaprolactone mono(meth)acrylate. As a precursor of a carboxy group, an anhydride-containing monomer such as maleic anhydride, itaconic acid anhydride, or citraconic anhydride may be used. Among these, from the viewpoint of copolymerization property, cost, solubility and the like, (meth)acrylic acid is preferable.

Examples of the vinyl monomer having a sulfonic acid group include 2-acrylamide-2-methylpropanesulfonic acid. Examples of the vinyl monomer having a phosphoric acid group include mono(2-acryloyloxyethyl) phosphate and mono(1-methyl-2-acryloyloxyethyl) phosphate.

Among these vinyl monomers, the repeating unit derived from the vinyl monomer having an alkali-soluble group is preferably included in the colorant multimer of the invention. When the colorant multimer of the invention contains the above described repeating unit, favorable removability of a non-exposed area during development can be obtained when the colorant multimer of the invention is used for a colored curable composition.

When the colorant multimer of the invention contains the repeating unit derived from the vinyl monomer having an alkali-soluble group, the content thereof is preferably 50 mg KOH/g or more, and more preferably from 50 mg KOH/g to 200 mg KOH/g. That is, in order to suppress the generation of precipitates in the developer, the content of the repeating unit derived from the vinyl monomer having an alkali-soluble group is preferably 50 mg KOH/g or more. When a colored curable composition is formed the colorant multimer of the invention together with a pigment, in order to effectively suppress the formation of aggregates of primary particles of the pigment, that is, secondary aggregates, or in order to

effectively weaken the cohesive force of the secondary aggregates, i the content of the repeating unit derived from the vinyl monomer having an alkali-soluble group is preferably from 50 mg KOH/g to 200 mg KOH/g.

The vinyl monomer that can be used for the copolymerization with the colorant monomer of the present invention is not specifically limited. Preferable examples thereof include (meth)acrylic acid esters, crotonic acid esters, vinyl esters, maleic acid diesters, fumaric acid diesters, itaconic acid diesters, (meth)acrylamides, vinyl ethers, vinyl alcohol esters, styrenes and (meth)acrylonitriles. Specific examples of the vinyl monomer include the following compounds. In the present specification, the term "(meth)acrylic" is used in some cases to collectively represent either of acrylic or methacrylic or both of acrylic and methacrylic.

Examples of (meth)acrylic acid esters include methyl (meth)acrylate, ethyl (meth)acrylate, n-propyl (meth)acrylate, isopropyl (meth)acrylate, n-butyl

(meth)acrylate, isobutyl (meth)acrylate, t-butyl (meth)acrylate, n-hexyl (meth)acrylate, cyclohexyl (meth)acrylate, t-butyl cyclohexyl (meth)acrylate, 2-ethylhexyl (meth)acrylate, t-octyl (meth)acrylate, dodecyl (meth)acrylate, octadecyl (meth)acrylate, acetoxyethyl (meth)acrylate, phenyl (meth)acrylate, 2-hydroxyethyl (meth)acrylate, 2-methoxyethyl (meth)acrylate, 2-ethoxyethyl (meth)acrylate, 2-(2-methoxyethoxy)ethyl (meth)acrylate, 3-phenoxy-2-hydroxypropyl (meth)acrylate, benzyl (meth)acrylate, diethylene glycol monomethylether (meth)acrylate, diethylene glycol monoethylether (meth)acrylate, triethylene glycol monomethylether (meth)acrylate, triethylene glycol monoethylether (meth)acrylate, polyethylene glycol monomethylether (meth)acrylate, polyethylene glycol monoethylether (meth)acrylate, β-phenoxyethoxyethyl (meth)acrylate, nonyl phenoxy polyethylene glycol (meth)acrylate, dicyclopentenyl (meth)acrylate, dicyclopentenyloxyethyl (meth)acrylate, trifluoroethyl (meth)acrylate, octafluoropentyl (meth)acrylate, perfluorooctylethyl (meth)acrylate, dicyclopentanyl (meth)acrylate, tribromophenyl (meth)acrylate, and tribromophenyloxyethyl (meth)acrylate.

Examples of crotonic acid esters include butyl crotonate and hexyl crotonate.

Examples of vinyl esters include vinyl acetate, vinyl propionate, vinyl butyrate, vinyl methoxy acetate and vinyl benzoate.

Examples of maleic acid diesters include dimethyl maleate, diethyl maleate and dibutyl maleate.

Examples of fumaric acid diesters include dimethyl fumarate, diethyl fumarate and dibutyl fumarate.

Examples of itaconic acid diesters include dimethyl itaconate, diethyl itaconate and dibutyl itaconate.

Examples of (meth)acrylamides include (meth)acrylamide, N-methyl (meth)acrylamide, N-ethyl (meth)acrylamide, N-propyl (meth)acrylamide, N-isopropyl (meth)acrylamide, N-n-butyl (meth)acrylamide, N-t-butyl (meth)acrylamide, N-cyclohexyl (meth)acrylamide, N-(2-methoxyethyl) (meth)acrylamide, N,N-dimethyl (meth)acrylamide, N,N-diethyl (meth)acrylamide, N-phenyl (meth)acrylamide, N-benzyl (meth)acrylamide, (meth)acryloyl morpholine and diacetone acrylamide.

Examples of the vinyl ethers include methyl vinyl ether, butyl vinyl ether, hexyl vinyl ether and methoxyethyl vinyl ether.

Examples of the styrenes include styrene, methylstyrene, dimethylstyrene, trimethylstyrene, ethylstyrene, isopropylstyrene, butylstyrene, hydroxystyrene, methoxystyrene, butoxystyrene, acetoxystyrene, chlorostyrene, dichlorostyrene, bromostyrene, chloromethylstyrene, hydroxystyrene protected by a group deprotectable with an acidic substance (such as t-Boc), methyl vinyl benzoate and α-methylstyrene.

Hereinbelow, specific examples of the additional monomer having an ethylenically unsaturated bond include the following, but the invention is not particularly limited to these examples.

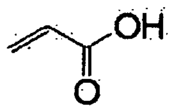

(b-1)

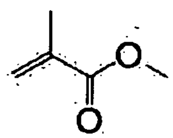

(b-8)

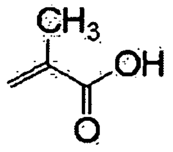

(b-2)

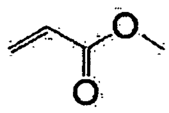

(b-9)

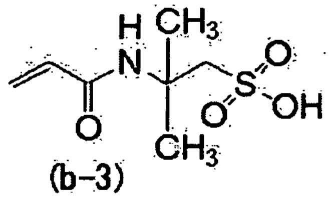
(b-3)

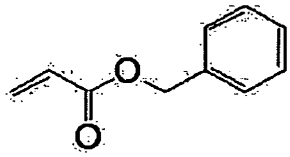
(b-10)

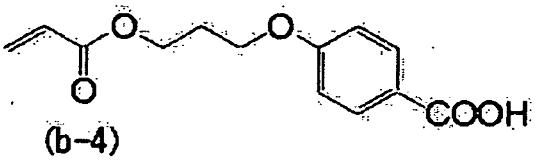
(b-4)

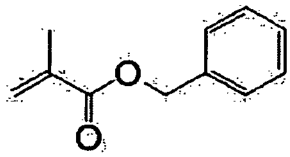
(b-11)

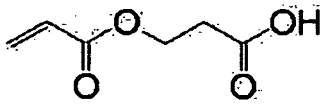
(b-5)

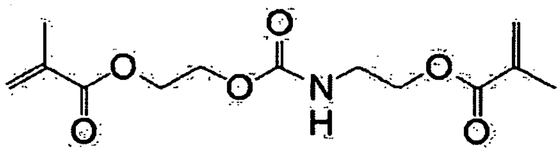
(b-12)

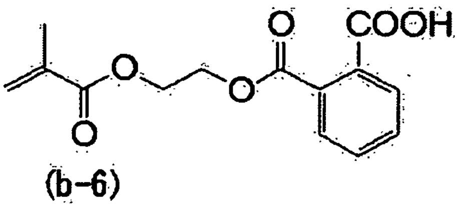
(b-6)

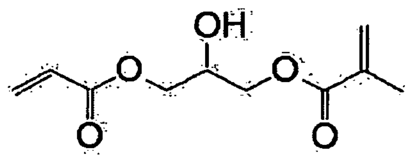
(b-13)

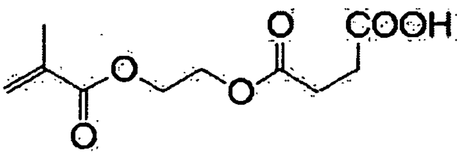
(b-7)

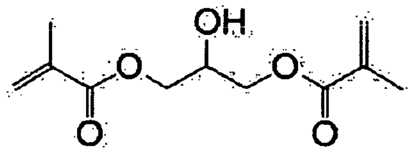
(b-14)

*Examples of colorant multimer*

Specific examples of the colorant multimer of the invention include the following, but the invention is not particularly limited to these examples. In Tables 2 to 9, the number of the "monomer a" corresponds to that of the specific examples of the above-described colorant monomers, and the number of the "monomer b" corresponds to that of the specific examples of the above-described monomer having an ethylenically unsaturated bond.

Table 2

| Exemplary compound | Monomer a | Weight ratio (wt%) | Monomer b | Weight ratio (wt%) | Molecular weight (Mw) | Mw/Mn |
|---|---|---|---|---|---|---|
| P1 | a-1 | 94 | b-2 | 6 | 16000 | 1.5 |
| P2 | a-1 | 69 | b-2 | 31 | 15000 | 1.6 |
| P3 | a-1 | 54 | b-2 | 46 | 12000 | 1.8 |
| P4 | a-1 | 85 | b-1 | 15 | 15000 | 1.5 |
| P5 | a-1 | 85 | b-1 | 15 | 22000 | 1.5 |

(continued)

| Exemplary compound | Monomer a | Weight ratio (wt%) | Monomer b | Weight ratio (wt%) | Molecular weight (Mw) | Mw/Mn |
|---|---|---|---|---|---|---|
| P6 | a-1 | 65 | b-1 | 35 | 17000 | 1.4 |
| P7 | a-1 | 85 | b-3 | 15 | 17000 | 1.7 |
| P8 | a-1 | 70 | b-3 | 30 | 11000 | 1.7 |
| P9 | a-1 | 85 | b-4 | 15 | 12000 | 1.6 |
| P10 | a-1 | 85 | b-5 | 15 | 18000 | 1.9 |
| P11 | a-1 | 70 | b-5 | 30 | 13000 | 1.4 |
| P12 | a-1 | 65 | b-5 | 35 | 25000 | 2.1 |
| P13 | a-1 | 85 | b-6 | 15 | 16000 | 1.7 |
| P14 | a-1 | 85 | b-7 | 15 | 14000 | 1.9 |
| P15 | a-1 | 70 | b-7 | 30 | 9000 | 1.8 |
| P16 | a-2 | 69 | b-2 | 31 | 24000 | 2.2 |
| P17 | a-2 | 54 | b-2 | 46 | 20000 | 1.9 |
| P18 | a-2 | 85 | b-1 | 15 | 15000 | 1.6 |
| P19 | a-2 | 85 | b-1 | 15 | 13000 | 1.3 |
| P20 | a-3 | 90 | b-1 | 10 | 16000 | 1.1 |
| P21 | a-3 | 90 | b-2 | 10 | 13000 | 1.5 |
| P22 | a-3 | 85 | b-3 | 15 | 16000 | 1.7 |
| P23 | a-3 | 80 | b-7 | 20 | 19000 | 1.5 |
| P24 | a-4 | 90 | b-2 | 10 | 18000 | 2.5 |
| P25 | a-4 | 85 | b-5 | 15 | 15000 | 1.3 |

Table 3

| Exemplary compound | Monomer a | Weight ratio (wt%) | Monomer b | Weight ratio (wt%) | Molecular weight (Mw) | Mw/Mn |
|---|---|---|---|---|---|---|
| P26 | a-13 | 90 | b-2 | 10 | 10000 | 1.4 |
| P27 | a-13 | 85 | b-2 | 15 | 19000 | 1.3 |
| P28 | a-13 | 90 | b-1 | 10 | 24000 | 2.0 |
| P29 | a-13 | 85 | b-1 | 15 | 15000 | 1.5 |
| P30 | a-13 | 85 | b-5 | 15 | 17000 | 1.2 |
| P31 | a-13 | 85 | b-6 | 15 | 17000 | 1.4 |
| P32 | a-13 | 85 | b-7 | 15 | 11000 | 1.5 |
| P33 | a-13 | 90 | b-7 | 10 | 13000 | 1.7 |
| P34 | a-13 | 90 | b-3 | 10 | 9000 | 1.6 |
| P35 | a-13 | 85 | b-3 | 15 | 18000 | 1.9 |
| P36 | a-13 | 70 | b-3 | 30 | 13000 | 1.4 |
| P37 | a-14 | 90 | b-2 | 10 | 25000 | 1.8 |
| P38 | a-14 | 85 | b-2 | 15 | 8500 | 1.7 |

(continued)

| Exemplary compound | Monomer a | Weight ratio (wt%) | Monomer b | Weight ratio (wt%) | Molecular weight (Mw) | Mw/Mn |
|---|---|---|---|---|---|---|
| P39 | a-14 | 85 | b-2 | 15 | 28000 | 1.7 |
| P40 | a-14 | 90 | b-1 | 10 | 10000 | 1.8 |
| P41 | a-14 | 85 | b-1 | 15 | 24000 | 2.2 |
| P42 | a-14 | 85 | b-1 | 15 | 13000 | 1.9 |
| P43 | a-14 | 85 | b-7 | 15 | 16000 | 1.5 |
| P44 | a-14 | 85 | b-7 | 15 | 14000 | 1.4 |
| P45 | a-14 | 90 | b-5 | 10 | 16000 | 1.2 |
| P46 | a-14 | 80 | b-5 | 20 | 15000 | 1.5 |
| P47 | a-15 | 90 | b-1 | 15 | 18000 | 1.4 |
| P48 | a-15 | 85 | b-1 | 20 | 19000 | 1.2 |
| P49 | a-16 | 90 | b-1 | 10 | 18000 | 1.3 |
| P50 | a-16 | 85 | b-1 | 15 | 15000 | 1.3 |

Table 4

| Exemplary compound | Monomer a | Weight ratio (wt%) | Monomer b | Weight ratio (wt%) | Molecular weight (Mw) | Mw/Mn |
|---|---|---|---|---|---|---|
| P51 | a-9 | 95 | b-2 | 5 | 16000 | 1.5 |
| P52 | a-9 | 90 | b-2 | 10 | 13000 | 1.1 |
| P53 | a-9 | 95 | b-1 | 5 | 17000 | 1.4 |
| P54 | a-9 | 90 | b-1 | 10 | 15000 | 1.5 |
| P55 | a-9 | 100 | - | - | 19000 | 1.9 |
| P56 | a-10 | 95 | b-2 | 5 | 16000 | 1.0 |
| P57 | a-10 | 90 | b-2 | 10 | 11000 | 1.6 |
| P58 | a-10 | 95 | b-1 | 5 | 12000 | 1.8 |
| P59 | a-10 | 90 | b-1 | 10 | 13000 | 2.1 |
| P60 | a-10 | 100 | - | - | 10000 | 1.6 |
| P61 | a-11 | 95 | b-2 | 5 | 11000 | 1.7 |
| P62 | a-11 | 90 | b-2 | 10 | 16000 | 1.6 |
| P63 | a-11 | 95 | b-1 | 5 | 12000 | 1.5 |
| P64 | a-11 | 90 | b-1 | 10 | 17000 | 1.8 |
| P65 | a-11 | 100 | - | - | 14000 | 1.3 |
| P66 | a-12 | 95 | b-2 | 5 | 9000 | 1.8 |
| P67 | a-12 | 90 | b-2 | 10 | 15000 | 1.0 |
| P68 | a-12 | 95 | b-1 | 5 | 12000 | 1.1 |
| P69 | a-12 | 90 | b-1 | 10 | 17000 | 1.9 |
| P70 | a-12 | 100 | - | - | 9000 | 1.6 |
| P71 | a-21 | 95 | b-2 | 5 | 14000 | 1.5 |

(continued)

| Exemplary compound | Monomer a | Weight ratio (wt%) | Monomer b | Weight ratio (wt%) | Molecular weight (Mw) | Mw/Mn |
|---|---|---|---|---|---|---|
| P72 | a-21 | 90 | b-2 | 10 | 13000 | 1.4 |
| P73 | a-21 | 95 | b-1 | 5 | 19000 | 1.2 |
| P74 | a-21 | 90 | b-1 | 10 | 13000 | 1.2 |
| P75 | a-21 | 100 | - | - | 8000 | 1.9 |

Table 5

| Exemplary compound | Monomer a | Weight ratio (wt%) | Monomer b | Weight ratio (wt%) | Molecular weight (Mw) | Mw/Mn |
|---|---|---|---|---|---|---|
| P76 | a-22 | 95 | b-2 | 5 | 14000 | 1.3 |
| P77 | a-22 | 90 | b-2 | 10 | 16000 | 1.5 |
| P78 | a-22 | 95 | b-1 | 5 | 22000 | 1.9 |
| P79 | a-22 | 90 | b-1 | 10 | 14000 | 1.6 |
| P80 | a-22 | 100 | - | - | 9000 | 1.4 |
| P81 | a-23 | 95 | b-2 | 5 | 12000 | 1.1 |
| P82 | a-23 | 90 | b-2 | 10 | 19000 | 1.3 |
| P83 | a-23 | 95 | b-1 | 5 | 18000 | 1.9 |
| P84 | a-23 | 90 | b-1 | 10 | 18000 | 1.7 |
| P85 | a-23 | 100 | - | - | 13000 | 1.5 |
| P86 | a-24 | 95 | b-2 | 5 | 15000 | 1.9 |
| P87 | a-24 | 90 | b-2 | 10 | 13000 | 1.4 |
| P88 | a-24 | 95 | b-1 | 5 | 13000 | 1.5 |
| P89 | a-24 | 90 | b-1 | 10 | 12000 | 1.6 |
| P90 | a-24 | 100 | - | - | 10000 | 1.3 |
| P91 | a-5 | 90 | b-2 | 10 | 26000 | 1.2 |
| P92 | a-5 | 90 | b-1 | 10 | 17000 | 1.4 |
| P93 | a-6 | 90 | b-2 | 10 | 11000 | 1.9 |
| P94 | a-6 | 90 | b-1 | 10 | 16000 | 1.4 |
| P95 | a-7 | 90 | b-2 | 10 | 15000 | 1.5 |
| P96 | a-7 | 90 | b-1 | 10 | 19000 | 1.3 |
| P97 | a-8 | 90 | b-2 | 10 | 13000 | 1.7 |
| P98 | a-8 | 90 | b-1 | 10 | 15000 | 1.5 |
| P99 | a-17 | 90 | b-2 | 10 | 12000 | 1.6 |
| P100 | a-17 | 90 | b-1 | 10 | 13000 | 1.2 |

Table 6

| Exemplary compound | Monomer a | Weight ratio (wt%) | Monomer a | Weight ratio (wt%) | Monomer b | Weight ratio (wt%) | Molecular weight (Mw) | Mw/Mn |
|---|---|---|---|---|---|---|---|---|
| P101 | a-1 | 35 | a-9 | 55 | b-2 | 10 | 13000 | 1.3 |
| P102 | a-1 | 35 | a-10 | 45 | b-2 | 10 | 19000 | 1.5 |
| P103 | a-1 | 35 | a-21 | 45 | b-1 | 10 | 15000 | 1.5 |
| P104 | a-1 | 35 | a-22 | 45 | b-1 | 10 | 12000 | 1.4 |
| P105 | a-1 | 25 | a-21 | 75 | - | - | 9000 | 1.2 |
| P106 | a-2 | 35 | a-9 | 45 | b-2 | 10 | 16000 | 1.6 |
| P107 | a-2 | 35 | a-10 | 45 | b-2 | 10 | 17000 | 1.5 |
| P108 | a-2 | 35 | a-21 | 45 | b-1 | 10 | 14000 | 1.7 |
| P109 | a-2 | 35 | a-22 | 45 | b-1 | 10 | 13000 | 1.3 |
| P110 | a-2 | 25 | a-21 | 75 | - | - | 10000 | 1.1 |
| P111 | a-3 | 35 | a-9 | 45 | b-2 | 10 | 13000 | 1.9 |
| P112 | a-3 | 35 | a-10 | 45 | b-2 | 10 | 15000 | 1.6 |
| P113 | a-3 | 35 | a-21 | 45 | b-1 | 10 | 14000 | 1.5 |
| P114 | a-3 | 35 | a-22 | 45 | b-1 | 10 | 15000 | 1.3 |
| P115 | a-3 | 25 | a-21 | 75 | - | - | 11000 | 1.7 |
| P116 | a-13 | 35 | a-9 | 45 | b-2 | 10 | 16000 | 1.3 |
| P117 | a-13 | 35 | a-10 | 45 | b-1 | 10 | 11000 | 1.2 |
| P118 | a-13 | 35 | a-21 | 45 | b-2 | 10 | 12000 | 1.6 |
| P119 | a-13 | 35 | a-22 | 45 | b-1 | 10 | 18000 | 1.5 |
| P120 | a-13 | 25 | a-21 | 75 | - | - | 8000 | 1.7 |
| P121 | a-14 | 35 | a-9 | 45 | b-1 | 10 | 13000 | 1.8 |
| P122 | a-14 | 35 | a-10 | 45 | b-2 | 10 | 16000 | 1.7 |
| P123 | a-14 | 35 | a-21 | 45 | b-1 | 10 | 18000 | 1.2 |
| P224 | a-14 | 35 | a-22 | 45 | b-2 | 10 | 17000 | 1.4 |
| P125 | a-14 | 25 | a-21 | 75 | - | - | 13000 | 1.6 |

Table 7

| Exemplary compound | Monomer a | Weight ratio (wt%) | Monomer b | Weight ratio (wt%) | Monomer b | Weight ratio (wt%) | Molecular weight (Mw) | Mw/Mn |
|---|---|---|---|---|---|---|---|---|
| P126 | a-1 | 85 | b-1 | 10 | b-2 | 5 | 22000 | 1.8 |
| P127 | a-1 | 85 | b-1 | 10 | b-3 | 5 | 17000 | 1.3 |
| P128 | a-1 | 85 | b-2 | 10 | b-3 | 5 | 14000 | 1.5 |
| P129 | a-1 | 85 | b-2 | 10 | b-7 | 5 | 20000 | 1.4 |
| P130 | a-1 | 85 | b-2 | 10 | b-5 | 5 | 15000 | 1.6 |
| P131 | a-2 | 85 | b-1 | 10 | b-2 | 5 | 13000 | 1:9 |
| P132 | a-2 | 85 | b-1 | 10 | b-3 | 5 | 17000 | 1.3 |

(continued)

| Exemplary compound | Monomer a | Weight ratio (wt%) | Monomer b | Weight ratio (wt%) | Monomer b | Weight ratio (wt%) | Molecular weight (Mw) | Mw/Mn |
|---|---|---|---|---|---|---|---|---|
| P133 | a-2 | 85 | b-2 | 10 | b-3 | 5 | 18000 | 1.7 |
| P134 | a-2 | 85 | b-2 | 10 | b-7 | 5 | 14000 | 1:8 |
| P135 | a-2 | 85 | b-2 | 10 | b-5 | 5 | 15000 | 1.9 |
| P136 | a-3 | 85 | b-1 | 10 | b-2 | 5 | 20000 | 2.5 |
| P137 | a-3 | 85 | b-1 | 10 | b-3 | 5 | 13000 | 1.7 |
| P138 | a-3 | 85 | b-2 | 10 | b-3 | 5 | 15000 | 1.4 |
| P139 | a-3 | 85 | b-2 | 10 | b-7 | 5 | 18000 | 1.5 |
| P140 | a-3 | 85 | b-2 | 10 | b-5 | 5 | 14000 | 1.6 |
| P141 | a-13 | 85 | b-1 | 10 | b-2 | 5 | 12000 | 1.8 |
| P142 | a-13 | 85 | b-1 | 10 | b-3 | 5 | 19000 | 1.4 |
| P143 | a-13 | 85 | b-2 | 10 | b-3 | 5 | 13000 | 1:7 |
| P144 | a-13 | 85 | b-2 | 10 | b-7 | 5 | 16000 | 1.2 |
| P145 | a-13 | 85 | b-2 | 10 | b-5 | 5 | 17000 | 1.8 |
| P146 | a-14 | 85 | b-1 | 10 | b-2 | 5 | 14000 | 1.6 |
| P147 | a-1.4 | 85 | b-1 | 10 | b-3 | 5 | 19000 | 1.7 |
| P148 | a-14 | 85 | b-2 | 10 | b-3 | 5 | 15000 | 1.3 |
| P149 | a-14 | 85 | b-2 | 10 | b-7 | 5 | 11000 | 1.6 |
| P150 | a-14 | 85 | b-2 | 10 | b-5 | 5 | 13000 | 1:8 |

Table 8

| Exemplary compound | Monomer a | Weight ratio (wt%) | Monomer b | Weight ratio (wt%) | Monomer b | Weight ratio (wt%) | Molecular weight (Mw) | Mw/Mn |
|---|---|---|---|---|---|---|---|---|
| P151 | a-9 | 90 | b-8 | 5 | b-2 | 5 | 15000 | 1.3 |
| P152 | a-9 | 90 | b-10 | 5 | b-2 | 5 | 17000 | 1.6 |
| P153 | a-9 | 90 | b-11 | 5 | b-2 | 5 | 19000 | 1.8 |
| P154 | a-9 | 90 | b-12 | 5 | b-2 | 5 | 14000 | 1.5 |
| P155 | a-9 | 90 | b-13 | 5 | b-2 | 5 | 16000 | 1.8 |
| P156 | a-10 | 90 | b-8 | 5 | b-2 | 5 | 13000 | 1.6 |
| P157 | a-10 | 90 | b-10 | 5 | b-2 | 5 | 19000 | 1.1 |
| P158 | a-10 | 90 | b-11 | 5 | b-2 | 5 | 12000 | 1.8 |
| P159 | a-10 | 90 | b-12 | 5 | b-2 | 5 | 15000 | 1.9 |
| P160 | a-10 | 90 | b-13 | 5 | b-2 | 5 | 14000 | 1.7 |
| P161 | a-11 | 90 | b-8 | 5 | b-2 | 5 | 19000 | 2.1 |
| P162 | a-11 | 90 | b-10 | 5 | b-2 | 5 | 7000 | 1.9 |
| P163 | a-11 | 90 | b-11 | 5 | b-2 | 5 | 15000 | 1.5 |
| P164 | a-11 | 90 | b-12 | 5 | b-2 | 5 | 16000 | 1.7 |

(continued)

| Exemplary compound | Monomer a | Weight ratio (wt%) | Monomer b | Weight ratio (wt%) | Monomer b | Weight ratio (wt%) | Molecular weight (Mw) | Mw/Mn |
|---|---|---|---|---|---|---|---|---|
| P165 | a-11 | 90 | b-13 | 5 | b-2 | 5 | 12000 | 2.3 |
| P166 | a-21 | 90 | b-8 | 5 | b-2 | 5 | 17000 | 1.5 |
| P167 | a-21 | 90 | b-10 | 5 | b-2 | 5 | 15000 | 1.7 |
| P168 | a-21 | 90 | b-11 | 5 | b-2 | 5 | 14000 | 1.7 |
| P169 | a-21 | 90 | b-12 | 5 | b-2 | 5 | 18000 | 1.8 |
| P170 | a-21 | 90 | b-13 | 5 | b-2 | 5 | 15000 | 1.3 |
| P171 | a-22 | 90 | b-8 | 5 | b-2 | 5 | 17000 | 1.6 |
| P172 | a-22 | 90 | b-10 | 5 | b-2 | 5 | 15000 | 1.4 |
| P173 | a-22 | 90 | b-11 | 5 | b-2 | 5 | 11000 | 1.8 |
| P174 | a-22 | 90 | b-12 | 5 | b-2 | 5 | 18000 | 1.3 |
| P175 | a-22 | 90 | b-13 | 5 | b-2 | 5 | 14000 | 1.7 |

Table 9

| Exemplary compound | Monomer a | Weight ratio (wt%) | Monomer b | Weight ratio (wt%) | Initiator (mol%) | Molecular weight (Mw) | Mw/Mn |
|---|---|---|---|---|---|---|---|
| P176 | J-1 | 88.1 | b-2 | 11.9 | 20 | 8000 | 1.3 |
| P177 | J-1 | 88.1 | b-2 | 11.9 | 24 | 7000 | 1.3 |
| P178 | J-1 | 88.1 | b-2 | 11.9 | 18 | 9000 | 1.5 |
| P179 | J-1 | 88.1 | b-2 | 11.9 | 15 | 10000 | 1.2 |
| P180 | J-1 | 88.1 | b-2 | 11.9 | 12 | 12000 | 1.5 |
| P181 | J-1 | 88.1 | b-2 | 11.9 | 10 | 15000 | 1.4 |
| P182 | J-1 | 88.1 | b-2 | 11.9 | 8 | 17000 | 1.7 |
| P183 | J-1 | 88.1 | b-2 | 11.9 | 5 | 19000 | 1.3 |
| P184 | J-1 | 89.4 | b-2 | 10.6 | 10 | 9000 | 1.4 |
| P185 | J-1 | 90.8 | b-2 | 9.2 | 10 | 9000 | 1.4 |
| P186 | J-1 | 92.2 | b-2 | 7.8 | 10 | 10000 | 1.4 |
| P187 | J-1 | 93.7 | b-2 | 6.3 | 10 | 10000 | 1.4 |
| P188 | J-1 | 95.2 | b-2 | 4.8 | 16 | 8000 | 1.3 |
| P189 | J-1 | 96.7 | b-2 | 3.27 | 4 | 11000 | 1.4 |
| P190 | J-1 | 88 | b-7 | 12 | 20 | 10000 | 1.6 |
| P191 | J-1 | 88 | b-1 | 12 | 20 | 9000 | 1.3 |
| P192 | J-2 | 88.1 | b-2 | 11.9 | 20 | 10000 | 1.5 |
| P193 | J-6 | 88.1 | b-2 | 11.9 | 20 | 11000 | 1.2 |
| P194 | J-6 | 88.1 | b-7 | 11.9 | 5 | 8000 | 1.3 |
| P195 | J-11 | 88.1 | b-2 | 11.9 | 4 | 9000 | 1.3 |
| P196 | J-13 | 88.1 | b-7 | 11.9 | 20 | 15000 | 1.4 |

(continued)

| Exemplary compound | Monomer a | Weight ratio (wt%) | Monomer b | Weight ratio (wt%) | Initiator (mol%) | Molecular weight (Mw) | Mw/Mn |
|---|---|---|---|---|---|---|---|
| P197 | J-21 | 88.1 | b-2 | 11.9 | 20 | 13000 | 1.5 |
| P198 | J-23 | 88.1 | b-2 | 11.9 | 10 | 9000 | 1.3 |
| P199 | J-24 | 88.1 | b-1 | 11.9 | 10 | 7000 | 1.2 |
| P200 | J-25 | 88.1 | b-2 | 11.9 | 10 | 10000 | 1.2 |

Table 10

| Exemplary compound | Monomer a | Weight ratio (wt%) | Monomer b | Weight ratio (wt%) | Initiator (mol%) | Molecular weight (Mw) | Mw/Mn |
|---|---|---|---|---|---|---|---|
| P201 | K-1 | 80.3 | b-2 | 19.7 | 6 | 8800 | 2.2 |
| P202 | K-1 | 84.5 | b-2 | 15.5 | 6 | 7000 | 2.8 |
| P203 | K-2 | 80.3 | b-2 | 19.7 | 6 | 8000 | 1.8 |
| P204 | K-2 | 84.5 | b-2 | 15.5 | 6 | 7000 | 1.5 |
| P205 | K-3 | 80.3 | b-2 | 19.7 | 6 | 12000 | 2 |
| P206 | K-3 | 84.5 | b-2 | 15.5 | 6 | 9000 | 1.7 |
| P207 | K-4 | 80.3 | b-2 | 19.7 | 6 | 86000 | 1.8 |
| P208 | K-4 | 84.5 | b-2 | 15.5 | 6 | 9500 | 1.5 |
| P209 | K-5 | 80.3 | b-2 | 19.7 | 6 | 10500 | 1.4 |
| P210 | K-5 | 84.5 | b-2 | 15.5 | 6 | 9000 | 2.2 |
| P211 | K-6 | 80.3 | b-2 | 19.7 | 6 | 7000 | 1.9 |
| P212 | K-6 | 84.5 | b-2 | 15.5 | 6 | 7500 | 1.9 |
| P213 | K-7 | 80.3 | b-2 | 19.7 | 6 | 8200 | 2.3 |
| P214 | K-7 | 84.5 | b-2 | 15.5 | 6 | 7800 | 1.8 |
| P215 | K-8 | 80.3 | b-2 | 19.7 | 6 | 6800 | 1.8 |
| P216 | K-8 | 84.5 | b-2 | 15.5 | 6 | 9100 | 1.8 |
| P217 | K-9 | 80.3 | b-2 | 19.7 | 6 | 8600 | 2.3 |
| P218 | K-9 | 84.5 | b-2 | 15.5 | 6 | 7300 | 1.7 |
| P219 | K-10 | 80.3 | b-2 | 19.7 | 6 | 7700 | 1.6 |
| P220 | K-10 | 84.5 | b-2 | 15.5 | 6 | 9000 | 1.6 |
| P221 | K-11 | 80.3 | b-2 | 19.7 | 6 | 6900 | 1.5 |
| P222 | K-11 | 84.5 | b-2 | 15.5 | 6 | 8900 | 1.9 |
| P223 | K-12 | 80.3 | b-2 | 19.7 | 6 | 11000 | 2 |
| P224 | K-12 | 84.5 | b-2 | 15.5 | 6 | 7900 | 1.8 |
| P225 | K-13 | 80.3 | b-2 | 19.7 | 6 | 9500 | 1.9 |
| P226 | K-13 | 84.5 | b-2 | 15.5 | 6 | 8100 | 1.7 |
| P227 | K-14 | 80.3 | b-2 | 19.7 | 6 | 7300 | 2.4 |
| P228 | K-14 | 84.5 | b-2 | 15.5 | 6 | 8200 | 1.9 |

Examples of the synthetic methods of some of the above-described specific examples of the colorant multimers are shown below, but the invention is not particularly limited to these examples.

*Synthesis of Exemplary Compound P2*

3.45 g of monomer a-1, 1.55 g of monomer b-2 and 420 mg of n-dodecanethiol were dissolved in 28.3 mL of propyleneglycol monomethylether acetate (PGMEA). The mixture was stirred at 85°C under nitrogen gas atmosphere, and then 478 mg of dimethyl-2,2'-azobis(2-methylpropionate) was added thereto. Thereafter, 478 mg of dimethyl-2,2'-azobis(2-methylpropionate) was added to the solution twice more after an interval of two hours each time, the reaction liquid was heated to 90°C, and was further stirred for 2 hours. After finishing the reaction, the reaction liquid was dropped into 400 mL of acetonitrile, and the obtained crystal was filtered, thereby obtaining 4.11 g of Exemplary compound P2.

*Synthesis of Exemplary compound P54*

4.5 g of monomer a-9, 0.5 g of monomer b-1 and 210 mg of n-dodecanethiol were dissolved in 28.3 mL of propyleneglycol monomethylether acetate (PGMEA). The mixture was stirred at 85°C under nitrogen gas atmosphere, and then 239 mg of dimethyl-2,2'-azobis(2-methylpropionate) was added thereto. Thereafter, 239 mg each of dimethyl-2,2'-azobis(2-methylpropionate) was added to the solution every two hours twice, the reaction liquid was heated to 90°C, and was further stirred for 2 hours.

After finishing the reaction, the reaction liquid was dropped into 400 mL of acetonitrile, and the obtained crystal was filtered, thereby obtaining 3.21 g of Exemplary compound P54.

*Synthesis of Exemplary compound P63*

4.75 g of monomer a-11, 0.25 g of monomer b-1 and 147 mg of n-dodecanethiol were dissolved in 28.3 mL of propyleneglycol monomethylether acetate (PGMEA). The mixture was stirred at 85°C under nitrogen gas atmosphere, and then 167 mg of dimethyl-2,2'-azobis(2-methylpropionate) was added thereto. Thereafter, 167 mg each of dimethyl-2,2'-azobis(2-methylpropionate) was added to the solution every two hours twice, the reaction liquid was heated to 90°C, and was further stirred for 2 hours. After finishing the reaction, the reaction liquid was dropped into 400 mL of acetonitrile, and the obtained crystal was filtered, thereby obtaining 3.61 g of Exemplary Compound P63.

*Synthesis of Exemplary Compound P67*

4.5 g of monomer a-12, 0.5 g of monomer b-2 and 191 mg of n-dodecanethiol were dissolved in 28.3 mL of propyleneglycol monomethylether acetate (PGMEA). The mixture was stirred at 85°C under nitrogen gas atmosphere, and then 218 mg of dimethyl-2,2'-azobis(2-methylpropionate) was added thereto. Thereafter, 218 mg each of dimethyl-2,2'-azobis(2-methylpropionate) was added to the solution every two hours twice, the reaction liquid was heated to 90°C, and was further stirred for 2 hours.

After the termination of the reaction, the reaction liquid was dropped into 400 mL of acetonitrile, and the obtained crystal was filtered, thereby obtaining 2.75 g of Exemplary Compound P67.

*Synthesis of Exemplary Compound P74*

4.5 g of monomer a-21, 0.5 g of monomer b-1, and 212 mg of n-dodecanethiol were dissolved in 28.3 mL of propyleneglycol monomethylether acetate (PGMEA). The mixture was stirred at 85°C under nitrogen gas atmosphere, and then 242 mg of dimethyl-2,2'-azobis(2-methylpropionate) was added thereto. Thereafter, 242 mg each of dimethyl-2,2'-azobis(2-methylpropionate) was added to the solution every two hours twice, the reaction liquid was heated to 90°C, and was further stirred for 2 hours.

After finishing the reaction, the reaction liquid was dropped into 400 mL of acetonitrile, and the obtained crystal was filtered, thereby obtaining 3.78 g of Exemplary Compound P74.

*Synthesis of Exemplary Compound P153*

4.5 g of monomer a-9, 0.25 g of monomer b-11, 0.25 g of monomer b-2, and 157 mg of n-dodecanethiol were dissolved in 28.3 mL of propyleneglycol monomethylether acetate (PGMEA). The mixture was stirred at 85°C under nitrogen gas atmosphere, and then 178 mg of dimethyl-2,2'-azobis(2-methylpropionate) was added thereto. Thereafter, 178 mg each of dimethyl-2,2'-azobis(2-methylpropionate) was added to the solution every two hours twice, the reaction liquid was heated to 90°C, and was further stirred for 2 hours. After finishing the reaction, the reaction liquid was dropped

into 400 mL of acetonitrile, and the obtained crystal was filtered, thereby obtaining 4.39 g of Exemplary Compound P153.

*Synthesis of Exemplary Compound P-176*

11.7 g of Exemplary Compound J-1, 1.58 g of methacrylic acid, 0.56 g of dodecanethiol were dissolved in 75.0 g of propyleneglycol monomethylether acetate (PGMEA). To this solution, while stirring at 85°C, a solution of 23.3 g of Exemplary compound J-1, 3.16 g of methacrylic acid, 1.11 g of dodecanethiol, and 3.8 g of dimethyl-2,2'-azobis(2-methylpropionate) dissolved in 150 g of propyleneglycol monomethylether acetate (PGMEA), was dropped over 3 hours. 4 hours after the start of the dropping, 1.14 g of dimethyl-2,2'-azobis(2-methylpropionate) was added to this reaction liquid, and then the mixture was further stirred at 85°C for 2 hours. Thereafter, 811 mL of PGMEA and 1081 mL of methanol were added to the reaction solution, and the reaction liquid was dropped into 4326 mL of acetonitrile while stirring. The precipitated crystal was filtered, and the obtained crystal was dried under reduced pressure, thereby obtaining 12.6 g of Exemplary Compound P-176.

*Synthesis of Exemplary Compound S-4*

The following Q-1 was synthesized in a manner similar to the synthesis of Exemplary Compound J-1, except that 3-mercapto-1-propanol used in the synthesis of Compound 11, which is an intermediate of Exemplary Compound J-1, was changed to 2-mercapto ethanol.

The structure of Q-1 was confirmed by $^1$H-NMR.

Exemplary Compound Q-1: $^1$H-NMR, 400 MHz, $\delta$ (DMSO-$d_6$) ppm: 0.91 (36H, s), 1.15 (6H, d), 1.21 - 2.17 (40H, m), 2.07 - 3.05 (6H, m), 3.61 - 3.84 (2H, m), 4.28 - 4.33 (3H, m), 5.56 (1H, br), 6.01 - 6.12 (3H, br), 7.78 (1H, s), 11.03 (1H, br), 11.83 - 12.25 (1H, br).

11.6 g of the obtained Q-1, 1.58 g of methacrylic acid, and 0.56 g of dodecane thiol were dissolved in 75.0 g of propyleneglycol monomethylether acetate (PGMEA). To this solution, while stirring at 85°C, a solution of 23.3 g of Q-1, 3.16 g of methacrylic acid, 1.11 g of dodecanethiol, and 3.8 g of dimethyl-2,2'-azobis(2-methylpropionate) dissolved in 150 g of propyleneglycol monomethylether acetate (PGMEA), was dropped over 3 hours. 4 hours after the start of the dropping, 1.14 g of dimethyl-2,2'-azobis(2-methylpropionate) was added to this reaction liquid, and the mixture was further stirred at 85°C for 2 hours. 811 mL of PGMEA and 1081 mL of methanol were added to the reaction solution, and the reaction liquid was dropped into 4326 mL of acetonitrile while stirring. The precipitated crystal was filtered, and the obtained crystal was dried under reduced pressure, thereby obtaining 13.2 g of Exemplary Compound S-4.

The structure of S-4 was confirmed by $^1$H-NMR by the disappearance of the peak at 5.56 - 6.12, which corresponds to the polymerizable group moiety of Q-1, and confirmed by an acid value measurement by confirming the introduction of methacrylic acid.

(Q-1)

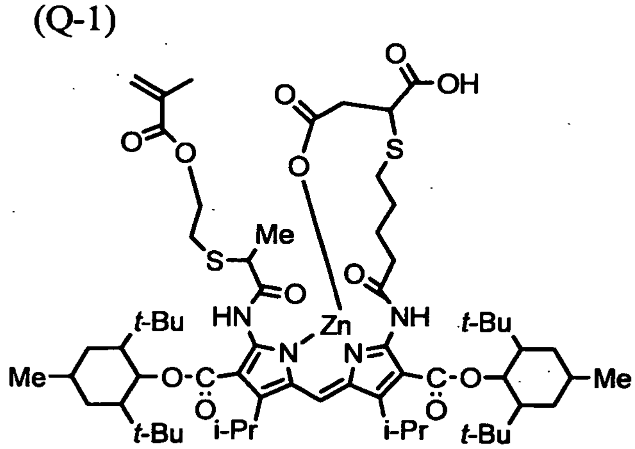

*Synthesis of Exemplary Compound S-16*

The following Q-2 was synthesized in a manner similar to the synthesis of Exemplary Compound J-1, except that 3-mercapto-1-propanol used in the synthesis of Compound 11, which is an intermediate of Exemplary Compound J-1, was changed to 2-mercaptoethanol, and pivaloyl chloride was used in place of chlorovaleryl chloride for synthesizing the intermediate 13.

The structure of Q-2 was confirmed by $^1$H-NMR.

Exemplary Compound Q-2: $^1$H-NMR, 400 MHz, δ (DMSO-$d_6$) ppm: 0.88 (42H, s), 1.11 - 1.67 (45H, m), 2.97 (2H, m), 3.61 - 3.84 (2H, m), 4.27 - 4.36 (3H, m), 5.56 (1H, s), 6.02 (2H, s), 6.12 (1H, s), 7.78 (1H, s), 11.36 - 11.83 (2H, br).

1.8 g of a copolymer of methacrylic acid and methyl methacrylate (weight ratio is 2 :1), which was synthesized separately, was dissolved in 100 g of N-methylpyrrolidone. 8.2 g of the obtained Q-2 was added to this solution, and the mixture was stirred at 40°C for 1 hour. 500 mL of methanol was added to the reaction solution, and the reaction liquid was dropped into 800 mL of acetonitrile while stirring. The precipitated crystal was filtered, and the obtained crystal was dried under reduced pressure, thereby obtaining 8.8 g of Exemplary Compound S-16.

The structure of S-16 was confirmed by $^1$H-NMR by the disappearance of the peak of the polymerizable group moiety of Q-2 and the disappearance of the acetic acid ion being substituted, and confirmed by an acid value measurement by confirming the introduction of methacrylic acid.

(Q-2)

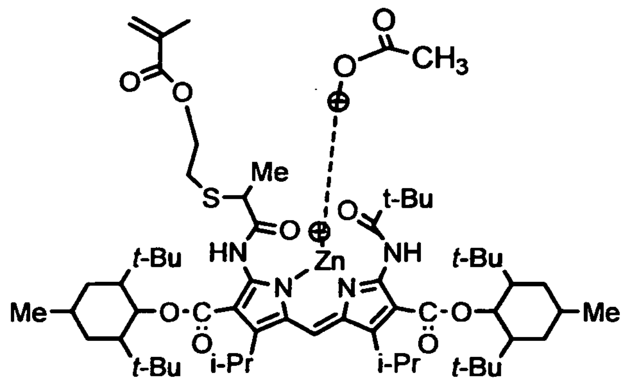

*Synthesis of Exemplary Compound S-20*

The following Q-3 was obtained by a method in which an alcohol obtained by using 3-mercapto-1-propanol instead of 2-mercapto ethanol in the synthesis of Compound 11 (an intermediate of Exemplary Compound J-1) is coupled with ethyl orthoformate and trifluoroacetic acid, and the coupled product was complexed with zinc acetate. 11.5 g of the obtained Q-3 and 2.5 g of a commercially available diisocyanate were mixed in 100 mL of N-methyl pyrrolidone, and the mixture was stirred at 40°C for 4 hours. Thereafter, 500 mL of methanol was added to the reaction solution, and the resultant liquid was dropped into 800 mL of acetonitrile while stirring. The precipitated crystal was filtered, and the obtained crystal was dried under reduced pressure, thereby obtaining 7.6 g of Exemplary Compound S-20.

(Q-3)

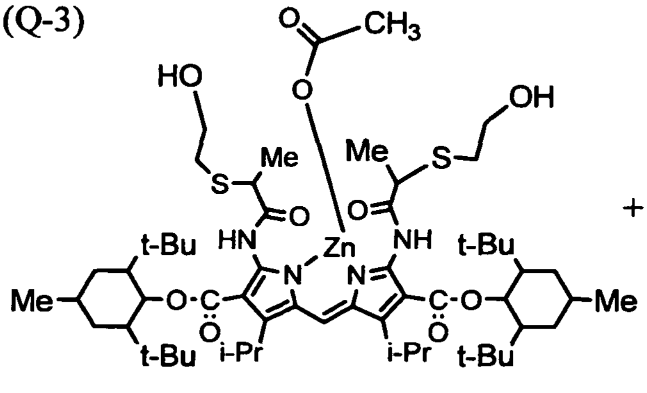

+

(Q-4)

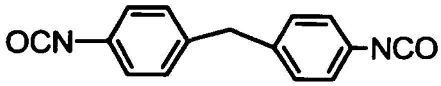

*Synthesis of Exemplary compound S-26*

11.7 g of Q-5 synthesized by coupling of Compound 13with Compound 15 (both of which are intermediates of Exemplary Compound J-1) and forming a complex with zinc, 1.1 g of a commercial tetramercapto compound Q-6, and 7.5 g of diazabicycloundecene (DBU) were mixed in 100 mL of N-methylpyrrolidone, and the mixture was stirred at 40°C for 4 hours. Thereafter, 500 mL of methanol was added to the reaction solution, and the resultant liquid was dropped into 800 mL of acetonitrile while stirring. The precipitated crystal was filtered, and the obtained crystal was dried under reduced pressure, thereby obtaining 4.2 g of Exemplary Compound S-26.

The structure of the obtained S-26 was confirmed by $^1$H-NMR.

Exemplary compound S-26: $^1$H-NMR, 400 MHz, δ (DMSO-$d_6$) ppm: 0.88 (144H, s), 1.08 - 1.9 (144H, m), 2.1 (36H, s), 2.3 - 3.2 (36H, m), 3.28 (4H, bs), 3.4 - 3.65 (4H, m), 4.23 (8H, bs), 6.03 (4H, s), 7.26 (4H, s), 7.53 (4H, s), 10.59 - 10.63 (8H, br).

(Q-5)

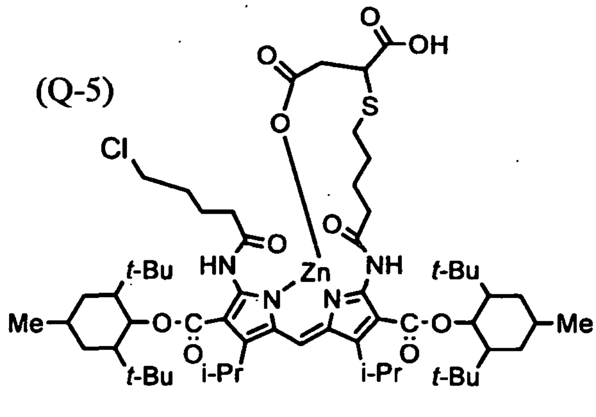

(Q-6)

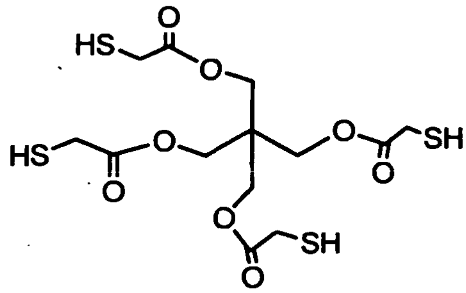

Among the above Exemplary Compounds, from the viewpoint of alkali developability, Exemplary Compounds P51 to P100 and P151 to P 175, Exemplary Compounds S-1 to S-13, Exemplary Compounds K-3 to K-6 and K-9 and K-10 are preferable, and Exemplary Compounds P51 to P90 and P151 to P 175, Exemplary Compounds S-1 to S-13, Exemplary Compound K-3, K-5, K-6, K-9 and K-10 are more preferable.

The molecular weight of the colorant multimer of the invention is preferably in the range of from 5,000 to 30,000 in terms of the weight average molecular weight (Mw), and in the range of from 3,000 to 20,000 in terms of the number average molecular weight (Mn). The molecular weight of the colorant multimer of the invention is more preferably in the range of from 5,000 to 25,000 in terms of the weight average molecular weight (Mw), and in the range of from 3,000 to 17,000 in terms of the number average molecular weight (Mn). The molecular weight of the colorant multimer of the invention is still more preferably in the range of from 5,000 to 20,000 in terms of the weight average molecular weight (Mw), and in the range of from 3,000 to 15,000 in terms of the number average molecular weight (Mn).

From the viewpoint of the developability when the colorant multimer of the invention is used for a colored curable composition to manufacture a color filter, the weight average molecular weight (Mw) of the colorant multimer of the invention is preferably 20,000 or less.

*Colored curable composition*

The colored curable composition according to the first aspect of the invention contains at least one of the colorant multimers of the first aspect of the invention as a colorant. The colored curable composition according to the invention is characterized by being cured with heat, light, or the both of them, and may contain other components such as a polymerization initiator, a solvent, a binder, a crosslinking agent or the like, as necessary.

Due to the characteristics of the dipyrromethene metal complex compound having a specific structure contained in the structure of the colorant multimer of the invention, the colored curable composition according to the invention can form a pixel pattern in a thin film (for example, at a thickness of 1 μm or less). Accordingly, the colored curable composition according to the invention is preferable for forming a color filter for a solid-state image sensor in which high definition with a minute size of 2 μm or less (the edge length of the pixel pattern viewed from the line normal to the substrate is 0.5 μm to 2.0 μm, for example) is required, and a good rectangular cross-sectional profile is required.

In the colored curable composition according to the invention, the colorant multimer may be used singly, or two or more kinds thereof may be used in combination.

The content of the colorant multimer in the colored curable composition according to the invention varies depending on the molecular weight and the molar absorption coefficients of the colorant multimer, and the content of the colorant multimer is preferably from 10% by mass to 70% by mass, more preferably from 10% by mass to 50% by mass, and still more preferably from 15% by mass to 30% by mass, with respect to the total solid content of the colored curable composition.

The colored curable composition and the color filter using the colored curable composition according to the invention may contain a colorant other than the colorant multimer of the invention in addition to the colorant multimer, as long as the effect of the invention is not impaired. Examples of the colorant other than the colorant multimer of the invention include triarylmethane colorants having an absorption maximum in the wavelength region of from 550 nm to 650 nm (such as C.I. Acid Blue 7, C.I. Acid Blue 83, C.I. Acid Blue 90, C.I. Solvent Blue 38, C.I. Acid Violet 17, C.I. Acid

Violet 49 or C.I. Acid Green 3), and xanthene colorants having an absorption maximum in the wavelength range of from 500 nm to 600 nm such as C.I. Acid Red 289.

The content of the triarylmethane colorant is not specifically limited as long as the effect of the invention is not impaired, and preferably from 0.5% by mass to 50% by mass, with respect to the total solid content in the colored curable composition according to the invention.

In order to manufacture a blue filter array, it is preferable to use a mixture of at least one of the colorant multimers and a phthalocyanine.

*Phthalocyanine colorant*

The phthalocyanine colorant used in the invention is not particularly limited so long as it is a colorant having a phthalocyanine backbone. The center metal included in the phthalocyanine colorant is not specifically limited, and may be any metal capable of constituting a phthalocyanine backbone. In particular, magnesium, titanium, iron, cobalt, nickel, copper, zinc and aluminium are preferably used as the center metal.

Specific examples of the phthalocyanine colorant according to the invention include C. I. Pigment Blue 15, C. I. Pigment Blue 15:1, C. I. Pigment Blue 15:2, C. I. Pigment Blue 15:3, C. I. Pigment Blue 15:4, C. I. Pigment Blue 15:5, C. I. Pigment Blue 15:6, C. I. Pigment Blue 16, C. I. Pigment Blue 17:1, C. I. Pigment Blue 75, C. I. Pigment Blue 79, C. I. Pigment Green 7, C. I. Pigment Green 36, C. I. Pigment Green 37, chloroaluminium phthalocyanine, hydroxyaluminium phthalocyanine, aluminium phthalocyanine oxide and zinc phthalocyanine. Among these, C. I. Pigment Blue 15, C. I. Pigment Blue 15:6, C. I. Pigment Blue 15:1 and C. I. Pigment Blue 15:2 are preferable, and C. I. Pigment Blue 15:6 is more preferable in view of light fastness and coloring property.

The content of the phthalocyanine colorant in the colored curable composition according to the invention is preferably from 10% by mass to 70% by mass, more preferably from 20% by mass to 60% by mass, and still more preferably from 35% by mass to 50% by mass with respect to the total solid contents of the colored curable composition.

With regard to the content ratio of the phthalocyanine colorant to the colorant multimer in terms of the dipyrromethene metal complex compound, the ratio of the phthalocyanine colorant to the dipyrromethene metal complex compound (the phthalocyanine colorant: the phthalocyanine colorant to the dipyrromethene metal complex compound) is preferably from 100:5 to 100:100, more preferably from 100:15 to 100:75, and still more preferably from 100:25 to 100:50,).

*Dispersant*

When the colored curable composition according to the invention contains a colorant, the colored curable composition may further contain a dispersant.

As the dispersant, known colorant dispersants and surfactants may be used.

Examples of the dispersant include many kinds of compounds and specific examples thereof include phthalocyanine derivatives (for example, EFKA-745 (trade name), manufactured by EFKA), SOLSPERSE 5000 (trade name, available from Lubrizol Japan Ltd.); cationic surfactants such as KP341 (olgano-siloxane polymer) (trade name, manufactured by Shin-Etsu Chemical Co., Ltd.), POLYFLOWNos. 75, 90, and 95 ((meth)acrylic acid-based (co)polymer) (trade name, all manufactured by Kyoeisha Chemical Co., Ltd.) and W001 (trade name, available from Yusho Co., Ltd.); nonionic surfactants such as polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate and sorbitan fatty acid esters; anionic surfactants such as W004, W005 and W017 (trade names, available from Yusho Co., Ltd.); high-molecular dispersants such as EFKA-46, EFKA-47, EFKA-47EA, EFKA POLYMER 100, EFKA POLYMER 400, EFKA POLYMER 401 and EFKA POLYMER 450 (trade names, manufactured by Morishita & Co., Ltd.); various SOLSPERSE dispersants such as SOLSPERSE 3000, 5000, 9000, 12000, 13240, 13940, 17000, 24000, 26000 and 28000 (trade names, available from Lubrizol Japan Ltd.); ADEKA PLURONIC L31, F38, L42, L44, L61, L64, F68, L72, P95, F77, P84, F87, P94, L101, P103, F108, L121 and P-123 (trade names, manufactured by Adeka Corporation), and ISONET S-20 (trade name, manufactured by Sanyo Chemical Industries, Ltd.).

The content of the dispersant in the colored curable composition according to the invention is preferably from 1% by mass to 80% by mass, more preferably from 5% by mass to 70% by mass, and most preferably from 10% by mass to 60% by mass with respect to the mass of the colorant.

*Polymerizable compound*

The colored curable composition according to the invention may include a polymerizable compound. Examples of the polymerizable compound include an addition-polymerizable compound having at least one ethylenically unsaturated double bond. Specifically, the polymerizable compound is selected from compounds having at least one, preferably

two or more terminal ethylenically unsaturated bonds. Such compounds are widely known in this industrial field, and may be used in the invention without specific limitation. These compounds may have any chemical form of, for example, a monomer, a prepolymer (i.e., a dimer, trimer or oligomer) or a mixture thereof, or a (co)polymer thereof.

Examples of the monomer or the (co)polymer thereof include the specific examples described in the paragraphs [0058] to [0065] of JP-A No. 2008-294982.

Preferable examples of the polymerizable compound include aliphatic alcohol esters such as those described in Japanese Examined Patent Publication (JP-B) No. 51-47334 and JP-A No. 57-196231, compounds having an aromatic backbone such as those described in JP-A Nos. 59-5240, 59-5241 and 2-226149, and compounds having an amino group such as those described in JP-A No. 1-165613.

More specifically, examples of the monomer or the (co)polymer thereof include unsaturated carboxylic acids (such as acrylic acid, methacrylic acid, itaconic acid, crotonic acid, isocrotonic acid and maleic acid), esters and amides thereof, and (co) polymers thereof Preferable examples thereof include an ester of an unsaturated carboxylic acid and an aliphatic polyvalent alcohol compound, an amide of an unsaturated carboxylic acid and an aliphatic polyvalent amine compound, and (co) polymers thereof. Furthermore, an adduct of an unsaturated carboxylic acid ester or an amide having a nucleophilic substituent such as a hydroxy group, an amino group or a mercapto group with a monofunctional or multifunctional isocyanate or epoxy; a dehydration condensate of an unsaturated carboxylic acid ester or an amide with a monofunctional or multifunctional carboxylic acid and the like are preferably used. Moreover, an adduct of an unsaturated carboxylic acid ester or amide having an electrophilic substituent such as an isocyanate group or an epoxy group with a monofunctional or multifunctional alcohol, amine or thiol; and a substituted reaction product of an unsaturated carboxylic acid ester or amide having a detachable substituent such as a halogen group or a tosyloxy group with a monofunctional or multifunctional alcohol, amine or thiol are also preferable. Examples thereof further include compounds in which the unsaturated carboxylic acid is replaced with unsaturated phosphonic acid, styrene, vinyl ether or the like.

Specific examples thereof that can be used in the invention include compounds such as those described in paragraphs [0095] to [0108] of JP-A No. 2009-288705.

The polymerizable monomer is preferably a compound which has at least one addition-polymerizable ethylenically unsaturated group and which has a boiling point of 100°C or higher at atmospheric pressure. Examples of the compound include a monofunctional acrylate or methacrylate such as polyethylene glycol mono(meth)acrylate, polypropylene glycol mono(meth)acrylate or phenoxyethyl (meth)acrylate; polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl) ether, tri(acryloyloxyethyl) isocyanurate; a compound formed by adding ethyleneoxide or propyleneoxide to a polyfunctional alcohol such as glycerin or trimethylolethane and (meth)acrylating the resultant adduct; urethane acrylates such as those described in JP-B Nos. 48-41708 and 50-6034 and JP-A No. 51-37193; polyester acrylates such as those described in JP-A No. 48-64183 and JP-B Nos. 49-43191 and 52-30490; and polyfunctional acrylates or methacrylates such as epoxy (meth)acrylates formed by reaction of an epoxy resin and (meth)acrylic acid; and mixtures thereof.

Examples of the compound which has at least one addition-polymerizable ethylenically unsaturated group and which has a boiling point of 100°C or higher at atmospheric pressure also include compounds such as those described in paragraphs [0254] to [0257] of JP-A No. 2008-292970.

In addition to the above, radical polymerizable monomers represented by the following Formulae (MO-1) to (MO-5) can be suitably used. In Formulae (MO-1) to (MO-5), when T represents an oxyalkylene group, the carbon terminal (rather than the oxygen terminal) of the oxyalkylene group combines with R.

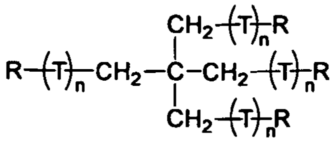 (MO-1) 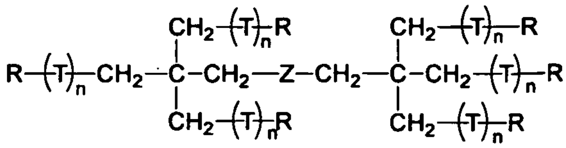 (MO-2)

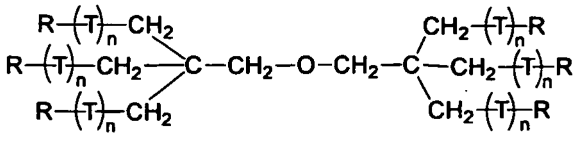 (MO-3)

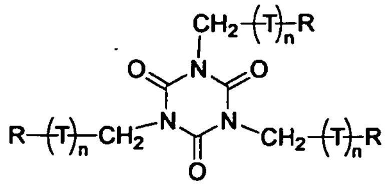
(MO-4)

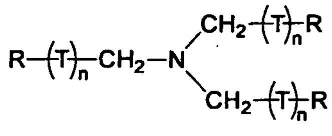
(MO-5)

R: 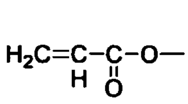 , 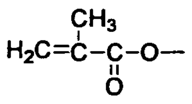 , 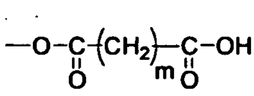 , 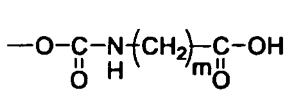 , —OH

T: $*-(CH_2)_m-*$, $-OCH_2-$, $-OCH_2CH_2-$, $-OCH_2CH_2CH_2-$, $-OCH_2CH_2CH_2CH_2-$

Z: —O— , 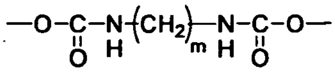

In Formulae (MO-1) to (MO-5), *n* represents an integer of from 0 to 14 and *m* represents an integer of from 1 to 8. Each R present in a molecule may be the same as or different from one another. Each T in a molecule may be the same as or different from one another.

In the radical polymerizable monomers represented by Formulae (MO-1) to (MO-5), at least one of R represents -OC(=O)CH=$CH_2$ or -OC(-O)C(CH3)=CH2.

Specific examples of the radical polymerizable monomers represented by Formulae (MO-1) to (MO-5) that can be suitably used in the invention include compounds such as those described in paragraphs [0248] to [0251] of JP-A No. 2007-269779.

Details of how to use these polymerizable compounds, such as what structure is used, whether they are used alone or in combination, or what amount is added, may be freely determined depending on the desired performance of the colored curable composition. For example, they may be selected from the following viewpoints.

In view of sensitivity, the polymerizable compound preferably has a structure having a higher content of unsaturated groups per molecule, and bifunctional or higher functional structures are preferable in many cases. In order to increase the strength of an image area (cured film in an image area), the polymerizable compound preferably has a tri- or higher-functional structure. A method of using a combination of compounds having different numbers of functional groups and/or different types of polymerizable groups (for example, compounds selected from an acrylic ester, a methacrylic ester, a styrene compound, and a vinyl ether compound) is also effective for regulating both of sensitivity and strength. Furthermore, selection and usage mode of the polymerizable compound are also important factors affecting compatibility with other components (for example, a photopolymerization initiator, a colorant such as a pigment, or a binder polymer) contained in the colored curable composition. For example, compatibility may be improved by using a low-purity compound or by using two or more kinds of polymerizable compounds in combination. Further, a specific structure may be selected in order to improve adhesiveness to a hard surface of a substrate.

The content of the polymerizable compound (total content in case of two or more polymerizable compounds being used) in the total solid content of the colored curable composition is not specifically limited, and is preferably from 10% by mass to 80% by mass, more preferably from 15% by mass to 75% by mass, and still more preferably from 20% by mass to 60% by mass in order to obtain the effect of the invention more effectively.

*Photopolymerization initiator*

The colored curable composition according to the invention may include a photopolymerization initiator.

The photopolymerization initiator is not specifically limited as long it may polymerize the polymerizable compound mentioned above, and is preferably selected in view of property, initiation efficiency, absorption wavelength, availability, cost and the like.

Examples of the photopolymerization initiator include at least one active halogen compound selected from halomethyloxadiazole compounds and halomethyl-s-triazine compounds; 3-aryl-substituted coumarin compounds; lophine dimmers; benzophenone compounds; acetophenone compounds and derivatives thereof; cyclopentadiene-benzene-iron complexes and salts thereof; and oxime compounds. Specific examples of the photopolymerization initiator

include those described in the paragraphs [0070] to [0077] of JP-A No. 2004-295116. Among these, oxime compounds are preferable in view of rapid polymerization reaction and the like.

Examples of the oxime compound (hereinbelow also referred to as "oxime photopolymerization initiator") is not specifically limited, and specific examples thereof include oxime compounds described in, for example, JP-A No. 2000-80068, WO02/100903A1, and JP-A No. 2001-233842.

Specific examples of the oxime compounds include, but are not limited to, 2-(O-benzoyloxime)-1-[4-(phenylthio)phenyl]-1,2-butanedione, 2-(O-benzoyloxime)-1-[4-(phenylthio)phenyl]-1,2-pentanedione, 2-(O-benzoyloxime)-1-[4-(phenylthio)phenyl]-1,2-hexanedione, 2-(O-benzoyloxime)-1-[4-(phenylthio)phenyl)-1,2-heptanedione, 2-(O-benzoyloxime)-1-[4-(phenylthio)phenyl]-1,2-octanedione, 2-(O-benzoyloxime)-1-[4-(methylphenylthio)phenyl]-1,2-butanedione, 2-(O-benzoyloxime)-1-[4-(ethylphenylthio)phenyl]-1,2-butanedione, 2-(O-benzoyloxime)-1-[4-(butylphenylthio)phenyl]-1,2-butanedione, 1-(O-acetyloxime)-1-[9-ethyl-6-(2-methylbenzoyl)-9H-carbazol-3-yl]ethanone, 1-(O-acetyloxime)-1-[9-methyl-6-(2-methylbenzoyl)-9H-carbazol-3-yl]ethanone, 1-(O-acetyloxime)-1-[9-propyl-6-(2-methylbenzoyl)-9H-carbazol-3-yl]ethanone, 1-(O-acetyloxime)-1-[9-ethyl-6-(2-ethylbenzoyl)-9H-carbazol-3-yl]ethanone and 1-(O-acetyloxime)-1-[9-ethyl-6-(2-butylbenzoyl)-9H-carbazol-3-yl]ethanone.

Among these, oxime-O-acyl compounds including 2-(O-benzoyloxime)-1-[4-(phenylthio)phenyl]-1,2-octanedione and 1-(O-acetyloxime)-1-[9-ethyl-6-(2-methylbenzoyl)-9H-carbazol-3-yl]ethanone are preferable in view of that a pattern having a good shape (specifically, a rectangle shape of a pattern in case of a solid-state image sensor) may be obtained with smaller amount of exposure. Specific examples thereof include CGI-124 and CGI-242 (trade names, manufactured by BASF Japan Ltd.).

In the invention, the compound represented by the following Formulae (P) and (Q) are preferable as the oxime compound in view of sensitivity, stability over time and coloring during post-heating.

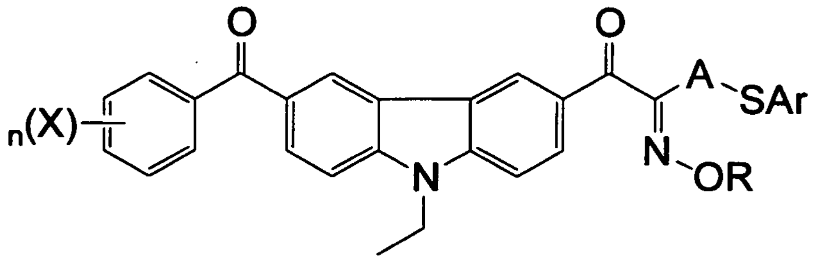

(P)

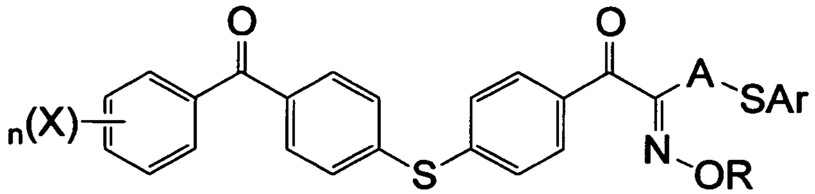

(Q)

In Formulae (P) and (Q), R and X each independently represent a monovalent substituent, A represents a bivalent organic group, Ar represents an aryl group, and n represents an integer of from 1 to 5.

R Formulae (P) and (Q) preferably represents an acyl group in order to improve sensitivity. Specifically, R preferably represents an acetyl group, a propionyl group, a benzoyl group or a toluyl group.

A in Formulae (P) and (Q) preferably represents an unsubstituted alkylene group, an alkylene group substituted by an alkyl group (such as a methyl group, an ethyl group, a tert-butyl group or a dodecyl group), an alkylene group substituted by an alkenyl group (such as a vinyl group or an allyl group), or an alkylene group substituted by an aryl group (such as a phenyl group, a p-tolyl group, a xylyl group, a cumenyl group, a naphthyl group, an anthryl group, a phenanthryl group or a styryl group), in order to improve sensitivity and suppress coloring by heating or storing over time.

Ar in Formulae (P) and (Q) preferably represents a substituted or unsubstituted phenyl group in order to improve sensitivity and suppress coloring by heating or storing over time. In case of the substituted phenyl group, preferable examples of the substituent include halogen groups such as a fluorine atom, a chlorine atom, a bromine atom and an iodine atom.

X in Formulae (P) and (Q) preferably represents an alkyl group which may have a substituent, an aryl group which may have a substituent, an alkenyl group which may have a substituent, an alkynyl group which may have a substituent, an alkoxy group which may have a substituent, an aryloxy group which may have a substituent, an alkylthioxy group which may have a substituent, an arylthioxy group which may have a substituent or an amino group which may have a substituent, in order to improve solubility in solvents and improve absorption efficiency in a long wavelength region.

In Formula (P), n preferably represents an integer of 1 or 2.

Hereinbelow specific examples of the compound represented by Formula (P) or Formula (Q) are shown, but the invention is not particularly limited to these examples.

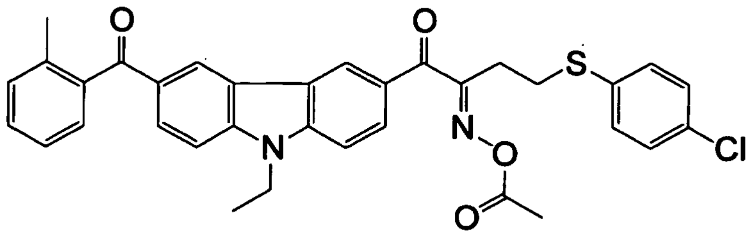

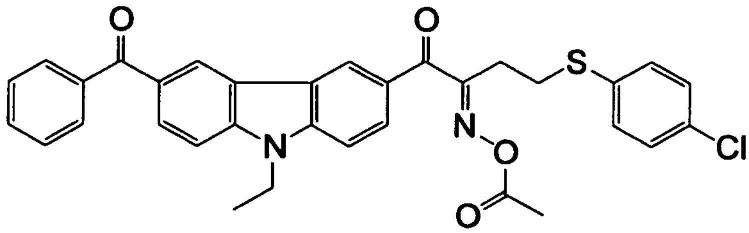

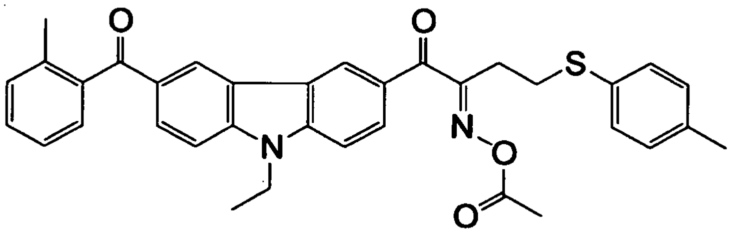

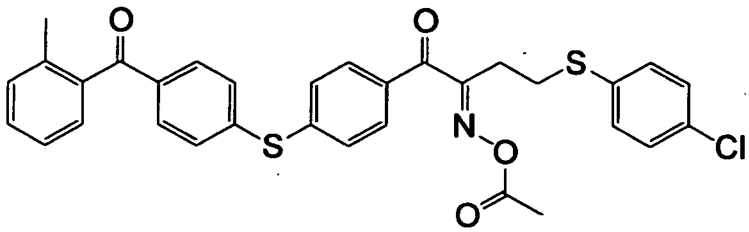

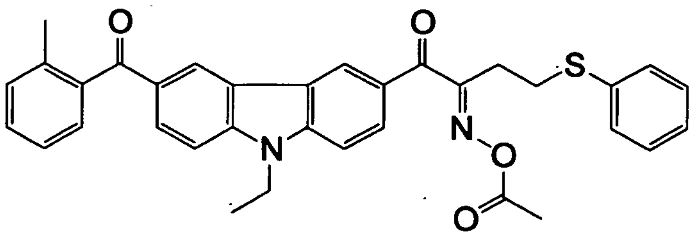

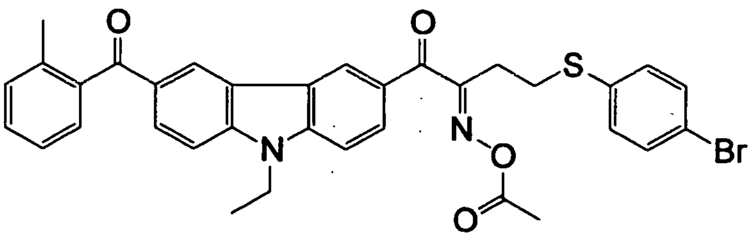

Besides the above-mentioned photopolymerization initiators, other known photopolymerization initiators described in the paragraph [0079] of JP-A No. 2004-295116 may be used for the colored curable composition according to the invention.
The photopolymerization initiator may be used singly or in combination of two or more kinds thereof. The content of the photopolymerization initiator (total content in case of two or more photopolymerization initiators being used) in the total solid components of the colored curable composition is preferably from 3% by mass to 20% by mass, more preferably from 4% by mass to 19% by mass, and still more preferably from 5% by mass to 18% by mass, in order to obtain the effect of the invention more effectively.

*Organic solvent*

The colored curable composition according to the invention may include an organic solvent.
The organic solvent is not specifically limited so long as it may satisfy the solubility of the components existing together and the coating property of the colored curable composition, and is preferably selected in view of solubility of the binder, coating property and safety.
Examples of the organic solvent include esters including ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate and ethyl lactate; oxyacetate alkyl esters such as methyl oxyacetate, ethyl oxyacetate or butyl oxyacetate (specifically, methyl methoxyacetate, ethyl methoxyacetate, butyl methoxyacetate, methyl ethoxyacetate or ethyl ethoxyacetate); 3-oxypropionic acid alkyl esters such as methyl 3-oxypropionate or ethyl 3-oxypropionate (specifically, methyl 3-methoxypropionate, ethyl 3-methoxypropionate, methyl 3-ethoxypropionate or ethyl 3-ethoxypropionate); 2-oxypropionic acid alkyl esters such as methyl 2-oxypropionate, ethyl 2-oxypropionate or propyl 2-oxypropionate (specifically, methyl 2-methoxypropionate, ethyl 2-methoxypropionate, propyl 2-methoxypropionate, methyl 2-ethoxypropionate or ethyl 2-ethoxypropionate), methyl 2-oxy-2-methylpropionate or ethyl 2-oxy-2-methylpropionate (specifically, methyl 2-methoxy-2-methylpropionate or ethyl 2-ethoxy-2-methylpropionate); and methyl pyruvate, ethyl pyruvate, propyl pyruvate, methyl acetoacetate, ethyl acetoacetate, methyl 2-oxobutanate, and ethyl 2-oxobutanate.
Examples of the organic solvent include ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate or propylene glycol monopropyl ether acetate.
Examples of the organic solvent include ketones such as methyl ethyl ketone, cyclohexanone, 2-heptanone or 3-heptanone.
Examples of the organic solvent include aromatic hydrocarbons such as toluene or xylene.
It is also preferable that two or more kinds of these organic solvents are used as a mixture in view of the solubility of the each components described above, and when an alkali soluble binder is included, in view of the solubility of the binder, improvement of the state of the surface to be coated, and the like. In this case, it is preferable to use a mixed solution of two or more kinds selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether and propylene glycol methyl ether acetate.
The content of the organic solvent in the colored curable composition is adjusted such that the concentration of the total solid content of the composition is preferably from 10% by mass to 80% by mass, more preferably from 15% by mass to 60% by mass.

*Other components*

In addition to the above-mentioned components, the colored curable composition according to the invention may further include other components such as an alkali-soluble binder o a crosslinking agent to the extent that the effect of the invention is not deteriorated.

*Alkali-soluble binder*

The alkali-soluble binder is not specifically limited so long as it has alkali solubility, and may be preferably selected in view of heat resistance, developing property, availability and the like.
Preferable examples of the alkali-soluble binder include a linear organic high-molecular polymer that may be dissolved in an organic solvent and may be developed by a weak alkali aqueous solution. Examples of such linear organic high-molecular polymer include a polymer having a carboxylic acid at a side chain thereof such as a methacrylic acid copolymer, an acrylic acid copolymer, an itaconic acid copolymer, a crotonic acid copolymer, a maleic acid copolymer

or a partially-esterified maleic acid copolymer as described in JP-ANo. 59-44615, JP-B Nos. 54-34327, 58-12577 and 54-25957 and JP-A Nos. 59-53836 and 59-71048. An acidic cellulose derivative having a carboxylic acid at side chain thereof is also useful. Furthermore, a polymer obtained by polymerizing a compound having a specific structure such as a ether dimer of a 2-(hydroxyalkyl) acrylic ester (for example, a compound described in JP-A No. 2004-300203) is useful.

Examples of the alkali-soluble binder that can be used in the invention further includes an adducts of a polymers having hydroxy groups with acid anhydrides, polyhydroxystyrene resins, polysiloxane resins, poly(2-hydroxyethyl(meth)acrylate), polyvinyl pyrrolidone, polyethylene oxides and polyvinyl alcohols. The linear organic high-molecular polymer may be a copolymer with a hydrophilic monomer. Examples thereof include alkoxyalkyl (meth)acrylates, hydroxyalkyl (meth)acrylates, glycerol (meth)acrylates, (meth)acrylamides, N-methylolacrylamides, secondary or tertiary alkylacrylamides, dialkylaminoalkyl (meth)acrylates, morpholine (meth)acrylates, vinylpyrrolidone, vinyltriazole, methyl (meth)acrylates, ethyl (meth)acrylates, branched or straight-chain propyl (meth)acrylates, branched or straight-chain butyl (meth)acrylates, and phenoxyhydroxy propyl(meth)acrylates. Other examples of the hydrophilic monomer include monomers having a tetrahydrofurfuryl group, a phosphoric acid group, a phosphoric acid ester group, a quaternary ammonium salt group, an ethyleneoxy chain, a propyleneoxy chain, a sulfonic acid group or a group derived from a salt thereof, or a morpholinoethyl group.

The alkali-soluble binder may have a polymerizable group at a side chain thereof in order to improve crosslinking efficiency. For example, polymers having an allyl group, a (meth)acryl group or an allyloxyalkyl group at a side chain thereof are useful. Examples of the polymer having a polymerizable group include commercial products including KS RESIST-106 (trade name, manufactured by Osaka Organic Chemical Industry Ltd.) and CYCLOMER-P series (trade names, manufactured by Daicel Chemical Industries, Ltd.). In order to improve strength of cured films, alcohol soluble nylons and a polyether of 2,2-bis-(4-hydroxyphenyl)propane and epichlorohydrin are also useful.

Among these various alkali-soluble binders, polyhydroxystyrene resins, polysiloxane resins, acrylic resins, acrylamide resins and acryl-acrylamide copolymer resins are preferable in view of heat resistance, and acrylic resins, acrylamide resins and acryl-acrylamide copolymer resins are preferable in order to control developing property.

Preferable examples of the acrylic resin include copolymers formed with monomers selected from benzyl (meth)acrylate, (meth) acrylic acid, hydroxyethyl (meth)acrylate, (meth)acrylamide and the like, and commercial products such as KS RESIST-106 (trade name, manufactured by Osaka Organic Chemical Industry Ltd.) and CYCLOMER-P series (trade names, manufactured by Daicel Chemical Industries, Ltd.).

The alkali-soluble binder is a polymer having a weight average molecular weight (polystyrene-converted value measured by GPC) of preferably 1,000 to $2\times10^5$, more preferably 2,000 to $1\times10^5$, and specifically preferably 5,000 to $5\times10^4$, in view of developing property, liquid viscosity and the like.

*Crosslinking agent*

The hardness of the colored cured film formed by curing the colored curable composition may further be improved by supplementarily using a crosslinking agent in the colored curable composition according to the invention.

The crosslinking agent is not specifically limited so long as it may cure a film by crosslinking reaction, and examples thereof include (a) an epoxy resin, (b) a melamine compound, a guanamine compound, a glycoluril compound or an urea compound substituted by at least one substituent selected from a methylol group, an alkoxymethyl group and an acyloxymethyl group, and (c) a phenol compound, a naphthol compound or a hydroxyanthracene compound substituted by at least one substituent selected from a methylol group, an alkoxymethyl group and an acyloxymethyl group. Among these, multifunctional epoxy resins are preferable.

With respect to the details of the specific examples of the crosslinking agent, the description on the paragraphs [0134] to [0147] of JP-A No. 2004-295116 may be referred.

*Polymerization inhibitor*

It is preferable that the colored curable composition according to the invention includes a small amount of a heat polymerization inhibitor in order to prevent unnecessary heat polymerization of the polymerizable compound during manufacture or storage of the colored curable composition.

Examples of the polymerization inhibitor that can be used in the invention include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butyl phenol), and N-nitrosophenylhydroxyamine primary cerium salt.

The addition amount of the polymerization inhibitor is preferably from about 0.01% by mass to about 5% by mass with respect to the total mass of the colored curable composition.

*Surfactant*

The colored curable composition according to the invention may contain a surfactant in order to improve the coatability. Examples of the surfactant that can be used in the invention include various surfactants such as a fluorine-containing surfactant, a nonionic surfactant, a cationic surfactant, an anionic surfactant, and a silicone surfactant.
In particular, when the colored curable composition according to the invention contains a fluorine-containing surfactant, the liquid properties (in particular, fluidity) of the composition prepared as a coating liquid are improved, whereby the uniformity of the coating thickness and the liquid saving can be improved.
That is, when a colored curable composition including a fluorine-containing surfactant is used as a coating liquid to form a film, the wettability on the surface to be coated is improved due to decrease in the surface tension between the surface to be coated and the coating liquid, thereby improving the coatability on the surface to be coated. As a result, even when a thin film of several to several tens micrometers is formed with a small amount of the liquid, a film with uniform thickness may be suitably formed.
The fluorine content in the fluorine-containing surfactant is preferably from 3% by mass to 40% by mass, more preferably from 5% by mass to 30% by mass, and still more preferably from 7% by mass to 25% by mass. When the fluorine content of the fluorine-containing surfactant is within the above range, it is effective in terms of the uniformity of the coating film thickness and the liquid saving, and excellent solubility in the colored curable composition can be achieved.
Examples of the fluorine-containing surfactant include MEGAFAC F171, F172, F173, F176, F177, F141, F142, F143, F144, R30, F437, F475, F479, F482, F554, F780 and F781 (trade names, manufactured by DIC Corporation), FLUORAD FC430, FC431 and FC171 (trade names, manufactured by Sumitomo 3M Limited), SURFLON S-382, SC-101, SC-103, SC-104, SC-105, SC1068, SC-381, SC-383, S393 and KH-40 (trade names manufactured by Asahi Glass Co., Ltd.), and SOLSPERSE 2000, (trade name, available form Lubrizol Japan Ltd.).
Examples of the cationic surfactant include a phthalocyanine derivative such as EFKA-745 (trade name, manufactured by Morishita & Co., Ltd.), an organosiloxane polymer such as KP341 (trade name, manufactured by Shin-Etsu Chemical Co., Ltd.), a (meth)acrylic acid based (co)polymer such as POLYFLOW No.75, No.90, No.95 (trade names, manufactured by Kyoeisha Chemical Co., Ltd.), or W001 (trade name, available from Yusho Co., Ltd.).
Examples of the nonionic surfactant include polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, and sorbitan fatty acid ester such as PLURONIC L10, L31, L61, L62,10R5,17R2 and 25R2, and TETRONIC 304, 701, 704, 901, 904 and 150R1 (trade names, manufactured by BASF Japan Ltd.).
Examples of the anionic surfactant include W004, W005 and W017 (trade names, available from Yusho Co., Ltd.).
Examples of the silicone surfactant include TORAY SILICONE DC3PA, SH7PA, DC11PA, SH21PA, SH28PA, SH29PA, SH30PA and SH8400 (trade names, manufactured by Dow Corning Toray Co., Ltd.), TSF 44 60 and 4452 (trade names, manufactured by Momentive Performance Materials Inc.), KP341 (trade name, manufactured by Shin-Etsu Chemical Co., Ltd.), and BYK323 and 330 (trade names, manufactured by BYK Chemie).
The surfactant may be used singly or in combination of two or more kinds thereof.
The additive amount of the surfactant is preferably form 0.001% by mass to 2.0% by mass, and more preferably from 0.005% by mass to 1.0% by mass, with respect to the total mass of the colored curable composition.

*Other additives*

As necessary, the colored curable composition may include various additives such as fillers, adhesion accelerating agents, antioxidants, ultraviolet absorbers or aggregation preventing agents. Examples of these additives include those described in the paragraphs [0155] to [0156] of JP-A No. 2004-295116 may be exemplified.
Further, the colored curable composition according to the invention may include a sensitizer or a light stabilizer such as those described in the paragraph [0078] of JP-A No. 2004-295116 or a heat polymerization inhibitor such as those described in the paragraph [0081] of JP-A No. 2004-295116.
In order to accelerate the alkali solubility of non-exposed areas and to further improve the developability of the colored curable composition, an organic carboxylic acid, preferably an organic carboxylic acid having a molecular weight of 1000 or less, may be added to the composition.
Specific examples of the organic carboxylic acid having a molecular weight of 1000 or less include aliphatic monocarboxylic acids such as formic acid, acetic acid, propionic acid, butyric acid, valeric acid, pivalic acid, caproic acid, diethyl acetate, enanthic acid or capric acid; aliphatic dicarboxylic acids such as oxalic acid, malonic acid, succinic acid, glutaric acid, adipic acid, pimelic acid, suberic acid, azelaic acid, sebacic acid, brassylic acid, methyl malonic acid, ethyl malonic acid, dimethyl malonic acid, methyl succinic acid, tetramethyl succinic acid or citraconic acid; aliphatic tricarboxylic acids such as tricarballylic acid, aconitic acid or camphoronic acid; aromatic monocarboxylic acids such as benzoic acid, toluic acid, cuminic acid, hemellitic acid or mesitylenic acid; aromatic polycarboxylic acids such as phthalic acid, isophthalic

acid, terephthalic acid, trimellitic acid, trimesic acid, mellophanic acid or pyromellitic acid; and other carboxylic acids such as phenyl acetic acid, hydroatropic acid, hydrocinnamic acid, mandelic acid, phenylsuccinic acid, atropic acid, cinnamic acid, methyl cinnamate, benzyl cinnamate, cinnamylidene acetic acid, coumaric acid or umbellic acid.

*Preparation method of colored curable composition*

The colored curable composition according to the invention is prepared by mixing the above-mentioned components.

During the preparation of the colored curable composition, the components for the colored curable composition may be mixed at one time, or each of the components may be dissolved or dispersed in a solvent and then mixed successively. The order of addition during mixing and the operation condition are not specifically limited. For example, the composition may be prepared by simultaneously dissolving or dispersing all components in a solvent, or when needed, the components may be suitably prepared into two or more solutions or dispersion liquids that are mixed before use (at the time of coating) to prepare a composition.

The colored curable composition prepared as above may be filtered using a filter or the like having a pore diameter of preferably from about 0.01μm to about 3.0μm, more preferably from about 0.05 μm to about 0.5μm, and subjected to use.

Since the colored curable composition according to the invention has excellent storage stability, and may form colored cured films having excellent light fastness, it may be used for forming colored pixels for color filters used for liquid crystal display devices (LCD) or solid-state image sensors (e.g., CCD, CMOS and the like), and for use in preparation of print ink, inkjet ink, paint and the like. Specifically, it may be used for forming colored pixels for solid-state image sensors including CCD and CMOS.

*Color filter and production method therefor*

Hereinbelow, a method for producing a color filter using the colored curable composition according to the invention (method for producing the color filter according to the invention) is explained.

In the method for producing the color filter according to the invention, the colored curable composition according to the invention as mentioned above is first applied onto a support by a coating process such as spin coating, casting coating, roll coating or the like to form a colored curable composition layer, and when needed, subjected to preliminary curing (pre-baking) to dry the colored curable composition layer (coating step).

Examples of the support used for the production method of the color filter according to the invention include soda glass, borosilicate glass (PYREX (registered trade name) glass) and quartz glass used for liquid crystal display devices and the like, and those glass materials on which a transparent electroconductive film has been adhered, photoelectronic conversion device substrates used for solid-state image sensors such as silicon substrates, and complementary metal oxide film semiconductor (CMOS) substrates. Black stripes for separating pixels may be formed on these substrates. When needed, an undercoat layer may be formed on these supports in order to improve adhesion to the upper layer, prevent diffusion of the materials, or planarize the surface.

When the colored curable composition is spin-coated on the support, the colored curable composition may conform well to the support by adding dropwise a suitable organic solvent and rotating prior to dropwise addition of the colored curable composition so as to decrease the amount of the liquid to be added dropwise.

In the coating process of the colored curable composition according to the invention, for example, even when the colored curable composition adheres to the nozzle of the ejection portion of the coating apparatus, the piping portion of the coating apparatus, or the inside of the coating apparatus, the colored curable composition can be easily cleaned and removed using a known cleaning liquid. In this case, in order to perform the cleaning and removal more efficiently, it is preferable to use the solvent described above as a solvent contained in the colored curable composition according to the invention as a cleaning liquid.

Further, cleaning liquids as recited in JP-ANos. 7-128867, 7-146562, 8-278637, 2000-273370, 2006-85140, 2006-291191, 2007-2101, 2007-2102, and 2007-281523 can also be suitably used as a cleaning liquid for cleaning and removing the colored curable composition according to the invention.

The cleaning liquid is preferably an alkylene glycol monoalkyl ether carboxylate or an alkylene glycol monoalkyl ether.

These solvents that can be used as a cleaning liquid may be used singly or two or more kinds thereof may be used in combination.

When two or more kinds of solvents are used in combination, it is preferable to use a mixed solution of a solvent that has a hydroxy group and a solvent that does not have a hydroxy group. The mass ratio of the solvent that has a hydroxy group and the solvent that does not have a hydroxy group (the solvent that has a hydroxy group / the solvent that does not have a hydroxy group) is from 1/99 to 99/1, preferably from 10/90 to 90/10, and more preferably from 20/80

to 80/20.

The mixed solvent is preferably a mixed solvent of propyleneglycol monomethylether acetate (PGMEA) and propyleneglycol monomethyl ether (PGME) with a mixing ratio of PGMEA/PGME is 60/40.

In order to increase the permeability of the cleaning liquid into the colored curable composition, the cleaning liquid may contain a surfactant such as the above-described surfactant that can be contained in the colored curable composition.

The conditions for the pre-baking may include a condition in which heating is performed using a hot plate or an oven at 70°C to 130°C for about 0.5 minute to 15 minutes.

The thickness of the colored curable composition layer formed using the colored curable composition is suitably selected according to the purpose. Generally, the thickness of the colored curable composition layer is preferably from 0.2 μm to 5.0 μm, more preferably from 0.3 μm to 2.5 um, and still more preferably from 0.3 μm to 1.5 μm. The thickness of the colored curable composition layer as used herein is a film thickness after pre-baking.

Next, in the production method of the color filter according to the invention, the colored curable composition layer formed on the support is exposed via a mask (exposure step).

The light or radiation that may be applied to this exposing is preferably g-ray, h-ray, i-ray, KrF ray or ArF ray, specifically preferably i-ray. When i-ray is used as irradiation light, it is preferable to irradiate at an exposure dose of 100 $mJ/cm^2$ to 10,000 $mJ/cm^2$.

The exposed colored curable composition layer may be heated using a hot plate or an oven at 70°C to 130°C for about 0.5 minute to 15 minutes prior to the subsequent developing treatment.

Furthermore, exposing may be performed while nitrogen gas is flowing in a chamber so as to suppress oxidation discoloration of the coloring material in the colored curable composition layer.

Subsequently, the exposed colored curable composition layer is developed using a developer (development step). In this manner, a negative-type or positive-type color pattern (resist pattern) may be formed.

A combination of various organic solvents or an alkaline aqueous solutions may be used as a developer so long as it dissolves uncured parts (unexposed areas) and does not dissolve cured parts (exposed areas) in the colored curable composition layer. When the developer is an alkaline aqueous solution, it is preferable to adjust the alkali concentration to preferably pH 11 to 13, more preferably pH 11.5 to 12.5. Specifically, an alkaline aqueous solution in which the concentration of tetraethylammonium hydroxide has been adjusted to 0.001% by mass to 10% by mass, preferably 0.01% by mass to 5% by mass may be used as a developer.

The developing time is preferably from 30 seconds to 300 seconds, more preferably from 30 seconds to 120 seconds. The developing temperature is preferably 20°C to 40°C, more preferably 23°C.

Developing may be performed by using a paddle system, a shower system, a spray system or the like.

It is preferable that washing is performed by using water after developing using an alkali aqueous solution. A washing system is also suitably selected according to the purpose, and rinse treatment may be performed by rotating a support such as a silicon wafer at a revolution of 10 rpm to 500 rpm and supplying pure water in shower state from a spray nozzle from the above of the revolution center.

Thereafter, in the production method of the color filter according to the invention, the pattern (resist pattern) formed by developing may be subjected to post-heating and/or post-exposure to accelerate curing of the color pattern when needed (post-curing step).

*Post-exposure by ultraviolet radiation irradiation*

In post-exposure by ultraviolet radiation irradiation, the color pattern that has been subjected to a developing treatment as mentioned above is irradiated with ultraviolet light (UV light) having an irradiation light dose [$mJ/cm^2$] of 10 or more times as large as an exposure dose [$mJ/cm^2$] in the exposing treatment prior to the development. By irradiating the developed pattern (the pattern formed using a negative-working curable composition containing a colorant) with ultraviolet light (UV light) for a predetermined time period at between the developing treatment and the heat treatment in the pattern forming step, color transfer during the subsequent heating may be effectively prevented, and light fastness is improved.

As a light source for irradiating ultraviolet light, for example, an ultra high-pressure mercury lamp, a high-pressure mercury lamp, a low-pressure mercury lamp, a DEEP UV lamp or the like may be used. Among these, a light source that irradiates ultraviolet light including light at a wavelength of 275 nm or less, and can irradiate light in which an irradiation illuminance [$mW/cm^2$] of the light at a wavelength of 275 nm or less is 5% or more with respect to the integral irradiation illuminance of the light over the whole wavelengths range of the ultraviolet light is preferable. By adjusting the irradiation illuminance of the light at a wavelength of 275 nm or less in the ultraviolet light to 5% or more, effect of suppressing color transfer to the adjacent pixels and the upper and lower layers and effect of improving light fastness may be further improved.

From these viewpoints, it is preferable that the post-exposure by ultraviolet radiation irradiation is performed

by using a light source that differs from the light source (such as i-ray) used in the exposing in the pattern forming step, specifically using a high-pressure mercury lamp, a low-pressure mercury lamp or the like. Among these, for the same reason as mentioned above, the irradiation illuminance [$mW/cm^2$] of the light at a wavelength of 275 nm or less is preferably 7% or more with respect to the integral irradiation illuminance of the light at whole wavelengths in the ultraviolet light. Furthermore, it is desirable that the upper limit of the irradiation illuminance of the light at a wavelength of 275 nm or less is 25% or less.

The integral irradiation illuminance refers to a sum (area) of illuminance of lights of wavelengths included in irradiated light when a curve is drawn by taking an illuminance for every spectral wavelength (radiation energy for passing through a unit area in a unit time period; [$mW/m^2$]) as a vertical axis and the wavelength [nm] of the light as a horizontal axis.

It is preferable that ultraviolet light is irradiated by an irradiation light dose [$mJ/cm^2$] of 10-fold or higher than the exposure dose [$mJ/cm^2$] in the exposure during the pattern forming step. When the irradiated light amount in the post-exposure step is lower than 10-fold the exposure dose in the exposure during the pattern forming step, color transfer to adjacent pixels and to upper and lower layers may not be prevented, and light fastness may be deteriorated.

Among these, the irradiation light dose of ultraviolet light is preferably 12-fold to 200-fold, more preferably 15-fold to 100-fold the exposure dose in the exposure during the pattern forming step.

In this case, the integral irradiation illuminance in the irradiated ultraviolet light is preferably 200 $mW/cm^2$ or more. When the integral irradiation illuminance is 200 $mW/cm^2$ or more, effect of suppressing color transfer to adjacent pixels and upper and lower layers and effect of improving light fastness may be improved more effectively. Among these, the integral irradiation illuminance is preferably from 250 $mW/cm^2$ to 2000 $mW/cm^2$, and more preferably from 300 $mW/cm^2$ to 1000 $mW/cm^2$.

This post-heat treatment is performed preferably at 100°C to 300°C, more preferably at 150°C to 250°C by using, for example, a hot plate or an oven.

The heating time is preferably from 30 seconds to 30,000 seconds, more preferably from 60 seconds to 1,000 seconds.

The post-exposure may be performed by g-ray, h-ray, i-ray, KrF, ArF, UV light, electron beam or X-ray, preferably performed by g-ray, h-ray, i-ray or UV light, and more preferably performed by UV light. The irradiation by UV light (UV cure) is preferably performed at a low temperature such as from 20°C to 50°C, preferably, from 25°C to 40°C. It is preferable that the wavelength of UV light includes a wavelength of from 200 nm to 300 nm. As the light source for irradiating UV light, for example, a high-pressure mercury lamp or a low-pressure mercury lamp may be used. The irradiation time may be from 10 seconds to 180 seconds, preferably from 20 seconds to 120 seconds, more preferably from 30 seconds to 60 seconds.

Although either the post-exposure or post-heating may be performed first, it is preferable to perform the post-exposure prior to the post-heating. This is because deformation due to heat sagging and bottom spreading of the color pattern that are observed in the subsequent post-heating step may be prevented due to the acceleration of curing by the post-exposure,.

The color pattern thus obtained constitutes pixels of the color filter.

In the preparation of a color filter having pixels of plural hues, the above-mentioned coating, exposure and development steps, and optionally post-curing step, may be repeated according to the desired numbers of colors.

The color filter obtained by the production method of the color filter according to the first aspect of the invention (the color filter according to the first aspect of the invention) is excellent in light fastness since the colored curable composition according to the first aspect of the invention is used.

Therefore, the color filter according to the first aspect of the invention may be used for liquid crystal display devices, and solid-state image sensors including CCD image sensors and CMOS image sensors, and camera systems using them. Among these, it is preferable for use in a solid-state image sensor in which a color pattern with a minute size is formed on a thin film and a good rectangular cross-sectional profile is required, specifically for uses in CCD devices, CMOS and the like having high resolutions of more than 1,000,000 pixels.

*Solid-state image sensor*

The solid-state image sensor according to the first aspect of the invention includes the color filter according to the first aspect of the invention. Since the color filter according to the invention has high light fastness, a solid-state image sensor including this color filter may provide excellent color reproducibility.

The configuration of the solid-state image sensor is not specifically limited so long as it is a configuration that includes the color filter according to the first aspect of the invention and acts as a solid-state image sensor, and examples may include the following configuration.

That is, it is a configuration including a support, plural photodiodes that constitute a light receiving area for a CCD image sensor (solid-state image sensor) and transfer electrodes including polysilicon or the like formed on the support, the color filter according to the first aspect of the invention formed thereon, and a microlense formed thereon.

Furthermore, it is desirable that the camera system including the color filter according to the first aspect of the invention includes a camera lens and an IR cut film that include dichroic-coated cover glass, microlense and the like in view of discoloration property of the coloring material, and that the materials therefor have an optical property to absorb a part or all parts of UV light of 400 nm or less. Furthermore, it is preferable that the structure of the camera system is a structure that decreases oxygen permeability to the color filter so as to suppress oxidation discoloration of the color material. For example, it is preferable that a part or all parts of the camera system is sealed with nitrogen gas.

*Liquid crystal display device*

The color filter according to the invention can be used for liquid crystal display devices as well as solid-state image sensors. The color filter according to the invention can be suitably used for liquid crystal display devices. In the liquid crystal display device including the color filter according to the invention, which contains a metal complex pigment having excellent spectroscopic properties and heat resistance as a colorant, the orientation defect due to the reduction in specific resistance is suppressed. As a result, images having excellent color can be displayed and excellent display properties can be achieved.
Therefore, the liquid crystal display device having the color filter according to the invention can display high quality images having excellent color and excellent display properties.
Definition and explanation of display devices are given, for example, in "Electronic Display Device" (Akio Sasaki, Kogyo Chosakai Publishing Co., Ltd., 1990), "Display Device" (Sumiaki Ibuki, Sangyo Tosho Publishing Co., Ltd., 1989) and the like. Liquid crystal display devices are described, for example, in "Next Generation Liquid Crystal Display Techniques" (Tatsuo Uchida, Kogyo Chosakai Publishing Co., Ltd., 1994). Liquid crystal display devices to which the color filter according to the invention may be applied are not particularly limited, and the color filter according to the invention may be used for various liquid crystal display devices such as those described, for example, in "Next Generation Liquid Crystal Display Techniques".
The color filter according to the invention can suitably be used in a color TFT liquid crystal display device. Details of color TFT liquid crystal display devices are described, for example, in "Color TFT Liquid Crystal Display" (Kyoritsu Shuppan Co., Ltd., 1996). Further, the color filter according to the invention may be applied to a liquid crystal display device with a wider view angle such as an in-plane switching (IPS) system or a multi-domain vertical alignment (MVA) system, or STN, TN, VA, OCS, FFS, R-OCB and the like.
The color filter according to the invention may also be applied to a COA (Color-filter On Array) system, which has high brightness and high definition. In the COA type liquid crystal display device, the color filter layer should satisfy the normal requirements mentioned above, and further requirements for an interlayer dielectric film such as low dielectric constant and resistance to a removal liquid. The color filter according to the invention, which is formed using a colorant multimer having exhibits excellent hue, exhibits excellent color purity and light transmittance and has a color pattern (pixels) with excellent color. Therefore, the color filter according to the invention is useful for the COA type liquid crystal display device with high definition and durability. In order to satisfy the requirement of low dielectric constant, a resin coating may be provided on the color filter layer.
These image display systems are described, for example, on page 43 of "EL, PDP, LCD Display - Trends in Techniques and Markets" (Research Study Division of Toray Research Center, Inc., 2001) and the like.
The liquid crystal display device according to the invention includes not only the color filter according to the invention but also various members such as an electrode substrate, a polarization film, a phase difference film, a back light, a spacer, and a view angle compensation film. The color filter according to the invention may be applied to a liquid crystal display device including these various known members.
These members are described, for example, in "'94 Market for Liquid Crystal Display Related Materials and Chemicals" (Kentaro Shima, CMC Publishing CO., LTD., 1994) and "2003 Current State and Outlook for Liquid Crystal Related Markets" (Ryokichi Omote, Fuji Chimera Research Institute, Inc., 2003).
Back lights are described, for example, in SID meeting Digest 1380 (2005) (A. Konno et.al) and Monthly Display, 2005 December, pages 18-24 (Hiroyasu Shima) and pages 25-30 (Takaaki Yagi).
When the color filter according to the invention is used in a liquid crystal display device, high-contrast display may be achieved in combination with a conventionally known three-wavelength cold-cathode tube. Furthermore, by using red, green and blue LED light sources (RGB-LED) as a back light, a liquid crystal display device having high brightness, high color purity, and good color reproducibility may be provided.
As described above, according to the present invention, a red to purple colorant for chromatic compensation having excellent spectroscopic properties, heat resistance, and light fastness, which contains a colorant multimer that includes, as a partial structure of a colorant moiety, a dipyrromethene metal complex compound or tautomer thereof obtained from a dipyrromethene compound and a metal or a metal compound, can be obtained. Furthermore, according to the present invention, the colored curable composition in which color mixing during the color filter manufacturing process is suppressed can be obtained. That is, a colored cured film obtained using the colored curable composition

exhibit excellent solvent resistance and excellent resistance against color transfer during curing with heat. As a result, problems that have not been solved with a color resist using the conventional dye for chromatic compensation may be solved. Therefore, the colorant multimer of the invention is particularly useful for a color filter used in solid-state image sensors or display devices (such as liquid crystal display device and organic EL display devices).

EXAMPLES

Hereinbelow, the invention is further illustrated below with reference to examples, but the invention is not limited to these examples unless departing from the scope of the invention. Unless otherwise specified, "part(s)" is expressed in terms of mass.

*Example 1-1*

*(1) Preparation of resist solution A (negative-working type)*

The following components were mixed, and dissolved, thereby preparing a resist solution A.

| | |
|---|---|
| - propyleneglycol monomethylether acetate | 5.20 parts |
| - cyclohexanone | 52.60 parts |
| - binder | 30.50 parts |

(41% cyclohexanone solution of benzyl methacrylate/methacrylic acid /2-hydroxyethyl methacrylate copolymer (molar ratio of 60:20:20), average molecular weight in terms of the equivalent polystyrene molecular weight: 30,200)

| | |
|---|---|
| - dipentaerythritol hexaacrylate | 10.20 parts |
| - polymerization inhibitor (p-methoxyphenol) | 0.006 part |
| - fluorine-containing surfactant (trade name: F-475; manufactured by DIC Corporation) | 0.80 parts |
| - photopolymerization initiator (4-benzoxolane-2,6-bis(trichloromethyl)-s-triazine; trade name: TAZ-107; manufactured by Midori Kagaku Co., Ltd.) | 0.58 parts |

*(2) Preparation ofglass substrate with undercoat layer*

A glass substrate (trade name: Corning 1737; manufactured by Corning Inc.) was subject to the ultrasonic-cleaning using a 0.5% aqueous NaOH solution, washed with water, and subjected to a dehydration baking treatment (for 20 minute at 200°C). Subsequently, the resist solution A obtained in item (1) above was coated on the cleaned glass substrate using a spin coater such that the obtained film after drying has a thickness of 2 μm, and then the glass substrate was heated and dried at 220°C for 1 hour, thereby obtaining a glass substrate with an undercoat layer.

*(3) Preparation of colored curable composition*

*(3-1) Preparation of dispersion of C.I. Pigment Blue 15:6*

The dispersion of C.I. Pigment Blue 15:6 was prepared as follows. That is, a mixed liquid containing 11.8 parts by mass of C.I. Pigment Blue 15:6 (average primary particle diameter of 55 nm), 5.9 parts by mass of a pigment dispersant BY-161 (trade name; manufactured by BYK Chemie GmbH), and 82.3 parts by mass of PGMEA was mixed and dispersed using a beads mill (using zirconia beads having a diameter of 0.3 mm) for 3 hours, thereby preparing a pigment dispersion. The pigment dispersion was subjected to a dispersion treatment under a pressure of 2,000 $Kg/cm^3$ at a flow rate of 500 g/minute using a high pressure dispersing machine equipped with a pressure-reducing system (NANO-3000-10; trade name; manufactured by Beryu Co., Ltd.). This dispersion treatment was repeated 10 times, thereby obtaining a pigment dispersion (C.I. Pigment Blue 15:6 dispersion). The average primary particle diameter of the pigment in the obtained pigment dispersion measured by a dynamic light scattering method using MICROTRAC NANOTRAC UP-A EX150 (trade name; manufactured by Nikkiso Co., Ltd.) was 24 nm.

*(3-2) Preparation of colored curable composition*

The following components were mixed and dispersed, thereby obtaining a colored curable composition.

- cyclohexanone 1.133 parts
- copolymer of benzyl methacrylate/methacrylic acid (20% CyH solution) (molar ratio of 70:30, weight average molecular weight: 30,000) 1.009 parts
- SOLSPERSE 20000 (1% cyclohexane solution) (available form Lubrizol Japan Ltd.) 0.125 parts
- oxime photopolymerization initiator (compound having the structure as shown below) 0.087 parts
- colorant multimer (Exemplary Compound P21) 0.183 parts
- Pigment Blue 15:6 dispersion (solid content concentration of 17.70%, pigment concentration of 11.80%) 2.418 parts
- glycerol propoxylate (1% cyclohexane solution) 0.048 parts
- dipentaerythritol hexaacrylate 0.225 parts

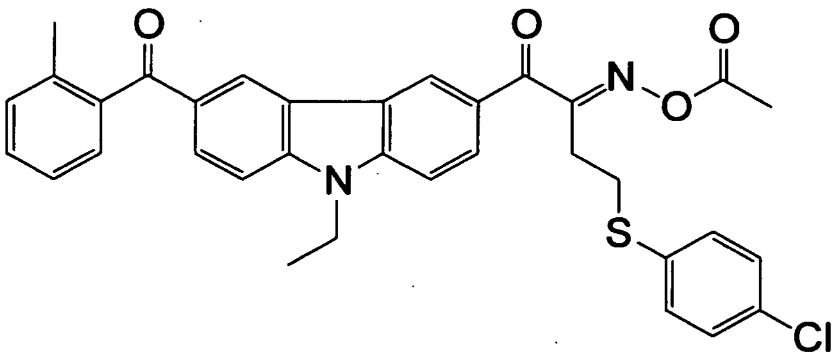

*(4) Exposure and development (image formation ) of colored curable composition*

The colored curable composition obtained in item (3) above was coated on the undercoat layer of the glass substrate obtained in item (2) above using a spin coater such that the obtained film after drying has a thickness of 0.6 μm, and then the film was pre-baked at 100°C for 120 seconds.

Subsequently, the coated film was irradiated with light having a wavelength of 365 nm through a mask having a pattern with a line width of 2 μm at an exposure dose of 200 mJ/cm$^2$ using an exposure machine UX3100-SR (trade name; manufactured by Ushio Inc.). After the exposure, the film was developed with a developer CD-2000 (trade name; manufactured by Fujifilm Electronic Materials Co., Ltd.) under the condition of at 25°C for 40 seconds. Thereafter, the film was rinsed with running water for 30 seconds, spray dried, and post-baked at 200°C for 15 minutes.

*(5) Evaluation*

The heat resistance and solvent resistance, and light fastness of the coated film obtained by applying the colored curable composition on the glass substrate were evaluated in the following manner. The evaluation results are shown in the following Table 14.

*Heat resistance*

The glass substrate on which the colored curable composition obtained in item (3) above was coated was placed on a hot plate at 200°C such that the bottom surface of the glass substrate comes into contact with the hot plate and was heated for 1 hour. The color difference (ΔE*ab value) of the colored curable composition before and after the heating was measured using a colorimeter (trade name: MCPD-1000; manufactured by Otsuka Electronics Co., Ltd.), and an index of the heat resistance was evaluated in accordance with the following evaluation criteria. A smaller ΔE*ab value indicates a better heat resistance. Here, the ΔE*ab value is a value calculated from the following color-difference formula according to CIE 1976 (L*, a*, b*) color space (Color Science Handbook (New edition in 1985); p. 266, edited by the Color Science Association of Japan).

$$\Delta E^*ab = \{(\Delta L^*)^2+(\Delta a^*)^2+(\Delta b^*)^2\}^{1/2}$$

Evaluation Criteria

A: ΔE*ab value is smaller than 3

B: ΔE*ab value is 3 or larger and smaller than 5
C: ΔE*ab value is from 5 to 15
D: ΔE*ab value is larger than 15

*Solvent resistance*

The spectrum of the coated film after the post-baking obtained in item (4) above was measured (spectrum A). On this coated film, the resist solution A obtained in item (1) above was coated such that the obtained film had a thickness of 1 μm, and then the film was pre-baked. Thereafter, the film was developed with a developer CD-2000 (trade name; manufactured by Fujifilm Electronic Materials Co., Ltd.) under the condition of at 23 °C for 120 seconds, and the spectrum was measured again (spectrum B). As an index of solvent resistance, the colorant remaining ratio was calculated based on a difference between the spectrum A and the spectrum B. A value closer to 100% indicates a higher solvent resistance.

Evaluation Criteria

A: Colorant remaining ratio is more than 90%
B: Colorant remaining ratio is from 70% to 90%
C: Colorant remaining ratio is less than 70%

*Light fastness*

The spectrum of the coated film after the post-baking obtained in item (4) above was measured (spectrum A). This coated film was irradiated with light with a xenon lamp at an irradiation dose of 100,000 lux for 20 hours (equivalent to 2,000,000 lux-hour). The color difference (ΔE*ab value) of the coated film before and after the irradiation was measured. The color difference was used as an index of light fastness. A smaller ΔE*ab value indicates a better light fastness. The evaluation criteria are as follows:

Evaluation Criteria

A: ΔE*ab value is smaller than 3
B: ΔE*ab value is 3 or larger and smaller than 5
C: AE*ab value is from 5 to 15
D: ΔE*ab value is larger than 15

*Examples 1-2 to 1-59, and Comparative Examples 1-1 and 1-2*

In Examples 1-2 to 1-59, and Comparative Examples 1-1 and 1-2, patterns were formed and evaluated similarly to Example 1-1 except that an equal amount of the respective colorants listed in the following Tables 14 to 17 were used in place of Exemplary Compound P21 in "(3) preparation of colored curable composition" in Example 1-1. The evaluation results are shown in Tables 14 to 17. The structures of Comparative Colorant 1 and Comparative Colorant 2 (C.I. Acid Red 87) in Table 14 are shown below.

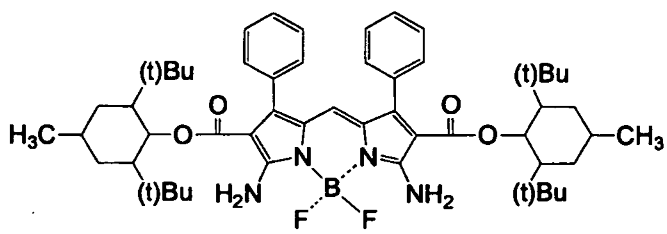

Comparative Colorant 1

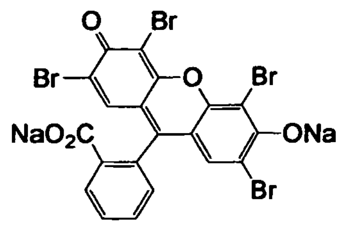

Comparative Colorant 2

Table 14

| | Colorant multimer | Heat resistance | Solvent resistance | Light fastness |
|---|---|---|---|---|
| Example 1-1 | P21 | B | A | B |
| Example 1-2 | P28 | B | A | B |
| Example 1-3 | P53 | B | A | A |
| Example 1-4 | P57 | B | A | A |
| Example 1-5 | P62 | A | A | A |
| Example 1-6 | P72 | A | A | B |
| Example 1-7 | P77 | A | A | B |
| Example 1-8 | P92 | B | A | B |
| Example 1-9 | P100 | B | A | B |
| Comparative Example 1-1 | Comparative Colorant 1 | D | C | D |
| Comparative Example 1-2 | Comparative Colorant 2 | C | B | D |

Table 15

| | Colorant multimer | Heat resistance | Solvent resistance | Light fastness |
|---|---|---|---|---|
| Example 1-10 | P176 | B | A | B |
| Example 1-11 | P179 | B | A | B |
| Example 1-12 | P183 | B | A | B |
| Example 1-13 | P184 | B | A | B |
| Example 1-14 | P185 | B | A | B |
| Example 1-15 | P192 | B | A | B |
| Example 1-16 | P193 | A | A | A |
| Example 1-17 | P197 | A | A | B |

Table 16

| | Colorant multimer | Heat resistance | Solvent resistance | Light fastness |
|---|---|---|---|---|
| Example 1-18 | S-1 | A | A | B |
| Example 1-19 | S-2 | A | A | A |
| Example 1-20 | S-3 | A | A | A |
| Example 1-21 | S-4 | A | A | A |
| Example 1-22 | S-5 | A | A | A |
| Example 1-23 | S-6 | A | A | A |
| Example 1-24 | S-7 | A | A | B |
| Example 1-25 | S-8 | B | A | B |
| Example 1-26 | S-9 | A | A | A |
| Example 1-27 | S-10 | B | A | C |
| Example 1-28 | S-11 | A | A | A |
| Example 1-29 | S-12 | A | A | A |

(continued)

| | Colorant multimer | Heat resistance | Solvent resistance | Light fastness |
|---|---|---|---|---|
| Example 1-30 | S-13 | A | A | A |
| Example 1-31 | S-14 | A | B | A |
| Example 1-32 | S-15 | A | B | A |
| Example 1-33 | S-16 | B | B | B |
| Example 1-34 | S-17 | B | B | B |
| Example 1-35 | S-18 | B | B | B |
| Example 1-36 | S-19 | A | A | A |
| Example 1-37 | S-20 | B | B | B |
| Example 1-38 | S-21 | B | B | B |
| Example 1-39 | S-22 | A | B | B |
| Example 1-40 | S-23 | A | B | B |
| Example 1-41 | S-24 | B | B | B |
| Example 1-42 | S-25 | A | B | B |
| Example 1-43 | S-26 | A | B | B |

Table 17

| | Colorant multimer | Heat resistance | Solvent resistance | Light fastness |
|---|---|---|---|---|
| Example 1-44 | P201 | A | A | B |
| Example 1-45 | P202 | A | A | B |
| Example 1-46 | P203 | A | A | B |
| Example 1-47 | P204 | A | A | B |
| Example 1-48 | P205 | B | B | B |
| Example 1-49 | P207 | B | A | B |
| Example 1-50 | P209 | A | A | A |
| Example 1-51 | P211 | A | B | B |
| Example 1-52 | P213 | A | A | B |
| Example 1-53 | P215 | A | A | B |
| Example 1-54 | P217 | A | A | B |
| Example 1-55 | P219 | A | B | B |
| Example 1-56 | P221 | B | A | B |
| Example 1-57 | P223 | A | A | B |
| Example 1-58 | P225 | A | A | C |
| Example 1-59 | P227 | B | B | C |

*Examples 2-1 to 2-59, and Comparative Examples 2-1 to 2-2*

The color filters of Examples 2-1 to 2-59, and Comparative Examples 2-1 to 2-2 were manufactured in the following procedures using the colored curable compositions used in Examples 1-1 to 1-59 and Comparative Example 1-1 to 1-2, respectively, and color transfer of the color filters was evaluated. The evaluation results are shown in the

following Tables 18 to 21.

*Manufacture of monochromatic color filter.*

Each of the colored curable compositions used in Examples 1-1 to 1-59 and Comparative Examples 1-1 to 1-2 was coated on the glass substrate of Example 1-1 prepared in accordance with item (2) above using a spin coater such that the obtained film had a dry film thickness of 1 μm, and the glass substrate was pre-baked at 100°C for 120 seconds to form a colored film thereon. The colored film was exposed through a mask having a 7.0 μm -square pattern arrayed over a 4 mm × 3 mm area on a substrate at an exposure dose of 200 mJ/cm$^2$ and a illuminance of 1200 mW/cm$^2$ (integrated irradiation illuminance), using an i-line stepper (trade name: FPA-3000i5+; manufactured by Canon Inc.) After the exposure, the film was subjected to paddle development at 23°C for 60 seconds using a developer CD-2000 (trade name; 60% solution, manufactured by Fujifilm Electronic Materials Co., Ltd.) to form a pattern. The pattern was then rinsed with running water for 20 seconds, and was spray dried. Thereafter, an ultraviolet irradiation treatment after exposure was conducted, in which the entire glass substrate on which the pattern has been formed was irradiated with ultraviolet rays at an exposure dose of 10000 mJ/cm$^2$ using a high pressure ultraviolet mercury lamp (trade name: UMA-802-HC552FFAL; manufactured by Ushio Inc.). After the irradiation, the substrate on which the pattern has been formed was post-baked at 220°C for 300 seconds on a hot plate, thereby forming a colored pattern on the glass plate. Here, the irradiation illuminance [mW/cm$^2$] of the light at a wavelength of 275 nm or less is 10% with respect to the integral irradiation illuminance of the light over the whole wavelength range of the ultraviolet light.

*Evaluation of color transfer*

On the surface of the obtained color filter on which colored pattern has been formed, CT-2000L solution (transparent undercoating agent) (trade name; manufacture by Fujifilm Electronic Materials Co., Ltd.) was coated such that the obtained film had a dry film thickness of 1 μm, and the film was dried to form a transparent film. The transparent film was subjected to a heating treatment at 200°C for 5 minutes. After finishing the heating treatment, the absorbance of the transparent film adjacent to the colored pattern was measured with a microspectrophotometer (LCF-1500M; trade name; manufactured by Otsuka Electronics Co. Ltd.). As an index of color transfer, the ratio (%) of the value of the absorbance of the obtained transparent film to that of the colored pattern measured before the heating was calculated.

Evaluation Criteria

The ratio (%) of color transfer to adjacent pixel

A: The ratio (%) of transfer to adjacent pixel is less than 1%
B: The ratio (%) of color transfer to adjacent pixel is 1% or more and less than 10%
C: The ratio (%) of color transfer to adjacent pixel is 10% or mole and less than 30%
D: The ratio (%) of color transfer to adjacent pixel is more than 30%

Table 18

| | Colorant multimer | Color transfer |
|---|---|---|
| Example 2-1 | P21 | B |
| Example 2-2 | P28 | B |
| Example 2-3 | P53 | A |
| Example 2-4 | P57 | A |
| Example 2-5 | P62 | B |
| Example 2-6 | P72 | A |
| Example 2-7 | P77 | A |
| Example 2-8 | P99 | B |
| Example 2-9 | P100 | B |
| Comparative Example 2-1 | Comparative Colorant 1 | D |

(continued)

| | Colorant multimer | Color transfer |
|---|---|---|
| Comparative Example 2-2 | Comparative Colorant 2 | C |

Table 19

| | Colorant multimer | Color transfer |
|---|---|---|
| Example 2-10 | P176 | B |
| Example 2-11 | P179 | B |
| Example 2-12 | P183 | A |
| Example 2-13 | P184 | B |
| Example 2-14 | P185 | B |
| Example 2-15 | P192 | B |
| Example 2-16 | P193 | B |
| Example 2-17 | P197 | B |

Table 20

| | Colorant multimer | Color transfer |
|---|---|---|
| Example 2-18 | S-1 | B |
| Example 2-19 | S-2 | A |
| Example 2-20 | S-3 | A |
| Example 2-21 | S-4 | A |
| Example 2-22 | S-5 | A |
| Example 2-23 | S-6 | A |
| Example 2-24 | S-7 | A |
| Example 2-25 | S-8 | B |
| Example 2-26 | S-9 | A |
| Example 2-27 | S-10 | B |
| Example 2-28 | S-11 | A |
| Example 2-29 | S-12 | A |
| Example 2-30 | S-13 | A |
| Example 2-31 | S-14 | A |
| Example 2-32 | S-15 | A |
| Example 2-33 | S-16 | B |
| Example 2-34 | S-17 | B |
| Example 2-35 | S-18 | B |
| Example 2-36 | S-19 | A |
| Example 2-37 | S-20 | B |
| Example 2-38 | S-21 | B |
| Example 2-39 | S-22 | A |

(continued)

| | Colorant multimer | Color transfer |
|---|---|---|
| Example 2-40 | S-23 | A |
| Example 2-41 | S-24 | B |
| Example 2-42 | S-25 | A |
| Example 2-43 | S-26 | A |

Table 21

| | Colorant multimer | Color transfer |
|---|---|---|
| Example 2-44 | P201 | B |
| Example 2-45 | P202 | C |
| Example 2-46 | P203 | B |
| Example 2-47 | P204 | C |
| Example 2-48 | P205 | A |
| Example 2-49 | P207 | B |
| Example 2-50 | P209 | B |
| Example 2-51 | P211 | A |
| Example 2-52 | P213 | B |
| Example 2-53 | P215 | B |
| Example 2-54 | P217 | B |
| Example 2-55 | P219 | B |
| Example 2-56 | P221 | C |
| Example 2-57 | P223 | C |
| Example 2-58 | P225 | C |
| Example 2-59 | P227 | C |

As shown in Tables 14 to 17, in Examples 1-1 to 1-59 in which the colorant multimers of the invention are used, excellent solvent resistance, heat resistance and light fastness are exhibited.

Further, as shown in Tables 18 to 21, in the color filters of Examples 2-1 to 2-59 in which the colorant multimers of the invention are used, color transfer to adjacent pixel pattern are suppressed.

## Claims

**1.** A colorant multimer comprising, as a partial structure of a colorant moiety, a dipyrromethene metal complex compound or tautomer thereof obtained from:

(i) a dipyrromethene compound represented by the following Formula (M); and
(ii) a metal or a metal compound:

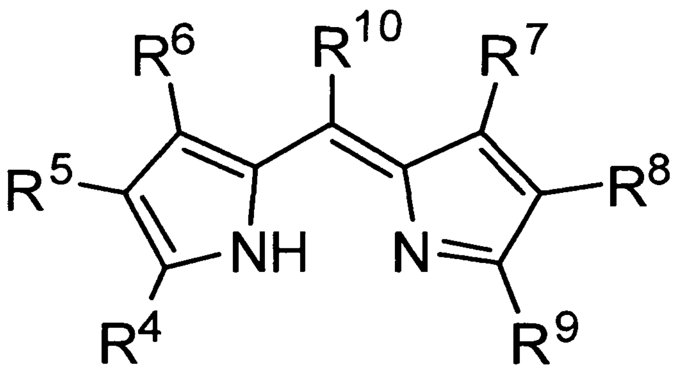

Formula (M)

wherein in Formula (M), $R^4$, $R^5$, $R^6$, $R^7$, $R^8$, $R^9$, and $R^{10}$ each independently represent a hydrogen atom or a monovalent substituent,
wherein the colorant multimer comprises at least one of constituent units represented by the following Formula (A), (B) or (C):

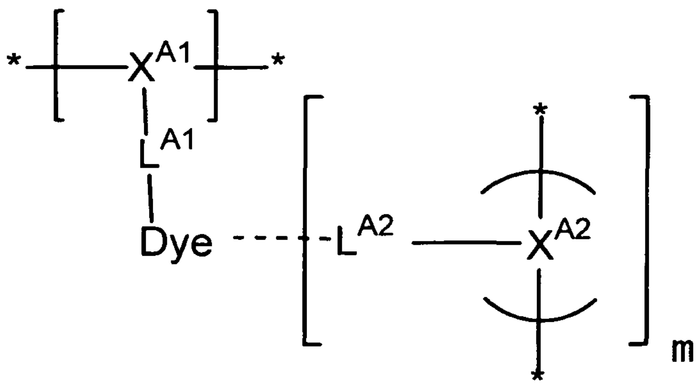

Formula (A)

wherein in Formula (A), $X^{A1}$ represents a linking group formed by polymerization; $L^{A1}$ represents a single bond or a divalent linking group; "Dye" represents a colorant residue formed by removing any one to (*m*+1) hydrogen atoms from the dipyrromethene metal complex compound or tautomer thereof; XA2 represents a linking group formed by polymerization; $L^{A2}$ represents a single bond or a divalent linking group; m represents an integer of from 0 to 3; and "Dye" and $L^{A2}$ may be linked to each other by a covalent bond, an ionic bond or a coordinate bond:

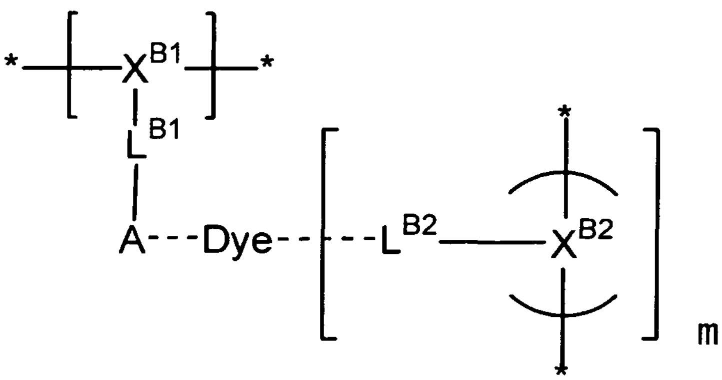

Formula (B)

wherein in Formula (B), $X^{B1}$ represents a linking group formed by polymerization; $L^{B1}$ represents a single bond or a divalent linking group; A represents a group that can be bonded to "Dye" via an ionic bond or a coordinate bond; "Dye" represents a colorant residue having a group that can be bonded to A, via an ionic bond or a coordinate bond, on a substituent in the dipyrromethene metal complex compound or tautomer thereof; $X^{B2}$ represents a linking group formed by polymerization; $L^{B2}$ represents a single bond or a divalent linking group; m represents an integer of from 0 to 3; and "Dye" and $L^{B2}$ may be linked to each other by a covalent bond, an ionic bond or a coordinate bond:

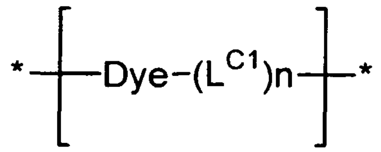

Formula (C)

wherein in Formula (C), $L^{C1}$ represents a single bond or a divalent linking group; "Dye " represents a colorant residue formed by removing any two of hydrogen atoms from the dipyrromethene metal complex compound or tautomer thereof; and n represents an integer of from 1 to 4.

2. The colorant multimer according to claim 1, wherein the dipyrromethene metal complex compound or tautomer thereof is represented by the following Formula (5) or (6):

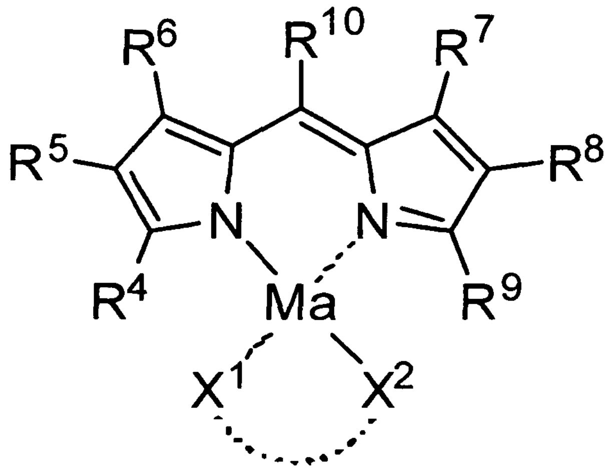

Formula (5)

wherein in Formula (5), $R^4$ to $R^9$ each independently represent a hydrogen atom or a substituent; $R^{10}$ represents a hydrogen atom, a halogen atom, an alkyl group, an aryl group or a heterocyclic group; Ma represents a metal atom or a metal compound; $X^1$ represents a group that can be bonded to Ma; $X^2$ represents a group that neutralizes the charge of Ma; and $X^1$ and $X^2$ may be linked to each other to form a 5-, 6-, or 7-membered ring together with Ma:

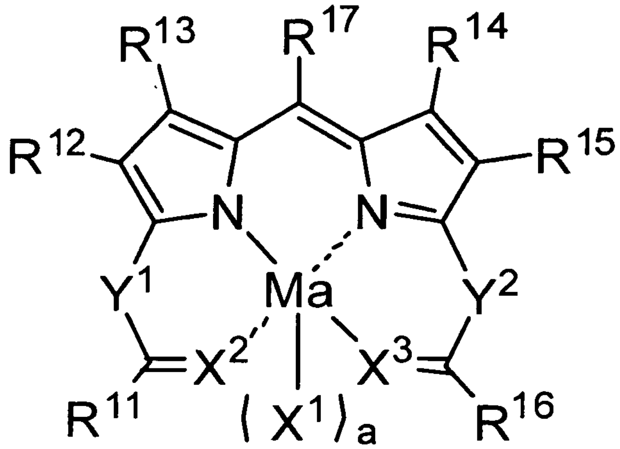

Formula (6)

wherein in Formula (6), $R^{11}$ and $R^{16}$ each independently represent an alkyl group, an alkenyl group, an aryl group, a heterocyclic group, an alkoxy group, an aryloxy group, an alkylamino group, an arylamino group, or a heterocyclic amino group; $R^{12}$ to $R^{15}$ each independently represent a hydrogen atom or a substituent; $R^{17}$ represents a hydrogen atom, a halogen atom, an alkyl group, an aryl group, or a heterocyclic group; Ma represents a metal atom or a metal compound; $X^2$ and $X^3$ each independently represent NR' (wherein R' represents a hydrogen atom, an alkyl group, an alkenyl group, an aryl group, a heterocyclic group, an acyl group, an alkylsulfonyl group or an arylsulfonyl group), a nitrogen atom, an oxygen atom, or a sulfur atom; $Y^1$ and $Y^2$ each independently represent NR" (wherein R" represents a hydrogen atom, an alkyl group, an alkenyl group, an aryl group, a heterocyclic group, an acyl group,

an alkylsulfonyl group, or an arylsulfonyl group), a nitrogen atom or a carbon atom; $R^{11}$ and $Y^1$ may be linked to each other to form a 5-, 6-, or 7-membered ring; $R^{16}$ and $Y^2$ may be linked to each other to form a 5-, 6-, or 7-membered ring; $X^1$ represents a group that can be bonded to Ma; and *a* represents 0, 1, or 2.

**3.** The colorant multimer according to claim 1 or claim 2, wherein the dipyrromethene metal complex compound or tautomer thereof is represented by the formula (6) as defined in claim 2.

**4.** The colorant multimer according to claim 1, wherein the constituent unit represented by Formula (A) is derived from a colorant monomer represented by the following Formula (1):

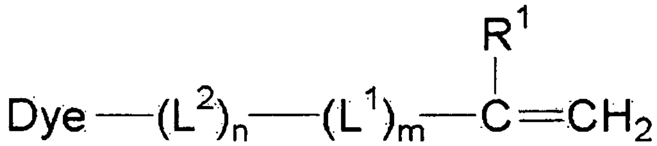
Formula (1)

wherein in Formula (1), $R^1$ represents a hydrogen atom, a halogen atom, an alkyl group or an aryl group; $L^1$ represents $-N(R^2)C(=O)-$, $-OC(=O)-$, $-C(=O)N(R^2)-$, $-C(=O)O-$, a group represented by the following Formula (2), a group represented by the following Formula (3), or a group represented by the following Formula (4); $L^2$ represents a divalent linking group; *m* and *n* each independently represent 0 or 1; "Dye" represents a colorant residue formed by removing any one hydrogen atom from the dipyrromethene metal complex compound or tautomer thereof; and $R^2$ represents a hydrogen atom, an alkyl group, an aryl group or a heterocyclic group:

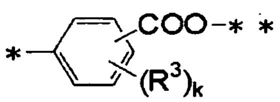
Formula (2)

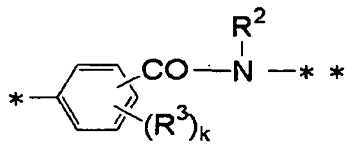
Formula (3)

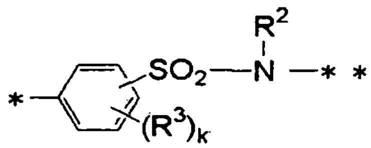
Formula (4)

wherein, $R^2$ in Formulae (3) and (4) independently represents a hydrogen atom, an alkyl group, an aryl group or a heterocyclic group; $R^3$ in Formulae (2) to (4) independently represents a hydrogen atom or a substituent; k in Formulae (2) to (4) independently represents an integer of from 0 to 4; * in Formulae (2) to (4) independently represents a position to which the $-C(R^1)=CH_2$ group in Formula (1) is linked; and ** in Formulae (2) to (4) independently represents a position to which $L^2$ or "Dye" (when n represents 0) in Formula (1) is linked.

**5.** The colorant multimer according to claim 4, further comprising, as a copolymerization component, a monomer having a terminal ethylenically unsaturated bond and having a structure different from the structure of the colorant monomer represented by Formula (1).

**6.** The colorant multimer according to any one of claims 2 to 5, wherein Ma in Formula (5) or Formula (6) is at least one of Zn, Co, V=O or Cu.

**7.** The colorant multimer according to any one of claims 2 to 5, wherein Ma in Formula (5) or Formula (6) is Zn.

**8.** The colorant multimer according to any one of claims 1 to 7, wherein the colorant multimer has an alkali-soluble group.

**9.** The colorant multimer according to claim 8, wherein at least one selected from the group consisting of the colorant multimer comprising at least one of the constituent units represented by Formula (A), (B) or (C), the colorant monomer represented by Formula (1), and the monomer having a terminal ethylenically unsaturated bond and having a structure different from that of the colorant monomer represented by Formula (1), has the alkali-soluble group.

**10.** The colorant multimer according to claim 8 or claim 9, wherein the colorant multimer comprising at least one of the constituent units represented by Formula (A), (B) or (C), or "Dye" in Formula (1), has the alkali-soluble group.

**11.** A colored curable composition comprising the colorant multimer according to any one of claims 1 to 10.

12. A color filter formed by using the colored curable composition according to claim 11.

13. A method of manufacturing a color filter, comprising coating the colored curable composition according to claim 11 on a substrate, exposing the coated film through a mask, and developing the exposed film to form a pattern image.

**Patentansprüche**

1. Farbstoff-Multimer, umfassend als Teilstruktur eines Farbstoffanteils eine Dipyrromethen-Metallkomplexverbindung oder Tautomer davon, erhalten von:

   (i) einer Dipyrromethenverbindung mit der folgenden Formel (M); und
   (ii) einem Metall oder einer Metallverbindung:

   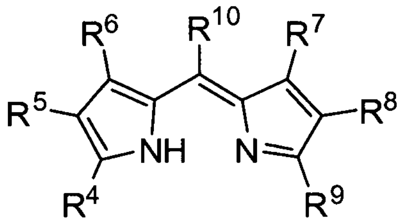

   Formel (M)

   worin in der Formel (M) $R^4$, $R^5$, $R^6$, $R^7$, $R^8$, $R^9$ und $R^{10}$ jeweils unabhängig ein Wasserstoffatom oder ein monovalenter Substituent sind,
   worin das Farbstoff-Multimer zumindest eine von Bestandteilseinheiten mit der folgenden Formel (A), (B) oder (C) enthält:

   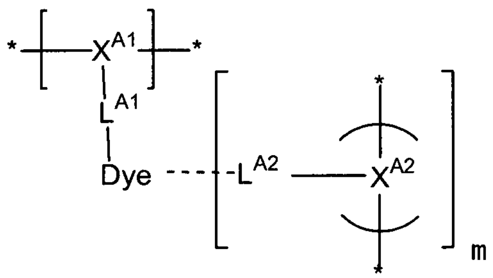

   Formel (A)

   worin in der Formel (A) $X^{A1}$ eine Bindegruppe ist, gebildet durch Polymerisation, $L^{A1}$ eine Einfachbindung oder eine bivalente Bindegruppe ist, "Dye" ein Farbrest ist, gebildet durch Entfernen von einem bis (m+1) Wasserstoffatomen von der Dipyrromethen-Metallkomplexverbindung oder dem Tautomer davon, $X^{A2}$ eine Bindegruppe ist, gebildet durch Polymerisation, $L^{A2}$ eine Einfachbindung oder bivalente Bindegruppe ist, m eine ganze Zahl von 0 bis 3 ist und "Dye" und $L^{A2}$ aneinander durch eine kovalente Bindung, ionische Bindung oder Koordinatenbindung gebunden sein können;

   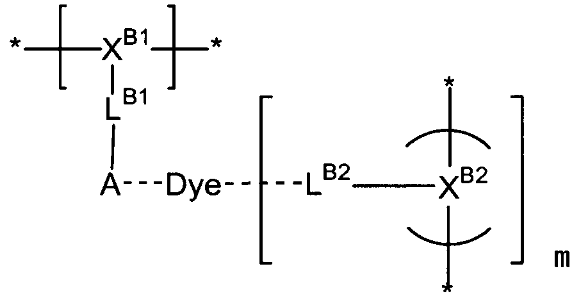

   Formel (B)

   worin in der Formel (B) $X^{B1}$ eine Bindegruppe ist, gebildet durch Polymerisation, $L^{B1}$ eine Einfachbindung oder bivalente Bindegruppe ist, A eine Gruppe ist, die an "Dye" über eine ionische Bindung oder Koordinatenbindung

gebunden sein kann, "Dye" ein Farbstoffrest ist, mit einer Gruppe, die über eine ionische Bindung oder Koordinatenbindung an einen Substituenten in der Dipyrromethen-Metallkomplexverbindung oder Tautomer davon gebunden sein kann, $X^{B2}$ eine Bindegruppe ist, gebildet durch Polymerisation, $L^{B2}$ eine Einfachbindung oder bivalente Bindegruppe ist, m eine ganze Zahl von 0 bis 3 ist und "Dye" und $L^{B2}$ aneinander durch eine kovalente Bindung, ionische Bindung oder Koordinatenbindung gebunden sein können;

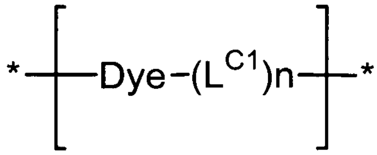

Formel (C)

worin in der Formel (C) $L^{C1}$ eine Einfachbindung oder bivalente Bindegruppe ist, "Dye" ein Farbstoffrest ist, gebildet durch Entfernen von irgendwelchen zwei Wasserstoffatomen von der Dipyrromethen-Metallkomplexverbindung oder Tautomer davon und n eine ganze Zahl von 1 bis 4 ist.

**2.** Farbstoff-Multimer nach Anspruch 1, worin die Dipyrromethen-Metallkomplexverbindung oder Tautomer davon durch folgende Formel (5) oder (6) dargestellt ist:

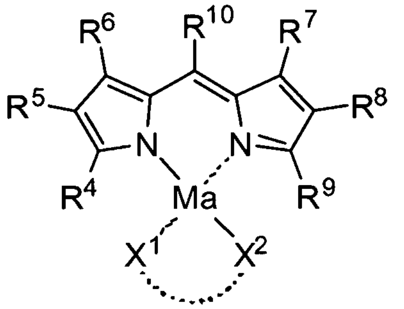

Formel (5)

worin in der Formel (5) $R^4$ bis $R^9$ jeweils unabhängig ein Wasserstoffatom oder ein Substituent sind, $R^{10}$ ein Wasserstoffatom, Halogenatom, Alkylgruppe, Arylgruppe oder heterocyclische Gruppe sind, Ma ein Metallatom oder eine Metallverbindung sind, $X^1$ eine Gruppe ist, die an Ma gebunden sein kann, $X^2$ eine Gruppe ist, die die Ladung von Ma neutralisiert, und $X^1$ und $X^2$ aneinander gebunden sein können, unter Bildung eines 5-, 6- oder 7-gliedrigen Rings zusammen mit Ma;

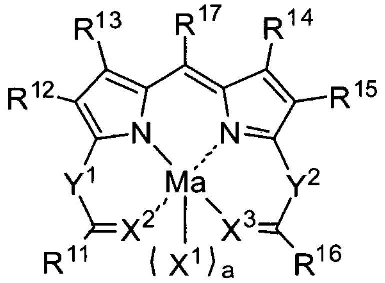

Formel (6)

worin in der Formel (6) $R^{11}$ und $R^{16}$ jeweils unabhängig eine Alkylgruppe, Alkenylgruppe, Arylgruppe, heterocyclische Gruppe, Alkoxygruppe, Aryloxygruppe, Alkylaminogruppe, Arylaminogruppe oder heterocyclische Aminogruppe sind, $R^{12}$ bis $R^{15}$ jeweils unabhängig ein Wasserstoffatom oder ein Substituent sind, $R^{17}$ ein Wasserstoffatom, Halogenatom, Alkylgruppe, Arylgruppe oder heterocyclische Gruppe ist, Ma ein Metallatom oder eine Metallverbindung ist, $X^2$ und $X^3$ jeweils unabhängig NR' (worin R' ein Wasserstoffatom, Alkylgruppe, Alkenylgruppe, Arylgruppe, heterocyclische Gruppe, Acylgruppe, Alkylsulfonylgruppe oder Arylsulfonylgruppe ist), Stickstoffatom, Sauerstoffatom oder Schwefelatom sind, $Y^1$ und $Y^2$ jeweils unabhängig NR" (von R" ein Wasserstoffatom, Alkylgruppe, Alkenylgruppe, Arylgruppe, heterocyclische Gruppe, Acylgruppe, Alkylsulfonylgruppe, oder Arylsulfonylgruppe ist), Stickstoffatom oder Kohlenstoffatom sind, $R^{11}$ und $Y^1$ aneinander gebildet sein können, zur Bildung eines 5-, 6- oder 7-gliedrigen Rings, $R^{16}$ und $Y^2$ aneinander gebunden sein können, zur Bildung eines 5-, 6- oder 7-gliedrigen Rings, $X^1$ eine Gruppe ist, die an Ma gebunden sein kann, und a 0, 1 oder 2 ist.

**3.** Farbstoff-Multimer nach Anspruch 1 oder 2, worin die Dipyrromethen-Metallkomplexverbindung oder das Tautomer davon durch die Formel (6) wie in Anspruch 2 definiert dargestellt ist.

**4.** Farbstoff-Multimer nach Anspruch 1, worin die Bestanteilseinheit, dargestellt durch die Formel (A), von einem Farbstoffmonomer stammt, dargestellt durch die folgende Formel (1):

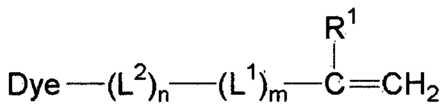

Formel (1)

worin in der Formel (1) $R^1$ ein Wasserstoffatom, Halogenatom, Alkylgruppe oder Arylgruppe ist, $L^1$ $-N(R^2)C(=O)-$, $-OC(=O)-$, $-C(=O)N(R^2)-$, $-C(=O)O-$, eine Gruppe mit der folgenden Formel (2), eine Gruppe mit der folgenden Formel (3) oder eine Gruppe mit der folgenden Formel (4) ist, $L^2$ eine bivalente Bindegruppe ist, m und n unabhängig 0 oder 1 sind, "Dye" ein Farbstoffrest ist, gebildet durch Entfernen von einem Wasserstoffatom von der Dipyrromethen-Metallkomplexverbindung oder Tautomer davon, und $R^2$ ein Wasserstoffatom, Alkylgruppe, Arylgruppe oder heterocyclische Gruppe ist:

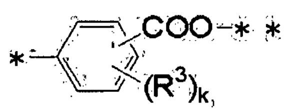

Formel (2)

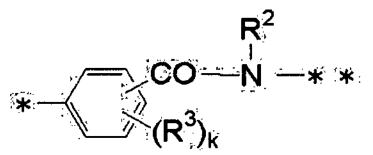

Formel (3)

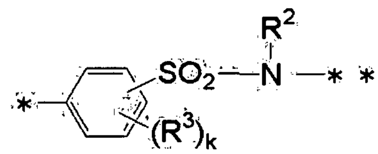

Formel (4)

worin $R^2$ in den Formeln (3) und (4) unabhängig ein Wasserstoffatom, eine Alkylgruppe, Arylgruppe oder heterocyclische Gruppe sind, $R^3$ in den Formeln (2) bis (4) unabhängig ein Wasserstoffatom oder ein Substituent sind, k in den Formeln (2) bis (4) unabhängig eine ganze Zahl von 0 bis 4 ist; * in den Formeln (2) bis (4) unabhängig eine Position ist, an die die $-C(R^1)=CH_2$-Gruppe in der Formel (1) gebunden ist, und ** in den Formeln (2) bis (4) unabhängig eine Position ist, an die $L^2$ oder "Dyes" (wenn n 0 ist) in der Formel (1) gebunden ist.

**5.** Farbstoff-Multimer nach Anspruch 4, weiterhin umfassend als Copolymerisationskomponente ein Monomer mit einer terminalen ethylenisch ungesättigten Bindung und mit einer Struktur, die von der Struktur des Farbstoffmonomers mit der Formel (1) verschieden ist.

**6.** Farbstoff-Multimer nach einem der Ansprüche 2 bis 5, worin Ma in der Formel (5) oder (6) zumindest eines von Zn, Co, V=O oder Cu ist.

**7.** Farbstoff-Multimer nach einem der Ansprüche 2 bis 5, worin Ma in der Formel (5) oder (6) Zn ist.

**8.** Farbstoff-Multimer nach einem der Ansprüche 1 bis 7, worin das Farbstoff-Multimer eine alkalilösliche Gruppe hat.

**9.** Farbstoff-Multimer nach Anspruch 8, worin zumindest eines, ausgewählt aus der Gruppe bestehend aus dem Farbstoff-Multimer, umfassend zumindest eine der Bestandteilseinheiten, dargestellt durch die Formeln (A), (B) oder (C), dem Farbstoffmonomer mit der Formel (1) und Monomer mit einer terminalen ethylenisch ungesättigen Bindung und mit einer Struktur, die von der des Farbstoffmonomers mit der Formel (1) verschieden ist, die alkalilösliche Gruppe hat.

**10.** Farbstoff-Multimer nach Anspruch 8 oder 9, worin das Farbstoff-Multimer mit zumindest einer von den Bestandteilseinheiten mit der Formel (A), (B) oder (C) oder "Dye" in der Formel (1) die alkalilösliche Gruppe hat.

**11.** Gefärbte härtbare Zusammensetzung, umfassend das Farbstoff-Multimer nach einem der Ansprüche 1 bis 10.

**12.** Farbfilter, gebildet durch Verwendung der gefärbten härtbaren Zusammensetzung nach Anspruch 11.

**13.** Verfahren zur Herstellung eines Farbfilters, umfassend die Beschichtung der gefärbten härtbaren Zusammensetzung nach Anspruch 11 auf einem Substrat, Belichten des beschichteten Filmes durch eine Maske und Entwickeln des belichteten Filmes zur Bildung eines Musterbildes.

## Revendications

**1.** Multimère colorant comprenant, en tant que structure partielle d'un fragment de colorant, un composé de complexe dipyrrométhène-métal ou un tautomère de celui-ci obtenu à partir :

(i) d'un composé de dipyrrométhène représenté par la formule (M) suivante ; et
(ii) d'un métal ou d'un composé métallique :

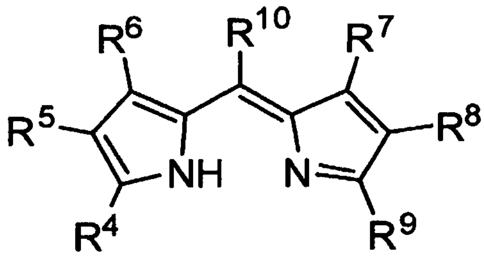

Formule (M)

dans lequel , dans la formule (M), $R^4$, $R^5$, $R^6$, $R^7$, $R^8$, $R^9$ et $R^{10}$ représentent chacun indépendamment un atome d'hydrogène ou un substituant monovalent,
dans lequel le multimère colorant comprend au moins l'un de motifs constitutifs représentés par la formule (A), (B) ou (C) suivante :

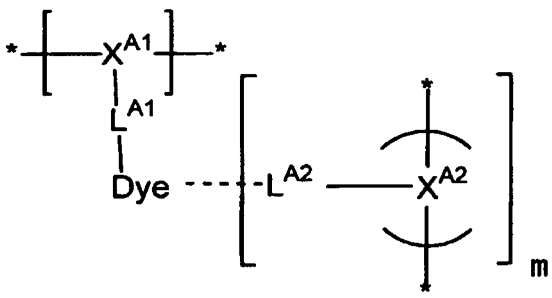

Formule (A)

dans lequel , dans la formule (A), $X^{A1}$ représente un groupement de liaison formé par polymérisation ; $L^{A1}$ représente une liaison simple ou un groupement de liaison divalent ; "Dye" représente un résidu de colorant formé par élimination de l'un quelconque jusqu'à (m+1) atomes d'hydrogène du composé de complexe de dipyrrométhène-métal ou du tautomère de celui-ci ; $X^{A2}$ représente un groupement de liaison formé par polymérisation ; $L^{A2}$ représente une liaison simple ou un groupement de liaison divalent ; m représente un nombre entier de 0 à 3 ; et "Dye" et $L^{A2}$ peuvent être liés l'un à l'autre par une liaison covalente, une liaison ionique ou une liaison de coordination ;

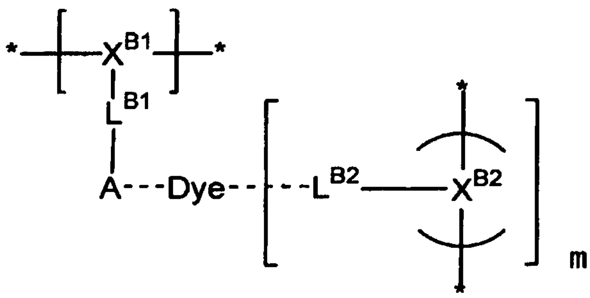

Formule (B)

dans lequel , dans la formule (B), $X^{B1}$ représente un groupement de liaison formé par polymérisation ; $L^{B1}$

représente une liaison simple ou un groupement de liaison divalent ; A représente un groupement qui peut être lié à "Dye" par l'intermédiaire d'une liaison ionique ou d'une liaison de coordination ; "Dye" représente un résidu de colorant comprenant un groupement qui peut être lié à A par l'intermédiaire d'une liaison ionique ou d'une liaison de coordination sur un substituant dans le composé de complexe de dipyrrométhène-métal ou du tautomère de celui-ci ; $X^{B2}$ représente un groupement de liaison formé par polymérisation ; $L^{B2}$ représente une liaison simple ou un groupement de liaison divalent ; m représente un nombre entier de 0 à 3 ; et "Dye" et $L^{B2}$ peuvent être liés l'un à l'autre par une liaison covalente, une liaison ionique ou une liaison de coordination ;

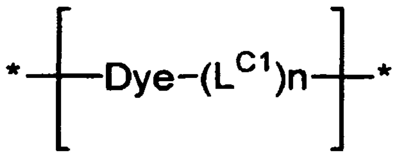

Formule (C)

dans lequel , dans la formule (C), $L^{C1}$ représente une liaison simple ou un groupement de liaison divalent ; "Dye" représente un résidu de colorant formé par élimination de deux atomes d'hydrogène quelconques du composé de complexe de dipyrrométhène-métal ou du tautomère de celui-ci ; et n représente un nombre entier de 1 à 4.

**2.** Multimère colorant selon la revendication 1, dans lequel le composé de complexe de dipyrrométhène-métal ou le tautomère de celui-ci est représenté par la formule (5) ou (6) suivante :

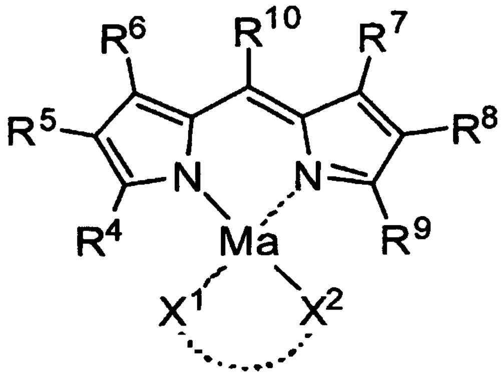

Formule (5)

dans lequel , dans la formule (5), $R^4$ à $R^9$ représentent chacun indépendamment un atome d'hydrogène ou un substituant ; $R^{10}$ représente un atome d'hydrogène, un atome d'halogène, un groupement alkyle, un groupement aryle ou un groupement hétérocyclique ; Ma représente un atome de métal ou un composé métallique ; $X^1$ représente un groupement qui peut être lié à Ma ; $X^2$ représente un groupement qui neutralise la charge de Ma ; et $X^1$ et $X^2$ peuvent être liés l'un à l'autre pour former un cycle à 5, 6 ou 7 chaînons avec Ma ;

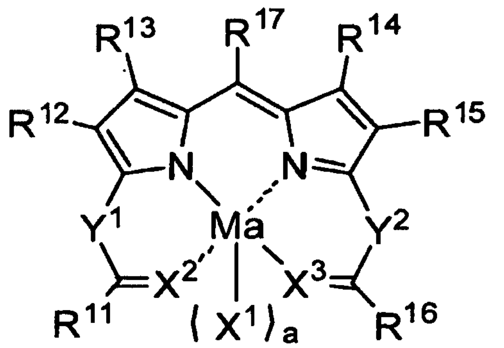

Formule (6)

dans laquelle, dans la formule (6), $R^{11}$ et $R^{16}$ représentent chacun indépendamment un groupement alkyle, un groupement alcényle, un groupement aryle, un groupement hétérocyclique, un groupement alcoxy, un groupement

aryloxy, un groupement alkylamino, un groupement arylamino ou un groupement amino hétérocyclique ; $R^{12}$ à $R^{15}$ représentent chacun indépendamment un atome d'hydrogène ou un substituant ; $R^{17}$ représente un atome d'hydrogène, un atome d'halogène, un groupement alkyle, un groupement aryle ou un groupement hétérocyclique ; Ma représente un atome de métal ou un composé métallique ; $X^2$ et $X^3$ représentent chacun indépendamment NR' (où R' représente un atome d'hydrogène, un groupement alkyle, un groupement alcényle, un groupement aryle, un groupement hétérocyclique, un groupement acyle, un groupement alkylsulfonyle ou un groupement arylsulfonyle), un atome d'azote, un atome d'oxygène ou un atome de soufre ; $Y^1$ et $Y^2$ représentent chacun indépendamment NR" (où R" représente un atome d'hydrogène, un groupement alkyle, un groupement alcényle, un groupement aryle, un groupement hétérocyclique, un groupement acyle, un groupement alkylsulfonyle ou un groupement arylsulfonyle), un atome d'azote ou un atome de carbone ; $R^{11}$ et $Y^1$ peuvent être liés l'un à l'autre pour former un cycle à 5, 6 ou 7 chaînons ; $R^{16}$ et $Y^2$ peuvent être liés l'un à l'autre pour former un cycle à 5, 6 ou 7 chaînons ; $X^1$ représente un groupement qui peut être lié à Ma ; et a représente 0, 1 ou 2.

**3.** Multimère colorant selon la revendication 1 ou la revendication 2, dans lequel le composé de complexe de dipyrrométhène-métal ou le tautomère de celui-ci est représenté par la formule (6) telle que définie dans la revendication 2.

**4.** Multimère colorant selon la revendication 1, dans lequel le motif constitutif représenté par la formule (A) est dérivé d'un monomère colorant représenté par la formule (1) suivante :

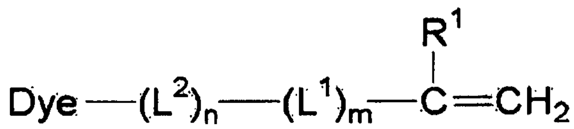

Formule (1)

dans lequel , dans la formule (1), $R^1$ représente un atome d'hydrogène, un atome d'halogène, un groupement alkyle ou un groupement aryle ; $L^1$ représente $-N(R^2)C(=O)-$, $-OC(=O)-$, $-C(=O)N(R^2)-$, $-C(=O)O-$, un groupement représenté par la formule (2) suivante, un groupement représenté par la formule (3) suivante ou un groupement représenté par la formule (4) suivante ; $L^2$ représente un groupement de liaison divalent ; m et n représentent chacun indépendamment 0 ou 1 ; "Dye" représente un résidu de colorant formé par élimination d'un quelconque atome d'hydrogène du composé de complexe de dipyrrométhène-métal ou du tautomère de celui-ci ; et $R^2$ représente un atome d'hydrogène, un groupement alkyle, un groupement aryle ou un groupement hétérocyclique ;

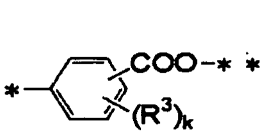

Formule (2)

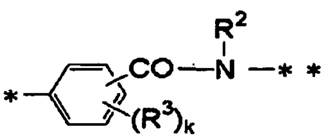

Formule (3)

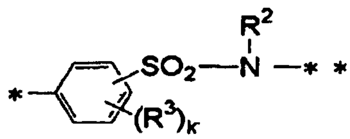

Formule (4)

dans lequel , $R^2$ dans les formules (3) et (4) représente indépendamment un atome d'hydrogène, un groupement alkyle, un groupement aryle ou un groupement hétérocyclique ; $R^3$ dans les formules (2) à (4) représente indépendamment un atome d'hydrogène ou un substituant ; k dans les formules (2) à (4) représente indépendamment un nombre entier de 0 à 4 ; * dans les formules (2) à (4) représente indépendamment une position à laquelle le groupe $-C(R^1)=CH_2$ dans la formule (1) est lié ; et ** dans les formules (2) à (4) représente indépendamment une position à laquelle $L^2$ ou "Dye" (lorsque n représente 0) dans la formule (1) est lié.

**5.** Multimère colorant selon la revendication 4, comprenant en outre, en tant que composant de polymérisation, un monomère comprenant une liaison terminale à insaturation éthylénique et ayant une structure différente de la structure du monomère colorant représenté par la formule (1).

**6.** Multimère colorant selon l'une quelconque des revendications 2 à 5, dans lequel Ma dans la formule (5) ou dans la formule (6) est l'un au moins parmi Zn, Co, V=O ou Cu.

**7.** Multimère colorant selon l'une quelconque des revendications 2 à 5, dans lequel Ma dans la formule (5) ou dans la formule (6) est Zn.

**8.** Multimère colorant selon l'une quelconque des revendications 1 à 7, dans lequel le multimère colorant comprend un groupement soluble dans les alcalis.

**9.** Multimère colorant selon la revendication 8, dans lequel au moins l'un choisi dans le groupe constitué du multimère colorant comprenant l'un au moins des motifs constitutifs représentés par la formule (A), (B) ou (C), le monomère colorant représenté par la formule (1) et le monomère comprenant une liaison terminale à insaturation éthylénique et ayant une structure différente de la structure du monomère colorant représenté par la formule (1), comprend le groupement soluble dans les alcalis.

**10.** Multimère colorant selon la revendication 8 ou la revendication 9, dans lequel le multimère colorant comprenant l'un au moins des motifs constitutifs représentés par la formule (A), (B) ou (C), ou le "Dye" dans la formule (1), comprend le groupement soluble dans les alcalis.

**11.** Composition colorée durcissable comprenant le multimère colorant selon l'une quelconque des revendications 1 à 10.

**12.** Filtre de couleur formé en utilisant la composition colorée durcissable selon la revendication 11.

**13.** Procédé de fabrication d'un filtre de couleur, comprenant l'application de la composition colorée durcissable selon la revendication 11 sur un substrat, l'exposition du film revêtu à travers un masque et le développement du film exposé pour former une image selon un motif.

FIG.1

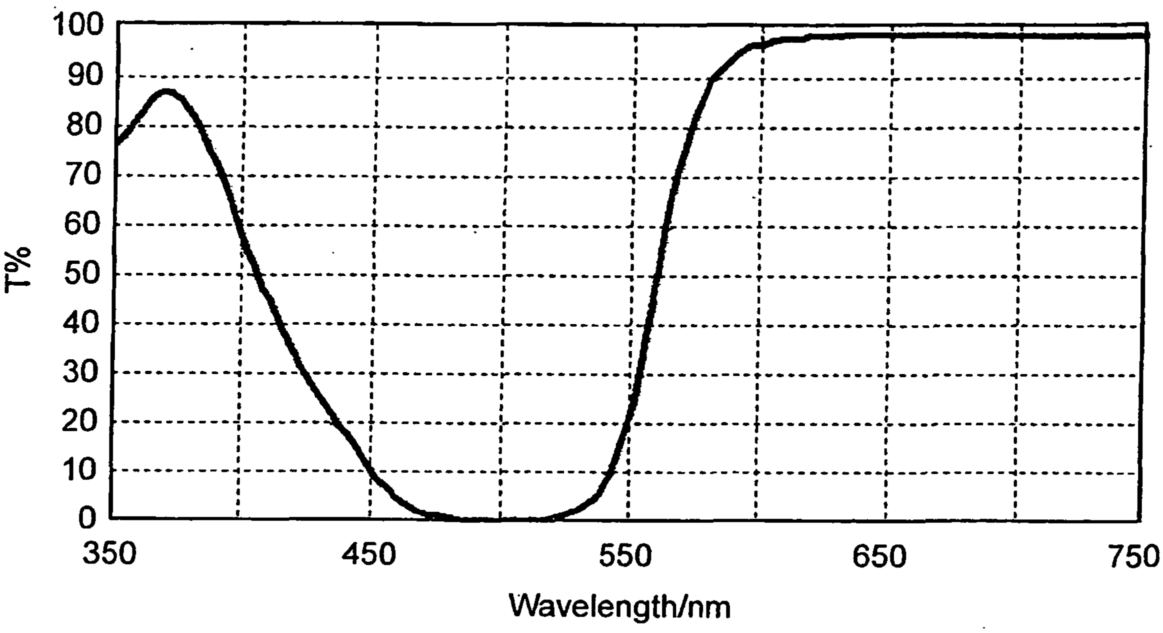
100
90
80
70
60
50
40
30
20
10
0
T%
350
450
550
650
750
Wavelength/nm

FIG.2

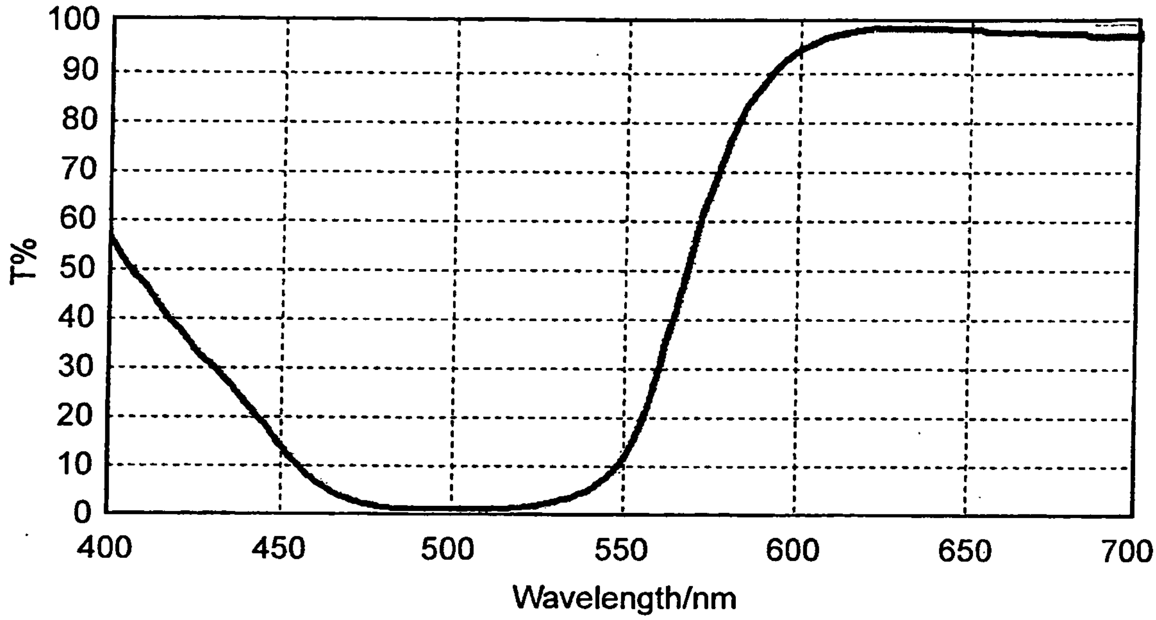
100
90
80
70
60
50
40
30
20
10
0
T%
400
450
500
550
600
650
700
Wavelength/nm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6075375 A
- US 20080076044 A
- JP 3279035 B
- JP 3324279 B
- JP 11352685 A
- JP 11352686 A
- JP 2000019729 A
- JP 2000019738 A
- JP 2002236360 A
- JP 2005316012 A
- JP 3309514 B
- JP 2006258916 A
- JP 2007139906 A
- JP 2007138051 A
- JP 3736221 B
- US 4774339 A
- US 5433896 A
- JP 2001240761 A
- JP 2002155052 A
- JP 3614586 B
- JP 2008292970 A
- JP 4065576 B
- JP 2008294982 A
- JP 51047334 B
- JP 57196231 A
- JP 59005240 A
- JP 59005241 A
- JP 2226149 A
- JP 1165613 A
- JP 2009288705 A
- JP 48041708 B
- JP 50006034 A
- JP 51037193 A
- JP 48064183 A
- JP 49043191 B
- JP 52030490 A
- JP 2007269779 A
- JP 2004295116 A
- JP 2000080068 A
- WO 02100903 A1
- JP 2001233842 A
- JP 59044615 A
- JP 54034327 B
- JP 58012577 A
- JP 54025957 A
- JP 59053836 A
- JP 59071048 A
- JP 2004300203 A
- JP 7128867 A
- JP 7146562 A
- JP 8278637 A
- JP 2000273370 A
- JP 2006085140 A
- JP 2006291191 A
- JP 2007002101 A
- JP 2007002102 A
- JP 2007281523 A


### Non-patent literature cited in the description


- **TAKEICHI SAKAGUCHI ; KYOHEI UENO.** Metal Chelates. Nankodo, 1995, vol. 1
- *Metal Chelates,* 1996, vol. 2
- *Metal Chelates,* 1997, vol. 3
- *Aust. J. Chem,* 1965, vol. 11, 1835-1845
- **J. H. BOGER et al.** *Heteroatom Chemistry,* 1990, vol. 1 (5), 389
- *Journal of American Chemistry,* 1957, vol. 79, 5019-5023
- Catalytic hydrogenation reaction, Application for organic synthesis. Tokyo Kagaku Dojin, 255
- *Bull. Chem. Soc. Jpn.,* 1964, vol. 37, 887
- **AKIO SASAKI.** Electronic Display Device. Kogyo Chosakai Publishing Co., Ltd, 1990
- **SUMIAKI IBUKI.** Display Device. Sangyo Tosho Publishing Co., Ltd, 1989
- **TATSUO UCHIDA.** Next Generation Liquid Crystal Display Techniques. Kogyo Chosakai Publishing Co., Ltd, 1994
- Color TFT Liquid Crystal Display. Kyoritsu Shuppan Co., Ltd, 1996
- EL, PDP, LCD Display - Trends in Techniques and Markets. Research Study Division of Toray Research Center, Inc, 2001, 43
- **KENTARO SHIMA.** 94 Market for Liquid Crystal Display Related Materials and Chemicals. CMC Publishing CO., LTD, 1994
- **RYOKICHI OMOTE.** 2003 Current State and Outlook for Liquid Crystal Related Markets. Fuji Chimera Research Institute, Inc, 2003
- **A. KONNO.** *SID meeting Digest,* 2005, 1380

- **HIROYASU SHIMA.** *Monthly Display,* December 2005, 18-24
- Color Science Handbook. 1985, 266